(19) Europäisches Patentamt
European Patent Office
Office européen des brevets

(11) **EP 1 032 044 B1**

(12) **EUROPEAN PATENT SPECIFICATION**

(45) Date of publication and mention
of the grant of the patent:
**22.08.2012 Bulletin 2012/34**

(51) Int Cl.:
**H01L 27/108** *(2006.01)*     **G11C 11/40** *(2006.01)*
**G11C 11/404** *(2006.01)*     **G11C 11/405** *(2006.01)*
**H01L 27/11** *(2006.01)*

(21) Application number: **00400524.5**

(22) Date of filing: **28.02.2000**

(54) **Semiconductor memory cell**

Halbleiter-Speicherzelle

Cellule de mémoire semi-conductrice

(84) Designated Contracting States:
**DE FR GB**

(30) Priority: **26.02.1999   JP 5005099**
**31.03.1999   JP 9330799**
**30.11.1999   JP 34005499**

(43) Date of publication of application:
**30.08.2000   Bulletin 2000/35**

(73) Proprietor: **Sony Corporation
Tokyo (JP)**

(72) Inventors:
• **Mukai, Mikio,
c/o Sony Corp.
Tokyo (JP)**
• **Hayashi, Yutaka
Tokyo (JP)**

(74) Representative: **Thévenet, Jean-Bruno et al
Cabinet Beau de Loménie
158, rue de l'Université
75340 Paris Cédex 07 (FR)**

(56) References cited:
**EP-A2- 0 869 511**

**Description**

**BACKGROUND OF THE INVENTION AND RELATED ART STATEMENT**

The present invention relates to a semiconductor memory cell which comprises at least a first transistor for readout, a second transistor for switching, a junction type transistor for current control and an MIS type diode for retaining information and which does not require a so-called refresh operation for retaining information.

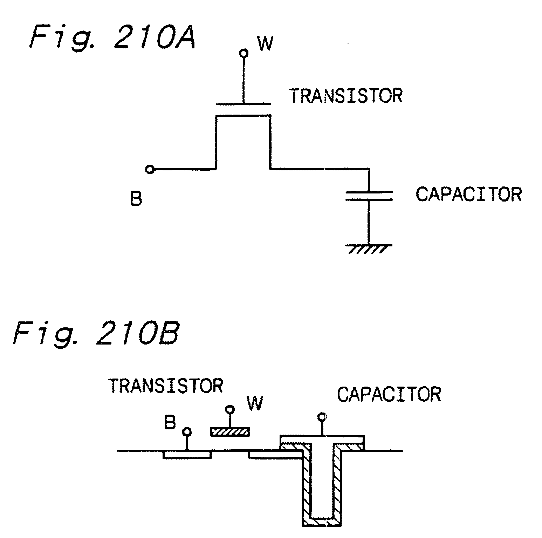

As a high-density semiconductor memory cell, conventionally, there is used a dynamic semiconductor memory cell that is called a single-transistor semiconductor memory cell including one transistor and one capacitor as shown in Fig. 210A. In the above semiconductor memory cell, an electric charge stored in the capacitor is required to be large enough to generate a sufficiently large voltage change on a bit line. However, with a decrease in the planar dimensions of the semiconductor memory cell, the capacitor formed in a parallel planar shape decreases in size, which causes the following new problem. When information stored as an electric charge in the capacitor of the semiconductor memory cell is read out, the read-out information is buried in a noise. Or, since the stray capacitance of the bit line in the semiconductor memory cell increases from generation to generation, only a small voltage change is generated on the bit line. As means for solving the above problems, there has been proposed a dynamic semiconductor memory cell having a trench capacitor cell structure as shown in Fig. 210B or a stacked capacitor cell structure. Since, however, the fabrication-related technology has its own limits on the depth of the trench (or groove) or the height of the stack, the capacitance of the capacitor is also limited. For this reason, dynamic semiconductor memory cells having the above structures are said to encounter the above limits unless expensive new materials are introduced for the capacitor as far as the dimensions thereof beyond the deep sub-micron rule (low sub-micron rule) are concerned.

In the planar dimensions smaller than those of the deep sub-micron rule (low sub-micron rule), the transistor constituting the semiconductor memory cell also has problems of deterioration of the drain breakdown voltage and a punchthrough from a drain region to a source region. There is therefore a large risk that current leakage takes place even if the voltage applied to the semiconductor memory cell is still within a predetermined range. When a semiconductor memory cell is made smaller in size, therefore, it is difficult to normally operate the semiconductor memory cell having a conventional transistor structure.

For overcoming the above limit problems of the capacitor, the present Applicant has proposed a semiconductor memory cell comprising two transistors or two transistors physically merged into one unit, as is disclosed in Japanese Patent Application No. 246264/1993 (JP-A-7-99251) corresponding to U.S. Patent No. 5,428,238. The following explanation is made by referring to Japanese Patent Application No. 246264/1993 (JP-A-7-99251). The semiconductor memory cell shown in Figs. 15(A) and 15(B) of the above Japanese Patent Application comprises a first semi-conductive region $SC_1$ of a first conductivity type formed in a surface region of a semiconductor substrate or formed on an insulating substrate, a first conductive region $SC_2$ formed in a surface region of the first semi-conductive region $SC_1$ so as to form a rectifier junction together with the first semi-conductive region $SC_1$, a second semi-conductive region $SC_3$ of a second conductivity type formed in a surface region of the first semi-conductive region $SC_1$ and spaced from the first conductive region $SC_2$, a second conductive region $SC_4$ formed in a surface region of the second semi-conductive region $SC_3$ so as to form a rectifier junction together with the second semi-conductive region $SC_3$, and a conductive gate G formed on a barrier layer so as to bridge the first semi-conductive region $SC_1$ and the second conductive region $SC_4$ and so as to bridge the first conductive region $SC_2$ and the second semi-conductive region $SC_3$, the conductive gate G being connected to a first memory-cell-selecting line, the first conductive region $SC_2$ being connected to a write-in information setting line, and the second conductive region $SC_4$ being connected to a second memory-cell-selecting line.

The first semi-conductive region $SC_1$ (functioning as a channel forming region $Ch_2$), the first conductive region $SC_2$ and the second semi-conductive region $SC_3$ (functioning as source/drain regions) and the conductive gate G constitute a switching transistor $TR_2$. On the other hand, the second semi-conductive region $SC_3$ (functioning as a channel forming region $Ch_1$), the first semi-conductive region $SC_1$ and the second conductive region $SC_4$ (functioning as source/drain regions) and the conductive gate G constitute an information storing transistor $TR_1$.

When information is written in the above semiconductor memory cell, the switching transistor $TR_2$ is brought into an on-state. As a result, the information is stored in the channel forming region $Ch_1$ of the information storing transistor $TR_1$ as a potential or as an electric charge. When the information is read out, the threshold voltage of the information storing transistor TR1 seen from the conductive gate G varies, depending upon the potential or the electric charge stored in the channel forming region Ch1 of the information storing transistor TR1. Therefore, when the information is read out, the storage state of the information storing transistor TR1 can be judged from the magnitude of a channel current (including a zero magnitude) by applying a properly selected potential to the conductive gate G. The information is read out by detecting the operation state of the information storing transistor TR1.

That is, when information is read out, the information storing transistor TR1 is brought into an on-state or an off-state, depending upon the information stored therein. Since the second conductive region SC4 is connected to the second line, a current which is large or small depending upon the stored information ("0" or "1") flows in the information storing transistor TR1. In this way, the information stored in the semiconductor memory cell can be read out through the information storing transistor TR1.

Further, the present Applicant in Japanese Patent Application No. 251646/1997 (JP-A-10-154757) has proposed a semiconductor memory cell comprising three transistors such as a transistor TR1 for readout, a transistor TR2 for switching and a junction type transistor TR3 for current control.

In the above semiconductor memory cell, information is stored in the second semi-conductive region SC3. However, the second semiconductor-conductive region SC3 is a floating region, so that the information disappears due to a leak current after a certain period of time. For retaining the information, therefore, there is required a refresh operation every constant period of time.

Furthermore, a semiconductor memory cell according to the preambles of the appended independent claims is disclosed in document EP 0 869 511 A2.

**OBJECT AND SUMMARY OF THE INVENTION**

It is an object of the present invention to provide a memory cell which requires no refresh operation for retaining information, permits reliable writing and readout of information, has transistor operation stabilized, has a large window (current difference) for reading out information in the memory cell, requires no large-capacitance capacitor unlike a conventional DRAM and permits a decrease in dimensions, or a semiconductor memory cell for a logic, and further to provide a semiconductor memory cell comprising at least two transistors, a junction type transistor for current control and a diode for retaining information or a semiconductor memory cell in which these are merged into one unit.

The invention is defined by the semiconductor memory cells of independent claims 1 and 7. Preferred embodiments are defined in the dependent claims.

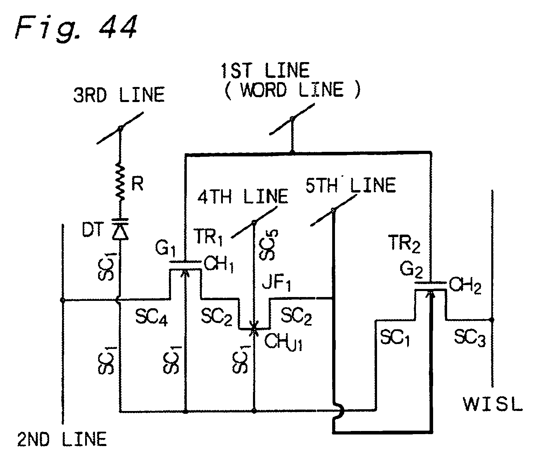

Fifth, sixth seventh, ninth and tenth aspects of the present invention for achieving the above object are defined in the following description. None of the other aspects and manufacturing methods described below form part of the claimed invention. According to a fifth aspect of the present invention for achieving the above object, there is provided a semiconductor memory cell comprising, as a drawing of its principle is shown in Fig. 44, 45A, 45B, 46, 47A, 47B, 48, 49, 50A, 50B, 61, 62A, 62B, 65, 66A, 66B, 67, 68A or 68B,

(1) a first transistor for readout, having a first conductivity type, and having source/drain regions, a semi-conductive channel forming region which is in contact with the source/drain regions and spaces out the source/drain regions, and a gate capacitively coupled with the channel forming region,
(2) a second transistor for switching, having a second conductivity type, and having source/drain regions, a semi-conductive channel forming region which is in contact with the source/drain regions and spaces out the source/drain regions, and a gate capacitively coupled with the channel forming region,
(3) a junction-field-effect transistor for current control, having source/drain regions, a channel region and gate regions, and
(4) an MIS type diode for retaining information,

wherein:

one source/drain region of the first transistor corresponds to the channel forming region of the second transistor and corresponds to one source/drain region of the junction-field-effect transistor,
one source/drain region of the second transistor corresponds to the channel forming region of the first transistor and corresponds to one gate region of the junction-field-effect transistor, and
one end of the MIS type diode is formed of an extending portion of the channel forming region of the first transistor, the other end of the MIS type diode is formed of an electrode composed of a conductive material, and the electrode is connected to a line having a predetermined potential.

In the semiconductor memory cell according to the fifth aspect of the present invention, there may be employed a constitution in which the gate of the first transistor and the gate of the second transistor are connected to a first line for memory cell selection (for example, word line), the other source/drain region of the first transistor is connected to a second line, the other end of the MIS type diode is connected to a third line corresponding to the above line having a predetermined potential through a high-resistance element, the other gate region of the junction-field-effect transistor is connected to a fourth line, one source/drain region of the first transistor is connected to a fifth line through the junction-field-effect transistor, and the other source/drain region of the second transistor is connected to a write-in information setting line. Under bias conditions where there is a risk of excessive current flowing in the MIS type diode, it is preferred to provide the above high-resistance element. Further, when the other end of the MIS type diode is connected to the above third line having a predetermined potential through the high-resistance element, the property degradation of a wide gap thin film to be described later can be prevented. It is preferred to employ a constitution in which the second line is used as a bit line and a second predetermined potential is applied to the fifth line or a constitution in which the fifth line is used as a bit line and a second predetermined potential is applied to the second line.

There may be also employed another constitution in which one source/drain region of the first transistor is connected to the write-in information setting line through the junction-field-effect transistor and a diode in place of being connected to the fifth line through the junction-field-effect transistor. In this case, it is preferred to employ a constitution in which the second line is used as a bit line or a constitution in which the write-in information setting line is co-used as a bit line and a second predetermined potential is applied to the second line. In explanations to be made hereinafter, when a diode, a pn junction diode to be described later or a majority carrier diode is provided, it is preferred to employ a constitution in which the second line is used as a bit line or a constitution in which the write-in information setting line is co-used as a bit line and a second predetermined potential is applied to the second line.

There may be also employed another constitution in which the other gate region of the junction-field-effect transistor is connected to the write-in information setting line in place of being connected to the fourth line. In this case, there may be employed a constitution in which one source/drain region of the first transistor is connected to the write-in information setting line through the junction-field-effect transistor and a diode in place of being connected to the fifth line through the junction-field-effect transistor.

There may be employed still another constitution in which one source/drain region of the first transistor is connected to the fourth line through the junction-field-effect transistor and a diode in place of being connected to the fifth line through the junction-field-effect transistor.

There may be also employed yet another constitution in which the other gate region of the junction-field-effect transistor is connected to one gate region of the junction-field-effect transistor in place of being connected to the fourth line. In this case, one end of the MIS type diode and the other gate region of the junction-field-effect transistor may be formed as a common region. In these cases, there may be employed a constitution in which one source/drain region of the first transistor is connected to the write-in information setting line through the junction-field-effect transistor and a diode in place of being connected to the fifth line through the junction-field-effect transistor.

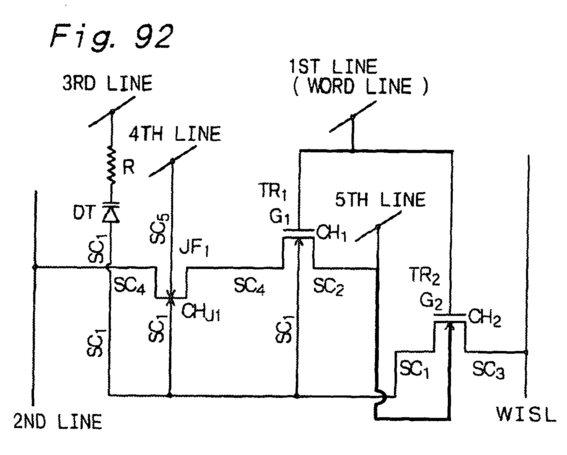

According to a sixth aspect of the present invention for achieving the above object, there is provided a semi-conductor memory cell comprising, as a drawing of its principle is shown in Fig. 92, 93A, 93B, 94, 95A, 95B, 96, 97A, 97B, 104, 105A, 105B, 108, 109A, 109B, 110, 111A, 111B, 112, 113A, 113B, 126, 127A or 127B,

(1) a first transistor for readout, having a first conductivity type, and having source/drain regions, a semi-conductive channel forming region which is in contact with the source/drain regions and spaces out the source/drain regions, and a gate capacitively coupled with the channel forming region,

(2) a second transistor for switching, having a second conductivity type, and having source/drain regions, a semi-conductive channel forming region which is in contact with the source/drain regions and spaces out the source/drain regions, and a gate capacitively coupled with the channel forming region,

(3) a junction-field-effect transistor for current control, having source/drain regions, a channel region and gate regions, and

(4) an MIS type diode for retaining information,

wherein:

one source/drain region of the first transistor corresponds to the channel forming region of the second transistor, the other source/drain region of the first transistor corresponds to one source/drain region of the junction-field-effect transistor,

one source/drain region of the second transistor corresponds to the channel forming region of the first transistor and corresponds to one gate region of the junction-field-effect transistor, and

one end of the MIS type diode is formed of an extending portion of the channel forming region of the first transistor, the other end of the MIS type diode is formed of an electrode composed of a conductive material, and the electrode is connected to a line having a predetermined potential.

In the semiconductor memory cell according to the sixth aspect of the present invention, there may be employed a constitution in which the gate of the first transistor and the gate of the second transistor are connected to a first line for memory cell selection (for example, word line), the other source/drain region of the first transistor is connected to a second line through the junction-field-effect transistor, the other end of the MIS type diode is connected to a third line corresponding to the above line having a predetermined potential through a high-resistance element, the other gate region of the junction-field-effect transistor is connected to a fourth line, one source/drain region of the first transistor is connected to a fifth line, and the other source/drain region of the second transistor is connected to a write-in information setting line. It is preferred to employ a constitution in which the second line is used as a bit line and a second predetermined potential is applied to the fifth line, or a constitution in which the fifth line is used as a bit line and a second predetermined potential is applied to the second line.

In the above case, there may be also employed a constitution in which one source/drain region of the first transistor is connected to the write-in information setting line through a diode in place of being connected to the fifth line.

There may be employed another constitution in which the other gate region of the junction-field-effect transistor is connected to the write-in information setting line in place of being connected to the fourth line. In this case, there may be employed a constitution in which one source/drain region of the first transistor is connected to the write-in information setting line through a diode in place of being connected to the fifth line.

There may be also employed a constitution in which the other gate region of the junction-field-effect transistor is connected to one gate region of the junction-field-effect transistor in place of being connected to the fourth line. In this case, one end of the MIS type diode and the other gate region of the junction-field-effect transistor can be formed as a common region. In these cases, there may be employed a constitution in which one source/drain region of the first transistor is connected to the write-in information setting line through a diode in place of being connected to the fifth line.

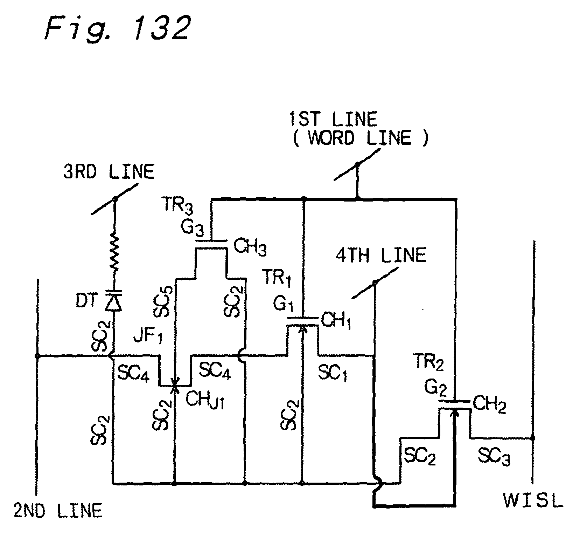

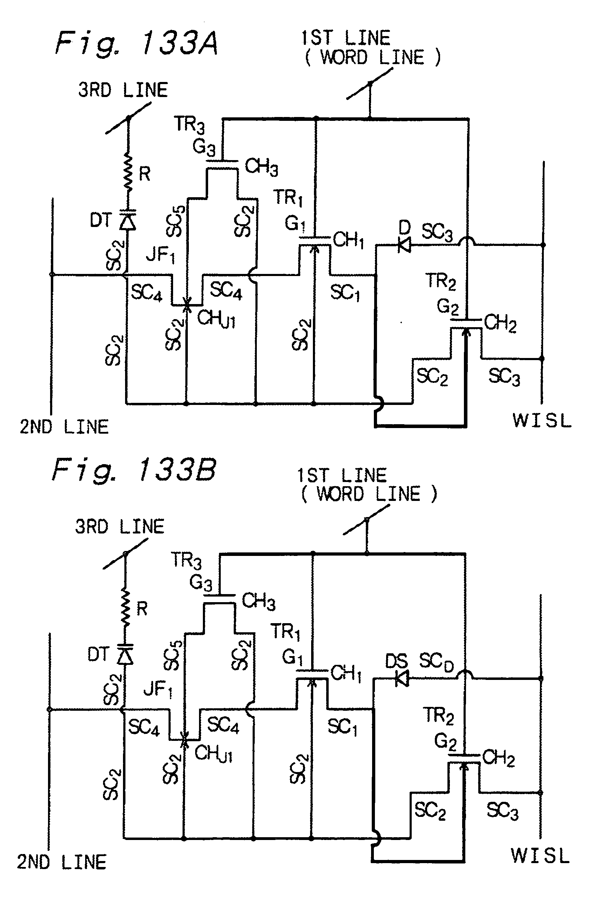

According to a seventh aspect of the present invention for achieving the above object, there is provided a semiconductor memory cell comprising, as a drawing of its principle is shown in Fig. 132, 133A or 133B,

(1) a first transistor for readout, having a first conductivity type, and having source/drain regions, a semi-conductive channel forming region which is in contact with the source/drain regions and spaces out the source/drain regions, and a gate capacitively coupled with the channel forming region,

(2) a second transistor for switching, having a second conductivity type, and having source/drain regions, a semi-conductive channel forming region which is in contact with the source/drain regions and spaces out the source/drain regions, and a gate capacitively coupled with the channel forming region,

(3) a third transistor for current control, having the second conductivity type, and having source/drain regions, a semi-conductive channel forming region which is in contact with the source/drain regions and spaces out the source/ drain regions, and a gate capacitively coupled with the channel forming region,

(4) a junction-field-effect transistor for current control, having source/drain regions, a channel region and gate regions, and

(5) an MIS type diode for retaining information,

wherein:

one source/drain region of the first transistor corresponds to the channel forming region of the second transistor,
the other source/drain region of the first transistor corresponds to one source/drain region of the junction-field-effect transistor,
one source/drain region of the second transistor corresponds to the channel forming region of the first transistor, corresponds to one gate region of the junction-field-effect transistor and corresponds to one source/drain region of the third transistor,
the other source/drain region of the third transistor corresponds to the other gate region of the junction-field-effect transistor, and
one end of the MIS type diode is formed of an extending portion of the channel forming region of the first transistor, the other end of the MIS type diode is formed of an electrode composed of a conductive material, and the electrode is connected to a line having a predetermined potential.

In the semiconductor memory cell according to the seventh aspect of the present invention, there may be employed a constitution in which the gate of the first transistor, the gate of the second transistor and the gate of the third transistor are connected to a first line for memory cell selection (for example, word line), the other source/drain region of the first transistor is connected to a second line through the junction-field-effect transistor, the other end of the MIS type diode is connected to a third line corresponding to the above line having a predetermined potential through a high-resistance element, one source/drain region of the first transistor is connected to a fourth line, and the other source/ drain region of the second transistor is connected to a write-in information setting line. It is preferred to employ a constitution in which the second line is used as a bit line and a second predetermined potential is applied to the fourth line, or a constitution in which the fourth line is used as a bit line and a second predetermined potential is applied to the second line.

In the above case, there may be employed a constitution in which one source/drain region of the first transistor is connected to the write-in information setting line through a diode in place of being connected to the fourth line.

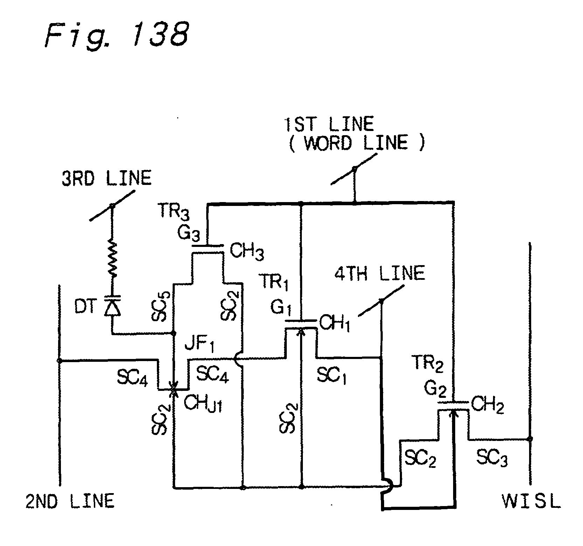

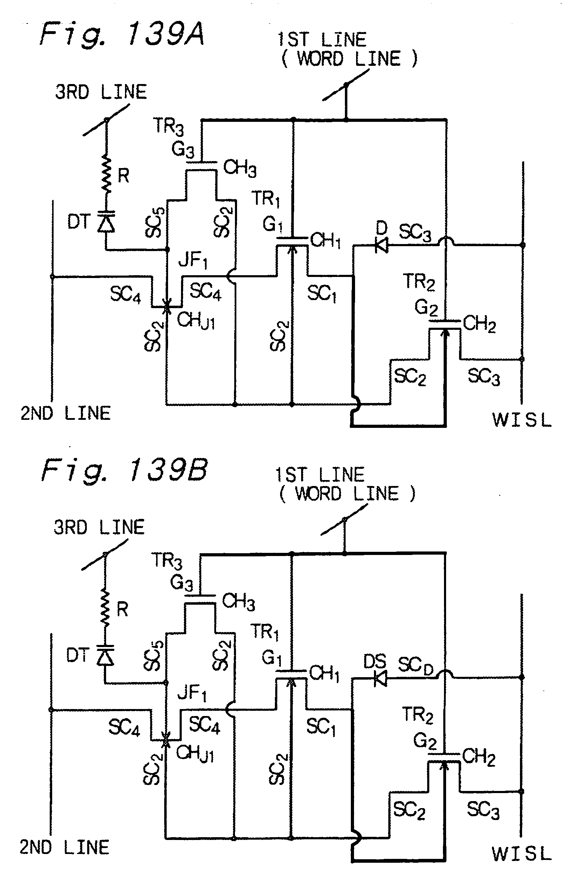

According to an eighth aspect which is not part of the present invention for achieving the above object, there is provided a semiconductor memory cell comprising, as a drawing of its principle is shown in Fig. 138, 139A or 139B,

(1) a first transistor for readout, having a first conductivity type, and having source/drain regions, a semi-conductive channel forming region which is in contact with the source/drain regions and spaces out the source/drain regions, and a gate capacitively coupled with the channel forming region,

(2) a second transistor for switching, having a second conductivity type, and having source/drain regions, a semi-conductive channel forming region which is in contact with the source/drain regions and spaces out the source/drain regions, and a gate capacitively coupled with the channel forming region,

(3) a third transistor for current control, having the second conductivity type, and having source/drain regions, a semi-conductive channel forming region which is in contact with the source/drain regions and spaces out the source/drain regions, and a gate capacitively coupled with the channel forming region,

(4) a junction-field-effect transistor for current control, having source/drain regions, a channel region and gate regions, and

(5) an MIS type diode for retaining information,

wherein:

one source/drain region of the first transistor corresponds to the channel forming region of the second transistor,

the other source/drain region of the first transistor corresponds to one source/drain region of the junction-field-effect transistor,

one source/drain region of the second transistor corresponds to the channel forming region of the first transistor, corresponds to one gate region of the junction-field-effect transistor and corresponds to one source/drain region of the third transistor,

the other source/drain region of the third transistor corresponds to the other gate region of the junction-field-effect transistor, and

one end of the MIS type diode corresponds to the other source/drain region of the third transistor, the other end of the MIS type diode is formed of an electrode composed of a conductive material, and the electrode is connected to a line having a predetermined potential.

In the semiconductor memory cell according to the eighth aspect, there may be employed a constitution in which the gate of the first transistor, the gate of the second transistor and the gate of the third transistor are connected to a first line for memory cell selection (for example, word line), the other source/drain region of the first transistor is connected to a second line through the junction-field-effect transistor, the other end of the MIS type diode is connected to a third line corresponding to the above line having a predetermined potential through a high-resistance element, one source/drain region of the first transistor is connected to a fourth line, and the other source/drain region of the second transistor is connected to a write-in information setting line. It is preferred to employ a constitution in which the second line is used as a bit line and a second predetermined potential is applied to the fourth line or a constitution in which the fourth line is used as a bit line and a second predetermined potential is applied to the second line.

In the above case, there may be employed a constitution in which one source/drain region of the first transistor is connected to the write-in information setting line through a diode in place of being connected to the fourth line.

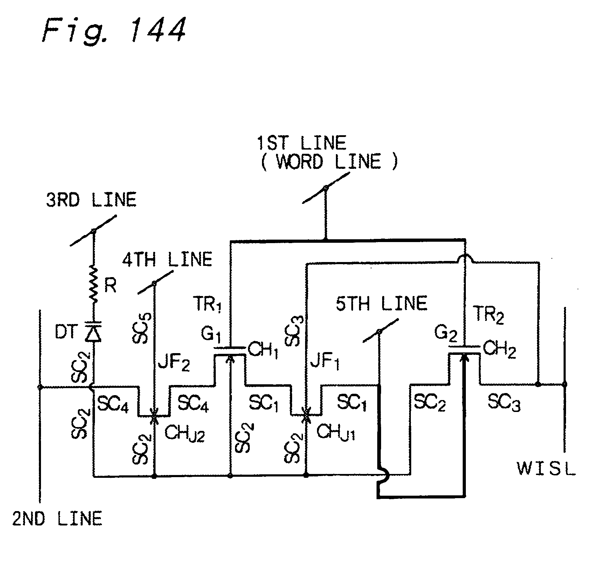

According to a ninth aspect of the present invention for achieving the above object, there is provided a semi-conductor memory cell comprising, as a drawing of its principle is shown in Fig. 144, 145A, 145B, 146, 147A, 147B, 156, 157A or 157B,

(1) a first transistor for readout, having a first conductivity type, and having source/drain regions, a semi-conductive channel forming region which is in contact with the source/drain regions and spaces out the source/drain regions, and a gate capacitively coupled with the channel forming region,

(2) a second transistor for switching, having a second conductivity type, and having source/drain regions, a semi-conductive channel forming region which is in contact with the source/drain regions and spaces out the source/drain regions, and a gate capacitively coupled with the channel forming region,

(3) a first junction-field-effect transistor for current control, having source/drain regions, a channel region and gate regions,

(4) a second junction-field-effect transistor for current control, having source/drain regions, a channel region and gate regions, and

(5) an MIS type diode for retaining information,

wherein:

one source/drain region of the first transistor corresponds to the channel forming region of the second transistor and corresponds to one source/drain region of the first junction-field-effect transistor,

the other source/drain region of the first transistor corresponds to one source/drain region of the second junction-field-effect transistor,

one source/drain region of the second transistor corresponds to the channel forming region of the first transistor, corresponds to one gate region of the first junction-field-effect transistor and corresponds to one gate region of the second junction-field-effect transistor, and

one end of the MIS type diode is formed of an extending portion of the channel forming region of the first transistor, the other end of the MIS type diode is formed of an electrode composed of a conductive material, and the electrode is connected to a line having a predetermined potential.

In the semiconductor memory cell according to the ninth aspect of the present invention, there may be employed a constitution in which the gate of the first transistor and the gate of the second transistor are connected to a first line for memory cell selection (for example, word line), the other source/drain region of the first transistor is connected to a second line through the second junction-field-effect transistor, the other end of the MIS type diode is connected to a third line corresponding to the above line having a predetermined potential through a high-resistance element, the other gate region of the second junction-field-effect transistor is connected to a fourth line, one source/drain region of the first transistor is connected to a fifth line through the first junction-field-effect transistor, the other gate region of the first junction-field-effect transistor is connected to a write-in information setting line, and the other source/drain region of the second transistor is connected to the write-in information setting line. There may be employed another constitution in which the other gate region of the second junction-field-effect transistor is connected to one gate region of the second junction-field-effect transistor in place of being connected to the fourth line. In this case, one end of the MIS type diode and the other gate region of the second junction-field-effect transistor can be formed as a common region. In these cases, it is preferred to employ a constitution in which the second line is used as a bit line and a second predetermined potential is applied to the fifth line or a constitution in which the fifth line is used as a bit line and a second predetermined potential is applied to the second line. In these cases, further, there may be employed a constitution in which one source/drain region of the first transistor is connected to the write-in information setting line through the first junction-field-effect transistor and a diode in place of being connected to the fifth line through the first junction-field-effect transistor.

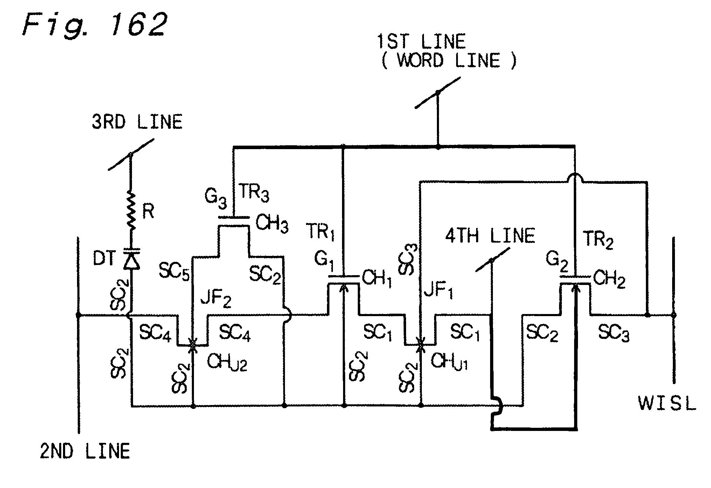

According to a tenth aspect of the present invention for achieving the above object, there is provided a semiconductor memory cell comprising, as a drawing of its principle is shown in Figs. 162 to 164,

(1) a first transistor for readout, having a first conductivity type, and having source/drain regions, a semi-conductive channel forming region which is in contact with the source/drain regions and spaces out the source/drain regions, and a gate capacitively coupled with the channel forming region,

(2) a second transistor for switching, having a second conductivity type, and having source/drain regions, a semi-conductive channel forming region which is in contact with the source/drain regions and spaces out the source/drain regions, and a gate capacitively coupled with the channel forming region,

(3) a third transistor for current control, having the second conductivity type, and having source/drain regions, a semi-conductive channel forming region which is in contact with the source/drain regions and spaces out the source/drain regions, and a gate capacitively coupled with the channel forming region,

(4) a first junction-field-effect transistor for current control, having source/drain regions, a channel region and gate regions,

(5) a second junction-field-effect transistor for current control, having source/drain regions, a channel region and gate regions, and

(6) an MIS type diode for retaining information,

wherein:

one source/drain region of the first transistor corresponds to the channel forming region of the second transistor and corresponds to one source/drain region of the first junction-field-effect transistor,

the other source/drain region of the first transistor corresponds to one source/drain region of the second junction-field-effect transistor,

one source/drain region of the second transistor corresponds to the channel forming region of the first transistor, corresponds to one gate region of the first junction-field-effect transistor, corresponds to one gate region of the second junction-field-effect transistor and corresponds to one source/drain region of the third transistor,

the other source/drain region of the third transistor corresponds to the other gate region of the second junction-field-effect transistor, and

one end of the MIS type diode is formed of an extending portion of the channel forming region of the first transistor, the other end of the MIS type diode is formed of an electrode composed of a conductive material, and the electrode is connected to a line having a predetermined potential.

In the semiconductor memory cell according to the tenth aspect of the present invention, there may be employed a constitution in which the gate of the first transistor, the gate of the second transistor and the gate of the third transistor are connected to a first line for memory cell selection (for example, word line), the other source/drain region of the first transistor is connected to a second line through the second junction-field-effect transistor, the other end of the MIS type diode is connected to a third line corresponding to the above line having a predetermined potential through a high-resistance element, one source/drain region of the first transistor is connected to a fourth line through the first junction-field-effect transistor, the other source/drain region of the second transistor is connected to a write-in information setting line, and the other gate region of the first junction-field-effect transistor is connected to the write-in information setting line. It is preferred to employ a constitution in which the second line is used as a bit line and a second predetermined potential is applied to the fourth line or a constitution in which the fourth line is used as a bit line and a second predetermined potential is applied to the second line.

In the above case, there may be also employed a constitution in which one source/drain region of the first transistor is connected to the write-in information setting line through the first junction-field-effect transistor and a diode in place of being connected to the fourth line through the first junction-field-effect transistor.

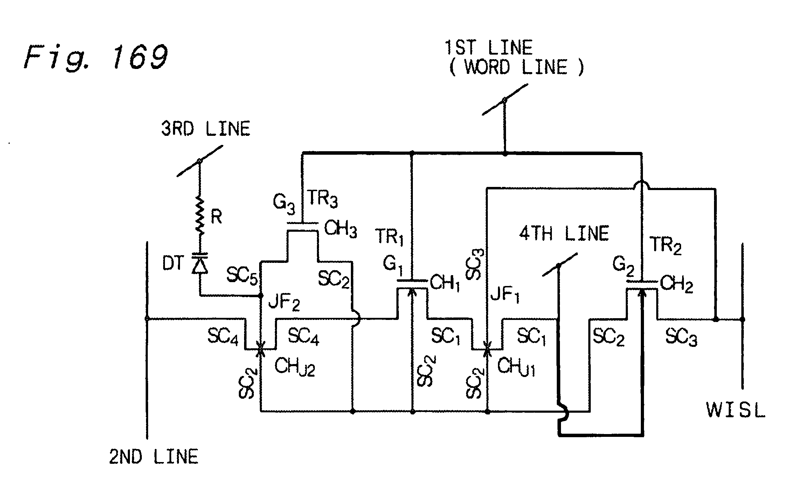

According to an eleventh aspect which is not part of the present invention for achieving the above object, there is provided a semiconductor memory cell comprising, as a drawing of its principle is shown in Figs. 169 to 171,

(1) a first transistor for readout, having a first conductivity type, and having source/drain regions, a semi-conductive channel forming region which is in contact with the source/drain regions and spaces out the source/drain regions, and a gate capacitively coupled with the channel forming region,

(2) a second transistor for switching, having a second conductivity type, and having source/drain regions, a semi-conductive channel forming region which is in contact with the source/drain regions and spaces out the source/drain regions, and a gate capacitively coupled with the channel forming region,

(3) a third transistor for current control, having the second conductivity type, and having source/drain regions, a semi-conductive channel forming region which is in contact with the source/drain regions and spaces out the source/drain regions, and a gate capacitively coupled with the channel forming region,

(4) a first junction-field-effect transistor for current control, having source/drain regions, a channel region and gate regions,

(5) a second junction-field-effect transistor for current control, having source/drain regions, a channel region and gate regions, and

(6) an MIS type diode for retaining information,

wherein:

one source/drain region of the first transistor corresponds to the channel forming region of the second transistor and corresponds to one source/drain region of the first junction-field-effect transistor,

the other source/drain region of the first transistor corresponds to one source/drain region of the second junction-field-effect transistor,

one source/drain region of the second transistor corresponds to channel forming region of the first transistor, corresponds to one gate region of the first junction-field-effect transistor, corresponds to one gate region of the second junction-field-effect transistor and corresponds to one source/drain region of the third transistor,

the other source/drain region of the third transistor corresponds to the other gate region of the second junction-field-effect transistor, and

one end of the MIS type diode corresponds to the other source/drain region of the third transistor, the other end of the MIS type diode is formed of an electrode composed of a conductive material, and the electrode is connected to a line having a predetermined potential.

In the semiconductor memory cell according to the eleventh aspect, there may be employed a constitution in which the gate of the first transistor, the gate of the second transistor and the gate of third transistor are connected to a first line for memory cell selection (for example, word line), the other source/drain region of the first transistor is connected to a second line through the second junction-field-effect transistor, the other end of the MIS type diode is connected to a third line corresponding to the above line having a predetermined potential through a high-resistance element, one source/drain region of the first transistor is connected to a fourth line through the first junction-field-effect transistor, the other source/drain region of the second transistor is connected to a write-in information setting line, and the other gate region of the first junction-field-effect transistor is connected to the write-in information setting line. It is preferred to employ a constitution in which the second line is used as a bit line and a second predetermined potential is applied to the fourth line or a constitution in which the fourth line is used as a bit line and a second predetermined potential is applied to the second line.

In the above case, there may be also employed a constitution in which one source/drain region of the first transistor is connected to the write-in information setting line through the first junction-field-effect transistor and a diode in place of being connected to the fourth line through the first junction-field-effect transistor.

In the semiconductor memory cell according to any one of the fifth to seventh aspects and ninth and tenth aspects of the present invention, there is a material interposed between one end and the other end of the MIS type diode, in which material the tunnel transition of carriers is caused depending upon a potential difference between the potential in the channel forming region of the first transistor and the potential in the other end of the MIS type diode. That is, the MIS type diode comprises the above material, the extending portion of the channel forming region of the first transistor and the electrode. And, it is preferred to employ the following constitution. Binary information of first information or second information is stored in the semiconductor memory cell, the first information to be stored in the semiconductor memory cell corresponds to a first potential in the channel forming region of the first transistor, and the second information to be stored in the semiconductor memory cell corresponds to a second potential in the channel forming region of the first transistor. (i) When the potential in the channel forming region of the first transistor is the first potential, the tunnel transition of carriers is caused from the other end to one end of the MIS type diode. As a result, carrier multiplication takes place, holes or electrons are stored in the above extending portion of the channel forming region of the first transistor depending upon the conductivity type of one end of the MIS type diode, and the potential in the channel forming region of the first transistor is held nearly at the first potential. (ii) When the potential in the channel forming region of the first transistor is the second potential, carriers having the polarity opposite to that of the above carriers transit from one end to the other end of the MIS type diode. As a result, the potential in the channel forming region of the first transistor is held at the second potential.

In the semiconductor memory cell according to any one of the eighth aspect and eleventh aspects which are not part of the present invention, there is a material interposed between one end and the other end of the MIS type diode, in which material the tunnel transition of carriers is caused depending upon a potential difference between the potential in the other source/drain region of the third transistor and the potential in the other end of the MIS type diode. That is, the MIS type diode comprises the above material, the other source/drain region of the third transistor and the electrode. And, it is preferred to employ the following constitution. Binary information of first information or second information is stored in the semiconductor memory cell, the first information to be stored in the semiconductor memory cell corresponds to a first potential in the channel forming region of the first transistor, and the second information to be stored in the semiconductor memory cell corresponds to a second potential in the channel forming region of the first transistor. (i) When the potential in the channel forming region of the first transistor is the first potential, the tunnel transition of carriers is caused from the other end to one end of the MIS type diode. As a result, carrier multiplication takes place, holes or electrons are stored in the other source/drain region of the third transistor depending upon the conductivity type of one end of the MIS type diode, and the potential in the channel forming region of the first transistor is held nearly at the first potential. (ii) When the potential in the channel forming region of the first transistor is the second potential, carriers having the polarity opposite to that of the above carriers transit from one end to the other end of the MIS type diode. As a result, the potential in the channel forming region of the first transistor is held at the second potential.

In the semiconductor memory cell according to any one of the fifth to eleventh aspects, preferably, a wide gap thin film is formed between the extending portion of the channel forming region of the first transistor or the other source/drain region of the third transistor constituting the MIS type diode and the electrode. That is, preferably, the wide gap thin film is composed of a material in which the tunnel transition of carriers is caused depending upon a potential difference between the potential in the channel forming region of the first transistor or the other source/drain region of the third transistor and the potential in the other end of the MIS type diode.

In the semiconductor memory cell according to the fifth aspect, sixth aspect or ninth aspect of the present invention, the gate of the first transistor and the gate of the second transistor may be formed separately from each other. For decreasing the size of the semiconductor memory cell, however, it is preferred to employ a constitution in which the first transistor and the second transistor have a common gate. In the semiconductor memory cell according to the seventh, or tenth aspect of the present invention, the gate of the first transistor, the gate of the second transistor and the gate of the third transistor may be formed separately from each other. For decreasing the size of the semiconductor memory cell, however, it is preferred to employ a constitution in which the first transistor, the second transistor and the third transistor have a common gate.

In the semiconductor memory cell of the present invention, that the potential in the channel forming region of the first transistor is held "nearly" at the first potential means that there is a case when the potential in the channel forming region of the first transistor is not held at a potential equal to the first potential in the strict sense. That is, in some case, holes or electrons are stored in the channel forming region of the first transistor or the other source/drain region of the third transistor so that the absolute value of the potential held in the channel forming region of the first transistor is higher than the absolute value of the first potential by 0.1 to 0.2 volt. The absolute value of the second potential is smaller than the absolute value of the above predetermined potential by a potential drop in the MIS type diode (including a potential drop in the high-resistance element when the high-resistance element is connected).

The wide gap thin film is composed of a material having energy barrier against the valence band upper end and conduction band lower end of the semi-conductive region constituting the extending portion of the first transistor or the other source/drain region of the third transistor which constitutes the MIS type diode. That is, the wide gap thin film is composed of a material having a wide gap as compared with the energy gap of the above semi-conductive region. The wide gap thin film is not necessarily required to be an insulating thin film so long as the above requirement is satisfied. When the above semi-conductive region is formed of silicon (Si), the wide gap thin film can be composed of a semi-conductive material having an energy gap of at least 2.2 eV. That is, the material constituting the wide gap thin film may be a material having an energy gap approximately twice or more the energy gap of the semi-conductive region (Si in the above case) constituting the extending portion of the channel forming region of the first transistor or the other source/drain region of the third transistor. The wide gap thin film may have a multi-layered structure or may have a composition which varies in the thickness direction. The wide gap thin film includes an $SiO_2$ or SiON film having a thickness of 5 nm or less and an SiN film having a thickness of 9 nm or less.

The junction-field-effect transistor (JFET), the first junction-field-effect transistor or the second junction-field-effect transistor in the semiconductor memory cell of the present invention can be formed by

(X) optimizing the distance between the facing gate regions of the junction-field-effect transistor, that is, the thickness of the channel region, and
(Y) optimizing impurity concentrations of the facing gate regions and the channel region of the junction-field-effect transistor.

It should be noted that if neither the distance between the gate regions (the thickness of the channel region), nor the impurity concentrations of the gate regions and the channel region are optimized, the depletion layer will not be widened, making it impossible to bring the junction-field-effect transistor into an on-state or an off-state. These optimizations need to be carried out by computer simulation or experiments.

The semiconductor memory cell according to any one of the aspects can be formed in a surface region of a semiconductor substrate, formed on an insulating interlayer on a semiconductor substrate, formed in a well formed in a semiconductor substrate, or formed on an electric insulator or an insulating interlayer, and is preferably formed in a well, or formed on an insulator or an insulating interlayer, or has an SOI structure or a TFT structure, for preventing alpha-particle or neutron induced soft error. The insulator or insulating interlayer is formed not only on a semiconductor substrate but also on a glass or quartz substrate.

The channel forming region or the channel region can be formed from a material such as silicon, silicon-germanium (Si-Ge) or GaAs by using a known process. Each gate of the first transistor, the second transistor and the third transistor can be formed of a material such as a metal; GaAs doped with an impurity at a high concentration; silicon, amorphous silicon, polysilicon doped with an impurity; a silicide; or a polyside, by using a known process. An insulating interlayer to cover the first transistor, the second transistor and the third transistor can be formed of a material such as SiO2, Si3N4, A12O3 or GaAlAs by using a known process. Each region can be formed of silicon, amorphous silicon or polysilicon doped with an impurity, a silicide, a two-layer structure having a silicide layer and a semi-conductive layer, silicon-germanium (Si-Ge) or GaAs doped with an impurity at a high concentration by using a known process, depending upon characteristics required. The semi-conductive layer can be formed of a material such as silicon, silicon-germanium or GaAs.

In the semiconductor memory cell of the present invention, each gate of the first transistor and the second transistor is connected to the first line for memory cell selection (for example, word line). It is therefore sufficient to provide one first line for memory cell selection, so that the chip area can be decreased. When the first transistor for readout and the second transistor for switching are merged into one unit, the semiconductor memory cell of the present invention is also beneficial in terms of reduction in the cell area and leakage current.

In the semiconductor memory cell of the present invention, one source/drain region of the second transistor (the first or second region) corresponds to the channel forming region of the first transistor. Further, the other source/drain region of the second transistor (the third region) is connected to the write-in information setting line. And, when the on- and off-states of the first transistor and the second transistor can be controlled by properly selecting a potential in the first line for memory cell selection (for example, word line). That is, when the potential in the first line for memory cell selection is set at a potential as high enough to bring the second transistor into an on-state at a write-in time, the second transistor is brought into an on-state, and whereby an electric charge is charged or accumulated in a capacitor formed between the first region and the second region in the second transistor depending upon the potential in the write-in information setting line. As a result, the information is stored in the channel forming region (the first or second region) of the first transistor as a potential difference between the first region and the second region or as an electric charge. When the information is read out, the potential or the electric charge (the information) stored or accumulated in the channel forming region of the first transistor is converted to a potential difference between the channel forming region (the first or second region) and the other source/drain region (the fourth region) in the first transistor, or is converted to an electric charge, and, the threshold voltage of the first transistor seen from the gate of the first transistor varies depending upon the electric charge (information). When the information is read out, therefore, the on/off operation of the first transistor can be controlled by applying a properly selected potential to the gate of the first transistor. That is, the information can be read out by detecting the operation state of the first transistor.

Further, the semiconductor memory cell of the present invention has the MIS type diode. The MIS type diode will be explained with reference to a case where one end of the MIS type diode is formed of an extending portion of the channel forming region of the first transistor. When a proper bias is applied between two ends of the MIS type diode, which proper bias is to cause a potential difference between the potential in the electrode constituting the other end of the MIS type diode and the potential of the band end in the surface of the extending portion (semi-conductive region) of the channel forming region of the first transistor constituting one end of the MIS type diode to be equal to, or higher than, the band gap of a material forming the above semi-conductive region, carrier multiplication takes place due to carriers which are tunnel-transited from the electrode and implanted in the surface of the extending portion of the channel forming region of the first transistor, thereby to cause a high-current state. For details, see, for example, Y. Hayashi, "Switching phenomena in thin-insulator metal-insulator-semiconductor diodes", Appl. Phys. Lett. 37(4), 15 August 1980. In other words, high-energy carriers are implanted from the other end to one end of the MIS type diode depending upon the potential or charge (information) of the channel forming region (first region or second region) of the first transistor, and carrier multiplication takes place. And, the channel forming region is supplied with carriers having the same conductivity type (polarity) as that of the channel forming region on the basis of the above carrier multiplication, and as a result, the first potential which is an information potential stored in the channel forming region (first region or second region) of the first transistor remains as a potential close to the first potential which is the original information potential in the channel forming region (first region or second region) of the first transistor, without approaching to the predetermined potential. When the information potential (second potential) in the extending portion of the channel forming region of the first transistor has a level close to the level of the potential in the electrode of the MIS type diode, majority carriers in the extending portion of the channel forming region of the first transistor are transited to the electrode on the basis of the tunnel transition, the potential in the extending portion of the channel forming region of the first transistor approaches to the potential in the electrode and is held at the second potential. Therefore, the semiconductor memory cell of the present invention does not require so-called refreshing operation unlike the case of a DRAM.

Moreover, the memory cell according to any one of the aspects of the present invention is provided with the junction-field-effect transistor in addition to the first transistor having the first conductivity type and the second transistor having the second conductivity type. Since the on/off operation of the junction-field-effect transistor is controlled when the information is read out, a large margin can be assured for the current which flows in the source/drain regions of the first transistor. As a result, the number of semiconductor memory cells that can be connected to, for example, the second line is hardly limited. Further, when the third transistor for current control is provided, the on/off operations of the third transistor is controlled when the information is read out. As a result, a remarkably large margin can be consistently assured for the current which flows in the source/drain regions of the first transistor. Therefore, the number of semiconductor memory cells connectable to, for example, the second line becomes further less liable to be limited.

BRIEF DESCRIPTION OF THE DRAWINGS

Figures 1-43 are deleted.

Fig. 44 shows the principle of a semiconductor memory cell according to the fifth aspect of the present invention.

Figs. 45A and 45B show the principles of variants of the semiconductor memory cell according to the fifth aspect of the present invention.

Fig. 46 shows the principle of a variant of the semiconductor memory cell according to the fifth aspect of the present invention.

Figs. 47A and 47B show the principles of variants of the semiconductor memory cell according to the fifth aspect of the present invention.

Fig. 48 shows the principle of a variant of the semiconductor memory cell according to the fifth aspect of the present invention.

Fig. 49 shows the principle of a variant of the semiconductor memory cell according to the fifth aspect of the present invention.

Figs. 50A and 50B show the principles of variants of the semiconductor memory cell according to the fifth aspect of the present invention.

Fig. 51 shows a schematic partial cross-sectional view of the semiconductor memory cell of Example 5.

Fig. 52 shows a schematic partial cross-sectional view of a variant of the semiconductor memory cell of Example 5.

Fig. 53 shows a schematic partial cross-sectional view of a variant of the semiconductor memory cell of Example 5.

Fig. 54 shows a schematic partial cross-sectional view of a variant of the semiconductor memory cell of Example 5.

Fig. 55 shows a schematic partial cross-sectional view of a variant of the semiconductor memory cell of Example 5.

Fig. 56 shows a schematic partial cross-sectional view of a variant of the semiconductor memory cell of Example 5.

Fig. 57 shows a schematic partial cross-sectional view of a variant of the semiconductor memory cell of Example 5.

Fig. 58 shows a schematic partial cross-sectional view of a variant of the semiconductor memory cell of Example 5.

Fig. 59 shows another schematic partial cross-sectional view of the variant shown in Fig. 58, prepared by cutting the variant with a different plane.

Fig. 60 shows a schematic partial cross-sectional view of a variant of the semiconductor memory cell of Example 5.

Fig. 61 shows the principle of a variant of the semiconductor memory cell according to the fifth aspect of the present invention.

Figs. 62A and 52B show the principles of variants of the semiconductor memory cell according to the fifth aspect of the present invention.

Fig. 63 shows a schematic partial cross-sectional view of a semiconductor memory cell of Example 6.

Fig. 64 shows a schematic partial cross-sectional view of a variant of the semiconductor memory cell of Example 6.

Fig. 65 shows the principle of a variant of the semiconductor memory cell according to the fifth aspect of the present invention.

Figs. 66A and 66B show the principle of variants of the semiconductor memory cell according to the fifth aspect of the present invention.

Fig. 67 shows the principle of a variant of the semiconductor memory cell according to the fifth aspect of the present invention.

Figs. 68A and 68B show the principle of variants of the semiconductor memory cell according to the fifth aspect of the present invention.

Fig. 69A shows a schematic partial cross-sectional view of a semiconductor memory cell of Example 7, and Fig. 69B shows a schematic plan view of layout of regions thereof.

Fig. 70 shows a schematic partial cross-sectional view of a variant of the semiconductor memory cell of Example 7.

Fig. 71 shows a schematic partial cross-sectional view of a variant of the semiconductor memory cell of Example 7.

Fig. 72A shows a schematic partial cross-sectional view of a variant of the semiconductor memory cell of Example 7, and Fig. 72B shows a schematic plan view of layout of regions thereof.

Figs. 73A and 73B show schematic partial cross-sectional views of variants of the semiconductor memory cell of Example 7.

Fig. 74 shows a schematic partial cross-sectional view of a variant of the semiconductor memory cell of Example 7.

Fig. 75A shows a schematic partial cross-sectional view of a variant of the semiconductor memory cell of Example 7, and Fig. 75B shows a schematic plan view of layout of regions thereof.

Fig. 76 shows another schematic partial cross-sectional view of the variant shown in Figs. 75A and 75B, prepared by cutting the variant with a different plane.

Fig. 77A shows a schematic partial cross-sectional view of a variant of the semiconductor memory cell of Example 7, Fig. 77B shows a schematic plan view of layout of regions thereof, and Fig.77C shows another schematic partial cross-sectional view of the regions thereof taken along some plane perpendicular to the cross section shown in Fig. 77A.

Fig. 78 shows a schematic partial cross-sectional view of a variant of the semiconductor memory cell of Example 7.

Fig. 79 shows a schematic partial cross-sectional view of a variant of the semiconductor memory cell of Example 7.

Fig. 80 shows a schematic partial cross-sectional view of a variant of the semiconductor memory cell of Example 7.

Fig. 81 shows a schematic partial cross-sectional view of a variant of the semiconductor memory cell of Example 7.

Fig. 82 shows a schematic partial cross-sectional view of a variant of the semiconductor memory cell of Example 7.

Figs. 83A and 83B show schematic partial cross-sectional views of variants of the semiconductor memory cell of Example 7.

Figs. 84A and 84B show schematic partial cross-sectional views of variants of the semiconductor memory cell of Example 7.

Figs. 85A and 85B show schematic partial cross-sectional views of variants of the semiconductor memory cell of Example 7.

Fig. 86 shows a schematic partial cross-sectional view of a variant of the semiconductor memory cell of Example 7.

Fig. 87 shows a schematic partial cross-sectional view of a variant of the semiconductor memory cell of Example 7.

Fig. 88 shows a schematic partial cross-sectional view of a variant of the semiconductor memory cell of Example 7.

Fig. 89 shows a schematic partial cross-sectional view of a variant of the semiconductor memory cell of Example 7.

Fig. 90 shows a schematic partial cross-sectional view of a variant of the semiconductor memory cell of Example 7.

Fig. 91 shows a schematic partial cross-sectional view of a variant of the semiconductor memory cell of Example 7.

Fig. 92 shows the principle of the semiconductor memory cell according to the sixth aspect of the present invention.

Figs. 93A and 93B show the principles of variants of the semiconductor memory cell according to the sixth aspect of the present invention.

Fig. 94 shows the principle of a variant of the semiconductor memory cell according to the sixth aspect of the present invention.

Figs. 95A and 95B show the principles of variants of the semiconductor memory cell according to the sixth aspect of the present invention.

Fig. 96 shows the principle of a variant of the semiconductor memory cell according to the sixth aspect of the present invention.

Figs. 97A and 97B show the principles of variants of the semiconductor memory cell according to the sixth aspect of the present invention.

Fig. 98 shows a schematic partial cross-sectional view of a semiconductor memory cell of Example 8.

Fig. 99 shows a schematic partial cross-sectional view of a variant of the semiconductor memory cell of Example 8.

Fig. 100 shows a schematic partial cross-sectional view of a variant of the semiconductor memory cell of Example 8.

Fig. 101 shows a schematic partial cross-sectional view of a variant of the semiconductor memory cell of Example 8.

Fig. 102 shows a schematic partial cross-sectional view of a variant of the semiconductor memory cell of Example 8.

Fig. 103 shows a schematic partial cross-sectional view of a variant of the semiconductor memory cell of Example 8.

Fig. 104 shows the principle of a variant of the semiconductor memory cell according to the sixth aspect of the present invention.

Figs. 105A and 105B show the principles of variants of the semiconductor memory cell according to the sixth aspect of the present invention.

Fig. 106 shows a schematic partial cross-sectional view of a semiconductor memory cell of Example 9.

Fig. 107 shows a schematic partial cross-sectional view of a variant of the semiconductor memory cell of Example 9.

Fig. 108 shows the principle of a variant of the semiconductor memory cell according to the sixth aspect of the present invention.

Figs. 109A and 109B show the principles of variants of the semiconductor memory cell according to the sixth aspect of the present invention.

Fig. 110 shows the principle of a variant of the semiconductor memory cell according to the sixth aspect of the present invention.

Figs. 111A and 111B show the principles of variants of the semiconductor memory cell according to the sixth aspect of the present invention.

Fig. 112 shows the principle of a variant of the semiconductor memory cell according to the sixth aspect of the present-invention.

Figs. 113A and 113B show the principles of variants of the semiconductor memory cell according to the sixth aspect of the present invention.

Fig. 114 shows a schematic partial cross-sectional view of a semiconductor memory cell of Example 10.

Fig. 115 shows a schematic partial cross-sectional view of a variant of the semiconductor memory cell of Example 10.

Fig. 116 shows a schematic partial cross-sectional view of a variant of the semiconductor memory cell of Example 10.

Fig. 117 shows a schematic partial cross-sectional view of a variant of the semiconductor memory cell of Example 10.

Fig. 118 shows a schematic partial cross-sectional view of a variant of the semiconductor memory cell of Example 10.

Fig. 119 shows a schematic partial cross-sectional view of a variant of the semiconductor memory cell of Example 10.

Fig. 120 shows a schematic partial cross-sectional view of a variant of the semiconductor memory cell of Example 10.

Fig. 121 shows a schematic partial cross-sectional view of a variant of the semiconductor memory cell of Example 10.

Fig. 122 shows a schematic partial cross-sectional view of a variant of the semiconductor memory cell of Example 10.

Fig. 123 shows a schematic partial cross-sectional view of a variant of the semiconductor memory cell of Example 10.

Fig. 124 shows a schematic partial cross-sectional view of a variant of the semiconductor memory cell of Example 10.

Fig. 125 shows a schematic partial cross-sectional view of a variant of the semiconductor memory cell of Example 10.

Fig. 126 shows the principle of a variant of the semiconductor memory cell according to the sixth aspect of the present invention.

Figs. 127A and 127B show the principles of variants of the semiconductor memory cell according to the sixth aspect of the present invention.

Fig. 128 shows a schematic partial cross-sectional view of a semiconductor memory cell of Example 11.

Fig. 129 shows a schematic partial cross-sectional view of a variant of the semiconductor memory cell of Example 11.

Fig. 130 shows a schematic partial cross-sectional view of a variant of the semiconductor memory cell of Example 11.

Fig. 131 shows a schematic partial cross-sectional view of a variant of the semiconductor memory cell of Example 11.

Fig. 132 shows the principle of the semiconductor memory cell according to the seventh aspect of the present invention.

Figs. 133A and 133B show the principles of variants of the semiconductor memory cell according to the seventh aspect of the present invention.

Fig. 134 shows a schematic partial cross-sectional view of a semiconductor memory cell of Example 12.

Fig. 135 shows a schematic partial cross-sectional view of a variant of the semiconductor memory cell of Example 12.

Fig. 136 shows a schematic partial cross-sectional view of a variant of the semiconductor memory cell of Example 12.

Fig. 137 shows a schematic partial cross-sectional view of a variant of the semiconductor memory cell of Example 12.

Fig. 138 shows the principle of the semiconductor memory cell according to the eighth aspect.

Figs. 139A and 139B show the principles of variants of the semiconductor memory cell according to the eighth aspect.

Fig. 140 shows a schematic partial cross-sectional view of a semiconductor memory cell of Example 13.

Fig. 141 shows a schematic partial cross-sectional view of a variant of the semiconductor memory cell of Example 13.

Fig. 142 shows a schematic partial cross-sectional view of a variant of the semiconductor memory cell of Example 13.

Fig. 143 shows a schematic partial cross-sectional view of a variant of the semiconductor memory cell of Example 13.

Fig. 144 shows the principle of the semiconductor memory cell according to the ninth aspect of the present invention.

Figs. 145A and 145B show the principles of variants of the semiconductor memory cell according to the ninth aspect of the present invention.

Fig. 146 shows the principle of a variant of the semiconductor memory cell according to the ninth aspect of the present invention.

Figs. 147A and 147B show the principles of variants of the semiconductor memory cell according to the ninth aspect of the present invention.

Fig. 148 shows a schematic partial cross-sectional view of a semiconductor memory cell of Example 14.

Fig. 149 shows a schematic partial cross-sectional view of a variant of the semiconductor memory cell of Example 14.

Fig. 150 shows a schematic partial cross-sectional view of a variant of the semiconductor memory cell of Example 14.

Fig. 151 shows a schematic partial cross-sectional view of a variant of-the semiconductor memory cell of Example 14.

Fig. 152 shows a schematic partial cross-sectional view of a variant of the semiconductor memory cell of Example 14.

Fig. 153 shows a schematic partial cross-sectional view of a variant of the semiconductor memory cell of Example 14.

Fig. 154 shows a schematic partial cross-sectional view of a variant of the semiconductor memory cell of Example 14.

Fig. 155 shows a schematic partial cross-sectional view of a variant of the semiconductor memory cell of Example 14.

Fig. 156 shows the principle of a variant of the semiconductor memory cell according to the ninth aspect of the present invention.

Figs. 157A and 157B show the principles of variants of the semiconductor memory cell according to the ninth aspect of the present invention.

Fig. 158 shows a schematic partial cross-sectional view of a semiconductor memory cell of Example 15.

Fig. 159 shows a schematic partial cross-sectional view of a variant of the semiconductor memory cell of Example 15.

Fig. 160 shows a schematic partial cross-sectional view of a variant of the semiconductor memory cell of Example 15.

Fig. 161 shows a schematic partial cross-sectional view of a variant of the semiconductor memory cell of Example 15.

Fig. 162 shows the principle of the semiconductor memory cell according to the tenth aspect of the present invention.

Fig. 163 shows the principle of a variant of the semiconductor memory cell according to the tenth aspect of the present invention.

Fig. 164 shows the principle of a variant of the semiconductor memory cell according to the tenth aspect of the present invention.

Fig. 165 shows a schematic partial cross-sectional view of a semiconductor memory cell of Example 16.

Fig. 166 shows a schematic partial cross-sectional view of a variant of the semiconductor memory cell of Example 16.

Fig. 167 shows a schematic partial cross-sectional view of a variant of the semiconductor memory cell of Example 16.

Fig. 168 shows a schematic partial cross-sectional view of a variant of the semiconductor memory cell of Example 16.

Fig. 169 shows the principle of the semiconductor memory cell according to the eleventh aspect.

Fig. 170 shows the principle of a variant of the semiconductor memory cell according to the eleventh aspect.

Fig. 171 shows the principle of a variant of the semiconductor memory cell according to the eleventh aspect.

Fig. 172 shows a schematic partial cross-sectional view of a semiconductor memory cell of Example 17.

Fig. 173 shows a schematic partial cross-sectional view of a variant of the semiconductor memory cell of Example 17.

Fig. 174 shows a schematic partial cross-sectional view of a variant of the semiconductor memory cell of Example 17.

Fig. 175 shows a schematic partial cross-sectional view of a variant of the semiconductor memory cell of Example 17.

Figs. 176A and 176B show schematic partial cross-sectional views of a semiconductor substrate, etc., for explaining the method of manufacturing the semiconductor memory cell of Example 7 shown in Fig. 69.

Figs. 177A and 177B, following Fig. 176B, show schematic partial cross-sectional views of a semiconductor substrate, etc., for explaining the method of manufacturing the semiconductor memory cell of Example 7 shown in Fig. 69.

Figs. 178A and 178B, following Fig. 177B, show schematic partial cross-sectional views of a semiconductor substrate, etc., for explaining the method of manufacturing the semiconductor memory cell of Example 7 shown in Fig. 69.

Figs. 179A and 179B show the principles of the semiconductor memory cells according to the twenty-fifth aspect.

Figs. 180A and 180B show schematic partial cross-sectional views of the semiconductor memory cells of Example 18.

Figs. 181A and 181B show schematic partial cross-sectional views of variants of the semiconductor memory cell of Example 18.

Figs. 182A and 182B show schematic partial cross-sectional views of variants of the semiconductor memory cell of Example 18.

Figs. 183A and 183B show schematic partial cross-sectional views of variants of the semiconductor memory cell of Example 18.

Figs. 184A and 184B show schematic partial cross-sectional views of variants of the semiconductor memory cell of Example 18.

Figs. 185A and 185B show schematic partial cross-sectional views of variants of the semiconductor memory cell of Example 18.

Figs. 186A and 186B show schematic partial cross-sectional views of the semiconductor memory cells of Example 19.

Figs. 187A and 187B show schematic partial cross-sectional views of variants of the semiconductor memory cell of Example 19.

Figs. 188A and 188B show schematic partial cross-sectional views of variants of the semiconductor memory cell of Example 19.

Fig. 189A shows a schematic layout of a gate and regions in the semiconductor memory cell of Example 19, and Fig. 189B shows a schematic layout of a gate and regions in a variant of the semiconductor memory cell of Example 19.

Figs. 190A and 190B show schematic partial cross-sectional views of variants of the semiconductor memory cell of Example 19.

Fig. 210A shows the concept of a conventional single-transistor memory cell, and Fig. 210B shows a cross-sectional view of a conventional memory cell having a trench capacitor cell structure.

## DESCRIPTION OF THE PREFERRED EMBODIMENTS

The present invention will be explained more specifically with reference to Examples 5 to 12, 14 to 16 18 and 19 hereinafter. Schematic partial cross-sectional views of semiconductor memory cells referred to in Examples are those which are prepared by cutting the semiconductor memory cells with a plane perpendicular to the extending direction of gates.

In the Figures, "SCS" shows a semiconductor substrate, "n-SCS" shows an n-type semiconductor substrate, "p-SCS" shows a p-type semiconductor substrate, "SPS" shows a supporting substrate, "IL", "IL1" and "IL2" show insulating interlayers, "IL0" shows an insulation material layer, and "IR2" shows a device separation region.

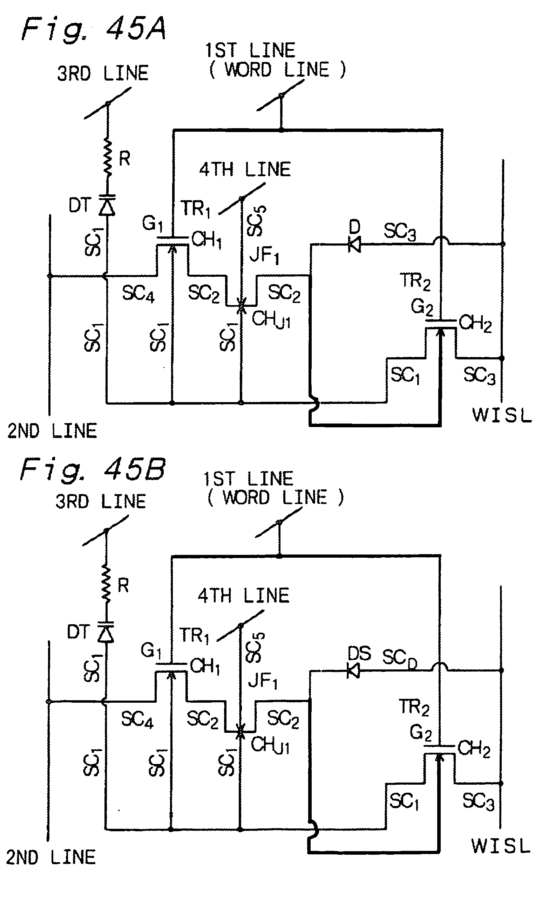

Example 5 is concerned with the semiconductor memory cell according to the fifth aspect of the present invention. As is shown in the principle drawing of Fig. 45A, the semiconductor memory cell of Example 5 comprises;

(1) a first transistor TR1 for readout, having a first conductivity type (for example, n-channel type) and having source/drain regions, a semi-conductive channel forming region CH1 which is in contact with the source/drain regions and spaces out the source/drain regions, and a gate G1 capacitively coupled with the channel forming region CH1,

(2) a second transistor TR2 for switching, having a second conductivity type (for example, p-channel type) and having source/drain regions a semi-conductive channel forming region CH2 which is in contact with the source/drain regions and spaces out the source/drain regions, and a gate G2 capacitively coupled with the channel forming region CH2,

(3) a junction-field-effect transistor JF1 for current control, having source/drain regions, a channel region CHJ1 and gate regions, and

(4) an MIS type diode DT for retaining information.

In the above semiconductor memory cell, one source/drain region of the first transistor $TR_1$ corresponds to the channel forming region $CH_2$ of the second transistor $TR_2$ and corresponds to one source/drain region of the junction-field-effect transistor $JF_1$,

one source/drain region of the second transistor $TR_2$ corresponds to the channel forming region $CH_1$ of the first transistor $TR_1$ and corresponds to one gate region of the junction-field-effect transistor $JF_1$, and

one end of the MIS type diode DT is formed of an extending portion of the channel forming region $CH_1$ of the first transistor $TR_1$, the other end of the MIS type diode DT is formed of an electrode composed of a conductive material, and the electrode is connected to the line (third line) having a predetermined potential. In Example 5, the first transistor $TR_1$ and the second transistor $TR_2$ are substantially separately formed transistors.

Further, the gate $G_1$ of the first transistor $TR_1$ and the gate $G_2$ of the second transistor $TR_2$ are connected to a first line (for example, word line) for memory cell selection, the other source/drain region of the first transistor $TR_1$ is connected to a second line, the other gate region of the junction-field-effect transistor $JF_1$ is connected to a fourth line, one source/drain region of the first transistor $TR_1$ is connected to a write-in information setting line WISL through the junction-field-effect transistor $JF_1$ and a diode D, the other source/drain region of the second transistor $TR_2$ is connected to the write-in information setting line WISL, and the other end of the MIS type diode DT is connected to a third line

(corresponding to the above line having a predetermined potential) through a high-resistance element R. It is preferred to employ a constitution in which the second line is used as a bit line, or a constitution in which the write-in information setting line WISL is used as a bit line as well and a second predetermined potential is applied to the second line.

A wide gap thin film WG is formed between the extending portion of the channel forming region $CH_1$ of the first transistor $TR_1$ which extending portion constitutes the MIS type diode DT and the electrode EL. This will also apply in the semiconductor memory cell to be explained below.

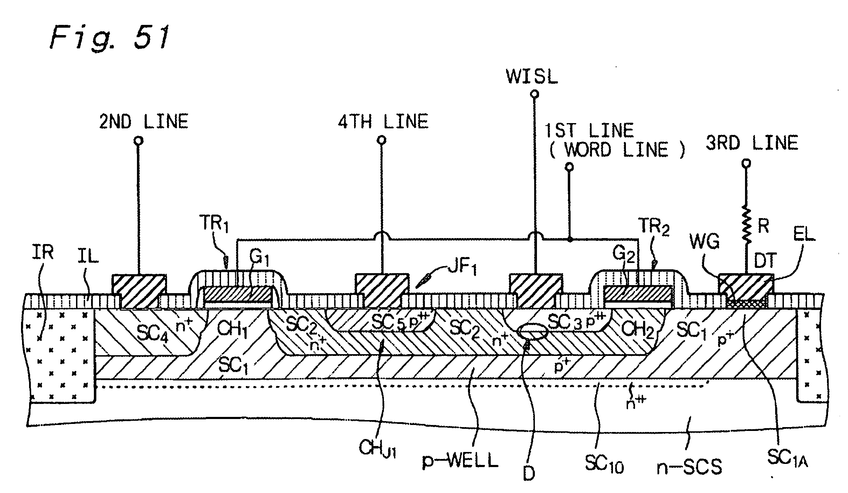

As is shown in the partial cross-sectional view of the Fig. 51, the semiconductor memory cell of Example 5 comprises;

(1) a first transistor $TR_1$ for readout, having a first conductivity type (for example, n-channel type) and having source/drain regions, a semi-conductive channel forming region $CH_1$ which is in contact with the source/drain regions and spaces out the source/drain regions, and a gate $G_1$ capacitively coupled with the channel forming region $CH_1$,

(2) a second transistor $TR_2$ for switching, having a second conductivity type (for example, p-channel type) and having source/drain regions, a semi-conductive channel forming region $CH_2$ which is in contact with the source/drain regions and spaces out the source/drain regions, and a gate $G_2$ capacitively coupled with the channel forming region $CH_2$,

(3) a junction-field-effect transistor $JF_1$ for current control, having source/drain regions, a channel region $CH_{J1}$ and gate regions, and

(4) an MIS type diode DT for retaining information, and the above semiconductor memory cell has;

(a) a semi-conductive first region $SC_1$ having a second conductivity type (for example, p*-type),

(b) a semi-conductive second region $SC_2$ which is formed in a surface region of the first region $SC_1$ and has a first conductivity type (for example, n*-type),

(c) a third region $SC_3$ which is formed in a surface region of the second region $SC_2$ and is in contact with the second region $SC_2$ so as to form a rectifier junction together with the second region $SC_2$, the third region $SC_3$ being a region which is semi-conductive and has the second conductivity type (for example, p$^{++}$-type) or which is formed of a silicide, a metal or a metal compound and is conductive,

(d) a fourth region $SC_4$ which is formed in a surface region of the first region $SC_1$ to be spaced from the second region $SC_2$ and is in contact with the first region $SC_1$ so as to form a rectifier junction together with the first region $SC_1$, the fourth region $SC_4$ being a region which is semi-conductive and has the first conductivity type (for example, n*-type) or which is formed of a silicide, a metal or a metal compound and is conductive, and

(e) a fifth region $SC_5$ which is formed in a surface region of the second region $SC_2$ to be spaced from the third region $SC_3$ and is in contact with the second region $SC_2$ so as to form a rectifier junction together with the second region $SC_2$, the fifth region $SC_5$ being a region which is semi-conductive and has the second conductivity type (for example, p$^{++}$-type) or which is formed of a silicide, a metal or a metal compound and is conductive.

Concerning the first transistor $TR_1$,

(A-1) one source/drain region is formed of a portion of a surface region of the second region $SC_2$,

(A-2) the other source/drain region is formed of the fourth region $SC_4$,

(A-3) the channel forming region $CH_1$ is formed of a portion of a surface region of the first region $SC_1$ which portion is interposed between said portion of the surface region of the second region $SC_2$ and the fourth region $SC_4$, and

(A-4) the gate $G_1$ is formed on the channel forming region $CH_1$ of the first transistor $TR_1$ through an insulation layer.

Concerning the second transistor $TR_2$,

(B-1) one source/drain region is formed of other portion of the surface region of the first region $SC_1$,

(B-2) the other source/drain region is formed of the third region $sC_3$,

(B-3) the channel forming region $CH_2$ is formed of other portion of the surface region of the second region $SC_2$ which other portion is interposed between said other portion of the surface region of the first region $SC_1$ and the third region $SC_3$, and

(B-4) the gate $G_2$ is formed on the channel forming region $CH_2$ of the second transistor $TR_2$ through an insulation layer.

Concerning the junction-field-effect transistor $JF_1$,

(C-1) the gate regions are formed of the fifth region $SC_5$ and a part of the first region $SC_1$ which part is opposed to the fifth region $SC_5$,

(C-2) the channel region $CH_{J1}$ is formed of part of the second region $SC_2$ which part is interposed between the fifth

region $SC_5$ and said part of the first region $SC_1$,

(C-3) one source/drain region is formed of said portion of the surface region of the second region $SC_2$ which portion extends from one end of the channel region $CH_{J1}$ of the junction-field-effect transistor $JF_1$ and constitutes one source/drain region of the first transistor $TR_1$, and

(C-4) the other source/drain region is formed of a portion of the second region $SC_2$ which portion extends from the other end of the channel region $CH_{J1}$ of the junction-field-effect transistor $JF_1$.

Concerning the MIS type diode DT,

(D-1) one end thereof is formed of part $SC_{1A}$ of the first region $SC_1$, and

(D-2) an electrode constituting the other end thereof is formed to be opposed to said part $SC_{1A}$ of the first region $SC_1$ constituting one end of the MIS type diode DT, through a wide gap thin film WG.

The wide gap thin film WG can be composed of a material in which the tunnel transition of carriers is caused depending upon a potential difference between the potential in the first region $SC_1$ (the channel forming region $CH_1$ of the first transistor $TR_1$) and the potential in the other end (electrode EL) of the MIS type diode DT. Specifically, it can be composed, for example, of an $SiO_2$ or SiON film having a thickness of 5 nm or smaller, or an SiN film having a thickness of 9 nm or smaller.

The electrode EL constituting the other end of the MIS type diode DT is connected to the line (third line) through the high-resistance element R having a resistance of approximately $10^9$ to $10^{12}$ $\Omega$. Specifically, the electrode EL constituting the other end of the MIS type diode DT and the high-resistance element R are integrally formed and are composed of a polysilicon thin layer containing an impurity having the first conductivity type.

In the above semiconductor memory cell, further,

(E) the gate $G_1$ of the first transistor $TR_1$ and the gate $G_2$ of the second transistor $TR_2$ are connected to the first line (for example, word line) for memory cell selection,

(F) the third region $SC_3$ is connected to the write-in information setting line WISL,

(G) the fourth region $SC_4$ is connected to the second line,

(H) the electrode EL constituting the other end of the MIS type diode DT is connected to the third line having a predetermined potential, and

(I) the fifth region $SC_5$ is connected to the fourth line.

In the semiconductor memory cell of Example 5, the second region $SC_2$ and the third region $SC_3$ constitute a pn junction diode D, and the second region $SC_2$ is connected to the write-in information setting line WISL through the third region $SC_3$. The above pn junction diode D can be formed by adjusting the impurity concentrations of the second region $SC_2$ and the third region $SC_3$ to proper values. It is preferred to employ a constitution in which the second line is used as a bit line, or a constitution in which the write-in information setting line WISL is used as a bit line as well and a second predetermined potential is applied to the second line.

The junction-field-effect transistor $JF_1$ is formed by

(X) optimizing the distance between the facing gate regions (the fifth region $SC_5$ and the part of the first region $SC_1$ which part is opposed to the fifth region $SC_5$), that is, the thickness of the channel region $CH_{J1}$, and

(Y) optimizing the impurity concentration of each of the facing gate regions (the fifth region $SC_5$ and the part of the first region $SC_1$ which part is opposed to the fifth region $SC_5$) and the impurity concentration of the channel region $CH_{J1}$.

In Example 5, the semiconductor memory cell (specifically, the first region $SC_1$) is formed in a well structure which is formed, for example, in an n-type semiconductor substrate and has the second conductivity type (for example, p-type).

In the semiconductor memory cell of Example 5, when a first high-concentration-impurity-containing layer $SC_{10}$ having the first conductivity type (for example, $n^{++}$-type) is formed below the first region $SC_1$, the potential or charge to be stored in the channel forming region $CH_1$ of the first transistor $TR_1$ for readout can be increased.

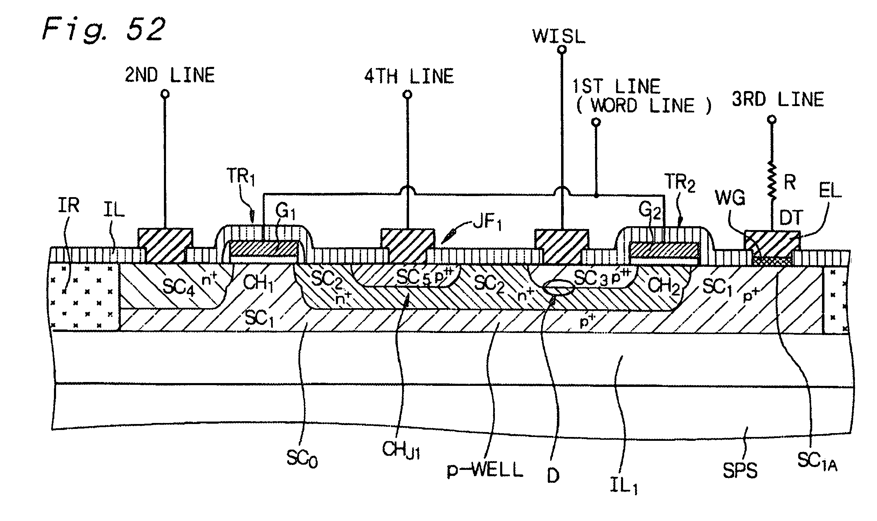

Fig. 52 shows a variant of the semiconductor memory cell of Example 5 shown in Fig. 51. In this variant, a semiconductor memory cell structured as shown in Fig. 51 is formed in a semiconductor layer $SC_0$ formed on an insulating interlayer $IL_1$ on a supporting substrate SPS. The semiconductor memory cell having the above structure can be manufactured according to the already explained method of forming an SOI structure or a TFT structure.

In the semiconductor memory cell shown in Fig. 51, as is shown in the principle drawing of Fig. 44, there may be employed an embodiment in which the formation of the pn junction diode D is omitted and the second region $SC_2$

corresponding to one source/drain region of the first transistor $TR_1$ is connected to a fifth line (not shown in Fig. 51). In the above embodiment, it is preferred to employ a constitution in which the second line is used as a bit line and a second predetermined potential is applied to the fifth line, or a constitution in which the fifth line is used as a bit line and a second predetermined potential is applied to the second line.

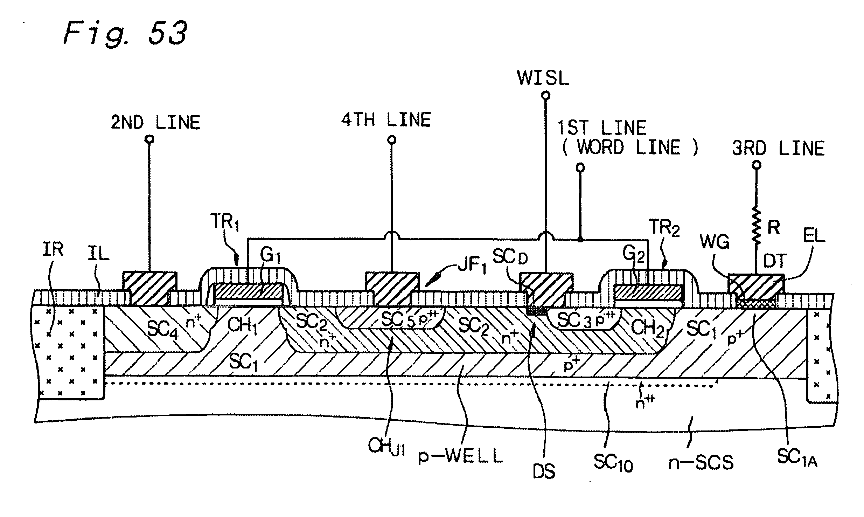

Further, Figs. 53 to 60 show variants of the semiconductor memory cell of Example 5 shown in Fig. 51.

The semiconductor memory cell shown in the principle drawing of Fig. 45B and the schematic partial cross-sectional view of Fig. 53 further has a diode-constituting region $SC_D$ which is formed in a surface region of the second region $SC_2$ and is in contact with the second region $SC_2$ to form a rectifier junction together with the second region $SC_2$, and the diode-constituting region $SC_D$ and the second region $SC_2$ constitute a majority carrier diode DS of a Schottky junction type. One source/drain region of the first transistor $TR_1$ is connected to the write-in information setting line WISL through the junction-field-effect transistor $JF_1$ and the majority carrier diode DS of a Schottky junction type in place of being connected to the fifth line through the junction-field-effect transistor $JF_1$. That is, the second region $SC_2$ is connected to the write-in information setting line WISL through the diode-constituting region $SC_D$. In the semiconductor memory cell shown in Fig. 53, the diode-constituting region $SC_D$ is formed adjacently to the third region $SC_3$, while the position of the diode-constituting region $SC_D$ shall not be limited thereto.

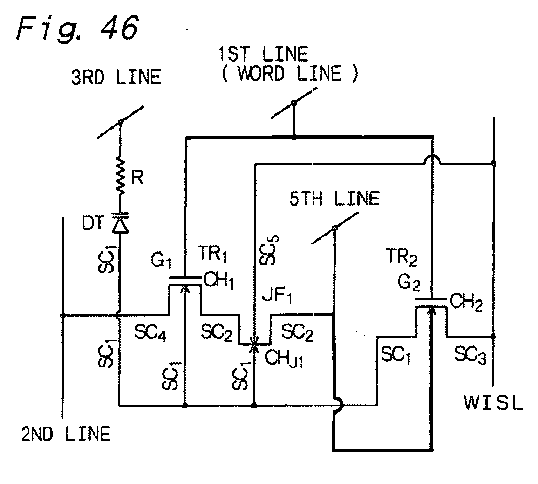

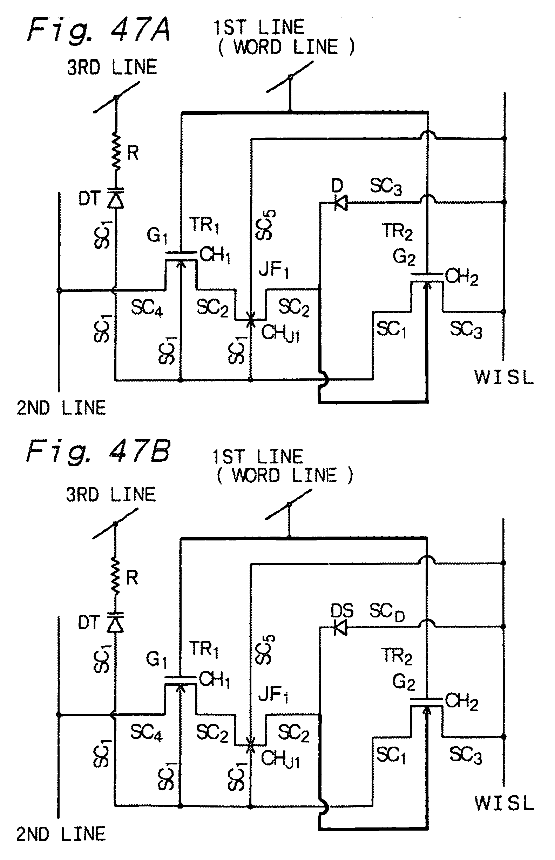

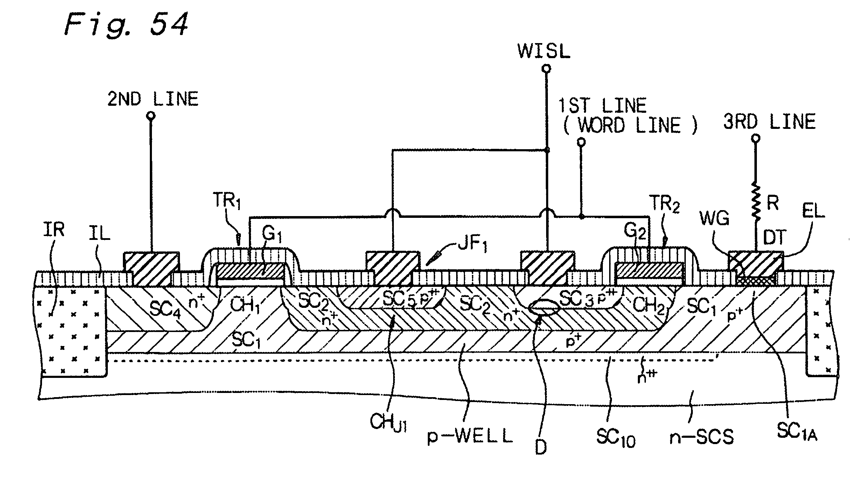

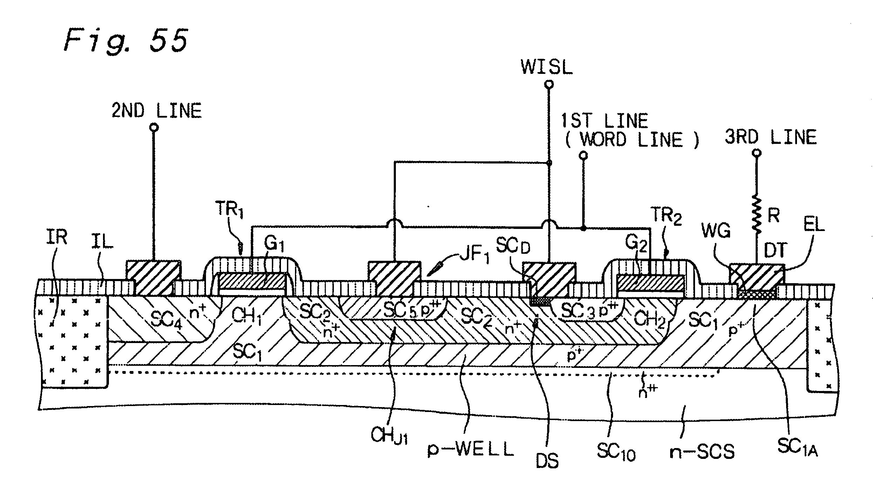

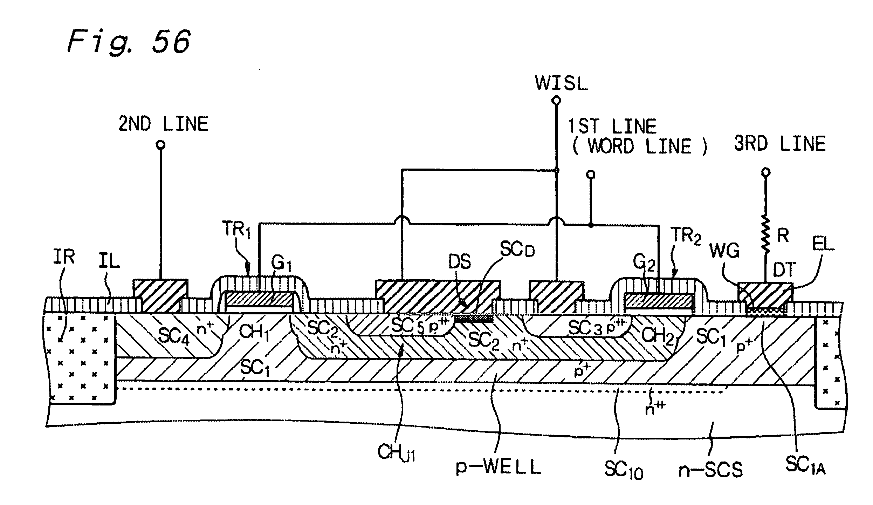

As shown in the principle drawings of Fig. 46 and Figs. 47A and 47B, the other gate region of the junction-field-effect transistor $JF_1$ may be connected to the write-in information setting line WISL in place of being connected to the fourth line. That is, as is shown in the schematic partial cross-sectional views of Figs. 54, 55 and 56, the fifth region $SC_5$ may be connected to the write-in information setting line WISL in place of being connected to the fourth line. The semiconductor memory cell shown in Fig. 54 is a variant of the semiconductor memory cell shown in Fig. 51, and the semiconductor memory cells shown in Figs. 55 and 56 are variants of the semiconductor memory cell shown in Fig. 53. The semiconductor memory cells shown in Figs. 55 and 56 have the same constitutions except that the diode-constituting regions $SC_D$ are formed in different positions.

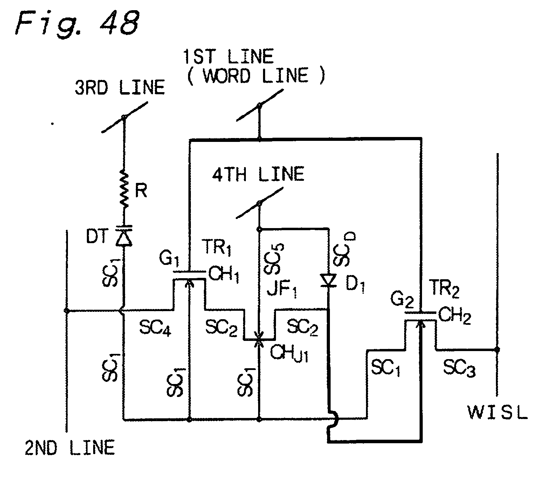

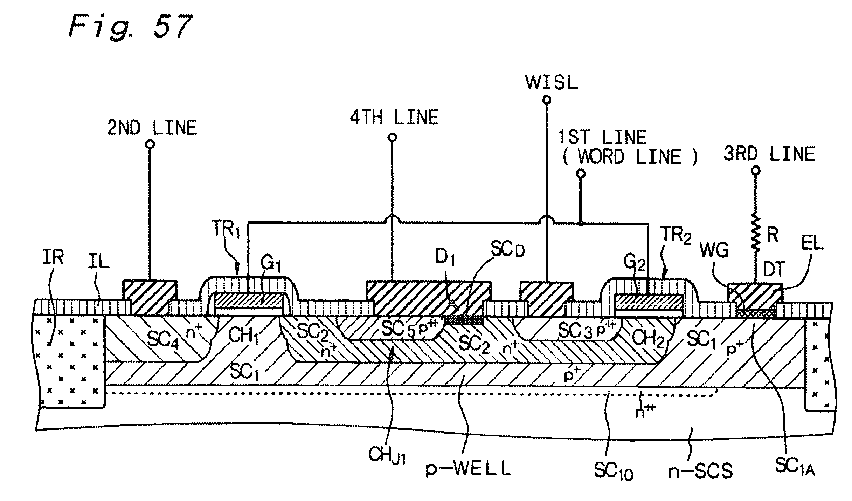

In the semiconductor memory cell shown in the principle drawing of Fig. 48 and the schematic partial cross-sectional view of Fig. 57, one source/drain region of the first transistor $TR_1$ is connected to the fourth line through the junction-field-effect transistor $JF_1$ and a diode $D_1$ in place of being connected to the fifth line through the junction-field-effect transistor $JF_1$. That is, the semiconductor memory cell further has a diode-constituting region $SC_D$ which is formed in a surface region of the second region $SC_2$ and is in contact with the second region $SC_2$ to form a rectifier junction together with the second region $SC_2$. The diode-constituting region $SC_D$ and the second region $SC_2$ constitute the diode $D_1$, and the second region $SC_2$ is connected to the fourth line through the diode-constituting region $SC_D$. In this case, it is preferred to employ a constitution in which the second line is used as a bit line. The diode-constituting region $SC_D$ is formed preferably adjacently to the fifth region $SC_5$, since the structure of the semiconductor memory cell can be simplified.

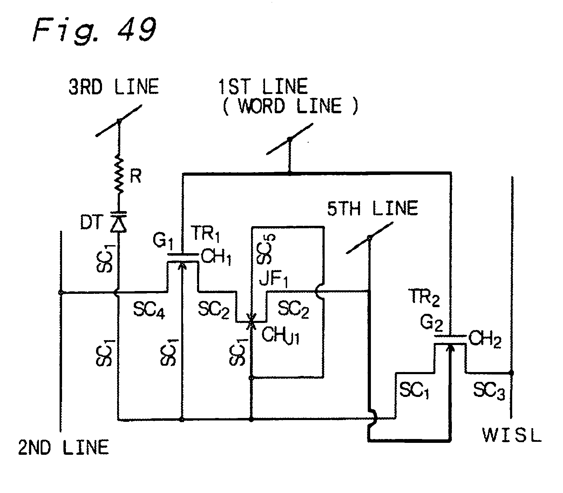

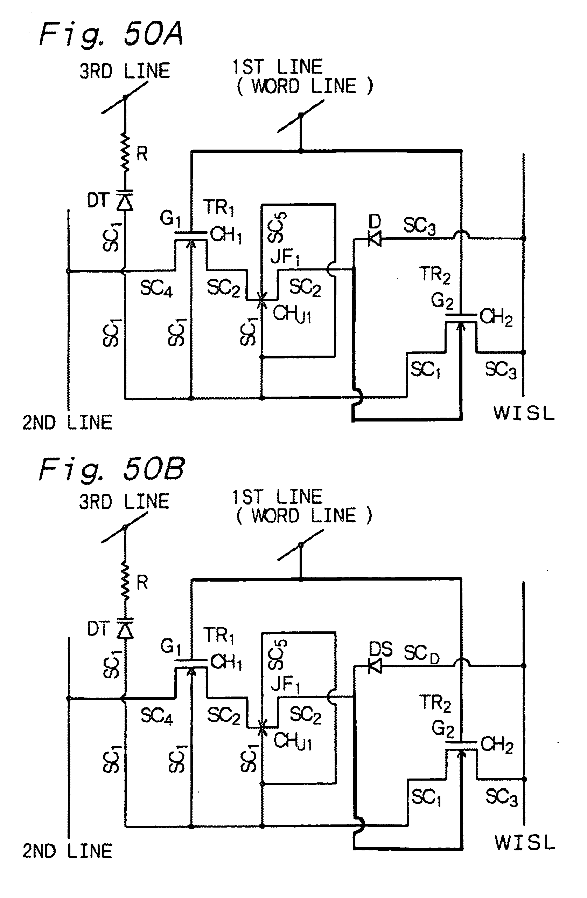

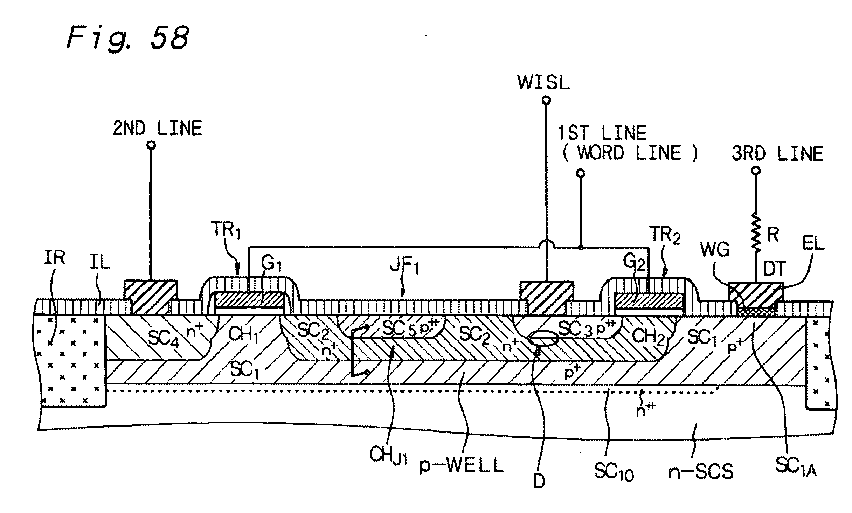

In the semiconductor memory cell shown in the principle drawing of Fig. 50A and the schematic partial cross-sectional view of Fig. 58, the other gate region of the junction-field-effect transistor $JF_1$ is connected to one gate region of the junction-field-effect transistor $JF_1$ in place of being connected to the fourth line. That is, the fifth region $SC_5$ is connected to the first region $SC_1$ in place of being connected to the fourth line. Further, the second region $SC_2$ and the third region $SC_3$ constitute a pn junction diode D, and the second region $SC_2$ is connected to the write-in information setting line WISL through the third region $SC_3$. In this case, it is preferred to employ a constitution in which the second line is used as a bit line, or a constitution in which the write-in information setting line WISL is used as a bit line as well and a second predetermined potential is applied to the second line. As is shown in the principle drawing of Fig. 49, there may be employed a constitution in which the pn junction diode D is omitted and the second region $SC_2$ corresponding to one source/drain region of the first transistor $TR_1$ is connected to a fifth line (not shown in Fig. 58). In this case, it is preferred to employ a constitution in which the second line is used as a bit line and a second predetermined potential is applied to the fifth line, or a constitution in which the fifth line is used as a bit line and a second predetermined potential is applied to the second line.

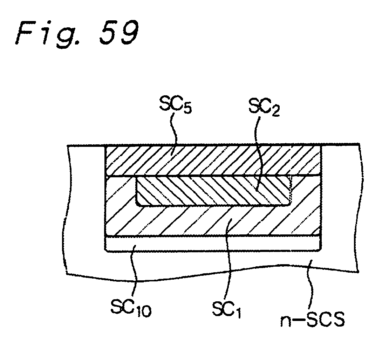

As is shown in the schematic partial cross-sectional view of Fig. 59 obtained by cutting the semiconductor memory cell with a vertical plane in parallel with the direction in which the gate extends, the fifth region SC5 and the first region SC1 can be connected, for example, by forming a structure in which a portion of the first region SC1 extends up to a vicinity of the surface of the semiconductor substrate and the fifth region SC5 and the extending portion of the first region SC1 are brought into contact with each other outside the second region SC2. When the semiconductor memory cell is structured as described above, the wiring structure of the semiconductor memory cell can be simplified.

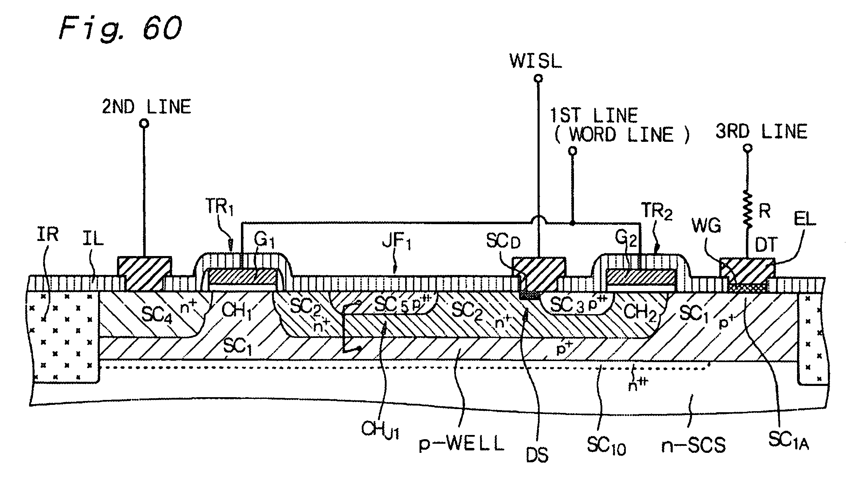

In the semiconductor memory cell shown in the principle drawing of Fig. 50B and the schematic partial cross-sectional view of Fig. 60, the fifth region SC5 is also connected to the first region SC1 in place of being connected to the fourth line. Further, it has a diode-constituting region SCD which is formed in a surface region of the second region SC2 and is in contact with the second region SC2 to form a rectifier junction together with the second region SC2, the diode-constituting region SCD and the second region SC2 constitute a majority carrier diode DS of a Schottky junction type, and the second region SC2 is connected to the write-in information setting line WISL through the diode-constituting region SCD. In this case, it is preferred to employ a constitution in which the second line is used as a bit line, or a constitution in which the write-in information setting line WISL is used as a bit line as well and a second predetermined potential is applied to the second line.

Example 6

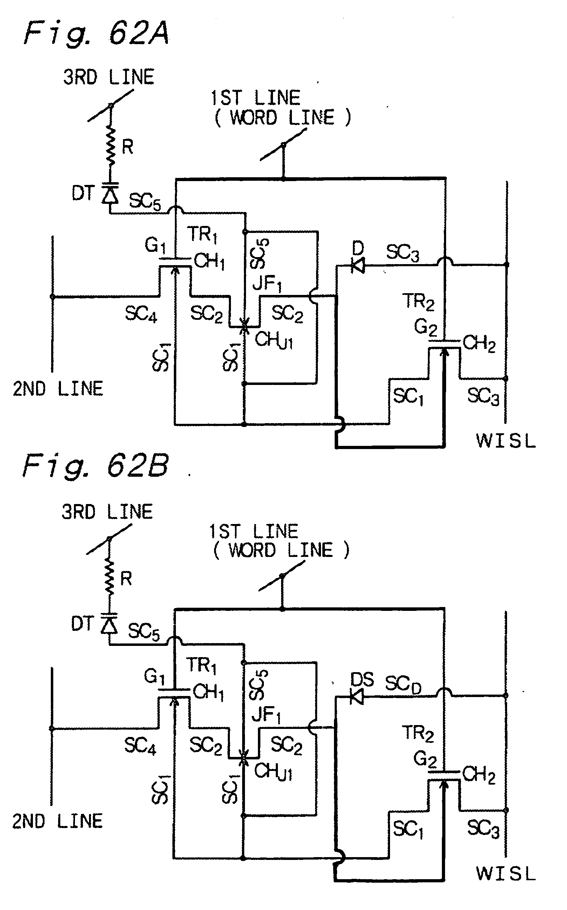

Example 6 is concerned with the semiconductor memory cell according to the fifth aspect of the present invention. Fig. 62A shows the principle of the semiconductor memory cell of Example 6. In the semiconductor memory cell of Example 6, the other gate region of the junction-field-effect transistor JF1 is connected to one gate region of the junction-field-effect transistor JF1 in place of being connected to the fourth line. More specifically, one end of the MIS type diode DT and the other gate region of the junction-field-effect transistor JF1 are formed as a common region. The fifth region SC5 constituting the other gate region of the junction-field-effect transistor JF1 corresponds to an extending portion of the channel forming region CH1 of the first transistor TR1.

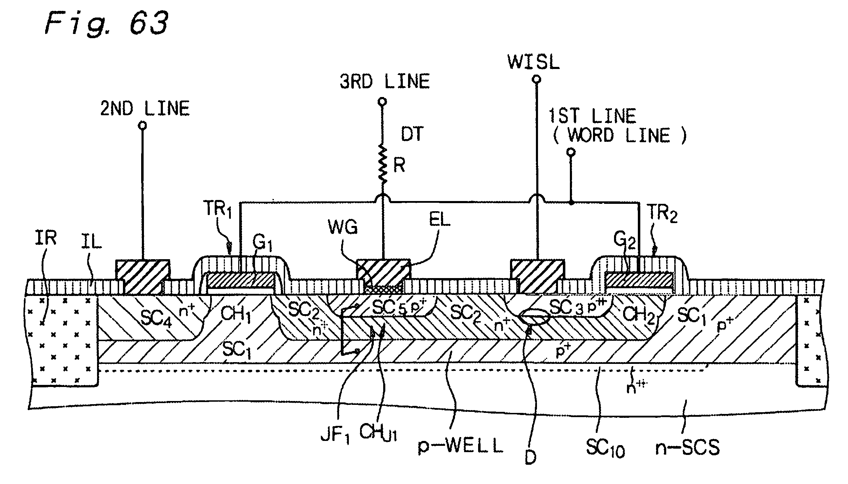

That is, as is shown in the schematic partial cross-sectional view of Fig. 63, the semiconductor memory cell of Example 6 comprises;

(1) a first transistor TR1 for readout, having a first conductivity type (for example, n-channel type), and having source/drain regions, a semi-conductive channel forming region CH1 which is in contact with the source/drain regions and spaces out the source/drain regions, and a gate G1 capacitively coupled with the channel forming region CH1,

(2) a second transistor TR2 for switching, having a second conductivity type (for example, p-channel type), and having source/drain regions, a semi-conductive channel forming region CH2 which is in contact with the source/drain regions and spaces out the source/drain regions, and a gate G2 capacitively coupled with the channel forming region CH2,

(3) a junction-field-effect transistor JF1 for current control, having source/drain regions, a channel region CHJ1 and gate regions, and

(4) an MIS type diode DT for retaining information, and the semiconductor memory cell has;

(a) a semi-conductive first region $SC_1$ having a second conductivity type (for example, $p^+$-type),

(b) a semi-conductive second region $SC_2$ which is formed in a surface region of the first region $SC_1$ and has a first conductivity type (for example, $n^+$-type),

(c) a third region $SC_3$ which is formed in a surface region of the second region $SC_2$ and is in contact with the second region $SC_2$ so as to form a rectifier junction together with the second region $SC_2$, the third region $SC_3$ being a region which is semi-conductive and has the second conductivity type (for example, $p^{++}$-type) or which is formed of a silicide, a metal or a metal compound and is conductive,

(d) a fourth region $SC_4$ which is formed in a surface region of the first region $SC_1$ to be spaced from the second region $SC_2$ and is in contact with the first region $SC_1$ so as to form a rectifier junction together with the first region $SC_1$, the fourth region $SC_4$ being a region which is semi-conductive and has the first conductivity type (for example, $n^+$-type) or which is formed of a silicide, a metal or a metal compound and is conductive, and

(e) a semi-conductive fifth region $SC_5$ which is formed in a surface region of the second region $SC_2$ to be spaced from the third region $SC_3$ and has the second conductivity type (for example, $p^{++}$-type).

Concerning the first transistor $TR_1$,

(A-1) one source/drain region is formed of a portion of a surface region of the second region $SC_2$,

(A-2) the other source/drain region is formed of the fourth region $SC_4$,

(A-3) the channel forming region $CH_1$ is formed of a portion of a surface region of the first region $SC_1$ which portion is interposed between said portion of the surface region of the second region $SC_2$ and the fourth region $SC_4$, and

(A-4) the gate $G_1$ is formed on the channel forming region $CH_1$ of the first transistor $TR_1$ through an insulation layer.

Concerning the second transistor $TR_2$,

(B-1) one source/drain region is formed of other portion of the surface region of the first region $SC_1$,

(B-2) the other source/drain region is formed of the third region $SC_3$,

(B-3) the channel forming region $CH_2$ is formed of other portion of the surface region of the second region $SC_2$ which other portion is interposed between said other portion of the surface region of the first region $SC_1$ and the third region $SC_3$, and

(B-4) the gate $G_2$ is formed on the channel forming region $CH_2$ of the second transistor through an insulation layer.

Further, concerning the junction-field-effect transistor $JF_1$,

(C-1) the gate regions are formed of the fifth region $SC_5$ and part of the first region $SC_1$ which part is opposed to the fifth region $SC_5$,

(C-2) the channel region $CH_{J1}$ is formed of part of the second region $SC_2$ which part is interposed between the fifth region $SC_5$ and said portion of the first region $SC_1$,

(C-3) one source/drain region is formed of said portion of the surface region of the second region $SC_2$ which portion extends from one end of the channel region $CH_{J1}$ of the junction-field-effect transistor $JF_1$ and constitutes one source/drain region of the first transistor $TR_1$, and

(C-4) the other source/drain region is formed of a portion of the second region $SC_2$ which portion extends from the other end of the channel region $CH_{J1}$ of the junction-field-effect transistor $JF_1$.

Concerning the MIS type diode DT, further,

(D-1) one end thereof is formed of the fifth region $SC_5$, and

(D-2) an electrode constituting the other end thereof is formed to be opposed to the fifth region $SC_5$ constituting one end of the MIS type diode DT, through a wide gap thin film WG.

The wide gap thin film WG can be composed of a material in which the tunnel transition of carriers is caused depending upon a potential difference between the potential in the fifth region $SC_5$ (corresponding to the extending portion of the channel forming region $CH_1$ of the first transistor $TR_1$) and the potential in the other end (electrode EL) of the MIS type diode DT. Specifically, it can be composed, for example, of an $SiO_2$ or SiON film having a thickness of 5 nm or smaller, or an SiN film having a thickness of 9 nm or smaller.

The electrode EL constituting the other end of the MIS type diode DT is connected to the line (third line) through a high-resistance element R having a resistance of approximately $10^9$ to $10^{12}\,\Omega$. Specifically, the electrode EL constituting the other end of the MIS type diode DT and the high-resistance element are integrally formed and are composed of a polysilicon thin layer containing an impurity having the first conductivity type.

In the above semiconductor memory cell, further,

(E) the gate $G_1$ of the first transistor $TR_1$ and the gate $G_1$ of the second transistor $TR_2$ are connected to a first line (for example, word line) for memory cell selection,

(F) the third region $SC_3$ is connected to a write-in information setting line WISL,

(G) the fourth region $SC_4$ is connected to a second line,

(H) the fifth region $SC_5$ is connected to the first region $SC_1$, and

(I) the electrode EL constituting the other end of the MIS type diode DT is connected to a third line having a predetermined potential.

In the semiconductor memory cell of Example 6, the second region $SC_2$ and the third region $SC_3$ constitute a pn junction diode D, and the second region $SC_2$ is connected to the write-in information setting line WISL through the third region $SC_3$. The above pn junction diode can be formed by adjusting the impurity concentrations of the second region $SC_2$ and the third region $SC_3$ to proper values. It is preferred to employ a constitution in which the second line is used as a bit line, or a constitution in which the write-in information setting line WISL is used as a bit line as well and a second predetermined potential is applied to the second line.

The junction-field-effect transistor $JF_1$ is formed by

(X) optimizing the distance between the facing gate regions (the fifth region $SC_5$ and the part of the first region $SC_1$ which part is opposed to the fifth region $SC_5$), that is, thickness of the channel region $CH_{J1}$, and

(Y) optimizing the impurity concentration of each of the facing gate regions (the fifth region $SC_5$ and the part of the first region $SC_1$ which part is opposed to the fifth region $SC_5$) and the impurity concentration of the channel region $CH_{J1}$.

In Example 6, the semiconductor memory cell (specifically, the first region $SC_1$) is formed in a well structure which is formed, for example, in an n-type semiconductor substrate and has the second conductivity type (for example, p-type).

In the semiconductor memory cell of Example 6, when a first high-concentration-impurity-containing layer $SC_{10}$ having the first conductivity type (for example, $n^{++}$-type) is formed below the first region $SC_1$, the potential or charge to be stored in the channel forming region $CH_1$ of the first transistor $TR_1$ for readout can be increased.

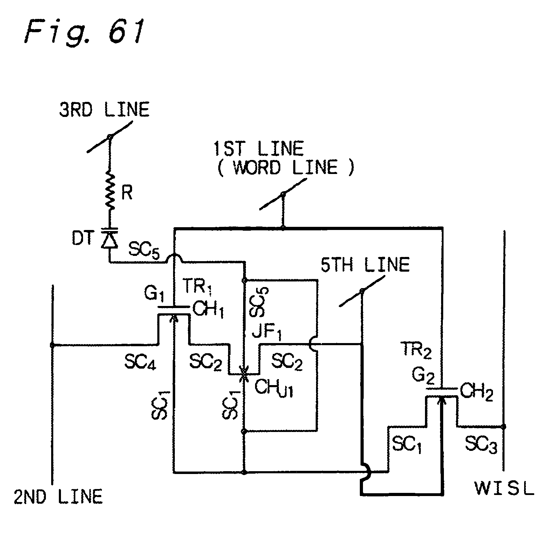

In the semiconductor memory cell shown in Fig. 63, as is shown in the principle drawing of Fig. 61, there may be employed an embodiment in which the formation of the pn junction diode D is omitted and the second region $SC_2$ corresponding to one source/drain region of the first transistor $TR_1$ is connected to a fifth line (not shown in Fig. 63). In the above embodiment, it is preferred to employ a constitution in which the second line is used as a bit line and a second predetermined potential is applied to the fifth line, or a constitution in which the fifth line is used as a bit line and a second predetermined potential is applied to the second line.

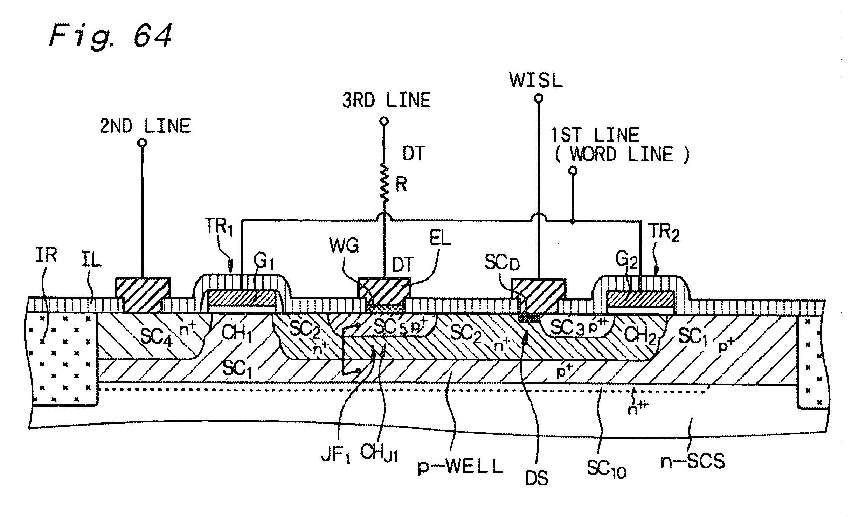

The semiconductor memory cell shown in the principle drawing of Fig. 62B and the schematic partial cross-sectional view of Fig. 64 further has a diode-constituting region $SC_D$ which is formed in a surface region of the second region $SC_2$ and is in contact with the second region $SC_2$ to form a rectifier junction together with the second region $SC_2$, and the diode-constituting region $SC_D$ and the second region $SC_2$ constitute a majority carrier diode DS of a Schottky junction type. One source/drain region of the first transistor $TR_1$ is connected to the write-in information setting line WISL through the junction-field-effect transistor $JF_1$ and the majority carrier diode DS of a Schottky junction type in place of being connected to the fifth line through the junction-field-effect transistor $JF_1$. That is, the second region $SC_2$ is connected to the write-in information setting line WISL through the diode-constituting region $SC_D$. In the semiconductor memory cell shown in Fig. 64, the diode-constituting region $SC_D$ is formed adjacently to the third region $SC_3$, while the position of the diode-constituting region $SC_D$ shall not be limited thereto.

Example 7

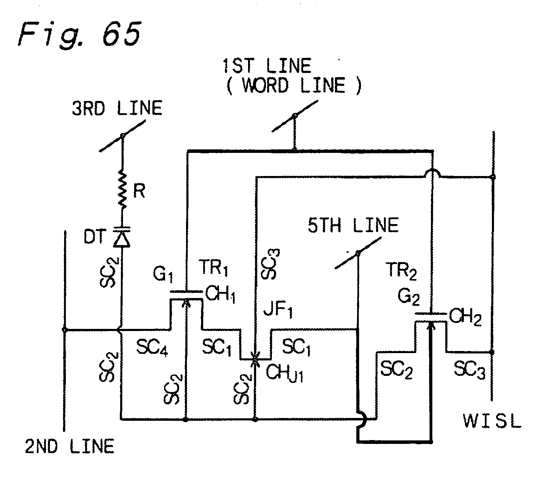

Example 7 is concerned with the semiconductor memory cell according to the seventh aspect of the present invention. Fig. 65 shows the principle of the semiconductor memory cell of Example 7. In the semiconductor memory cell of Example 7, the other gate region of the junction-field-effect transistor JF1 is connected to the write-in information setting line WISL in place of being connected to the fourth line.

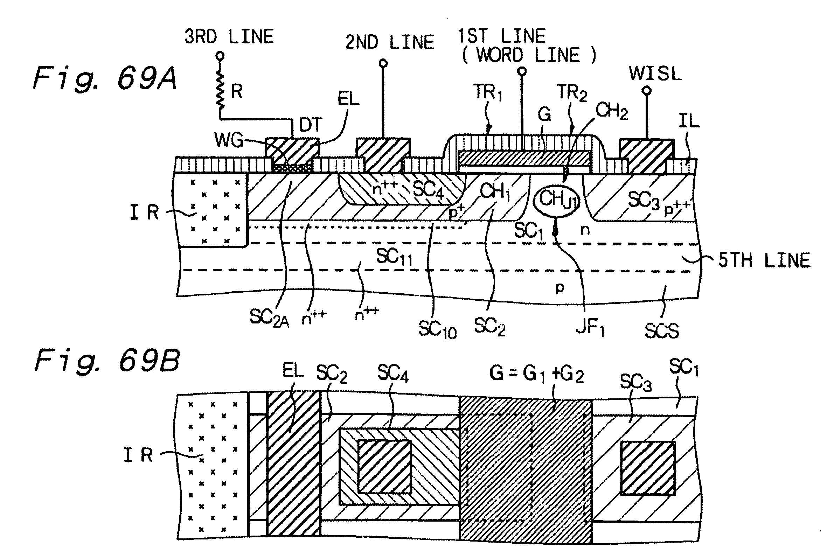

Further, as shown in the schematic partial cross-sectional view of Fig. 69A and the schematic layout of regions in Fig. 69B, the semiconductor memory cell of Example 7 differs from the semiconductor memory cell of Example 5 in that the fifth region SC5 is omitted and that the first transistor TR1 and the second transistor TR2 share a gate. That is, the semiconductor memory cell of Example 7 comprises;

(1) a first transistor TR1 for readout, having a first conductivity type (for example, n-channel type), and having source/drain regions, a semi-conductive channel forming region CH1 which is in contact with the source/drain regions and spaces out the source/drain regions, and a gate G capacitively coupled with the channel forming region CH1,
(2) a second transistor TR2 for switching, having a second conductivity type (for example, p-channel type) and having source/drain regions, a semi-conductive channel forming region CH2 which is in contact with the source/drain regions and spaces out the source/drain regions, and the gate G capacitively coupled with the channel forming region CH2,
(3) a junction-field-effect transistor JF1 for current control, having source/drain regions, a channel region CHJ1 and gate regions, and
(4) an MIS type diode DT for retaining information,
and the semiconductor memory cell has;

(a) a semi-conductive first region SC1 having a first conductivity type (for example, n-type),
(b) a semi-conductive second region $SC_2$ which is in contact with the first region $SC_1$ and has a second conductivity type (for example, $p^+$-type),
(c) a third region $SC_3$ which is formed in a surface region of the first region $SC_1$ and is in contact with the first region $SC_1$ so as to form a rectifier junction together with the first region $SC_1$, the third region $SC_3$ being a region which is semi-conductive and has the second conductivity type (for example, $p^{++}$-type) or which is formed of a silicide, a metal or a metal compound and is conductive,
(d) a fourth region $SC_4$ which is formed in a surface region of the second region $SC_2$ and is in contact with the second region $SC_2$ so as to form a rectifier junction together with the second region $SC_2$, the fourth region $SC_4$ being a region which is semi-conductive and has the first conductivity type (for example, $n^{++}$-type) or which is formed of a silicide, a metal or a metal compound and is conductive, and
(e) the gate G which is formed, through an insulation layer, so as to bridge the first region $SC_1$ and the fourth region $SC_4$ and so as to bridge the second region $SC_2$ and the third region $SC_3$ and is shared by the first transistor $TR_1$ and the second transistor $TR_2$.

The first region $SC_1$ and the second region $SC_2$ are in contact with each other. In the semiconductor memory cell shown in Fig. 69, specifically, the second region $SC_2$ is formed in a surface region of the first region $SC_1$.
Concerning the first transistor $TR_1$,

(A-1) one source/drain region is formed of a surface region of the first region $SC_1$,

(A-2) the other source/drain region is formed of the fourth region $SC_4$, and

(A-3) the channel forming region $CH_1$ is formed of a surface region of the second region $SC_2$ which surface region is interposed between the surface region of the first region $SC_1$ and the fourth region $SC_4$.

Concerning the second transistor $TR_2$,

(B-1) one source/drain region is formed of the surface region of the second region $SC_2$ which surface region constitutes the channel forming region $CH_1$ of the first transistor $TR_1$,

(B-2) the other source/drain region is formed of the third region $SC_3$, and

(B-3) the channel forming region $CH_2$ is formed of the surface region of the first region $SC_1$ which surface region constitutes one source/drain region of the first transistor $TR_1$.

Further, concerning the junction-field-effect transistor $JF_1$,

(C-1) the gate regions are formed of the third region $SC_3$ and part of the second region $SC_2$ which part is opposed to the third region $SC_3$,

(C-2) the channel region $CH_{J1}$ is formed of part of the first region $SC_1$ which part is interposed between the third region $SC_3$ and said part of the second region $SC_2$,

(C-3) one source/drain region is formed of the surface region of the first region $SC_1$ which surface region extends from one end of the channel region $CH_{J1}$ of the junction-field-effect transistor $JF_1$ and constitutes one source/drain region of the first transistor $TR_1$, and

(C-4) the other source/drain region is formed of a portion of the first region $SC_1$ which portion extends from the other end of the channel region $CH_{J1}$ of the junction-field-effect transistor $JF_1$.

Concerning the MIS type diode DT,

(D-1) one end thereof is formed of part $SC_{2A}$ of the second region $SC_2$, and

(D-2) an electrode constituting the other end thereof is formed to be opposed to said part $SC_{2A}$ of the second region $SC_2$ which part constitutes one end of the MIS type diode DT, through a wide gap thin film WG.

The wide gap thin film WG can be composed of a material in which the tunnel transition of carriers is caused depending upon a potential difference between the potential in the second region $SC_2$ (the channel forming region $CH_1$ of the first transistor $TR_1$) and the potential in the other end (electrode EL) of the MIS type diode DT. Specifically, it can be composed, for example, of an $SiO_2$ or SiON film having a thickness of 5 nm or smaller, or an SiN film having a thickness of 9 nm or smaller.

The electrode EL constituting the other end of the MIS type diode DT is connected to the line (third line) through a high-resistance element R having a resistance of approximately $10^9$ to $10^{12}$ Ω. Specifically, the electrode EL constituting the other end of the MIS type diode DT and the high-resistance element are integrally formed and are composed of a polysilicon thin layer containing an impurity having the first conductivity type.

In the above semiconductor memory cell, further,

(E) the gate G is connected to a first line (for example, word line) for memory cell selection,

(F) the third region $SC_3$ is connected to a write-in information setting line WISL,

(G) the fourth region $SC_4$ is connected to a second line, and

(H) the electrode EL constituting the other end of the MIS type diode DT is connected to a third line having a predetermined potential.

It is preferred to employ a constitution in which the first region $SC_1$ is connected to a fifth line, the second line is used as a bit line and a second predetermined potential is applied to the fifth line, or a constitution in which the first region $SC_1$ is connected to a fifth line, the fifth line is used as a bit line and a second predetermined potential is applied to the second line.

In Example 7, the semiconductor memory cell (specifically, the first region $SC_1$) is formed in a well structure which is formed, for example, in an p-type semiconductor substrate and has the first conductivity type (for example, n-type).

In the semiconductor memory cell of Example 7, when a first high-concentration-impurity-containing layer $SC_{10}$ having the first conductivity type (for example, $n^{++}$-type) is formed below the second region $SC_2$, the potential or charge to be stored in the channel forming region $CH_1$ of the first transistor $TR_1$ for readout can be increased. Further, a second high-concentration-impurity-containing layer $SC_{11}$ which works as the fifth line and has the first conductivity type (for example, $n^{++}$-type) is formed below the first region $SC_1$.

The junction-field-effect transistor $JF_1$ is formed by

(X) optimizing the distance between the facing gate regions (the third region $SC_3$ and the part of the second region $SC_2$ which part is opposed to the third region $SC_3$), that is, the thickness of the channel region $CH_{J1}$, and
(Y) optimizing the impurity concentration of each of the facing gate regions (the third region $SC_3$ and the part of the second region $SC_2$ which part is opposed to the third region $SC_3$) and the impurity concentration of the channel region $CH_{J1}$.

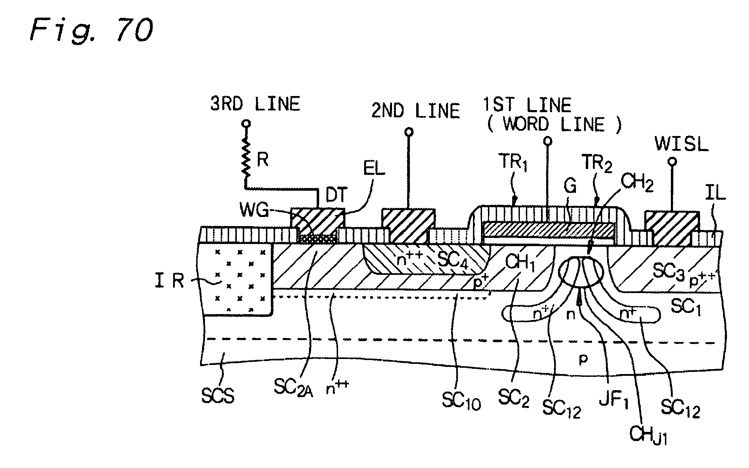

Figs. 70 to 91 show schematic partial cross-sectional views of variants of the semiconductor memory cell of Example 7.

In the semiconductor memory cell shown in Fig. 70, a first conductivity type region $SC_{12}$ is formed by ion-implanting an impurity having the first conductivity type to the channel region $CH_{J1}$ of the junction-field-effect transistor $JF_1$ by an oblique ion-implanting method. In this manner, the impurity concentration of the channel region $CH_{J1}$ can be controlled, and the performance of the junction-field-effect transistor $JF_1$ can be stabilized. A constitution including the formation of the first conductivity type region $SC_{12}$ can be applied to various semiconductor memory cells of the present invention although it differs depending upon the layout of the first region $SC_1$, the second region $SC_2$ and the third region $SC_3$.

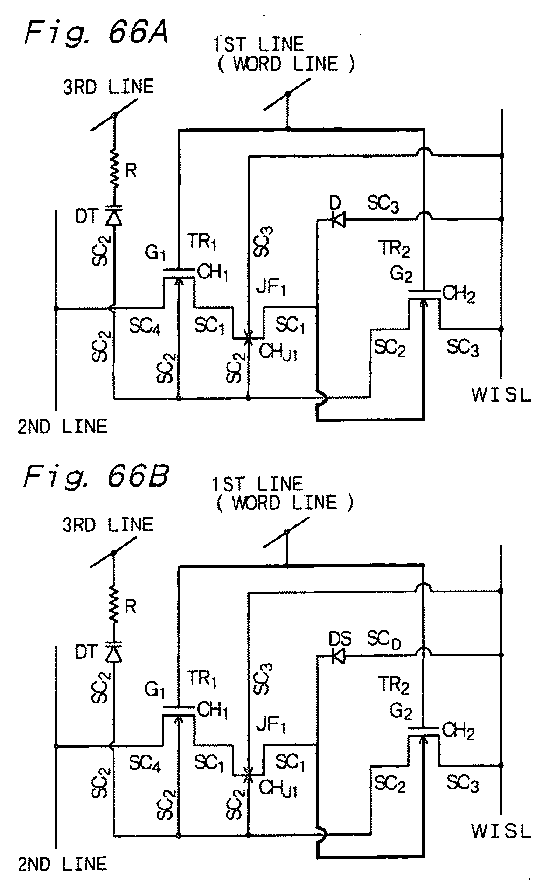

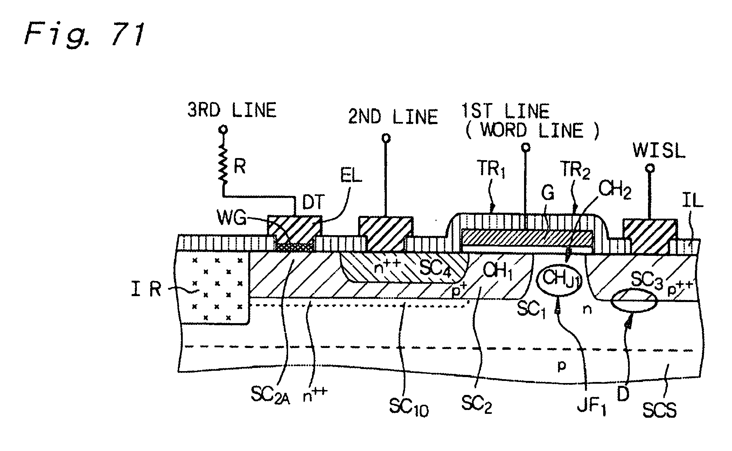

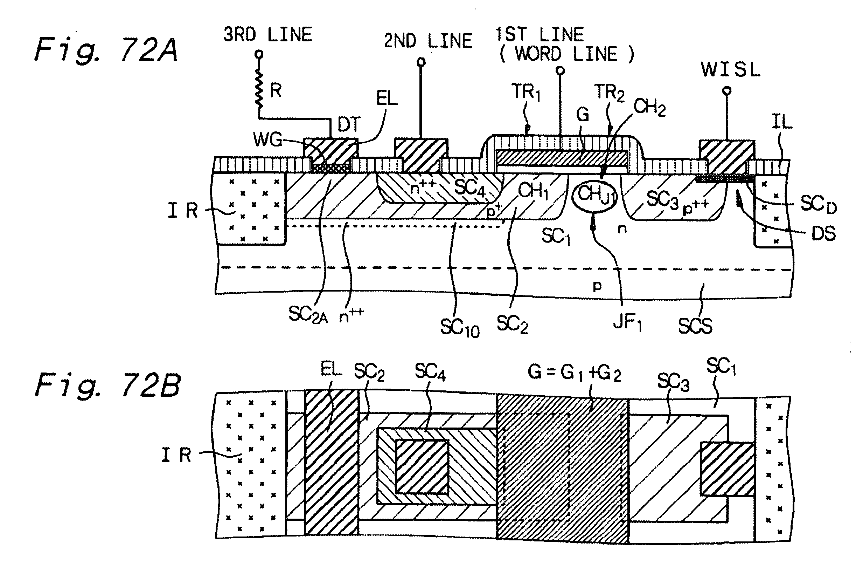

In the semiconductor memory cell shown in the drawing of the principle of Fig. 66A and the schematic partial cross-sectional view of Fig. 71, the first region $SC_1$ and the third region $SC_3$ constitute a pn junction diode D, and the first region $SC_1$ is connected to the write-in information setting line WISL through the third region $SC_3$. The above pn junction diode D can be formed by adjusting the impurity concentrations of the first region $SC_1$ and the third region $SC_3$ to proper values. Further, in the semiconductor memory cell shown in the drawing of the principle of Fig. 66B, the schematic partial cross-sectional view of Fig. 72A and the schematic layout of Fig. 72A, there is further provided a diode-constituting region $SC_D$ which is formed in a surface region of the first region $SC_1$ and is in contact with the first region $SC_1$ to form a rectifier junction together with the first region $SC_1$, the diode-constituting region $SC_D$ and the first region $SC_1$ constitute a majority carrier diode DS, and the first region $SC_1$ is connected to the write-in information setting line WISL through the diode-constituting region $SC_D$. In these cases, it is preferred to employ a constitution in which the second line is used as a bit line, or a constitution in which the write-in information setting line WISL is used as a bit line as well and a second predetermined potential is applied to the second line.

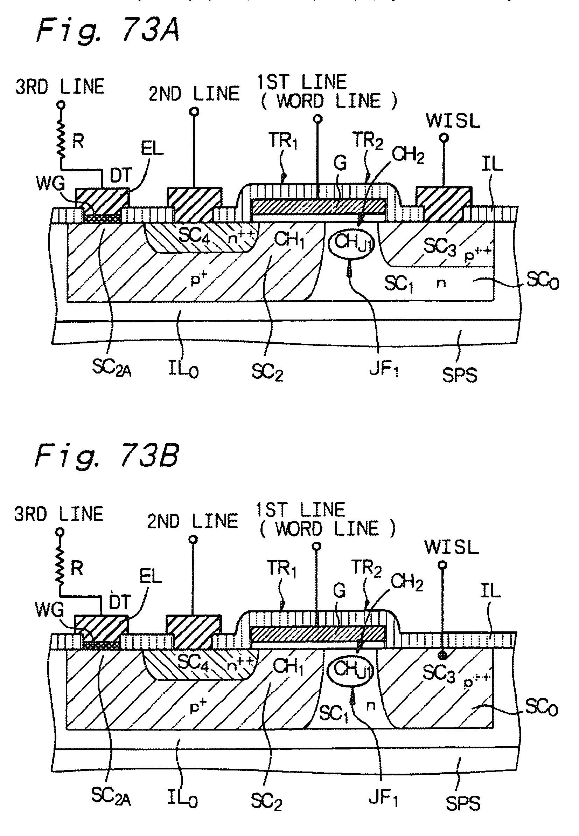

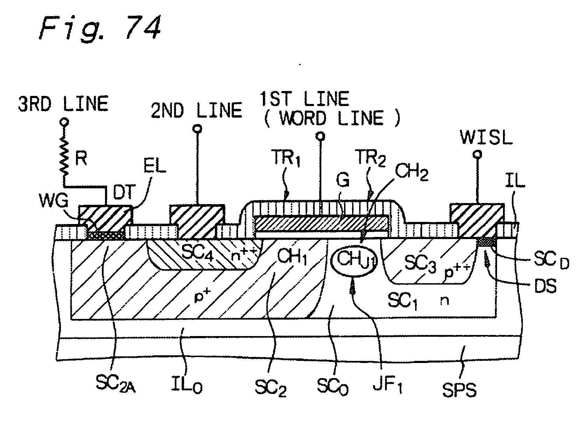

In the variants shown in Figs. 73A and 73B, the semiconductor memory cell structured as shown in Fig. 69 is formed in a semiconductor layer $SC_0$ surrounded by an insulation material layer $IL_0$ on a supporting substrate SPS. The difference between the semiconductor memory cell shown in Fig. 73A and the semiconductor memory cell shown in Fig. 73B is how far the third region $SC_3$ extends downwardly. When the semiconductor memory cell structured as shown in Fig. 73B is employed, an electrode from a side of the third region $SC_3$ to the write-in information setting line WISL can be taken out. These semiconductor memory cells are substantially structurally the same as the semiconductor memory cell shown in Fig. 69 in other points. In the variant shown in Fig. 74, the semiconductor memory cell structured as shown in Figs. 72A and 72B is formed in a semiconductor layer $SC_0$ surrounded by an insulation material layer $IL_0$ on a supporting substrate SPS. The semiconductor memory cell shown in Fig. 74 is substantially structurally the same as the semiconductor memory cell shown in Fig. 72 in other points. The semiconductor memory cells having the above structures can be manufactured according to the already explained method of manufacturing an SOI structure or a TFT structure.

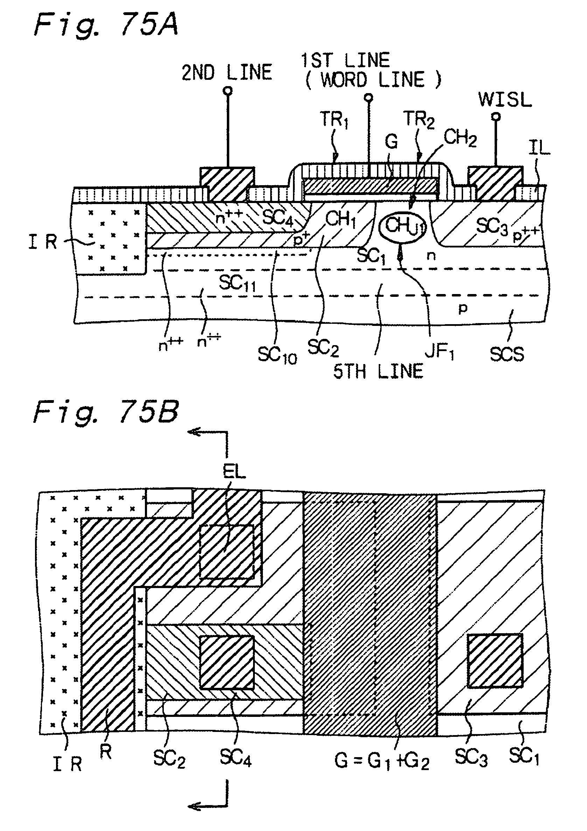

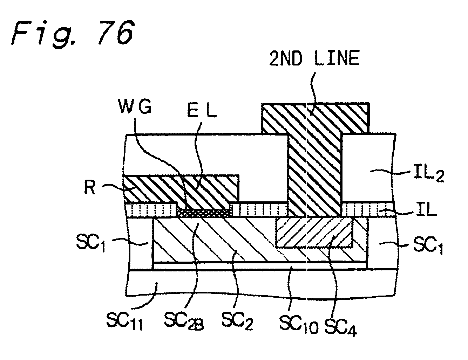

The semiconductor memory cell of Example 7 shown in Figs. 69A and 69B can be modified as shown in Figs. 75A, 75B and 76. Fig. 75A shows a schematic partial cross-sectional view of the semiconductor memory cell, Fig. 75B shows a schematic layout of regions, and Fig. 76 shows a schematic partial cross-sectional view taken along arrows in Fig. 75B. In the above semiconductor memory cell, a portion $SC_{2B}$ of the second region $SC_2$ extends up to a surface of the semiconductor substrate beside the fourth region $SC_4$. The extending portion $SC_{2B}$ of the second region $SC_2$ corresponds to one end of the MIS type diode DT. The electrode EL constituting the other end of the MIS type diode DT is formed on the extending portion $SC_{2B}$ of the second region $SC_2$ through the wide gap thin film WG. The high-resistance element R integrally extends from the electrode EL. The electrode EL and the high-resistance element R are composed of a polysilicon thin layer containing an impurity having the first conductivity type (for example, n-type). The second line (for example, bit line) is formed on a second insulating interlayer $IL_2$ and extends in the direction perpendicular to the paper surface of Fig. 76. The second region $SC_2$ structure shown in Figs. 75A, 75B and 76 can be applied to various variants of the semiconductor memory cell of the present invention.

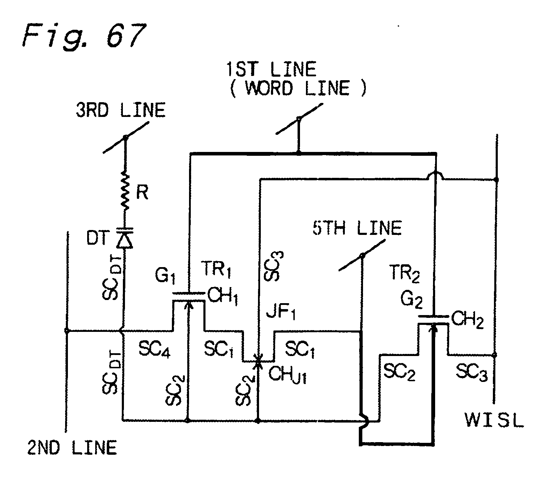

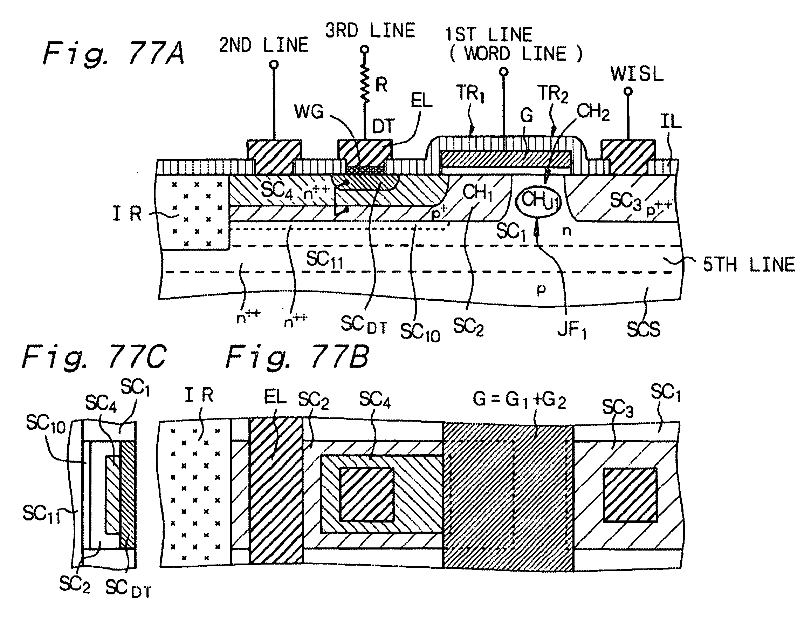

As is shown in the principle drawing of Fig. 67, the schematic partial cross-sectional view of Fig. 77A and the schematic layout of Fig. 77B, there may be employed a constitution in which a semi-conductive MIS-type-diode constituting region $SC_{DT}$ having the second conductivity type (for example, $p^+$-type) is formed in a surface region of the fourth region $SC_4$ and the MIS-type-diode constituting region $SC_{DT}$ and the second region $SC_2$ are connected to each other.

In the MIS type diode DT, one end thereof is formed of the MIS-type-diode constituting region $SC_{DT}$ which corresponds to an extending portion of the channel forming region $CH_1$ of the first transistor $TR_1$ or an extending portion of the second region $SC_2$, and an electrode EL constituting the other end thereof is formed so as to be opposed to the MIS-type-diode constituting region $SC_{DT}$ constituting one end of the MIS type diode DT through the wide gap thin film and is composed of a conductive material.

The MIS-type-diode constituting region $SC_{DT}$ and the second region $SC_2$ can be connected to each other, for example, by forming a structure in which a portion of the second region $SC_2$ is extended to a vicinity of the surface of the semiconductor substrate so that the MIS-type-diode constituting region $SC_{DT}$ and the extending portion of the second region $SC_2$ are in contact with each other outside the fourth region $SC_4$, as is shown in the schematic partial cross-sectional view of Fig. 77C. The above MIS-type-diode constituting region $SC_{DT}$ corresponds to the extending portion of the channel forming region $CH_1$ of the first transistor $TR_1$ or the extending portion of the second region $SC_2$. When the semiconductor memory cell is structured as described above, the wiring structure of the semiconductor memory cell can be simplified.

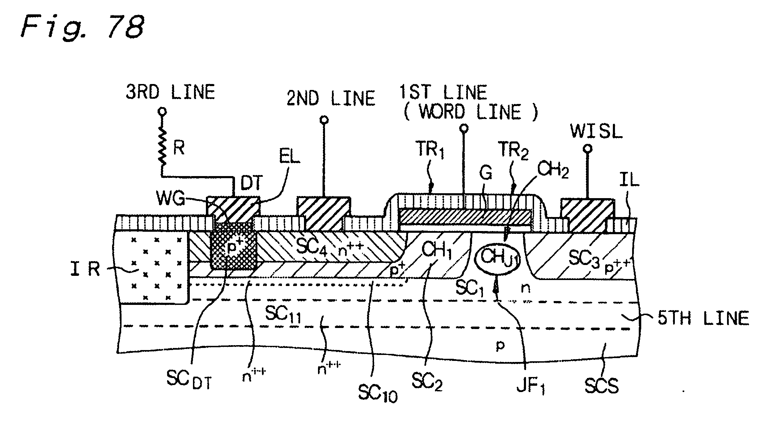

In a semiconductor memory cell shown in the schematic partial cross-sectional view of Fig. 78, a MIS-type-diode constituting region $SC_{DT}$ having the second conductivity type (for example, $p^+$-type) is formed in a buried plug form, and the MIS-type-diode constituting region $SC_{DT}$ through the fourth region $SC_4$ until it reaches the second region $SC_2$. The above MIS-type-diode constituting region $SC_{DT}$ corresponds to the extending portion of channel forming region $CH_1$ of the first transistor $TR_2$ or the extending portion of the second region $SC_2$. In the above structure, the MIS-type-diode constituting region $SC_{DT}$ and the second region $SC_2$ can be connected to each other as well. The semiconductor memory cell shown in Fig. 78 can be substantially structurally the same as the semiconductor memory cell shown in Fig. 69 except for the above point.

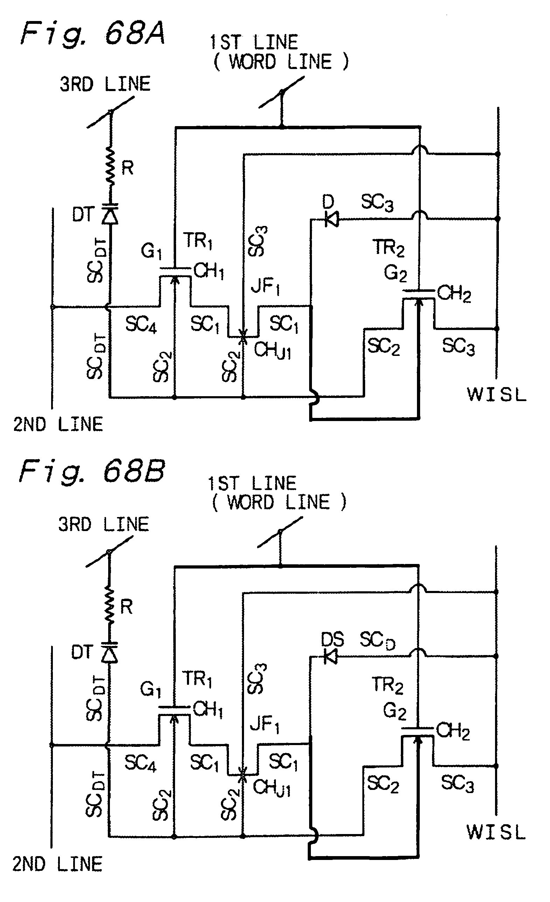

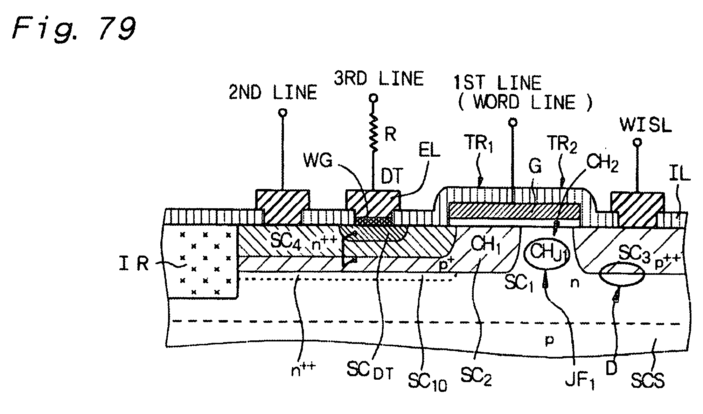

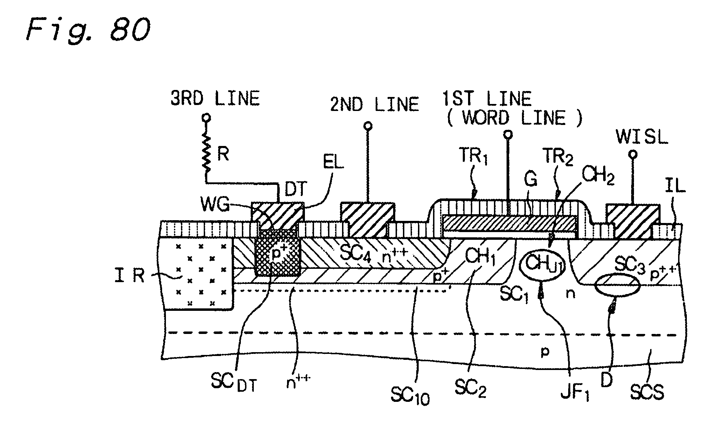

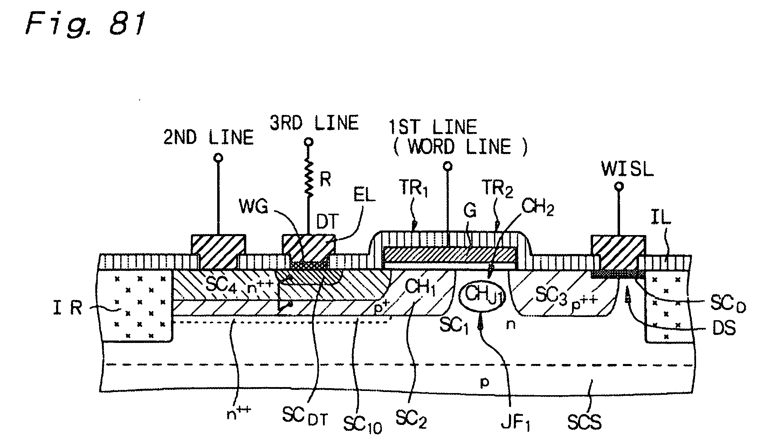

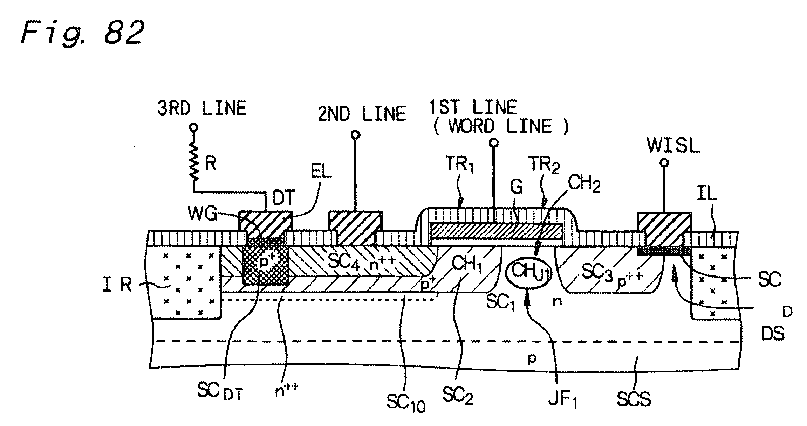

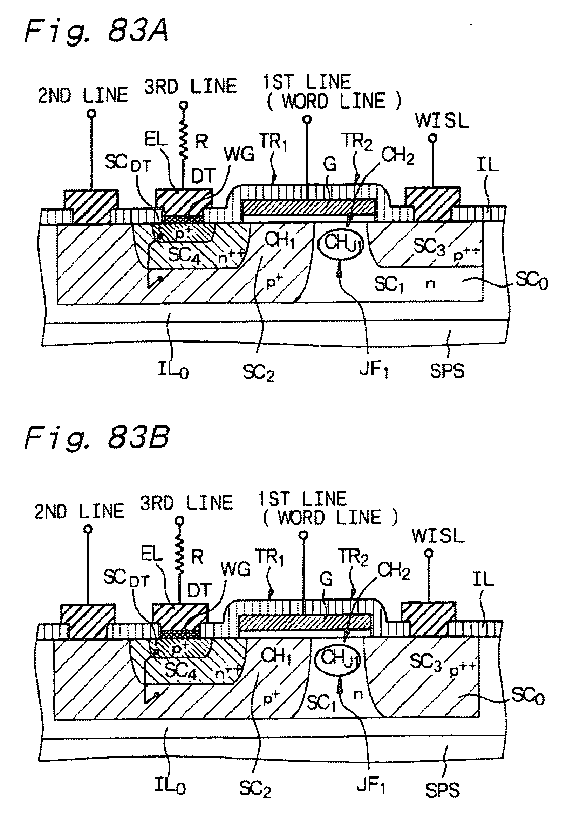

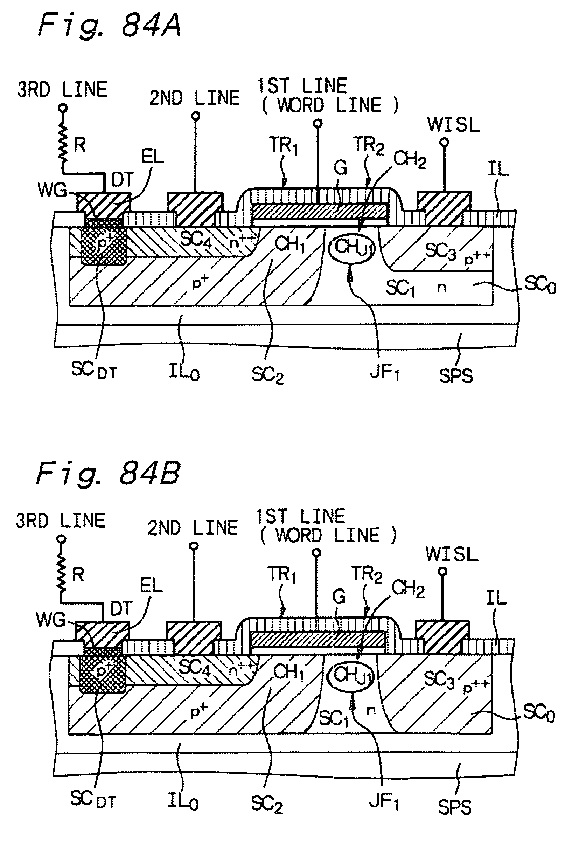

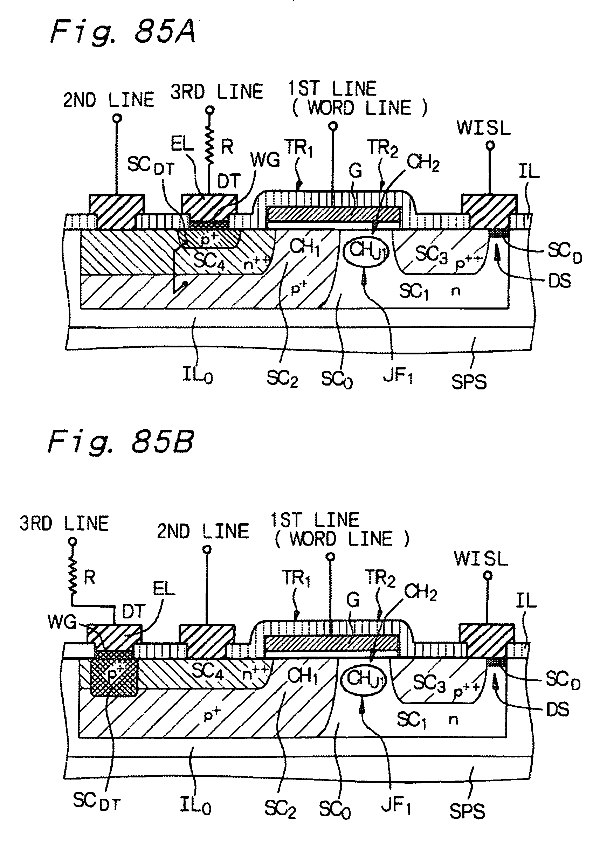

Semiconductor memory cells shown in schematic partial cross-sectional views of Figs. 79 and 80 (see Figs. 68A and 68B for their principle, respectively) are the variants of the semiconductor memory cell of Example 7 shown in Fig. 77 or 78, and have a constitution in which the first region $SC_1$ and the third region $SC_3$ constitute a pn junction D and the first region $SC_1$ is connected to the write-in information setting line WISL through the third region $SC_3$. Further, semiconductor memory cells shown in schematic partial cross-sectional views of Figs. 81 and 82 are the variants of the semiconductor memory cell of Example 7 shown in Fig. 77 and 78, and have a constitution in which further provided is a diode-constituting region $SC_D$ which is formed in a surface region of the first region $SC_1$ and is in contact with the first region $SC_1$ to form a rectifier junction together with the first region $SC_1$, the diode-constituting region $SC_D$ and the first region $SC_1$ constitute a majority carrier diode DS, and the first region $SC_1$ is connected to the write-in information setting line WISL through the diode-constituting region $SC_D$. Further, semiconductor memory cells shown in the schematic partial cross-sectional views of Figs. 83A and 83B are the variants of the semiconductor memory cell of Example 7 shown in Fig. 73A and 73B, and have a constitution in which further provided is a semi-conductive MIS-type-diode constituting region $SC_{DT}$ having the second conductivity type (for example, $p^+$-type) in a surface region of the fourth region $SC_4$, and the MIS-type-diode constituting region $SC_{DT}$ is connected to the second region $SC_2$. Further, semiconductor memory cells shown in schematic partial cross-sectional views of Figs. 84A and 84B are the variants of the semiconductor memory cell of Example 7 shown in Fig. 73A and 73B, and have a constitution in which a MIS-type-diode constituting region $SC_{DT}$ having the second conductivity type (for example, $p^+$-type) is formed in a buried plug form and the MIS-type-diode constituting region $SC_{DT}$ penetrates through the fourth region $SC_4$ until it reaches the second region $SC_2$. Further, a semiconductor memory cell shown in the schematic partial cross-sectional view of Fig. 85A is the variant of the semiconductor memory cell of Example 7 shown in Fig. 74, and has a constitution in which further provided is a MIS-type-diode constituting region $SC_{DT}$ having the second conductivity type (for example, $p^+$-type) in a surface region of the fourth region $SC_4$ and the MIS-type-diode constituting region $SC_{DT}$ is connected to the second region $SC_2$. Further, a semiconductor memory cell shown in the schematic partial cross-sectional view of Fig. 85B is the variant of the semiconductor memory cell of Example 7, shown in Fig. 74, and has a constitution in which a MIS-type-diode constituting region $SC_{DT}$ having the second conductivity type (for example, $p^+$-type) is formed in a buried plug form and the MIS-type-diode constituting region $SC_{DT}$ penetrates through the fourth region $SC_4$ until it reaches the second region $SC_2$.

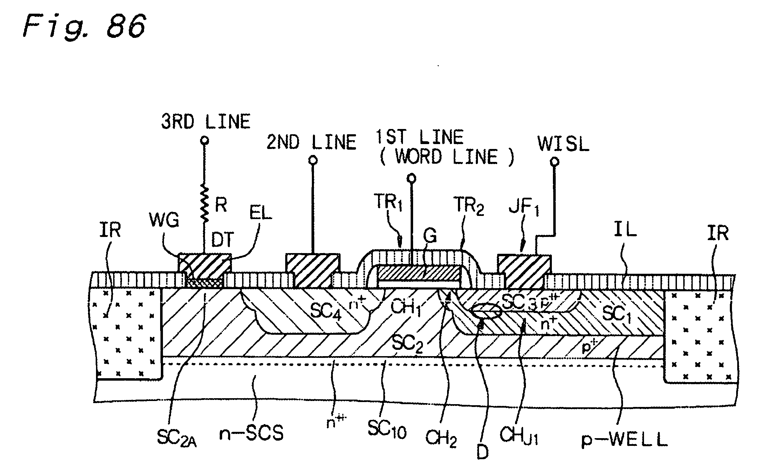

In a variant of the semiconductor memory cell shown in Fig. 86, the first region $SC_1$ and the second region $SC_2$ are in contact with each other. Specifically, the variant shown in Fig. 86 has a constitution in which the first region $SC_1$ is formed in a surface region of the second region $SC_2$, the first region $SC_1$ and the third region $SC_3$ constitute a pn junction diode D, and the first region $SC_1$ is connected to the write-in information setting line WISL through the third region $SC_3$.

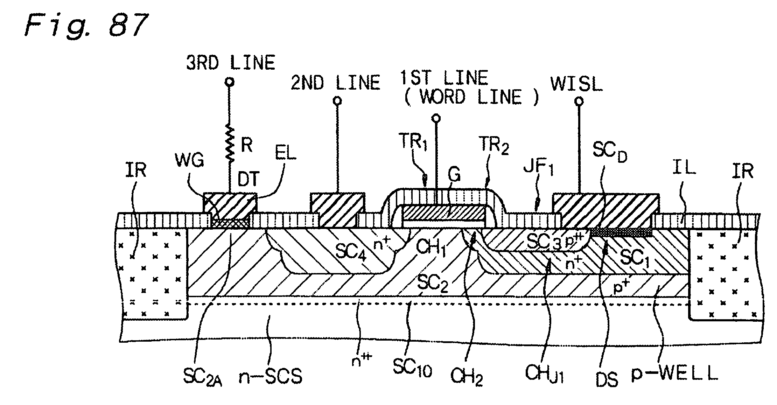

A variant of the semiconductor memory cell shown in Fig. 87 has a constitution in which the first region $SC_1$ is formed in a surface region of the second region $SC_2$, further, there is provided a diode-constituting region $SC_D$ which is formed in a surface region of the first region $SC_1$ and is in contact with the first region $SC_1$ to form a rectifier junction together with the first region $SC_1$, the diode-constituting region $SC_D$ and the first region $SC_1$ form a majority carrier diode DS, and the first region $SC_1$ is connected to the write-in information setting line WISL through the diode-constituting region $SC_D$.

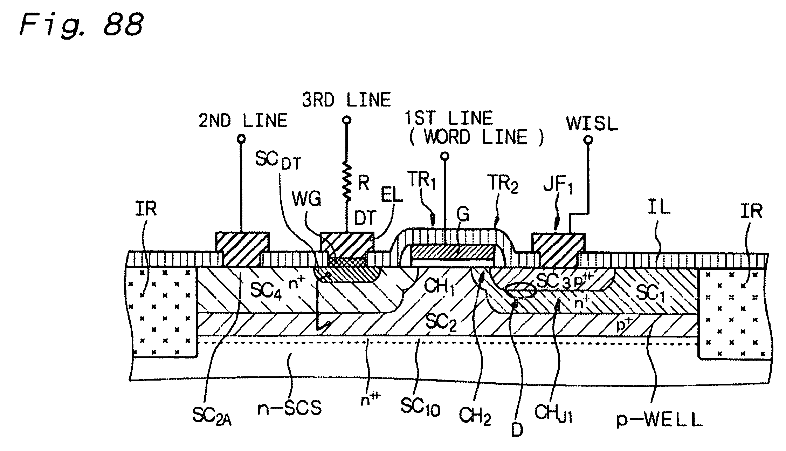

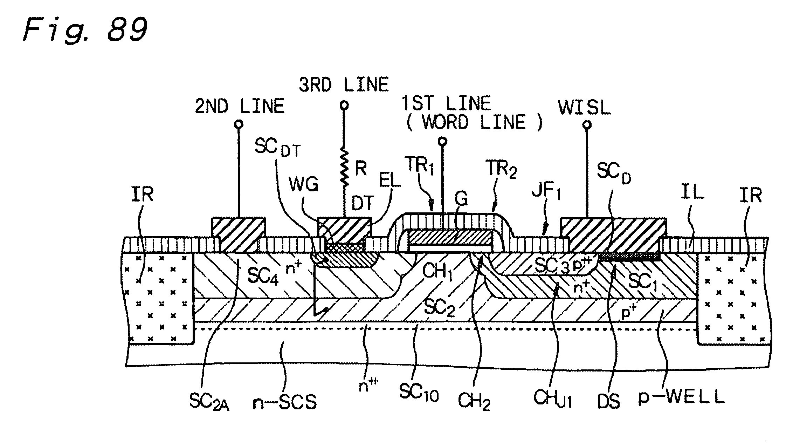

Semiconductor memory cells shown in Figs. 88 and 89 have a constitution in which the first region $SC_1$ is formed in a surface region of the second region $SC_2$, a semi-conductive MIS-type-diode constituting region $SC_{DT}$ having a second conductivity type (for example, $p^+$-type) is formed in a surface region of the fourth region $SC_4$, and the MIS-type-diode constituting region $SC_{DT}$ is connected to the second region $SC_2$. That is, the MIS-type-diode constituting region $SC_{DT}$ corresponds to the extending portion of the channel forming region $CH_1$ of the first transistor $TR_1$ or the extending portion of the second region $SC_2$. The semiconductor memory cell shown in Fig. 88 has a constitution in which the first region $SC_1$ and the third region $SC_3$ constitute a pn junction diode D, and the first region $SC_1$ is connected to the write-in information setting line WISL through the third region $SC_3$. The semiconductor memory cell shown in Fig. 89 has a constitution in which there is further provided a diode-constituting region $SC_D$ which is formed in a surface region of the first region $SC_1$ and is in contact with the first region $SC_1$ to form a rectifier junction together with the first region $SC_1$, the diode-constituting region $SC_D$ and the first region $SC_1$ constitute a majority carrier diode DS, and the first region $SC_1$ is connected to the write-in information setting line WISL through the diode-constituting region $SC_D$.

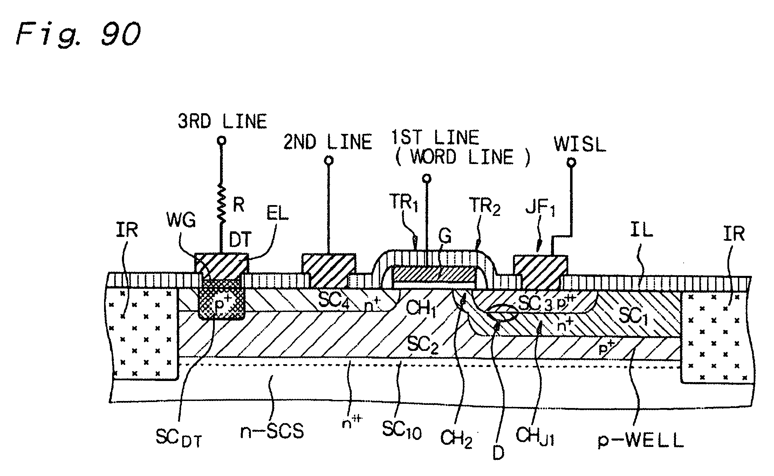

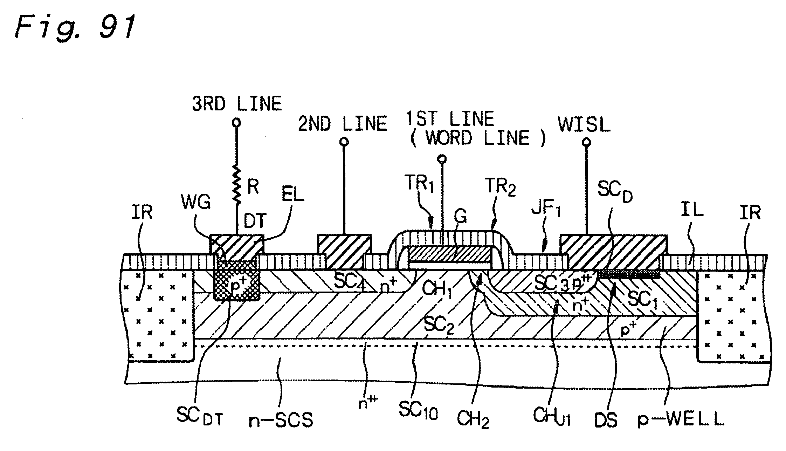

Semiconductor memory cells shown in Figs. 90 and 91 have a constitution in which the first region $SC_1$ is formed in a surface region of the second region $SC_2$, a MIS-type-diode constituting region $SC_{DT}$ having the second conductivity type (for example, $p^+$-type) is formed in a buried plug form, and the MIS-type-diode constituting region $SC_{DT}$ penetrates through the fourth region $SC_4$ until it reaches the second region $SC_2$. That is, the above MIS-type-diode constituting region $SC_{DT}$ corresponds to the extending portion of channel forming region $CH_1$ of the first transistor $TR_1$ or the extending portion of the second region $SC_2$ as well. The semiconductor memory cell shown in Fig. 90 also has a constitution in which the first region $SC_1$ and the third region $SC_3$ constitute a pn junction diode D, and the first region SC1 is connected to the write-in information setting line WISL through the third region SC3. The semiconductor memory cell shown in Fig. 91 has a constitution in which there is further provided a diode-constituting region SCD which is formed in a surface region of the first region SC1 and is in contact with the first region SC1 to form a rectifier junction together with the first region SC1, the diode-constituting region SCD and the first region SC1 constitute a majority carrier diode DS, and the first region SC1 is connected to the write-in information setting line WISL through the diode-constituting region SCD.

Example 8

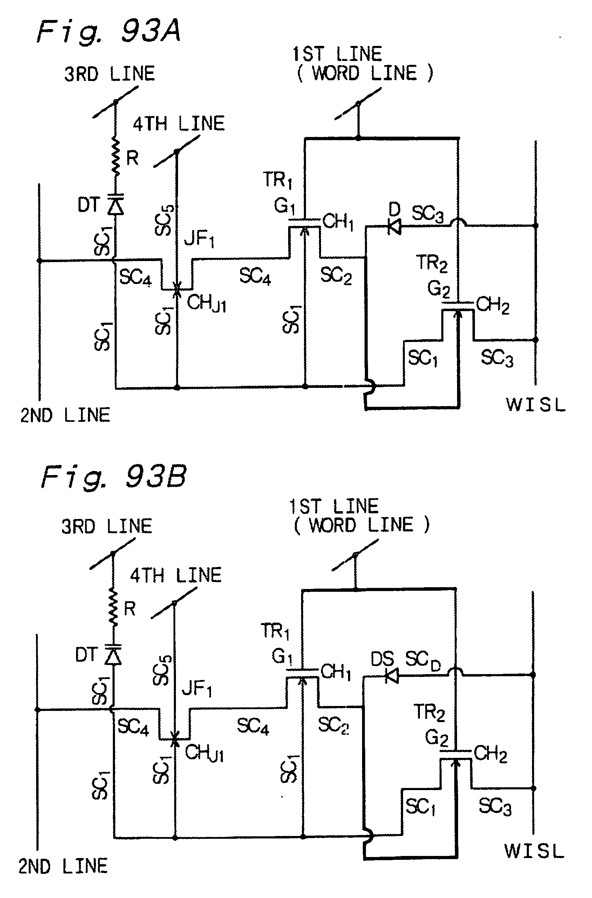

Example 8 is concerned with the semiconductor according to the sixth aspect of the present invention. As is shown in the principle drawing of Fig. 93A, the semiconductor memory cell of Example 8 comprises;

(1) a first transistor TR1 for readout, having a first conductivity type (for example, n-channel type) and having source/drain regions; a semi-conductive channel forming region CH1 which is in contact with the source/drain regions and spaces out the source/drain regions, and a gate G1 capacitively coupled with the channel forming region CH1,
(2) a second transistor TR2 for switching, having a second conductivity type (for example, p-channel type) and having source/drain regions, a semi-conductive channel forming region CH2 which is in contact with the source/drain regions and spaces out the source/drain regions, and a gate G2 capacitively coupled with the channel forming region CH2,
(3) a junction-field-effect transistor JF1 for current control, having source/drain regions, a channel region CHJ1 and gate regions, and
(4) an MIS type diode DT for retaining information.

In the above semiconductor memory cell,
one source/drain region of the first transistor $TR_1$ corresponds to the channel forming region $CH_2$ of the second transistor $TR_2$,
the other source/drain region of the first transistor $TR_1$ corresponds to one source/drain region of the junction-field-effect transistor $JF_1$,
one source/drain region of the second transistor $TR_2$ corresponds to the channel forming region $CH_1$ of the first transistor $TR_1$ and also corresponds to one gate region of the junction-field-effect transistor $JF_1$,
one end of the MIS type diode DT is formed of an extending portion of the channel forming region $CH_1$ of the first transistor $TR_1$, and the other end of the MIS type diode DT is formed of an electrode EL composed of a conductive material and is connected to the line (third line) having a predetermined potential. In Example 8, the first transistor $TR_1$ and the second transistor $TR_2$ are constituted of substantially separate transistors, respectively.

Further, the gate $G_1$ of the first transistor $TR_1$ and the gate $G_2$ of the second transistor $TR_2$ are connected to a first line (for example, word line) for memory cell selection, the other source/drain region of the first transistor $TR_1$ is connected to a second line through the junction-field-effect transistor $JF_1$, the other gate region of the junction-field-effect transistor $JF_1$ is connected to a fourth line, one source/drain region of the first transistor $TR_1$ is connected to a write-in information setting line WISL through a diode D, the other source/drain region of the second transistor $TR_2$ is

connected to the write-in information setting line WISL, and the other end of the MIS type diode DT is connected to a third line (corresponding to the above line) having a predetermined potential through a high-resistance element R. It is preferred to employ a constitution in which the second line is used as a bit line, or a constitution in which the write-in information setting line WISL is used as a bit line as well and a second predetermined potential is applied to the second line.

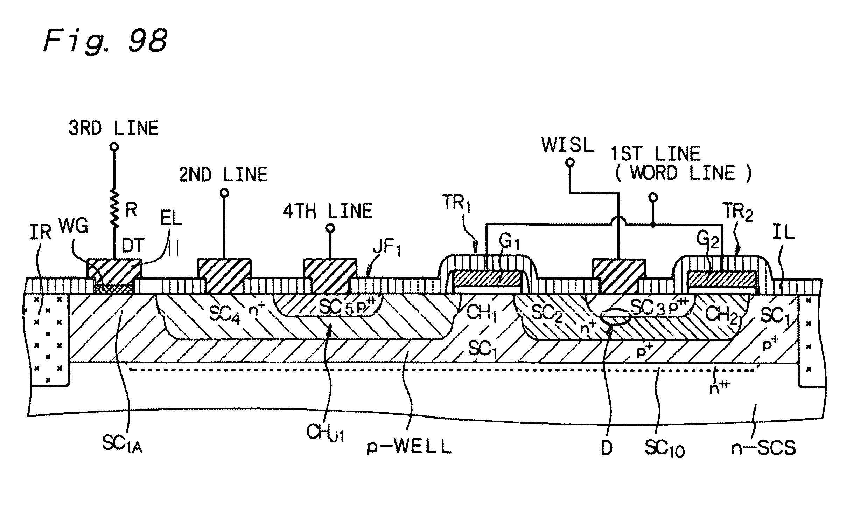

As shown in the schematic partial cross-sectional view of Fig. 98, the semiconductor memory cell of Example 8 differs from the semiconductor memory cell of Example 5 in a position where the junction-field-effect transistor $JF_1$ is formed. That is, the semiconductor memory cell of Example 8 comprises;

(1) a first transistor $TR_1$ for readout, having a first conductivity type (for example, n-channel type) and having source/drain regions, a semi-conductive channel forming region $CH_1$ which is in contact with the source/drain regions and spaces out the source/drain regions, and a gate $G_1$ capacitively coupled with the channel forming region $CH_1$,
(2) a second transistor $TR_2$ for switching, having a second conductivity type (for example, p-channel type) and having source/drain regions, a semi-conductive channel forming region $CH_2$ which is in contact with the source/drain regions and spaces out the source/drain regions, and a gate $G_2$ capacitively coupled with the channel forming region $CH_2$,
(3) a junction-field-effect transistor $JF_1$ for current control, having source/drain regions, a channel region $CH_{J1}$ and gate regions, and
(4) an MIS type diode DT for retaining information.

The semiconductor memory cell has;

(a) a semi-conductive first region $SC_1$ having a second conductivity type (for example, $p^+$-type),
(b) a semi-conductive second region $SC_2$ which is formed in a surface region of the first region $SC_1$ and has a first conductivity type (for example, $n^+$-type),
(c) a third region $SC_3$ which is formed in a surface region of the second region $SC_2$ and is in contact with the second region $SC_2$ so as to form a rectifier junction together with the second region $SC_2$, the third region $SC_3$ being a region which is semi-conductive and has the second conductivity type (for example, $p^{++}$-type) or which is formed of a silicide, a metal or a metal compound and is conductive,
(d) a semi-conductive fourth region $SC_4$ which is formed in a surface region of the first region $SC_1$ to be spaced from the second region $SC_2$ and has the first conductivity type (for example, $n^+$-type), and
(e) a fifth region $SC_5$ which is formed in a surface region of the fourth region $SC_4$ and is in contact with the fourth region $SC_4$ so as to form a rectifier junction together with the fourth region $SC_4$, the fifth region $SC_5$ being a region which is semi-conductive and has the second conductivity type (for example, $p^{++}$-type) or which is formed of a silicide, a metal or a metal compound and is conductive.

Concerning the first transistor $TR_1$,

(A-1) one source/drain region is formed of a portion of a surface region of the second region $SC_2$,
(A-2) the other source/drain region is formed of a surface region of the fourth region $SC_4$,
(A-3) the channel forming region $CH_1$ is formed of a portion of a surface region of the first region $SC_1$ which portion is interposed between said portion of the surface region of the second region $SC_2$ and the surface region of the fourth region $SC_4$, and
(A-4) the gate $G_1$ is formed on the channel forming region $CH_1$ of the first transistor $TR_1$ through an insulation layer.

Concerning the second transistor $TR_2$,

(B-1) one source/drain region is formed of other portion of the surface region of the first region $SC_1$,
(B-2) the other source/drain region is formed of the third region $SC_3$,
(B-3) the channel forming region $CH_2$ is formed of other portion of the surface region of the second region $SC_2$ which other portion is interposed between said other portion of the surface region of the first region $SC_1$ and the third region $SC_3$, and
(B-4) the gate $G_2$ is formed on the channel forming region $CH_2$ of the second transistor $TR_2$ through an insulation layer.

Further, concerning the junction-field-effect transistor $JF_1$,

(C-1) the gate regions are formed of the fifth region $SC_5$ and part of the first region $SC_1$ which part is opposed to the fifth region $SC_5$,
(C-2) the channel region $CH_{J1}$ is formed of part of the fourth region $SC_4$ which part is interposed between the fifth

region $SC_5$ and said part of the first region $SC_1$,

(C-3) one source/drain region is formed of the surface region of the fourth region $SC_4$ which surface region extends from one end of the channel region $CH_{J1}$ of the junction-field-effect transistor $JF_1$ and constitutes the other source/drain region of the first transistor $TR_1$, and

(C-4) the other source/drain region is formed of a portion of the fourth region $SC_4$ which portion extends from the other end of the channel region $CH_{J1}$ of the junction-field-effect transistor $JF_1$.

Concerning the MIS type diode DT,

(D-1) one end thereof is formed of part $SC_{1A}$ of the first region $SC_1$, and

(D-2) an electrode constituting the other end thereof is formed to be opposed to said part $SC_{1A}$ of the first region $SC_1$ which part constitutes one end of the MIS type diode DT, through a wide gap thin film WG.

The wide gap thin film WG can be composed of a material in which the tunnel transition of carriers is caused depending upon a potential difference between the potential in the first region $SC_1$ (the channel forming region $CH_1$ of the first transistor $TR_1$) and the potential in the other end (electrode EL) of the MIS type diode DT. Specifically, it can be composed, for example, of an $SiO_2$ or SiON film having a thickness of 5 nm or smaller, or an SiN film having a thickness of 9 nm or smaller.

The electrode EL constituting the other end of the MIS type diode DT is connected to the line (third line) through the high-resistance element R having a resistance of approximately $10^9$ to $10^{12}$ $\Omega$. Specifically, the electrode EL constituting the other end of the MIS type diode DT and the high-resistance element R are integrally formed and are composed of a polysilicon thin layer containing an impurity having the first conductivity type.

In the above semiconductor memory cell, further,

(E) the gate $G_1$ of the first transistor $TR_1$ and the gate $G_2$ of the second transistor $TR_2$ are connected to a first line (for example, word line) for memory cell selection,

(F) the third region $SC_3$ is connected to a write-in information setting line WISL,

(G) the portion of the fourth region $SC_4$ which portion constitutes the other source/drain region of the junction-field-effect transistor $JF_1$ is connected to a second line,

(H) the electrode EL constituting the other end of the MIS type diode DT is connected to a third line having a predetermined potential, and

(I) the fifth region $SC_5$ is connected to a fourth line.

In the semiconductor memory cell of Example 8, the second region $SC_2$ and the third region $SC_3$ constitute a pn junction diode D, and the second region $SC_2$ is connected to the write-in information setting line WISL through the third region $SC_3$. The above pn junction diode D can be formed by adjusting the impurity concentrations of the second region $SC_2$ and the third region $SC_3$ to proper values. It is preferred to employ a constitution in which the second line is used as a bit line, or a constitution in which the write-in information setting line WISL is used as a bit line as well and a second predetermined potential is applied to the second line.

The junction-field-effect transistor $JF_1$ is formed by

(X) optimizing the distance between the facing gate regions (the fifth region $SC_5$ and the part of the first region $SC_1$ which part is opposed to the fifth region $SC_5$), that is, the thickness of the channel region $CH_{J1}$, and

(Y) optimizing the impurity concentration of each of the facing gate regions (the fifth region $SC_5$ and the part of the first region $SC_1$ which part is opposed to the fifth region $SC_5$) and the impurity concentration of the channel region $CH_{J1}$.

In Example 8, the semiconductor memory cell (specifically, the first region $SC_1$) is formed in a well structure which is formed, for example, in an n-type semiconductor substrate and has the second conductivity type (for example, p-type).

In the semiconductor memory cell of Example 8, when a first high-concentration-impurity-containing layer $SC_{10}$ having the first conductivity type (for example, $n^{++}$-type) is formed below the first region $SC_1$, the potential or charge to be stored in the channel forming region $CH_1$ of the first transistor $TR_1$ for readout can be increased.

In the semiconductor memory cell shown in Fig. 98, as is shown in the principle drawing of Fig. 92, there may be employed an embodiment in which the formation of the pn junction diode D is omitted and the second region $SC_2$ corresponding to one source/drain region of the first transistor $TR_1$ is connected to a fifth line (not shown in Fig. 98). In this case, it is preferred to employ a constitution in which the second line is used as a bit line and a second predetermined potential is applied to the fifth line, or a constitution in which the fifth line is used as a bit line and a second predetermined potential is applied to the second line.

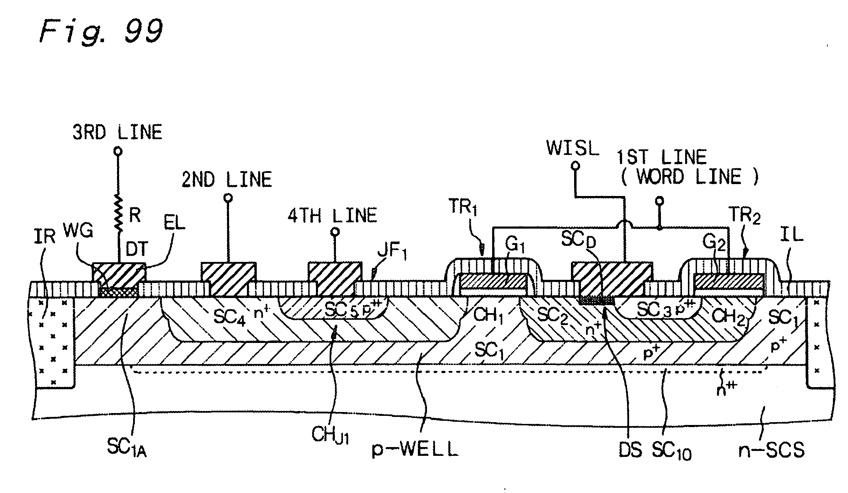

Figs. 99 to 103 show variants of the semiconductor memory cell shown in Fig. 98.

In the semiconductor memory cell shown in the principle drawing of Fig. 93B and the schematic partial cross-sectional view of Fig. 99, there is further provided a diode-constituting region $SC_D$ which is formed in a surface region of the second region $SC_2$ and is in contact with the second region $SC_2$ to form a rectifier junction together with the second region $SC_2$, and the diode-constituting region $SC_D$ and the second region $SC_2$ constitute a majority carrier diode DS of a Schottky junction type. One source/drain region of the first transistor $TR_1$ is connected to the write-in information setting line WISL through the majority carrier diode DS of a Schottky junction type in place of being connected to the fifth line. That is, the second region $SC_2$ is connected to the write-in information setting line WISL through the diode-constituting region $SC_D$. In the semiconductor memory cell shown in Fig. 99, the diode-constituting region $SC_D$ is formed adjacently to the third region $SC_3$, while the position of the diode-constituting region $SC_D$ shall not be limited thereto. It is preferred to employ a constitution in which the second line is used as a bit line, or a constitution in which the write-in information setting line WISL is used as a bit line as well and a second predetermined potential is applied to the second line.

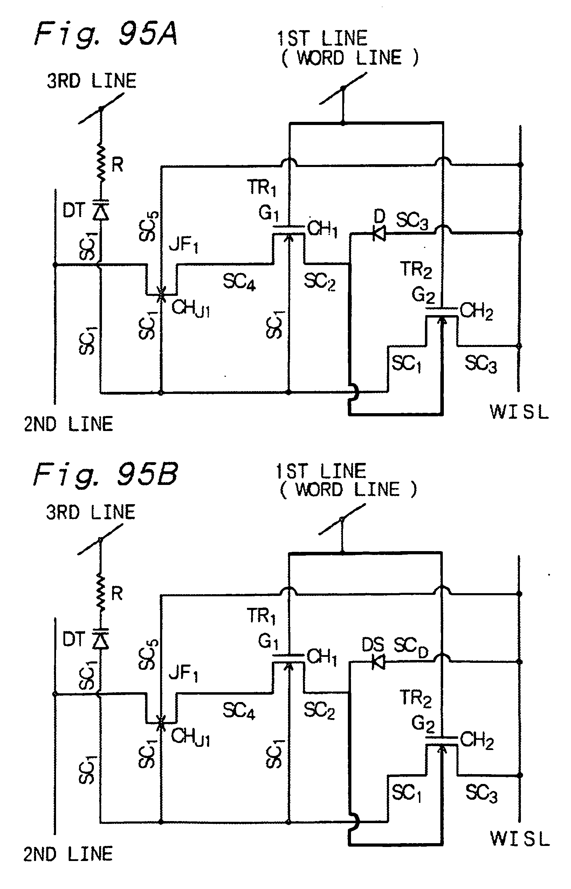

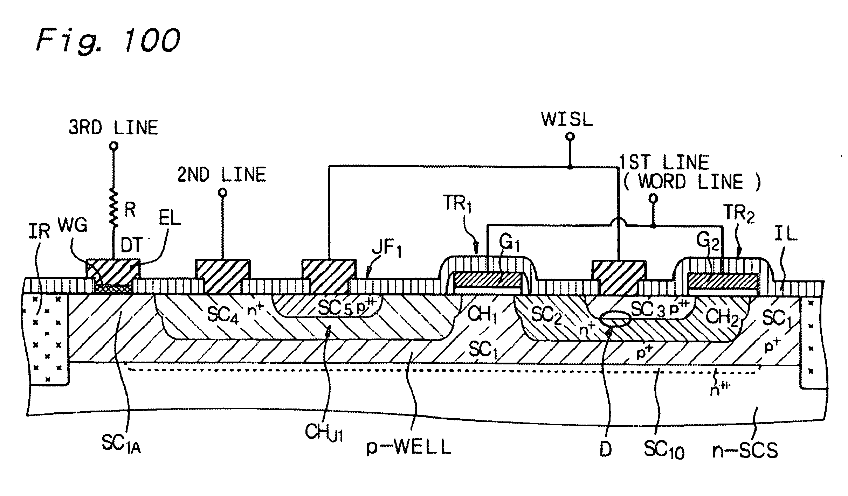

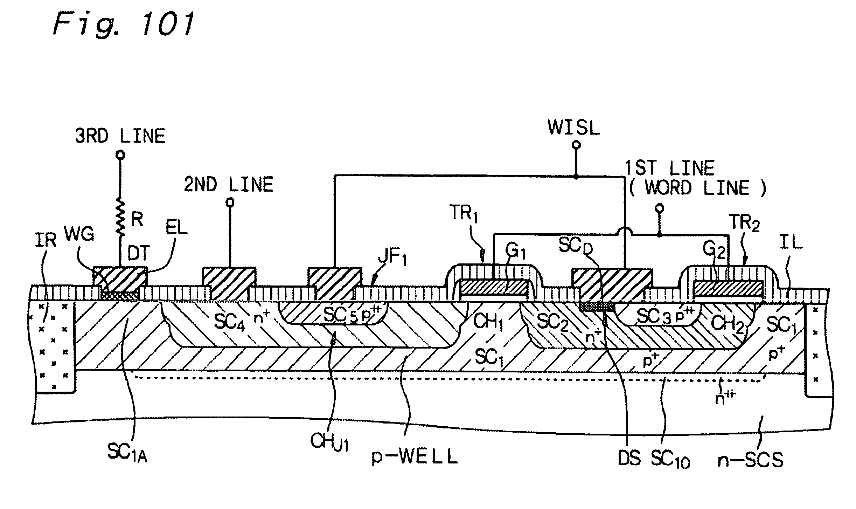

As is shown in the principle drawings of Figs. 95A and 95B, the other gate region of the junction-field-effect transistor $JF_1$ may be connected to the write-in information setting line WISL in place of being connected to the fourth line. That is, as is shown in the schematic partial cross-sectional views of Figs. 100 and 101, the fifth region $SC_5$ may be connected to the write-in information setting line WISL in place of being connected to the fourth line. The semiconductor memory cell shown in Fig. 10 is a variant of the semiconductor memory cell shown in Fig. 98, and the semiconductor memory cell shown in Fig. 101 is a variant of the semiconductor memory cell shown in Fig. 99.

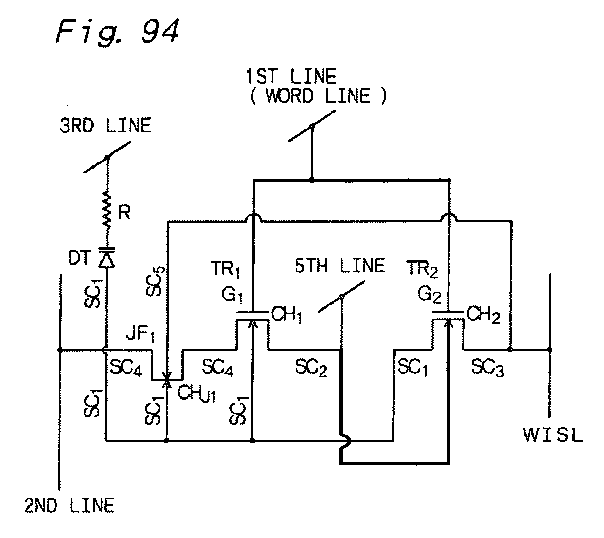

As is shown in the principle drawing of Fig. 94, there may be employed a constitution in which the formation of the pn junction diode D is omitted and the second region $SC_2$ corresponding to one source/drain region of the first transistor $TR_1$ is connected to a fifth line (not shown in Fig. 100). In this case, it is preferred to employ a constitution in which the second line is used as a bit line and a second predetermined potential is applied to the fifth line, or a constitution in which the fifth line is used as a bit line and a second predetermined potential is applied to the second line.

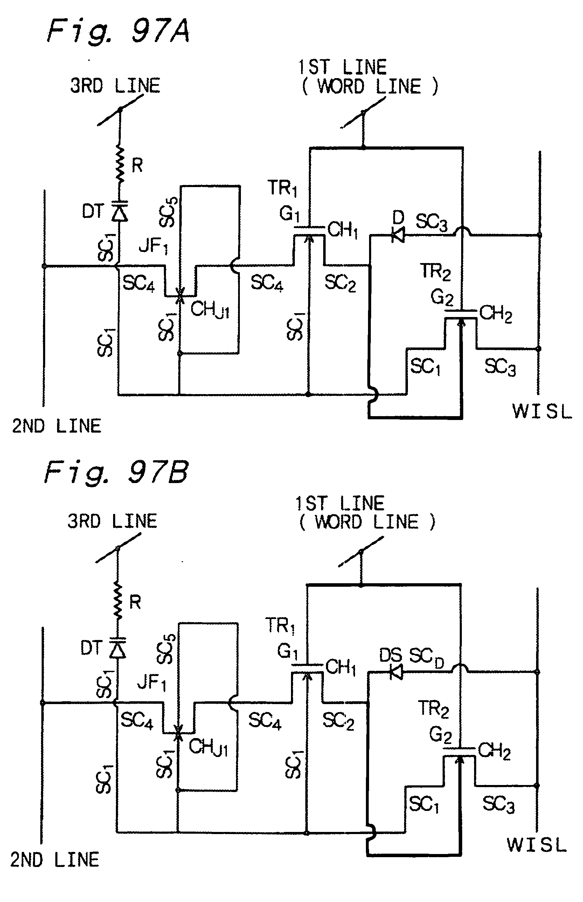

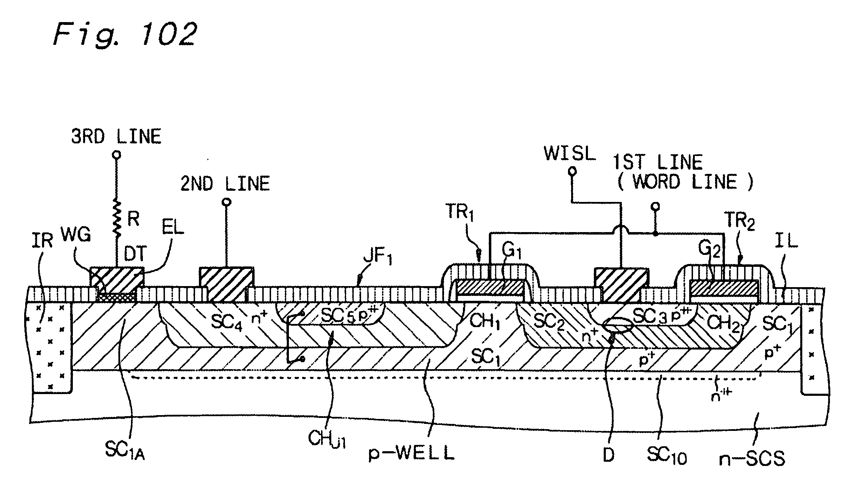

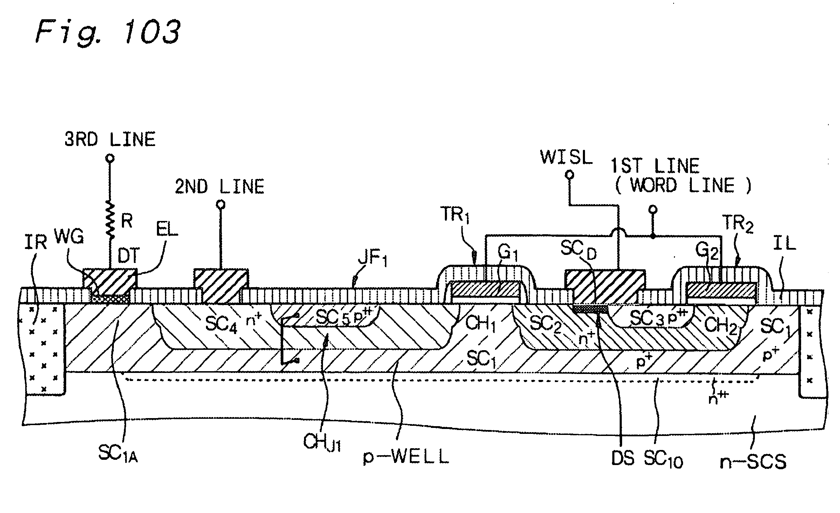

In semiconductor memory cells shown in the principle drawings of Figs. 97A and 97B and the schematic partial cross-sectional views of Figs. 102 and 103, the fifth region $SC_5$ is connected to the first region $SC_1$ in place of being connected to the fourth line. That is, the other gate region of the junction-field-effect transistor $JF_1$ is connected to one gate region of the junction-field-effect transistor $JF_1$ in place of being connected to the fourth line. Further, in the semiconductor memory cell shown in the schematic partial cross-sectional view of Fig. 102, the second region $SC_2$ and the third region $SC_3$ constitute a pn junction diode D, and the second region $SC_2$ is connected to the write-in information setting line WISL through the third region SC3. In the semiconductor memory cell shown in the schematic partial cross-sectional view of Fig. 103, there is further provided a diode-constituting region SCD which is formed in a surface region of the second region SC2 and is in contact with the second region SC2 to form a rectifier junction together with the second region SC2, the diode-constituting region SCD and the second region SC2 constitute a majority carrier diode DS of a Schottky junction type, and the second region SC2 is connected to the write-in information setting line WISL through the diode-constituting region SCD. In the above embodiments in which the diode or the majority carrier diode is provided, it is preferred to employ a constitution in which the second line is used as a bit line, or a constitution in which the write-in information setting line WISL is used as a bit line as well and a second predetermined potential is applied to the second line.

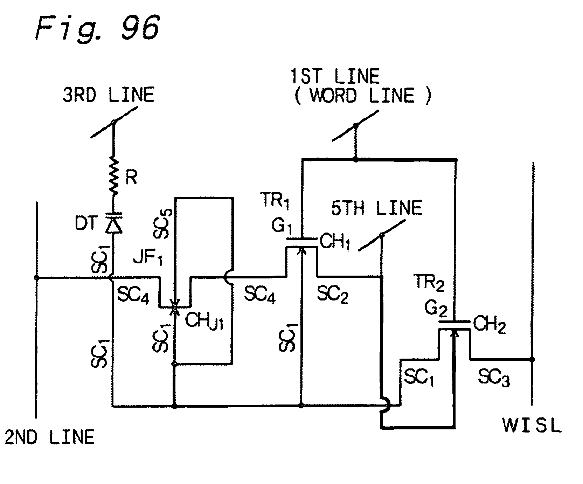

As is shown in the principle drawing of Fig. 96, there may be employed a constitution in which the formation of the pn junction diode D is omitted and the second region SC2 corresponding to one source/drain region of the first transistor TR1 is connected to a fifth line (not shown in Fig. 102). In this case, it is preferred to employ a constitution in which the second line is used as a bit line and a second predetermined potential is applied to the fifth line, or a constitution in which the fifth line is used as a bit line and a second predetermined potential is applied to the second line.

Example 9

Example 9 is concerned with the semiconductor memory cell according to the sixth aspect of the present invention. In the semiconductor memory cell of Example 9, the other gate region of the junction-field-effect transistor $JF_1$ in place of being connected to the fourth line. More specifically, one end of the MIS type diode DT and the other gate region of the junction-field-effect transistor $JF_1$ are formed as a common region. Further, the fifth region $SC_5$ constituting the other gate region of the junction-field-effect transistor $JF_1$ corresponds to an extending portion of the channel forming region $CH_1$ of the first transistor $TR_1$.

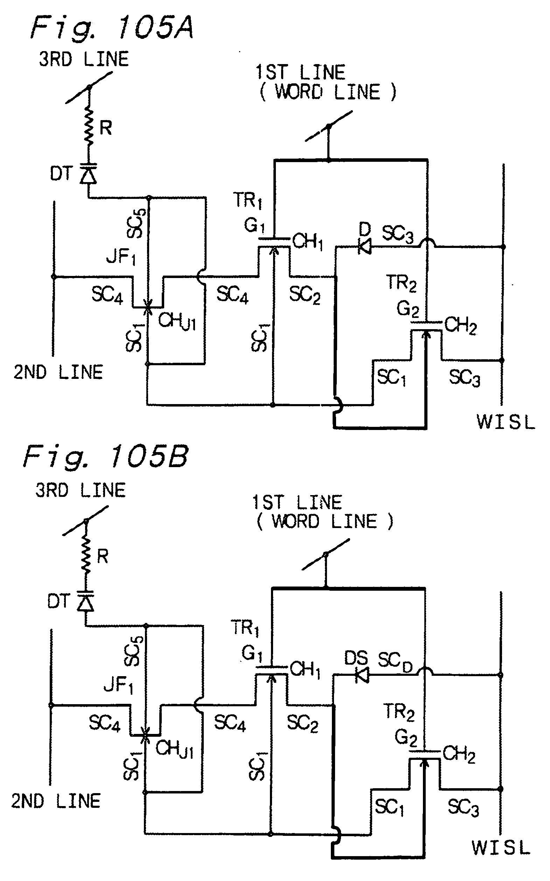

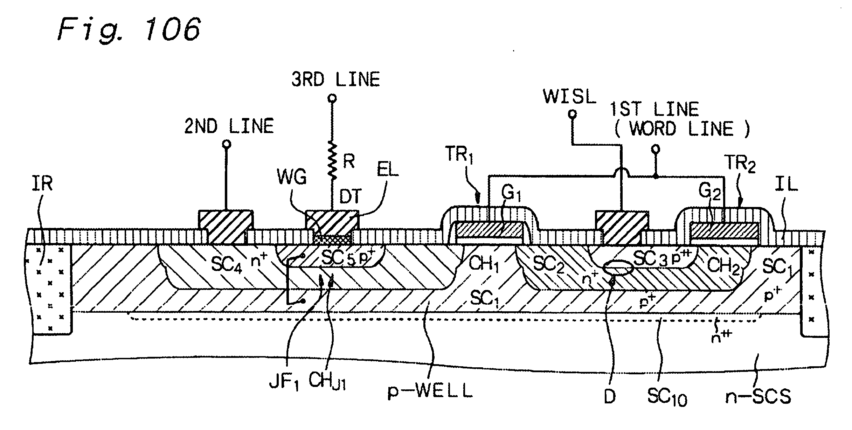

That is, as is shown in the schematic partial cross-sectional view of Fig. 106 and the principle drawing of Fig. 105A, the semiconductor memory cell of Example 9 comprises;

(1) a first transistor $TR_1$ for readout, having a first conductivity type (for example, n-channel type), and having source/drain regions, a semi-conductive channel forming region $CH_1$ which is in contact with the source/drain regions and spaces out the source/drain regions, and a gate $G_1$ capacitively coupled with the channel forming region $CH_1$,

(2) a second transistor $TR_2$ for switching, having a second conductivity type (for example, p-channel type), and having source/drain regions, a semi-conductive channel forming region $CH_2$ which is in contact with the source/drain regions and spaces out the source/drain regions, and a gate $G_2$ capacitively coupled with the channel forming region $CH_2$,

(3) a junction-field-effect transistor $JF_1$ for current control, having source/drain regions, a channel region $CH_{J1}$ and gate regions, and

(4) an MIS type diode DT for retaining information,

the semiconductor memory cell having;

(a) a semi-conductive first region $SC_1$ having a second conductivity type (for example, $p^+$-type),

(b) a semi-conductive second region $SC_2$ which is formed in a surface region of the first region $SC_1$ and has a first conductivity type (for example, $n^+$-type),

(c) a third region $SC_3$ which is formed in a surface region of the second region $SC_2$ and is in contact with the second region $SC_2$ so as to form a rectifier junction together with the second region $SC_2$, the third region $SC_3$ being a region which is semi-conductive and has the second conductivity type (for example, $p^{++}$-type) or which is conductive and is composed of a silicide, a metal or a metal compound,

(d) a semi-conductive fourth region $SC_4$ which is formed in a surface region of the first region $SC_1$ to be spaced from the second region $SC_2$ and has the first conductivity type (for example, $n^+$-type), and

(e) a semi-conductive fifth region $SC_5$ which is formed in a surface region of the fourth region $SC_4$ and has the second conductivity type (for example, $p^{++}$-type).

Concerning the first transistor $TR_1$,

(A-1) one source/drain region is formed of a portion of a surface region of the second region $SC_2$,

(A-2) the other source/drain region is formed of a surface region of the fourth region $SC_4$,

(A-3) the channel forming region $CH_1$ is formed of a portion of a surface region of the first region $SC_1$ which portion is interposed between said portion of the surface region of the second region $SC_2$ and the surface region of the fourth region $SC_4$, and

(A-4) the gate $G_1$ is formed on the channel forming region $CH_1$ through an insulation layer.

Concerning the second transistor $TR_2$,

(B-1) one source/drain region is formed of other portion of the surface region of the first region $SC_1$,

(B-2) the other source/drain region is formed of the third region $SC_3$,

(B-3) the channel forming region $CH_2$ is formed of other portion of the surface region of the second region $SC_2$ which other portion is interposed between said other portion of the surface region of the first region $SC_1$ and the third region $SC_3$, and

(B-4) the gate $G_2$ is formed on the channel forming region $CH_2$ through an insulation layer.

Concerning the junction-field-effect transistor $JF_1$,

(C-1) the gate regions are formed of the fifth region $SC_5$ and part of the first region $SC_1$ which part is opposed to the fifth region $SC_5$,

(C-2) the channel region $CH_{J1}$ is formed of part of the fourth region $SC_4$ which part is interposed between the fifth region $SC_5$ and said part of the first region $SC_1$,

(C-3) one source/drain region is formed of the surface region of the fourth region $SC_4$ which surface region extends from one end of the channel region $CH_{J1}$ of the junction-field-effect transistor $JF_1$ and constitutes the other source/drain region of the first transistor $TR_1$, and

(C-4) the other source/drain region is formed of a portion of the fourth region $SC_4$ which portion extends from the other end of the channel region $CH_{J1}$ of the junction-field-effect transistor $JF_1$.

Concerning the MIS type diode DT,

(D-1) one end thereof is formed of the fifth region $SC_5$, and

(D-2) an electrode constituting the other end thereof is formed to be opposed to the fifth region $SC_5$ which constitutes one end of the MIS type diode DT, through a wide gap thin film WG.

The wide gap thin film WG can be composed of a material in which the tunnel transition of carriers is caused depending upon a potential difference between the potential in the fifth region $SC_5$ (corresponding to the extending portion of the channel forming region $CH_1$ of the first transistor $TR_1$) and the potential in the other end (electrode EL) of the MIS type diode DT. Specifically, it can be composed, for example, of an $SiO_2$ or SiON film having a thickness of 5 nm or smaller, or an SiN film having a thickness of 9 nm or smaller.

The electrode EL constituting the other end of the MIS type diode DT is connected to the line (third line) through a high-resistance element R having a resistance of approximately $10^9$ to $10^{12}$ Ω. Specifically, the electrode EL constituting the other end of the MIS type diode DT and the high-resistance element R are integrally formed and are composed of a polysilicon thin layer containing an impurity having the first conductivity type.

In the above semiconductor memory cell, further,

(E) the gate $G_1$ of the first transistor $TR_1$ and the gate $G_2$ of the second transistor $TR_2$ are connected to a first line (for example, word line) for memory cell selection,
(F) the third region $SC_3$ is connected to a write-in information setting line WISL,
(G) the portion of the fourth region $SC_4$ which portion constitutes the other source/drain region of the junction-field-effect transistor $JF_1$ is connected to a second line,
(H) the fifth region $SC_5$ is connected to the first region $SC_1$, and
(I) the electrode EL constituting the other end of the MIS type diode DT is connected to a third line having a predetermined potential.

In the semiconductor memory cell of Example 9, the second region $SC_2$ and the third region $SC_3$ constitute a pn junction diode D, and the second region $SC_2$ is connected to the write-in information setting line WISL through the third region $SC_3$. The above pn junction diode D can be formed by adjusting the impurity concentrations of the second region $SC_2$ and the third region $SC_3$ to proper values. It is preferred to employ a constitution in which the second line is used as a bit line, or a constitution in which the write-in information setting line WISL is used as a bit line as well and a second predetermined potential is applied to the second line.

The junction-field-effect transistor $JF_1$ is formed by

(X) optimizing the distance between the facing gate regions (the fifth region $SC_5$ and the part of the first region $SC_1$ which part is opposed to the fifth region $SC_5$), that is, the thickness of the channel region $CH_{J1}$), and
(Y) optimizing the impurity concentration of each of the facing gate regions (the fifth region $SC_5$ and the part of the first region $SC_1$ which part is opposed to the fifth region $SC_5$) and the impurity concentration of the channel region $CH_{J1}$.

In Example 9, the semiconductor memory cell (specifically, the first region $SC_1$) is formed in a well structure which is formed, for example, in an n-type semiconductor substrate and has the second conductivity type (for example, p-type).

In the semiconductor memory cell of Example 9, when a first high-concentration-impurity-containing layer $SC_{10}$ having the first conductivity type (for example, $n^{++}$-type) is formed below the first region $SC_1$, the potential or charge to be stored in the channel forming region $CH_1$ of the first transistor $TR_1$ for readout can be increased.

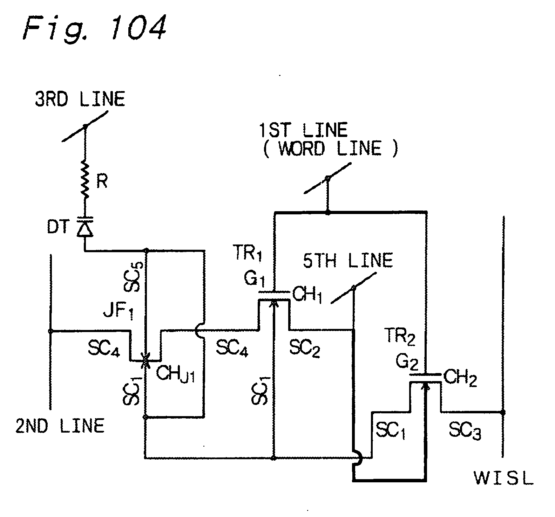

In the semiconductor memory cell shown in Fig. 106, as is shown in the principle drawing of Fig. 104, there may be employed an embodiment in which the formation of the pn junction diode D is omitted and the second region $SC_2$ corresponding to one source/drain region of the first transistor $TR_1$ is connected to a fifth line (not shown in Fig. 106). In this case, it is preferred to employ a constitution in which the second line is used as a bit line and a second predetermined potential is applied to the fifth line, or a constitution in which the fifth line is used as a bit line and a second predetermined potential is applied to the second line.

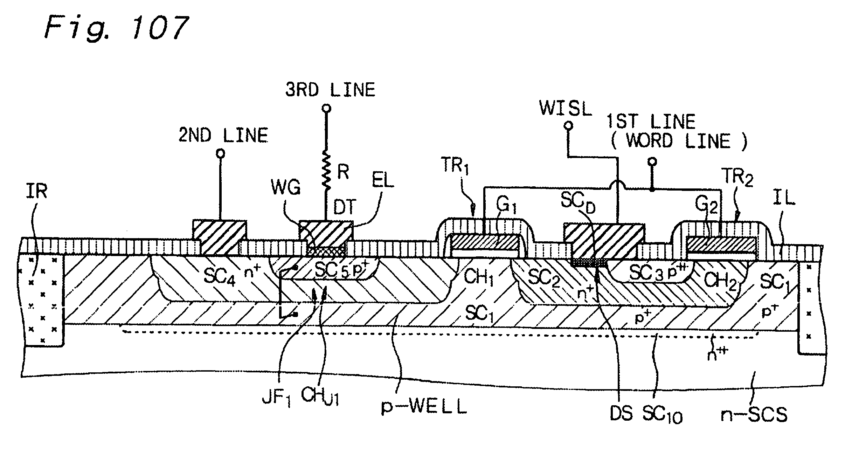

In a semiconductor memory cell shown in the principle drawing of Fig. 105B and the schematic partial cross-sectional view of Fig. 107, there is further provided a diode-constituting region SCD which is formed in a surface region of the second region SC2 and is in contact with the second region SC2 to form a rectifier junction together with the second region SC2, and the diode-constituting region SCD and the second region SC2 constitute a majority carrier diode DS of a Schottky junction type. One source/drain region of the first transistor TR1 is connected to the write-in information setting line WISL through the majority carrier diode DS of a Schottky junction type in place of being connected to the fifth line. That is, the second region SC2 is connected to the write-in information setting line WISL through the diode-constituting region SCD. In the semiconductor memory cell shown in Fig. 107, the diode-constituting region SCD is formed adjacently to the third region SC3, while the position of the diode-constituting region SCD shall not be limited thereto. It is preferred to employ a constitution in which the second line is used as a bit line, or a constitution in which the write-in information setting line WISL is used as a bit line as well and a second predetermined potential is applied to the second line.

Example 10

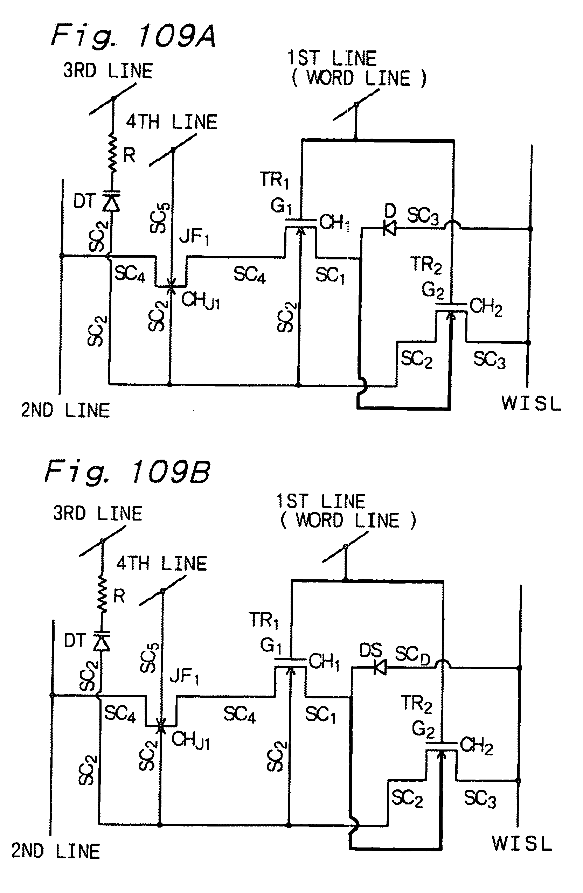

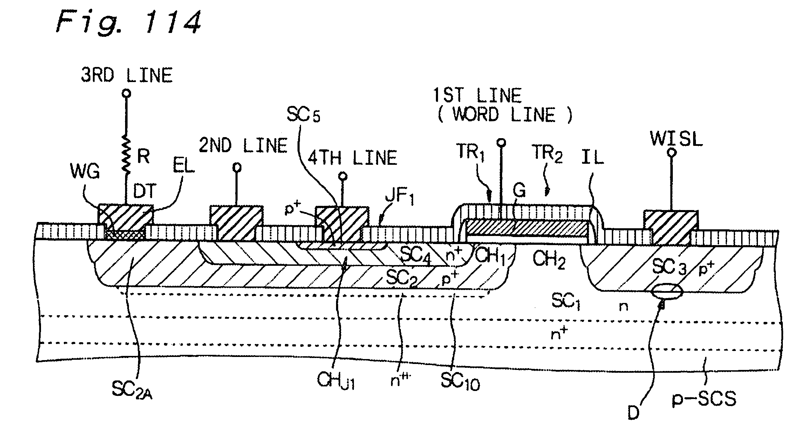

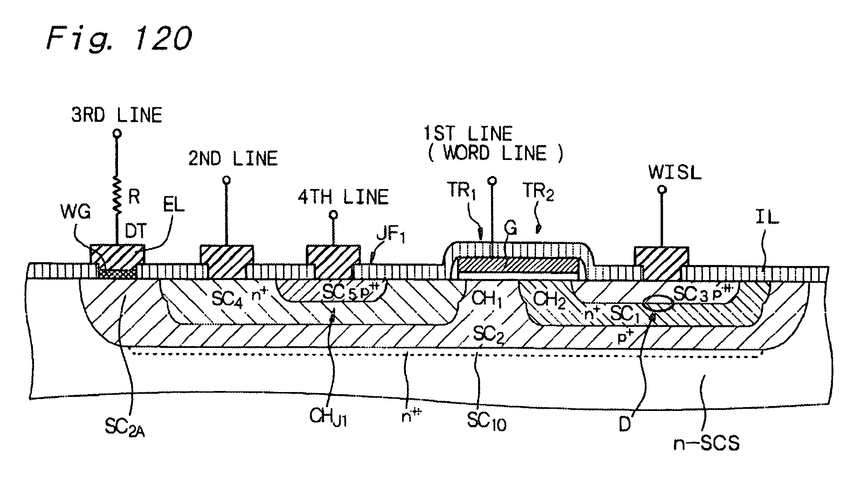

Example 10 is concerned with the semiconductor memory cell according to the sixth aspect of the present invention. The semiconductor memory cell of Example 10 differs from the semiconductor memory cell of Example 8 in that the gate is shared by the first transistor TR1 and the second transistor TR2. That is, as is shown in the schematic partial cross-sectional view of Fig. 114 or 120 and the principle drawing of Fig. 109A, the semiconductor memory cell of Example 10 comprises;

(1) a first transistor $TR_1$ for readout, having a first conductivity type (for example, n-channel type) and having source/drain regions, a semi-conductive channel forming region $CH_1$ which is in contact with the source/drain regions and spaces out the source/drain regions, and a gate G capacitively coupled with the channel forming region $CH_1$,
(2) a second transistor $TR_2$ for switching, having a second conductivity type (for example, p-channel type), and having source/drain regions, a semi-conductive channel forming region $CH_2$ which is in contact with the source/drain regions and spaces out the source/drain regions, and a gate G capacitively coupled with the channel forming region $CH_2$,
(3) a junction-field-effect transistor $JF_1$ for current control, having source/drain regions, a channel region $CH_{J1}$ and gate regions, and
(4) an MIS type diode DT for retaining information,
the semiconductor memory cell having;

(a) a semi-conductive first region $SC_1$ having a first conductivity type (for example, n-type),
(b) a semi-conductive second region $SC_2$ which is in contact with the first region $SC_1$ and has a second conductivity type (for example, $p^+$-type),
(c) a third region $SC_3$ which is formed in a surface region of the first region $SC_1$ and is in contact with the first region $SC_1$ so as to form a rectifier junction together with the first region $SC_1$, the third region $SC_3$ being a region which is semi-conductive and has the second conductivity type (for example, $p^+$-type) or which is conductive and composed of a silicide, a metal or a metal compound,
(d) a semi-conductive fourth region $SC_4$ which is formed in a surface region of the second region $SC_2$ and has the first conductivity type (for example, $n^+$-type),
(e) a fifth region $SC_5$ which is formed in a surface region of the fourth region $SC_4$ and is in contact with the fourth region $SC_4$ so as to form a rectifier junction together with the fourth region $SC_4$, the fifth region $SC_5$ being a region which is semi-conductive and has the second conductivity type (for example, $p^+$-type) or which is conductive and composed of a silicide, a metal or a metal compound, and
(f) the gate G which is formed, through an insulation layer, so as to bridge the first region $SC_1$ and the fourth region $SC_4$ and so as to bridge the second region $SC_2$ and the third region $SC_3$, and is shared by the first transistor $TR_1$ and the second transistor $TR_2$.

In the semiconductor memory cell shown in Fig. 114, the first region $SC_2$ and the second region $SC_2$ are in contact with each other, while, specifically, the second region $SC_2$ is formed in a surface region of the first region $SC_1$. In the semiconductor memory cell shown in Fig. 120, the first region $SC_1$ is formed in a surface region of the second region $SC_2$.
Concerning the first transistor $TR_1$,

(A-1) one source/drain region is formed of a surface region of the first region $SC_1$,
(A-2) the other source/drain region is formed of a surface region of the fourth region $SC_4$, and
(A-3) the channel forming region $CH_1$ is formed of a surface region of the second region $SC_2$ which surface region is interposed between the surface region of the first region $SC_1$ and the surface region of the fourth region $SC_4$.

Concerning the second transistor $TR_2$,

(B-1) one source/drain region is formed of the surface region of the second region $SC_2$ which surface region constitutes the channel forming region $CH_1$ of the first transistor $TR_1$,
(B-2) the other source/drain region is formed of the third region $SC_3$, and
(B-3) the channel forming region $CH_2$ is formed of the surface region of the first region $SC_1$ which surface region constitutes one source/drain region of the first transistor $TR_1$.

Concerning the junction-field-effect transistor $JF_1$,

(C-1) the gate regions are formed of the fifth region $SC_5$ and part of the second region $SC_2$ which part is opposed to the fifth region $SC_5$,

(C-2) the channel region $CH_{J1}$ is formed of part of the fourth region $SC_4$ which part is interposed between the fifth region $SC_5$ and said part of the second region $SC_2$,

(C-3) one source/drain region is formed of the surface region of the fourth region $SC_4$ which surface region extends from one end of the channel region $CH_{J1}$ of the junction-field-effect transistor $JF_1$ and constitutes the other source/drain region of the first transistor $TR_1$, and

(C-4) the other source/drain region is formed of a portion of the fourth region $SC_4$ which portion extends from the other end of the channel region $CH_{J1}$ of the junction-field-effect transistor $JF_1$.

Concerning the MIS type diode DT,

(D-1) one end thereof is formed of part $SC_{2A}$ of the second region $SC_2$, and

(D-2) an electrode constituting the other end thereof is formed to be opposed to said part $SC_{2A}$ of the second region $SC_2$ which part $SC_{2A}$ constitutes one end of the MIS type diode DT, through a wide gap thin film WG.

The wide gap thin film WG can be composed of a material in which the tunnel transition of carriers is caused depending upon a potential difference between the potential in the second region $SC_2$ (the channel forming region $CH_1$ of the first transistor $TR_1$) and the potential in the other end (electrode EL) of the MIS type diode DT. Specifically, it can be composed, for example, of an $SiO_2$ or SiON film having a thickness of 5 nm or smaller, or an SiN film having a thickness of 9 nm or smaller.

The electrode EL constituting the other end of the MIS type diode DT is connected to the line (third line) through a high-resistance element R having a resistance of approximately $10^9$ to $10^{12}\,\Omega$. Specifically, the electrode EL constituting the other end of the MIS type diode DT and the high-resistance element R are integrally formed and are composed of a polysilicon thin layer containing an impurity having the first conductivity type.

In the above semiconductor memory cell, further,

(E) the gate G is connected to a first line (for example, word line) for memory cell selection,

(F) the third region $SC_3$ is connected to a write-in information setting line WISL,

(G) the portion of the fourth region $SC_4$ which portion constitutes the other source/drain region of the junction-field-effect transistor $JF_1$ is connected to a second line,

(H) the electrode EL constituting the other end of the MIS type diode DT is connected to a third line having a predetermined potential, and

(I) the fifth region $SC_5$ is connected to a fourth line.

The first region $SC_1$ and the third region $SC_3$ constitute a pn junction diode D, and the first region $SC_1$ is connected to the write-in information setting line WISL through the third region $SC_3$. In this case, it is preferred to employ a constitution in which the second line is used as a bit line, or a constitution in which the write-in information setting line WISL is used as a bit line as well and a second predetermined potential is applied to the second line.

The semiconductor memory cell (specifically, the first region $SC_1$) shown in Fig. 114 is formed in a well structure which is formed, for example, in a p-type semiconductor substrate and has the first conductivity type (for example, n-type). Further, when a first high-concentration-impurity-containing layer $SC_{10}$ having the first conductivity type (for example, $n^{++}$-type) is formed below the second region $SC_2$, the potential or charge to be stored in the channel forming region $CH_1$ of the first transistor $TR_1$ for readout can be increased.

The semiconductor memory cell (specifically, the second region $SC_2$) shown in Fig. 120 is formed in a well structure which is formed, for example, in an n-type semiconductor substrate and has the second conductivity type (for example, p-type). Further, when a first high-concentration-impurity-containing layer $SC_{10}$ having the first conductivity type (for example, $n^{++}$-type) is formed below the second region $SC_2$, the potential or charge to be stored in the channel forming region $CH_1$ of the first transistor $TR_1$ for readout can be increased.

The junction-field-effect transistor $JF_1$ is formed by

(X) optimizing the distance between the facing gate regions (the fifth region $SC_5$ and the part of the second region $SC_2$ which part is opposed to the fifth region $SC_5$), that is, the thickness of the channel region $CH_{J1}$, and

(Y) optimizing the impurity concentration of each of the facing gate regions (the fifth region $SC_5$ and the part of the second region $SC_2$ which part is opposed to the fifth region $SC_5$) and the impurity concentration of the channel region $CH_{J1}$.

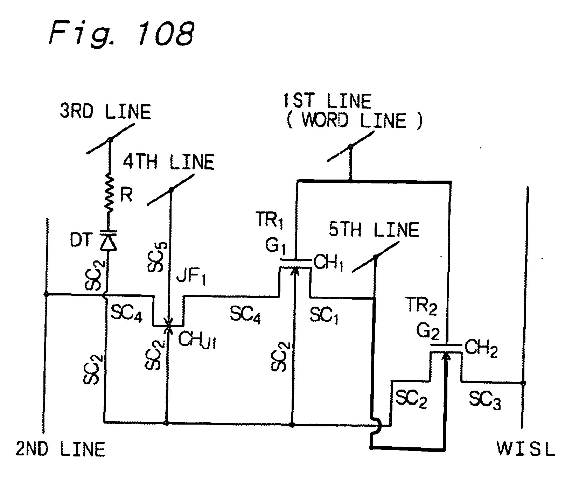

In the semiconductor memory cell shown in Fig. 114, there may be employed an embodiment in which the formation of the pn junction diode D is omitted and a second high-concentration-impurity-containing layer (not shown) which has the first conductivity type (for example, $n^{++}$-type) and works as a fifth line is formed below the first region $SC_1$. In the semiconductor memory cell shown in Fig. 120, there may be employed an embodiment in which the formation of the pn junction diode D is omitted and the first region $SC_1$ is connected to a fifth line (not shown). Fig. 108 shows the principle of these semiconductor memory cells. In these cases, it is preferred to employ a constitution in which the second line is used as a bit line and a second predetermined potential is applied to the fifth line, or a constitution in which the fifth line is used as a bit line and a second predetermined potential is applied to the second line.

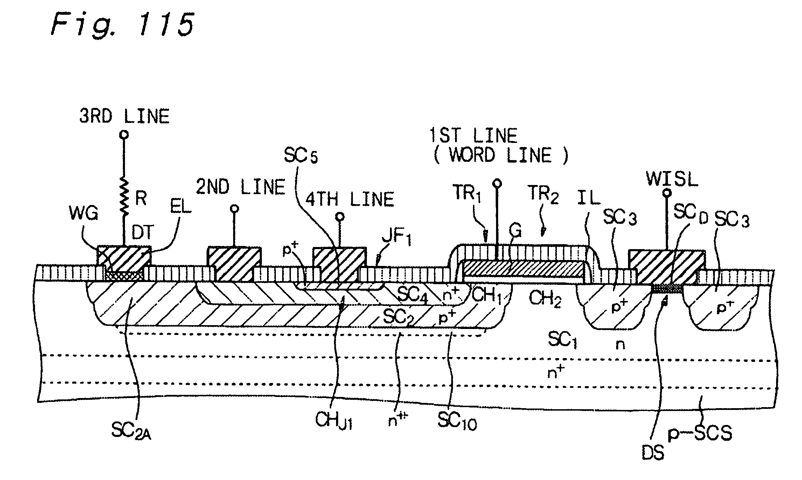

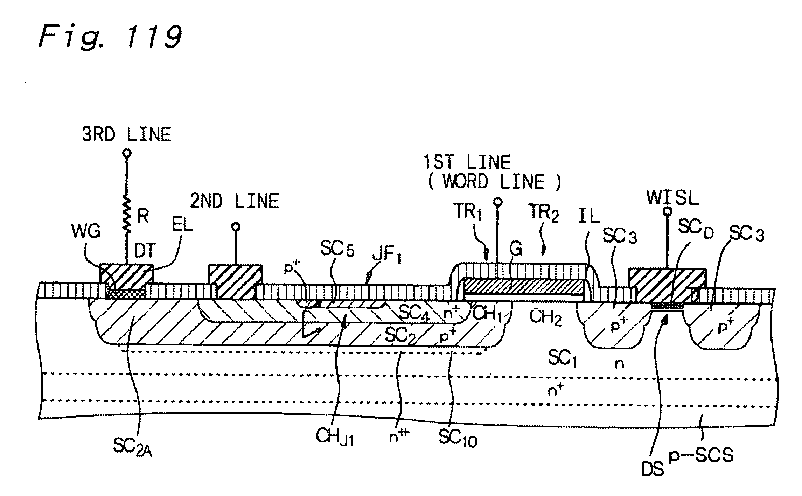

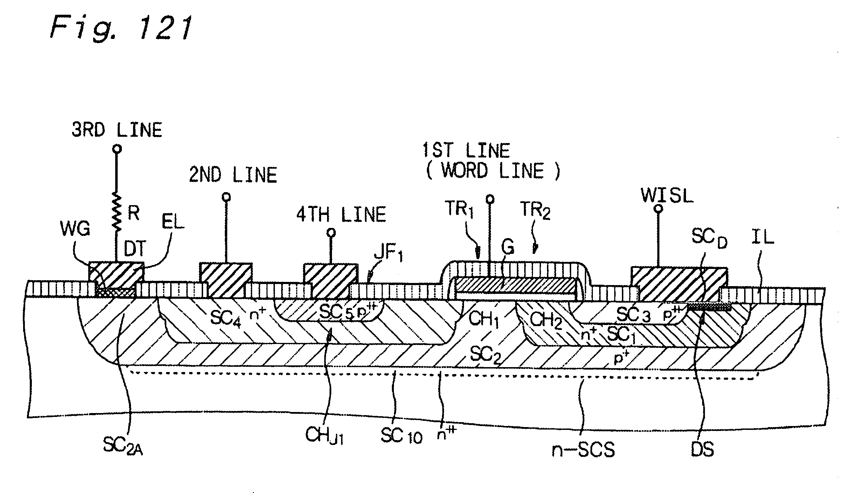

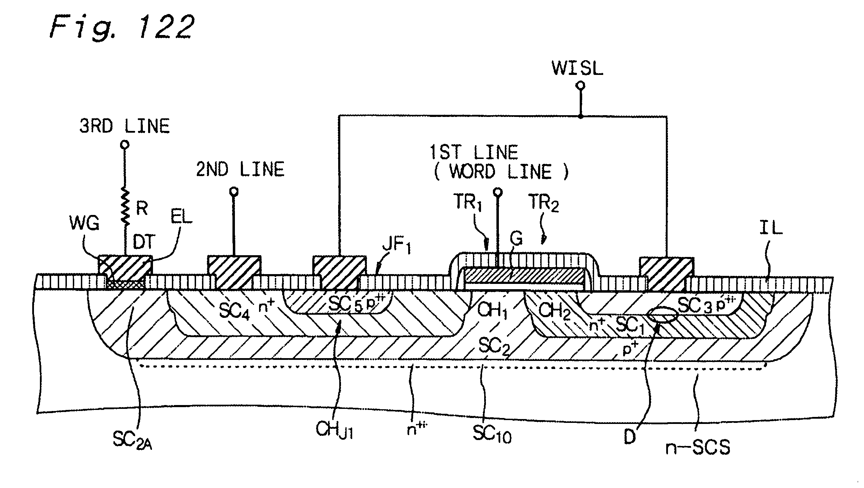

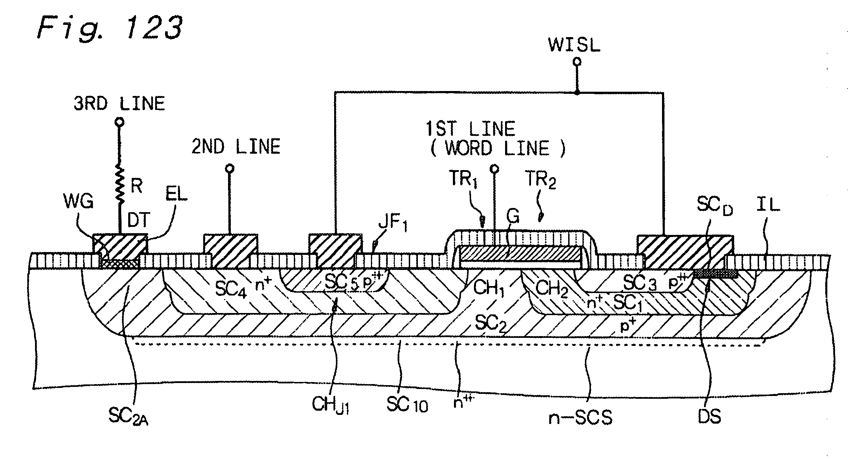

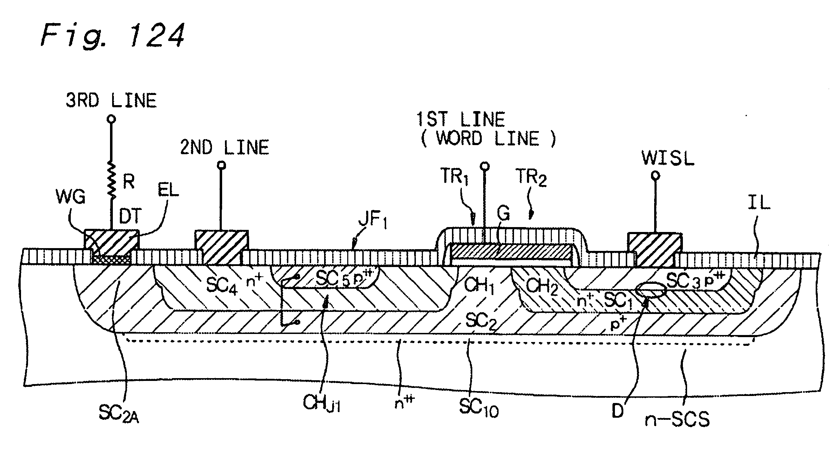

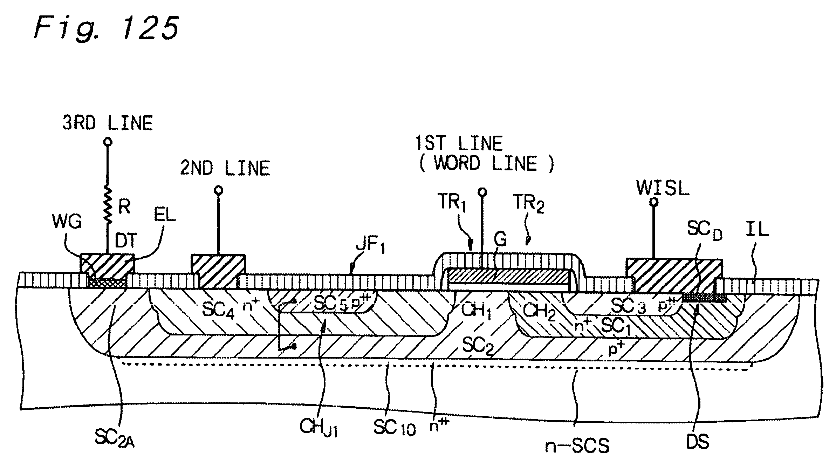

Figs. 115 to 119 and Figs. 121 to 125 show schematic partial cross-sectional views of variants of the semiconductor memory cell of Example 10. In the semiconductor memory cells shown in Figs. 115 to 119, the first region $SC_1$ and the second region $SC_2$ are in contact, and specifically, the second region $SC_2$ is formed in a surface region of the first region $SC_1$. In the semiconductor memory cells shown in Figs. 121 to 125, the first region $SC_1$ is formed in a surface region of the second region $SC_2$.

In the semiconductor memory cells shown in the principle drawing of Fig. 109A and the schematic partial cross-sectional views of Figs. 115 and 121, there is further provided a diode-constituting region $SC_D$ which is formed in a surface region of the first region $SC_1$ and is in contact with the first region $SC_1$ to form a rectifier junction together with the first region $SC_1$, the diode-constituting region $SC_D$ and the first region $SC_1$ constitute a majority carrier diode DS, and the first region $SC_1$ is connected to the write-in information setting line WISL through the majority carrier diode DS. In this case, it is preferred to employ a constitution in which the second line is used as a bit line, or a constitution in which the write-in information setting line WISL is used as a bit line as well and a second predetermined potential is applied to the second line. In Fig. 115, the diode-constituting region $SC_D$ is formed in the center of the third region $SC_3$ and is surrounded by the third region $SC_3$, while the position of the diode-constituting region $SC_D$ shall not be limited thereto.

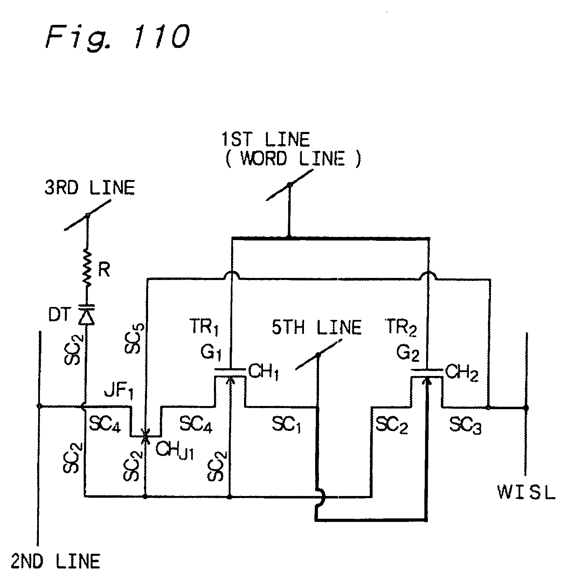

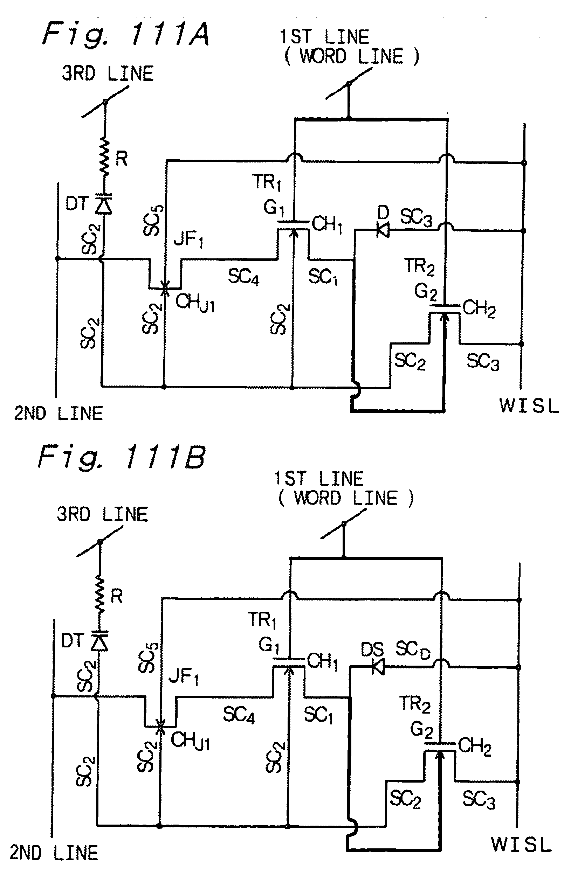

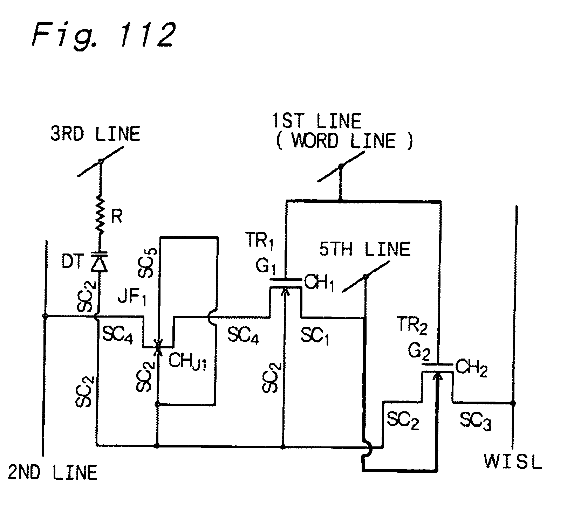

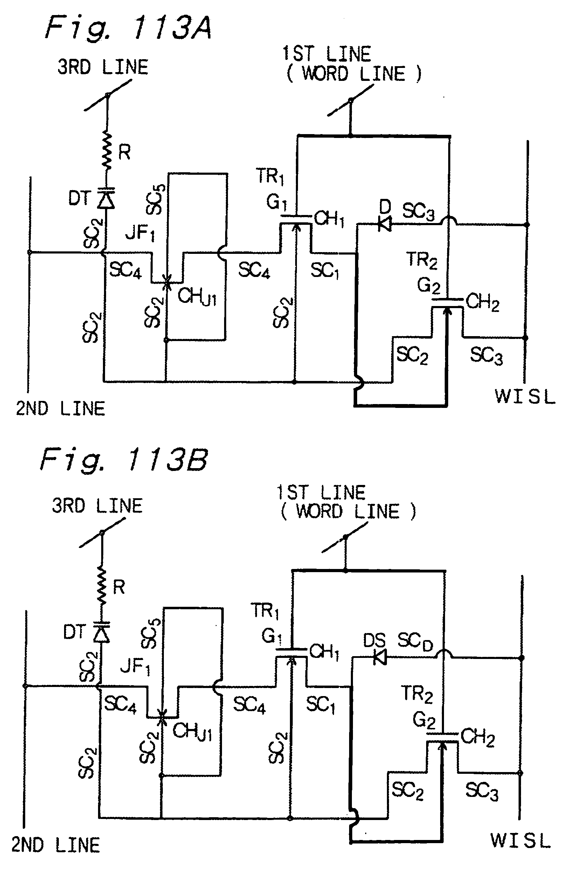

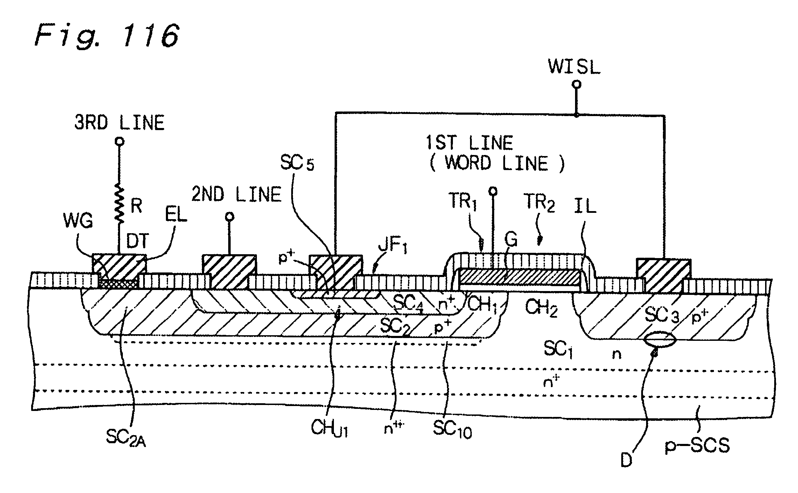

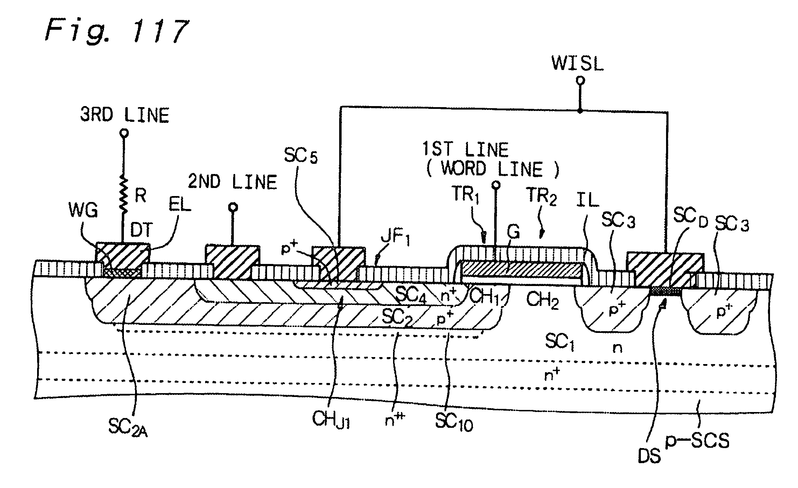

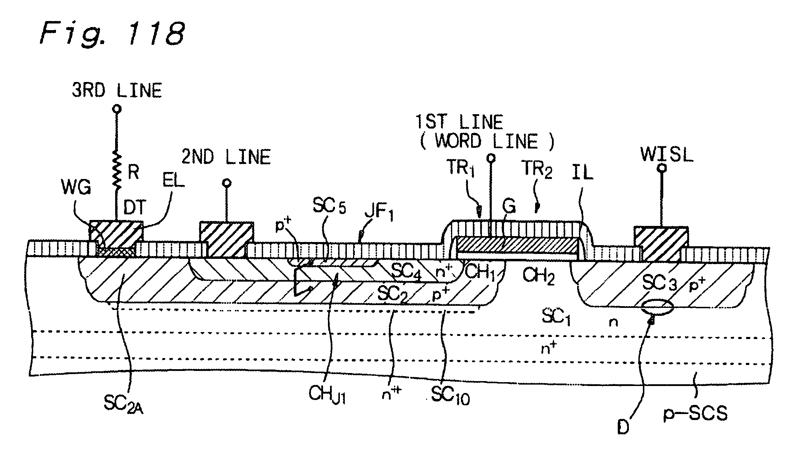

Further, as is shown in the principle drawings of Fig. 110 and Figs. 111A and 111B and the schematic partial cross-sectional views of Figs. 116, 117, 122 and 123, there may be employed a constitution in which the fifth region $SC_5$ is connected to the write-in information setting line WISL in place of being connected to the fourth line. Further, as is shown in the principle drawings of Fig. 112 and Figs. 113A and 113B and the schematic partial cross-sectional views of Figs. 118, 119, 124 and 125, there may be employed a constitution in which the fifth region $SC_5$ is connected to the second region $SC_2$ in place of being connected to the fourth line. In these cases, as is shown in Figs. 116, 118, 122 and 124, there may be employed a constitution in which the first region $SC_1$ and the third region $SC_3$ constitute a pn junction diode D, and the first region $SC_1$ is connected to the write-in information setting line WISL through the third region $SC_3$. Otherwise, as is shown in Figs. 117, 119, 123 and 125, there may be employed a constitution in which there is further provided a diode-constituting region $SC_D$ which is formed in a surface region of the first region $SC_1$ and is in contact with the first region $SC_1$ to form a rectifier junction together with the first region $SC_1$, the diode-constituting region $SC_D$ and the first region $SC_1$ constitute a majority carrier diode DS, and the first region $SC_1$ is connected to the write-in information setting line WISL through the diode-constituting region $SC_D$. In these cases where the diode or the majority carrier diode DS is formed, it is preferred to employ a constitution in which the second line is used as a bit line, or a constitution in which the write-in information setting line WISL is used as a bit line as well and a second predetermined potential is applied to the second line.

Example 11

Example 11 is concerned with the semiconductor memory cell according to the sixth aspect of the present invention. In the semiconductor memory cell of Example 11, the other gate region of the junction-field-effect transistor JF1 is connected to one gate region of the junction-field-effect transistor JF1 in place of being connected to the fourth line. More specifically, one end of the MIS type diode DT and the other gate region of the junction-field-effect transistor JF1 are formed as a common region. Further, the fifth region SC5 constituting the other gate region of the junction-field-effect transistor JF1 corresponds to an extending region of the channel forming region CH1 of the first transistor TR1.

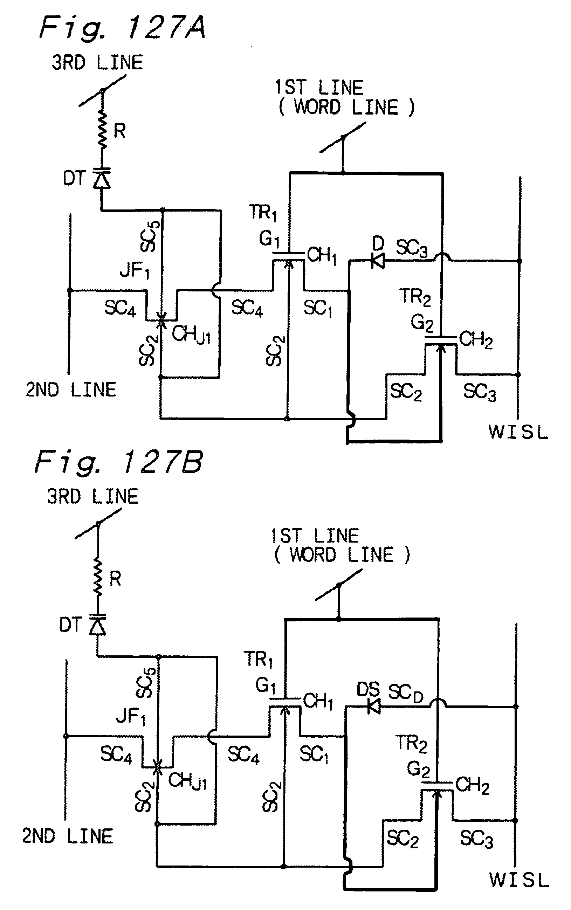

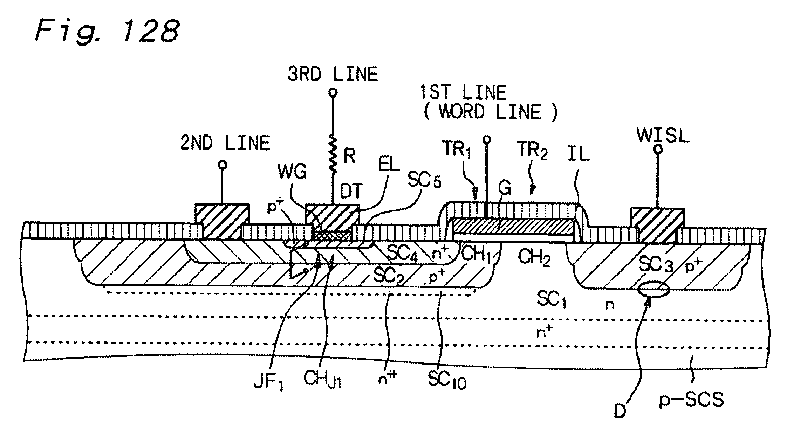

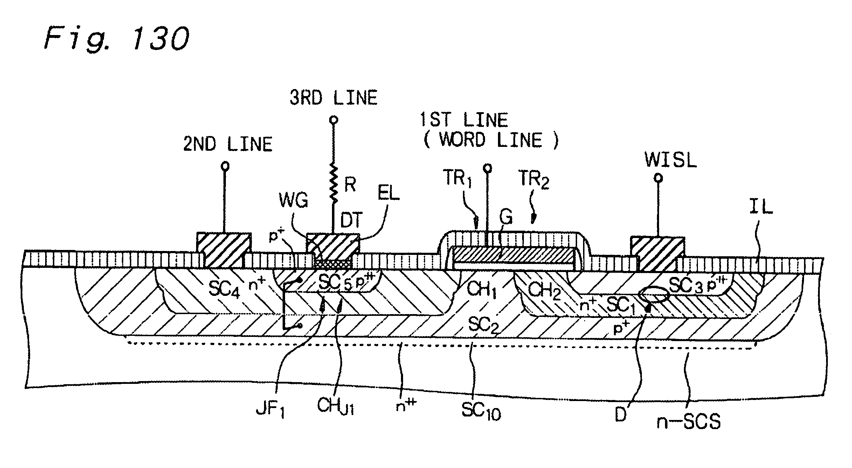

That is, as is shown in the principle drawing of Fig. 127A and the schematic partial cross-sectional views of Figs. 128 and 130, the semiconductor memory cell of Example 11 comprises;

(1) a first transistor TR1 for readout, having a first conductivity type (for example, n-channel type), and having source/drain regions, a semi-conductive channel forming region CH1 which is in contact with the source/drain regions and spaces out the source/drain regions, and a gate G capacitively coupled with the channel forming region CH1,

(2) a second transistor TR2 for switching, having a second conductivity type (for example, p-channel type), and having source/drain regions, a semi-conductive channel forming region CH2 which is in contact with the source/drain regions and spaces out the source/drain regions, and a gate G capacitively coupled with the channel forming region $CH_2$,

(3) a junction-field-effect transistor $JF_1$ for current control, having source/drain regions, a channel region $CH_{J1}$ and gate regions, and

(4) an MIS type diode DT for retaining information,
the semiconductor memory cell having;

(a) a semi-conductive first region $SC_1$ having a first conductivity type (for example, n-type),
(b) a semi-conductive second region $SC_2$ which is in contact with the first region $SC_1$ and has a second conductivity type (for example, $p^+$-type),
(c) a third region $SC_3$ which is formed in a surface region of the first region $SC_1$ and is in contact with the first region $SC_1$ so as to form a rectifier junction together with the first region $SC_1$, the third region $SC_3$ being a region which is semi-conductive and has the second conductivity type (for example, $p^+$-type) or which is conductive and is composed of a silicide, a metal or a metal compound,
(d) a semi-conductive fourth region $SC_4$ which is formed in a surface region of the second region $SC_2$ and has the first conductivity type (for example, $n^+$-type),
(e) a semi-conductive fifth region $SC_5$ which is formed in a surface region of the fourth region $SC_4$ and has the second conductivity type (for example, $p^+$-type), and
(f) the gate G which is formed, through an insulation layer, so as to bridge the first region $SC_1$ and the fourth region $SC_4$ and so as to bridge the second region $SC_2$ and the third region $SC_3$, and is shared by the first transistor $TR_1$ and the second transistor $TR_2$.

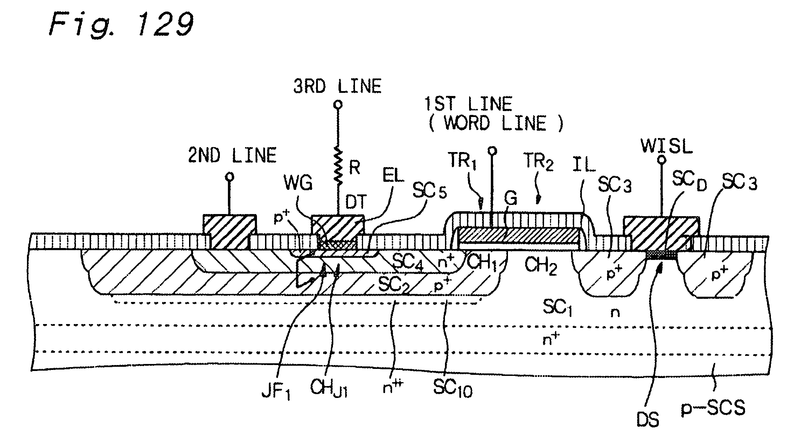

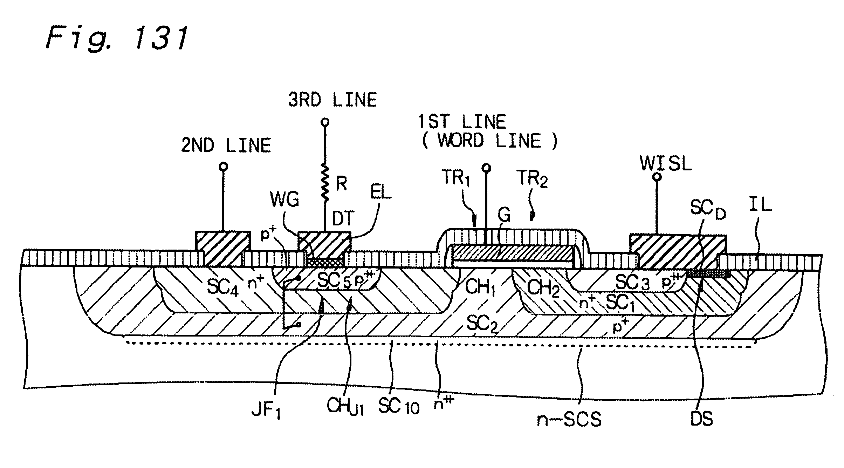

In the semiconductor memory cell shown in Fig. 128 and a semiconductor memory cell to be explained later with reference to Fig. 129, the first region $SC_1$ and the second region $SC_2$ are in contact with each other, and specifically, the second region $SC_2$ is formed in a surface region of the first region $SC_1$. In the semiconductor memory cell shown in Fig. 130 and a semiconductor memory cell to be explained later with reference to Fig. 131, the first region $SC_1$ is formed in a surface region of the second region $SC_2$.
Concerning the first transistor $TR_1$,

(A-1) one source/drain region is formed of a surface region of the first region $SC_1$,
(A-2) the other source/drain region is formed of a surface region of the fourth region $SC_4$, and
(A-3) the channel forming region $CH_1$ is formed of a surface region of the second region $SC_2$ which surface region is interposed between the surface region of the first region $SC_1$ and the surface region of the fourth region $SC_4$.

Concerning the first transistor $TR_1$,

(A-1) one source/drain region is formed of a surface region of the first region $SC_1$,
(A-2) the other source/drain region is formed of a surface region of the fourth region $SC_4$, and
(A-3) the channel forming region $CH_1$ is formed of a surface region of the second region $SC_2$ which surface region is interposed between the surface region of the first region $SC_1$ and the surface region of the fourth region $SC_4$.

Concerning the junction-field-effect transistor $JF_1$,

(C-1) the gate regions are formed of the fifth region $SC_5$ and part of the second region $SC_2$ which part is opposed to the fifth region $SC_5$,
(C-2) the channel region $CH_{J1}$ is formed of part of the fourth region $SC_4$ which part is interposed between the fifth region $SC_5$ and said part of the second region $SC_2$,
(C-3) one source/drain region is formed of the surface region of the fourth region $SC_4$ which surface region extends from one end of the channel region $CH_{J1}$ of the junction-field-effect transistor $JF_1$ and constitutes the other source/drain region of the first transistor $TR_1$, and
(C-4) the other source/drain region is formed of a portion of the fourth region $SC_4$ which portion extends from the other end of the channel region $CH_{J1}$ of the junction-field-effect transistor $JF_1$.

Concerning the MIS type diode DT,

(D-1) one end thereof is formed of the fifth region $SC_5$, and
(D-2) an electrode constituting the other end thereof is formed to be opposed to the fifth region $SC_5$ which constitutes one end of the MIS type diode DT, through a wide gap thin film WG.

The wide gap thin film WG can be composed of a material in which the tunnel transition of carriers is caused depending upon a potential difference between the potential in the fifth region $SC_5$ (corresponding to the extending portion of the channel forming region $CH_1$ of the first transistor $TR_1$) and the potential in the other end (electrode EL) of the MIS type diode DT. Specifically, it can be composed, for example, of an $SiO_2$ or SiON film having a thickness of 5 nm or smaller, or an SiN film having a thickness of 9 nm or smaller.

The electrode EL constituting the other end of the MIS type diode DT is connected to the line (third line) through a high-resistance element R having a resistance of approximately $10^9$ to $10^{12}\,\Omega$. Specifically, the electrode EL constituting the other end of the MIS type diode DT and the high-resistance element R are integrally formed and are composed of a polysilicon thin layer containing an impurity having the first conductivity type.

In the above semiconductor memory cell, further,

(E) the gate G is connected to a first line (for example, word line) for memory cell selection,
(F) the third region $SC_3$ is connected to a write-in information setting line WISL,
(G) the portion of the fourth region $SC_4$ which portion constitutes the other source/drain region of the junction-field-effect transistor $JF_1$ is connected to a second line,
(H) the fifth region $SC_5$ is connected to the second region $SC_2$, and
(I) the electrode EL constituting the other end of the MIS type diode DT is connected to a third line having a predetermined potential.

The first region $SC_1$ and the third region $SC_3$ constitute a pn junction diode D, and the first region $SC_1$ is connected to the write-in information setting line WISL through the third region $SC_3$. In this case, it is preferred to employ a constitution in which the second line is used as a bit line, or a constitution in which the write-in information setting line WISL is used as a bit line as well and a second predetermined potential is applied to the second line.

The semiconductor memory cell (specifically, the first region $SC_1$) shown in Fig. 128 or shown in Fig. 129 is formed in a well structure which is formed, for example, in a p-type semiconductor substrate and has the first conductivity type (for example, n-type). Further, when a first high-concentration-impurity-containing layer $SC_{10}$ having the first conductivity type (for example, $n^{++}$-type) is formed below the second region $SC_2$, the potential or charge to be stored in the channel forming region $CH_1$ of the first transistor $TR_1$ for readout can be increased.

The semiconductor memory cell (specifically, the second region $SC_2$) shown in Fig. 130 or shown in Fig. 131 is formed in a well structure which is formed, for example, in a n-type semiconductor substrate and has the second conductivity type (for example, p-type). Further, when a first high-concentration-impurity-containing layer $SC_{10}$ having the first conductivity type (for example, $n^{++}$-type) is formed below the second region $SC_2$, the potential or charge to be stored in the channel forming region $CH_1$ of the first transistor $TR_1$ for readout can be increased.

The junction-field-effect transistor $JF_1$ is formed by

(X) optimizing the distance between the facing gate regions (the fifth region $SC_5$ and the part of the second region $SC_2$ which part is opposed to the fifth region $SC_5$), that is, the thickness of the channel region $CH_{J1}$, and
(Y) optimizing the impurity concentration of each of the facing gate regions (the fifth region $SC_5$ and the part of the second region $SC_2$ which part is opposed to the fifth region $SC_5$) and the impurity concentration of the channel region $CH_{J1}$.

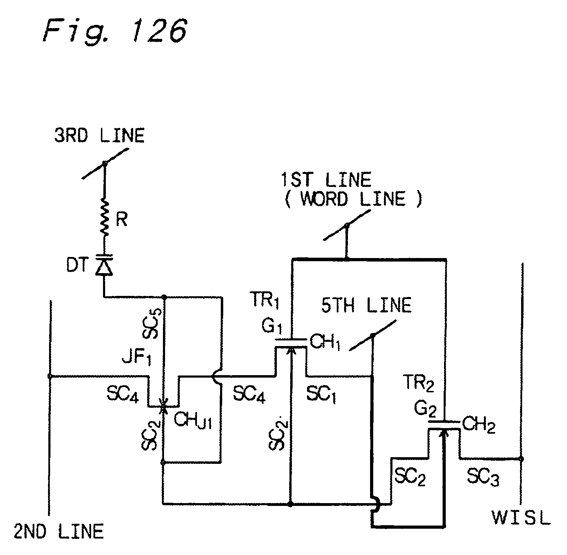

In the semiconductor memory cell shown in Fig. 128, there may be employed an embodiment in which the formation of the pn junction diode D is omitted and a second high-concentration-impurity-containing layer (not shown) which has the first conductivity type (for example, $n^{++}$-type) and works as a fifth line is formed below the first region $SC_1$. In the semiconductor memory cell shown in Fig. 130, there may be employed an embodiment in which the formation of the pn junction diode D is omitted and the first region $SC_1$ is connected to a fifth line (not shown). Fig. 126 shows the principle of these semiconductor memory cells. In these cases, it is preferred to employ a constitution in which the second line is used as a bit line and a second predetermined potential is applied to the fifth line, or a constitution in which the fifth line is used as a bit line and a second predetermined potential is applied to the second line.

In the semiconductor memory cells shown in the principle drawing of Fig. 127B and the schematic partial cross-sectional views of Figs. 129 and 131, there is further provided a diode-constituting region SCD which is formed in a surface region of the first region SC1 and is in contact with the first region SC1 to form a rectifier junction together with the first region SC1, the diode-constituting region SCD and the first region SC1 constitute a majority carrier diode DS, and the first region SC1 is connected to the write-in information setting line WISL through the diode-constituting region SCD. In this case, it is preferred to employ a constitution in which the second line is used as a bit line, or a constitution in which the write-in information setting line WISL is used as a bit line as well and a second predetermined potential is applied to the second line. In Fig. 129, the diode-constituting region SCD is formed in the center of the third region SC3 and is surrounded by the third region SC3, while the position of the diode-constituting region SCD shall not be limited thereto.

Example 12

Example 12 is concerned with the semiconductor memory cell according to the seventh aspect of the present invention. The semiconductor memory cell of Example 12 differs from the semiconductor memory cell of Example 10 in that a third transistor TR3 for current control is formed. That is, as is shown in the principle drawing of Fig. 133A, the semiconductor memory cell of Example 12 comprises;

(1) a first transistor TR1 for readout, having a first conductivity type (for example, n-channel type), and having source/drain regions, a semi-conductive channel forming region CH1 which is in contact with the source/drain regions and spaces out the source/drain regions, and a gate G capacitively coupled with the channel forming region CH1,
(2) a second transistor $TR_2$ for switching, having a second conductivity type (for example, p-channel type), and having source/drain regions, a semi-conductive channel forming region $CH_2$ which is in contact with the source/drain regions and spaces out the source/drain regions, and a gate G capacitively coupled with the channel forming region $CH_2$,
(3) a third transistor $TR_3$ for current control, having the second conductivity type (for example, p-channel type), and having source/drain regions, a semi-conductive channel forming region $CH_3$ which is in contact with the source/drain regions and spaces out the source/drain regions, and a gate G capacitively coupled with the channel forming region $CH_3$,
(4) a junction-field-effect transistor $JF_1$ for current control, having source/drain regions, a channel region $CH_{J1}$ and gate regions, and
(5) an MIS type diode DT for retaining information.

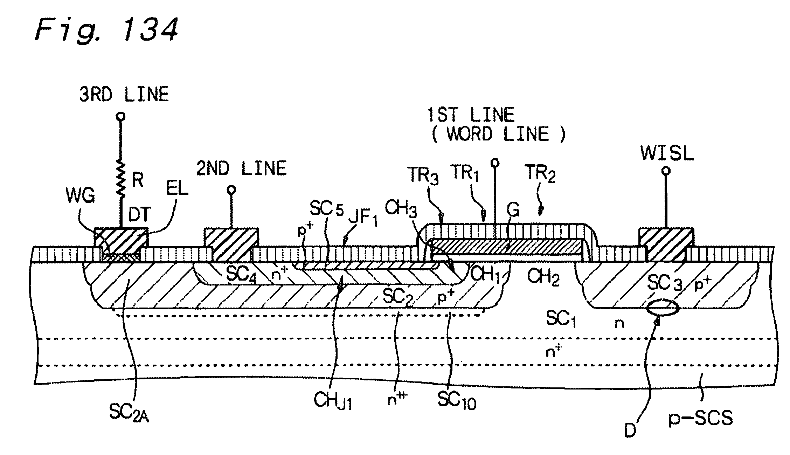

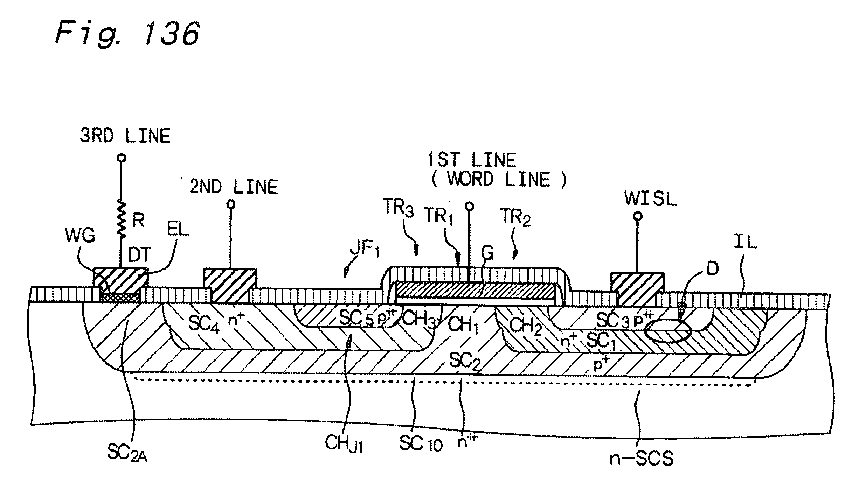

In the semiconductor memory cell of Example 12,
one source/drain region of the first transistor $TR_1$ corresponds to the channel forming region $CH_2$ of the second transistor $TR_2$,
the other source/drain region of the first transistor $TR_1$ corresponds to one source/drain region of the junction-field-effect transistor $JF_1$,
one source/drain region of the second transistor $TR_2$ corresponds to the channel forming region $CH_1$ of the first transistor $TR_1$, corresponds to one gate region of the junction-field-effect transistor $JF_1$ and corresponds to one source/drain region of the third transistor $TR_3$,
the other source/drain region of the third transistor $TR_3$ corresponds to the other gate region of the junction-field-effect transistor $JF_1$, and
one end of the MIS type diode DT is formed of an extending portion of the channel forming region $CH_1$ of the first transistor $TR_1$, the other end of the MIS type diode DT is formed of an electrode EL composed of a conductive material, and the electrode EL is connected to a line (third line) having a predetermined potential.
Further, the gate G of the first transistor $TR_1$, the gate G of the second transistor $TR_2$ and the gate G of the third transistor $TR_3$ are connected to a first line (for example, word line) for memory cell selection, the other source/drain regions of the first transistor $TR_1$ is connected to a second line through the junction-field-effect transistor $JF_1$, one source/drain region of the first transistor $TR_1$ is connected to a write-in information setting line WISL through a diode D, the other source/drain region of the second transistor $TR_2$ is connected to the write-in information setting line WISL, and the other end of the MIS type diode DT is connected to a third line (corresponding to the above line) having a predetermined potential through a high-resistance element R. It is preferred to employ a constitution in which the second line is used as a bit line, or a constitution in which the write-in information setting line WISL is used as a bit line as well and a second predetermined potential is applied to the second line.
As shown in the schematic partial cross-sectional views of Figs. 134 and 136, the semiconductor memory cell of Example 12 comprises;

(1) a first transistor $TR_1$ for readout, having a first conductivity type (for example, n-channel type), and having source/drain regions, a semi-conductive channel forming region $CH_1$ which is in contact with the source/drain regions and spaces out the source/drain regions, and a gate G capacitively coupled with the channel forming region $CH_1$,
(2) a second transistor $TR_2$ for switching, having a second conductivity type (for example, p-channel type), and having source/drain regions, a semi-conductive channel forming region $CH_2$ which is in contact with the source/drain regions and spaces out the source/drain regions, and a gate G capacitively coupled with the channel forming region $CH_2$,
(3) a third transistor $TR_3$ for current control, having the second conductivity type (for example, p-channel type), and having source/drain regions, a semi-conductive channel forming region $CH_3$ which is in contact with the source/drain regions and spaces out the source/drain regions, and a gate G capacitively coupled with the channel forming region $CH_3$,

(4) a junction-field-effect transistor $JF_1$ for current control, having source/drain regions, a channel region $CH_{J1}$ and gate regions, and

(5) an MIS type diode DT for retaining information.

the semiconductor memory cell having;

(a) a semi-conductive first region $SC_1$ having a first conductivity type (for example, n-type),

(b) a semi-conductive second region $SC_2$ which is in contact with the first region $SC_1$ and has a second conductivity type (for example, $p^+$-type),

(c) a third region $SC_3$ which is formed in a surface region of the first region $SC_1$ and is in contact with the first region $SC_1$ so as to form a rectifier junction together with the first region $SC_1$, the third region $SC_3$ being a region which is semi-conductive and has the second conductivity type (for example, $p^+$-type) or which is conductive and is composed of a silicide, a metal or a metal compound,

(d) a semi-conductive fourth region $SC_4$ which is formed in a surface region of the second region $SC_2$ and has the first conductivity type (for example, $n^+$-type),

(e) a fifth region $SC_5$ which is formed in a surface region of the fourth region $SC_4$ and is in contact with the fourth region $SC_4$ so as to form a rectifier junction together with the fourth region $SC_4$, the fifth region $SC_5$ being a region which is semi-conductive and has the second conductivity type (for example, $p^+$-type) or which is conductive and is composed of a silicide, a metal or a metal compound, and

(f) the gate G which is formed, through an

insulation layer, so as to bridge the first region $SC_1$ and the fourth region $SC_4$, so as to bridge the second region $SC_2$ and the third region $SC_3$ and so as to bridge the second region $SC_2$ and the fifth region $SC_5$, and is shared by the first transistor $TR_1$, the second transistor $TR_2$ and the third transistor $TR_3$.

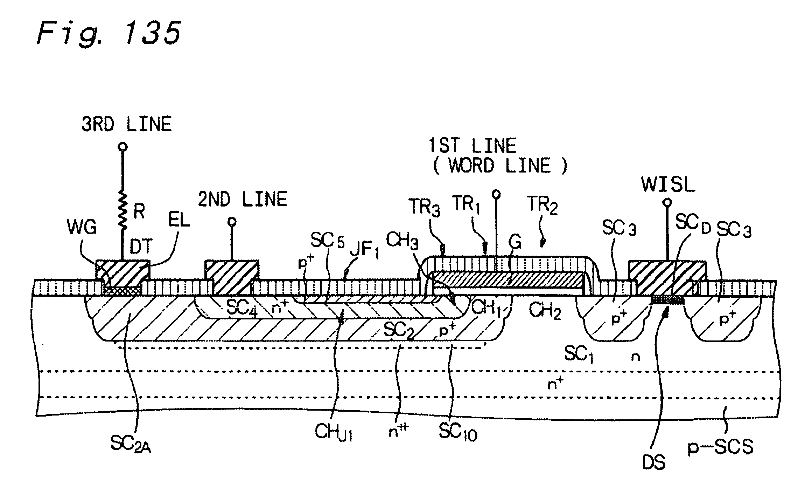

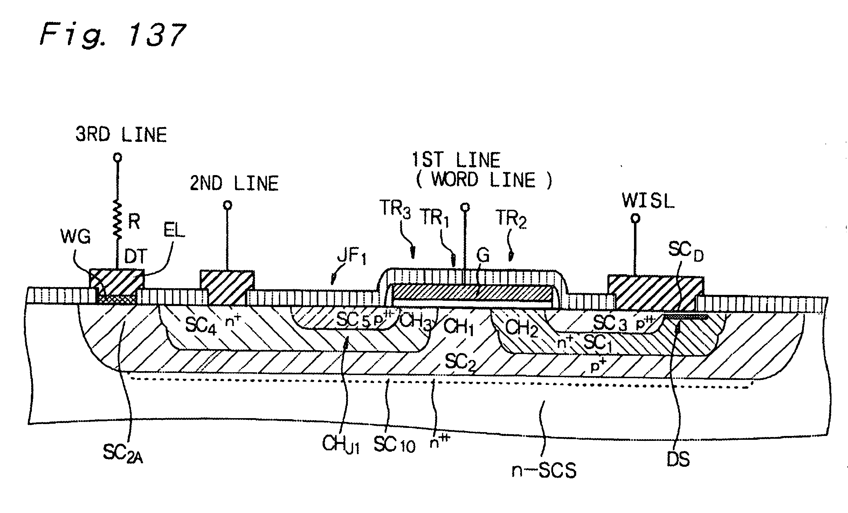

In the semiconductor memory cell shown in Fig. 134 and a semiconductor memory cell to be explained later with reference to Fig. 135, the first region $SC_1$ and the second region $SC_2$ are in contact with each other, and specifically, the second region $SC_2$ is formed in a surface region of the first region $SC_1$. In the semiconductor memory cell shown in Fig. 136 and a semiconductor memory cell to be explained later with reference to Fig. 137, the first region $SC_1$ is formed in a surface region of the second region $SC_2$.

Concerning the first transistor $TR_1$,

(A-1) one source/drain region is formed of a surface region of the first region $SC_1$,

(A-2) the other source/drain region is formed of a surface region of the fourth region $SC_4$, and

(A-3) the channel forming region $CH_1$ is formed of a surface region of the second region $SC_2$ which surface region is interposed between the surface region of the first region $SC_1$ and the surface region of the fourth region $SC_4$.

Concerning the second transistor $TR_2$,

(B-1) one source/drain region is formed of the surface region of the second region $SC_2$,

(B-2) the other source/drain region is formed of the third region $SC_3$, and

(B-3) the channel forming region $CH_2$ is formed of the surface region of the first region $SC_1$.

Concerning the third transistor $TR_3$,

(C-1) one source/drain region is formed of the surface region of the second region $SC_2$,

(C-2) the other source/drain region is formed of the fifth region $SC_5$, and

(C-3) the channel forming region $CH_3$ is formed of the surface region of the fourth region $SC_4$.

Concerning the junction-field-effect transistor $JF_1$,

(D-1) the gate regions are formed of the fifth region $SC_5$ and part of the second region $SC_2$ which part is opposed to the fifth region $SC_5$,

(D-2) the channel region $CH_{J1}$ is formed of part of the fourth region $SC_4$ which part is interposed between the fifth region $SC_5$ and said part of the second region $SC_2$,

(D-3) one source/drain region is formed of the surface region of the fourth region $SC_4$ which surface region extends from one end of the channel region $CH_{J1}$ of the junction-field-effect transistor $JF_1$ and constitutes the other source/drain region of the first transistor $TR_1$ and the channel forming region $CH_3$ of the third transistor $TR_3$, and

(D-4) the other source/drain region is formed of a potion of the fourth region $SC_4$ which portion extends from the other end of the channel region $CH_{J1}$ of the junction-field-effect transistor $JF_1$.

Concerning the MIS type diode DT,

(E-1) one end thereof is formed of part $SC_{2A}$ of the second region $SC_2$, and
(E-2) an electrode constituting the other end thereof is formed to be opposed to said part $SC_{2A}$ of the second region $SC_2$ which part $SC_{2A}$ constitutes one end of the MIS type diode DT, through a wide gap thin film WG.

The wide gap thin film WG can be composed of a material in which the tunnel transition of carriers is caused depending upon a potential difference between the potential in the second region $SC_2$ (the channel forming region $CH_1$ of the first transistor $TR_1$) and the potential in the other end (electrode EL) of the MIS type diode DT. Specifically, it can be composed, for example, of an $SiO_2$ or SiON film having a thickness of 5 nm or smaller, or an SiN film having a thickness of 9 nm or smaller.

The electrode EL constituting the other end of the MIS type diode DT is connected to the line (third line) through a high-resistance element R having a resistance of approximately $10^9$ to $10^{12}$ $\Omega$. Specifically, the electrode EL constituting the other end of the MIS type diode DT and the high-resistance element R are integrally formed and are composed of a polysilicon thin layer containing an impurity having the first conductivity type.

In the above semiconductor memory cell, further,

(F) the gate G is connected to a first line (for example, word line) for memory cell selection,
(G) the third region $SC_3$ is connected to a write-in information setting line WISL,
(H) the portion of the fourth region $SC_4$ which portion constitutes the other source/drain region of the junction-field-effect transistor $JF_1$ is connected to a second line, and
(I) the electrode EL constituting the other end of the MIS type diode DT is connected to a third line having a predetermined potential.

The first region $SC_1$ and the third region $SC_3$ constitute a pn junction diode D, and the first region $SC_1$ is connected to the write-in information setting line WISL through the third region $SC_3$. In this case, it is preferred to employ a constitution in which the second line is used as a bit line, or a constitution in which the write-in information setting line WISL is used as a bit line as well and a second predetermined potential is applied to the second line.

The junction-field-effect transistor $JF_1$ is formed by

(X) optimizing the distance between the facing gate regions (the fifth region $SC_5$ and the part of the second region $SC_2$ which part is opposed to the fifth region $SC_5$), that is, the thickness of the channel region $CH_{J1}$, and
(Y) optimizing the impurity concentration of each of the facing gate regions (the fifth region $SC_5$ and the part of the second region $SC_2$ which part is opposed to the fifth region $SC_5$) and the impurity concentration of the channel region $CH_{J1}$.

The semiconductor memory cell (specifically, the first region $SC_1$) shown in Fig. 134 is formed in a well structure which is formed, for example, in an p-type semiconductor substrate and has the first conductivity type (for example, n-type). Further, when a first high-concentration-impurity-containing layer $SC_{10}$ having the first conductivity type (for example, n++-type) is formed below the second region $SC_2$, the potential or charge to be stored in the channel forming region $CH_1$ of the first transistor $TR_1$ for readout can be increased. The semiconductor memory cell (specifically, the second region $SC_2$) shown in Fig. 136 is formed in a well structure which is formed, for example, in an n-type semiconductor substrate and has the second conductivity type (for example, p-type). Further, when a first high-concentration-impurity-containing layer $SC_{10}$ having the first conductivity type (for example, n++-type) is formed below the second region $SC_2$, the potential or charge to be stored in the channel forming region $CH_1$ of the first transistor $TR_1$ for readout can be increased.

In the semiconductor memory cell shown in Fig. 134 or Fig. 136, as is shown in the principle drawing of Fig. 132, there may be employed an embodiment in which the formation of the pn junction diode D is omitted and the first region $SC_1$ corresponding to one source/drain region of the first transistor $TR_1$ is connected to a fourth line (not shown in Fig. 134 or 136). That is, for example, in the semiconductor memory cell shown in Fig. 134, a second high-concentration-impurity-containing layer SC11 which has a first conductivity type (for example, n++-type) and works as the fourth line can be formed below the first region SC1. In these cases, it is preferred to employ a constitution in which the second line is used as a bit line and a second predetermined potential is applied to the fourth line, or a constitution in which the fourth line is used as a bit line and a second predetermined potential is applied to the second line.

In the semiconductor memory cell shown in the schematic partial cross-sectional view of Fig. 135 or Fig. 137 and the principle drawing of Fig. 133B, there may be employed a constitution in which there is further provided a diode-constituting region SCD which is formed in a surface region of the first region SC1 and is in contact with the first region SC1 to form a rectifier junction together with the first region SC1, the diode-constituting region SCD and the first region SC1 constitute a majority carrier diode DS, and the first region SC1 is connected to the write-in information setting line WISL through the diode-constituting region SCD. In this case, it is preferred to employ a constitution in which the second line is used as a bit line, or a constitution in which the write-in information setting line WISL is used as a bit line as well and a second predetermined potential is applied to the second line.

Example 13

The Example 13 is concerned with the semiconductor memory cell according to the eighth aspect which is not part of the present invention. The semiconductor memory cell of Example 13 differs from the semiconductor memory cell of Example 12 in that one end of the MIS type diode DT and the other gate region of the junction-field-effect transistor JF1 are formed as a common region.

That is, as is shown in the principle drawing of Fig. 139A, the semiconductor memory cell of Example 13 comprises;

(1) a first transistor $TR_1$ for readout, having a first conductivity type (for example, n-channel type), and having source/drain regions, a semi-conductive channel forming region $CH_1$ which is in contact with the source/drain regions and spaces out the source/drain regions, and a gate G capacitively coupled with the channel forming region $CH_1$,
(2) a second transistor $TR_2$ for switching, having a second conductivity type (for example, p-channel type), and having source/drain regions, a semi-conductive channel forming region $CH_2$ which is in contact with the source/drain regions and spaces out the source/drain regions, and a gate G capacitively coupled with the channel forming region $CH_2$,
(3) a third transistor $TR_3$ for current control, having the second conductivity type (for example, p-channel type), and having source/drain regions, a semi-conductive channel forming region $CH_3$ which is in contact with the source/drain regions and spaces out the source/drain regions, and a gate G capacitively coupled with the channel forming region $CH_3$,
(4) a junction-field-effect transistor $JF_1$ for current control, having source/drain regions, a channel region $CH_{J1}$ and gate regions, and
(5) an MIS type diode DT for retaining information.

In the semiconductor memory cell of Example 13,
one source/drain region of the first transistor $TR_1$ corresponds to the channel forming region $CH_2$ of the second transistor $TR_2$,
the other source/drain region of the first transistor $TR_1$ corresponds to one source/drain region of the junction-field-effect transistor $JF_1$,
one source/drain region of the second transistor $TR_2$ corresponds to the channel forming region $CH_1$ of the first transistor $TR_1$, corresponds to one gate region of the junction-field-effect transistor $JF_1$ and corresponds to one source/drain region of the third transistor $TR_3$,
the other source/drain region of the third transistor $TR_3$ corresponds to the other gate region of the junction-field-effect transistor $JF_1$, and
one end of the MIS type diode DT corresponds to the other source/drain region of the third transistor $TR_3$, the other end of the MIS type diode DT is formed of an electrode EL composed of a conductive material, and the electrode EL is connected to a line (third line) having a predetermined potential.

Further, the gate G of the first transistor $TR_1$, the gate G of the second transistor $TR_2$ and the gate of the third transistor $TR_3$ are connected to a first line (for example, word line) for memory cell selection, the other source/drain regions of the first transistor $TR_1$ is connected to a second line through the junction-field-effect transistor $JF_1$, one source/drain region of the first transistor $TR_1$ is connected to a write-in information setting line WISL through a diode D, the other source/drain region of the second transistor $TR_2$ is connected to the write-in information setting line WISL, and the other end of the MIS type diode DT is connected to a third line (corresponding to the above line) having a predetermined potential through a high-resistance element R. It is preferred to employ a constitution in which the second line is used as a bit line, or a constitution in which the write-in information setting line WISL is used as a bit line as well and a second predetermined potential is applied to the second line.

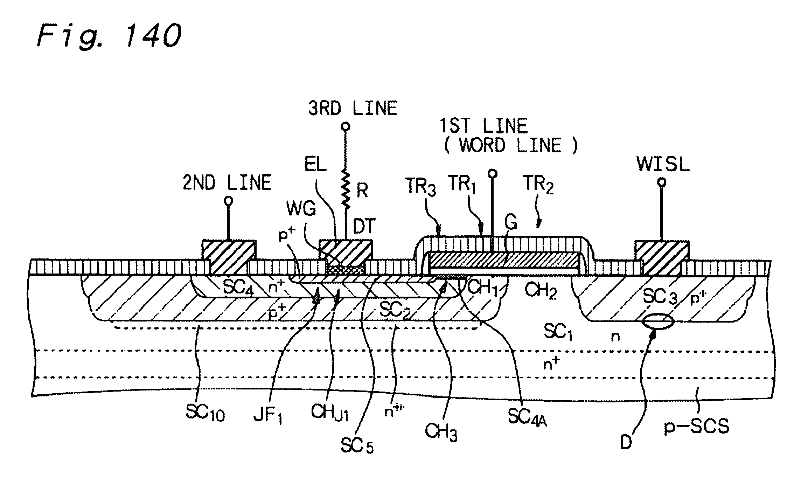

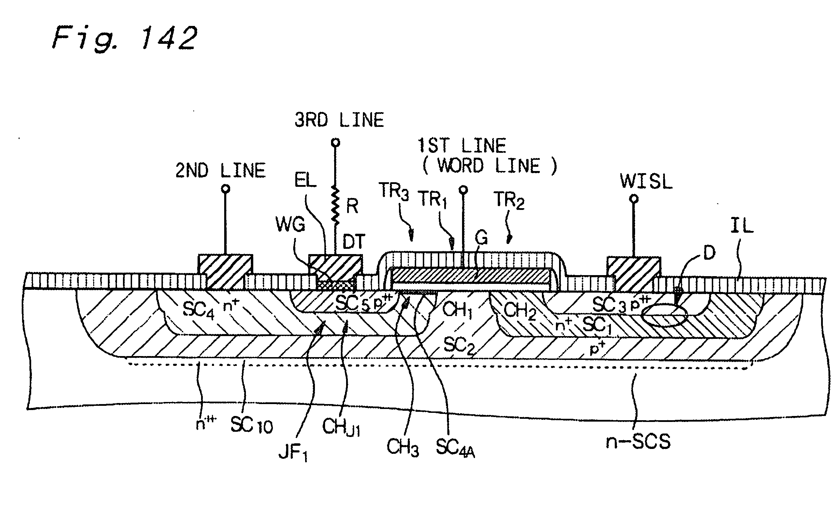

In another example, as shown in the schematic partial cross-sectional views of Figs. 140 and 142, the semiconductor memory cell of Example 13 comprises;

(1) a first transistor $TR_1$ for readout, having a first conductivity type (for example, n-channel type), and having source/drain regions, a semi-conductive channel forming region $CH_1$ which is in contact with the source/drain regions and spaces out the source/drain regions, and a gate G capacitively coupled with the channel forming region $CH_1$,
(2) a second transistor $TR_2$ for switching, having a second conductivity type (for example, p-channel type), and having source/drain regions, a semi-conductive channel forming region $CH_2$ which is in contact with the source/drain regions and spaces out the source/drain regions, and a gate G capacitively coupled with the channel forming region $CH_2$,

(3) a third transistor $TR_3$ for current control, having the second conductivity type (for example, p-channel type), and having source/drain regions, a semi-conductive channel forming region $CH_3$ which is in contact with the source/drain regions and spaces out the source/drain regions, and a gate G capacitively coupled with the channel forming region $CH_3$,

(4) a junction-field-effect transistor $JF_1$ for current control, having source/drain regions, a channel region $CH_{J1}$ and gate regions, and

(5) an MIS type diode DT for retaining information,

the semiconductor memory cell having;

(a) a semi-conductive first region $SC_1$ having a first conductivity type (for example, n-type),

(b) a semi-conductive second region $SC_2$ which is in contact with the first region $SC_1$ and has a second conductivity type (for example, $p^+$-type),

(c) a third region $SC_3$ which is formed in a surface region of the first region $SC_1$ and is in contact with the first region $SC_1$ so as to form a rectifier junction together with the first region $SC_1$, the third region $SC_3$ being a region which is semi-conductive and has the second conductivity type (for example, $p^+$-type) or which is conductive and is composed of a silicide, a metal or a metal compound,

(d) a semi-conductive fourth region $SC_4$ which is formed in a surface region of the second region $SC_2$ and has the first conductivity type (for example, $n^+$-type),

(e) a semi-conductive fifth region $SC_5$ which is formed in a surface region of the fourth region $SC_4$ and has the second conductivity type (for example, $p^+$-type), and

(f) the gate G which is formed, through an insulation layer, so as to bridge the first region $SC_1$ and the fourth region $SC_4$, so as to bridge the second region $SC_2$ and the third region $SC_3$ and so as to bridge the second region $SC_2$ and the fifth region $SC_5$, and is shared by the first transistor $TR_1$, the second transistor $TR_2$ and the third transistor $TR_3$.

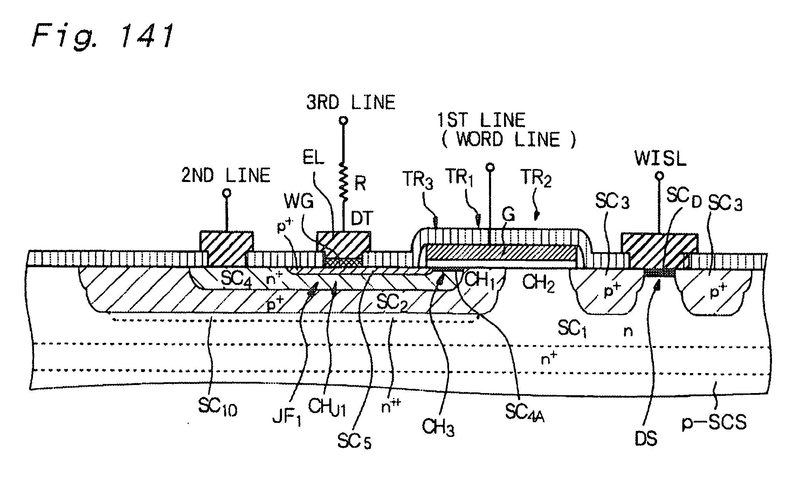

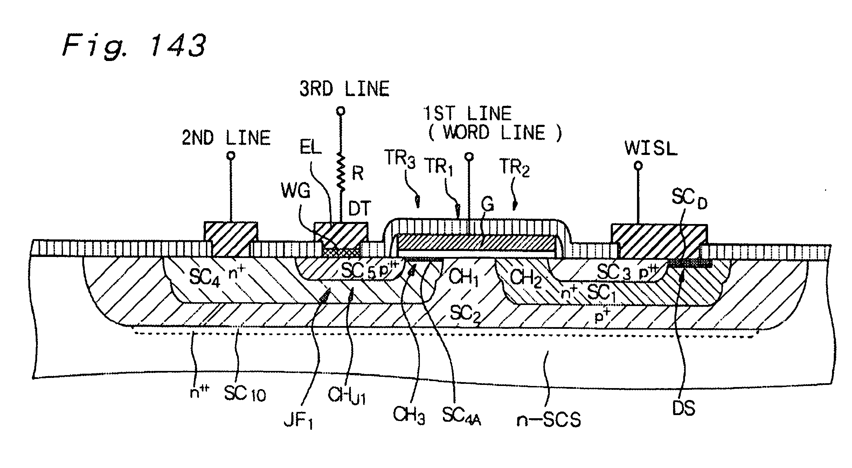

In the semiconductor memory cell shown in Fig. 140 and a semiconductor memory cell to be explained later with reference to Fig. 141, the first region $SC_1$ and the second region $SC_2$ are in contact with each other, and specifically, the second region $SC_2$ is formed in a surface region of the first region $SC_1$. In the semiconductor memory cell shown in Fig. 142 and a semiconductor memory cell to be explained later with reference to Fig. 143, the first region $SC_1$ is formed in a surface region of the second region $SC_2$.

Concerning the first transistor $TR_1$,

(A-1) one source/drain region is formed of a surface region of the first region $SC_1$,

(A-2) the other source/drain region is formed of a surface region of the fourth region $SC_4$, and

(A-3) the channel forming region $CH_1$ is formed of a surface region of the second region $SC_2$ which surface region is interposed between the surface region of the first region $SC_1$ and the surface region of the fourth region $SC_4$.

Concerning the second transistor $TR_2$,

(B-1) one source/drain region is formed of the surface region of the second region $SC_2$,

(B-2) the other source/drain region of the second transistor $TR_2$ is formed of the third region $SC_3$, and

(B-3) the channel forming region $CH_2$ is formed of the surface region of the first region $SC_1$.

Concerning the third transistor $TR_3$,

(C-1) one source/drain region is formed of the surface region of the second region $SC_2$,

(C-2) the other source/drain region of the third transistor $TR_3$ is formed of the fifth region $SC_5$, and

(C-3) the channel forming region $CH_3$ is formed of the surface region of the fourth region $SC_4$.

Concerning the junction-field-effect transistor $JF_1$,

(D-1) the gate regions are formed of the fifth region $SC_5$ and part of the second region $SC_2$ which part is opposed to the fifth region $SC_5$,

(D-2) the channel region $CH_{J1}$ is formed of part of the fourth region $SC_4$ which part is interposed between the fifth region $SC_5$ and said part of the second region $SC_2$,

(D-3) one source/drain region is formed of the surface region of the fourth region $SC_4$ which surface region extends from one end of the channel region $CH_{J1}$ of the junction-field-effect transistor $JF_1$ and constitutes the other source/drain region of the first transistor $TR_1$ and the channel forming region $CH_3$ of the third transistor $TR_3$, and

(D-4) the other source/drain region is formed of a portion of the fourth region $SC_4$ which portion extends from the other end of the channel region $CH_{J1}$ of the junction-field-effect transistor $JF_1$.

Further, concerning the MIS type diode DT,

(E-1) one end thereof is formed of the fifth region $SC_5$, and

(E-2) an electrode constituting the other end thereof is formed to be opposed to the fifth region $SC_5$ which constitutes one end of the MIS type diode DT, through a wide gap thin film WG.

The wide gap thin film WG can be composed of a material in which the tunnel transition of carriers is caused depending upon a potential difference between the potential in the fifth region $SC_5$ (the other source/drain region of the third transistor $TR_3$) and the potential in the other end (electrode EL) of the MIS type diode DT. Specifically, it can be composed, for example, of an $SiO_2$ or SiON film having a thickness of 5 nm or smaller, or an SiN film having a thickness of 9 nm or smaller.

The electrode EL constituting the other end of the MIS type diode DT is connected to the line (third line) through a high-resistance element R having a resistance of approximately $10^9$ to $10^{12}$ $\Omega$. Specifically, the electrode EL constituting the other end of the MIS type diode DT and the high-resistance element R are integrally formed and are composed of a polysilicon thin layer containing an impurity having the first conductivity type.

In the semiconductor memory cell, further,

(F) the gate G is connected to a first line (for example, word line) for memory cell selection,

(G) the third region $SC_3$ is connected to a write-in information setting line WISL,

(H) the portion of the fourth region $SC_4$ which portion constitutes the other source/drain region of the junction-field-effect transistor $JF_1$ is connected to a second line, and

(I) the electrode EL constituting the other end of the MIS type diode DT is connected to a third line having a predetermined potential.

In the semiconductor memory cell of Example 13, an impurity-containing layer $SC_{4A}$ having the second conductivity type (for example, $p^+$-type) is formed in the surface region of the fourth region $SC_4$ which surface region constitutes the channel forming region $CH_3$ of the third transistor $TR_3$. Therefore, while information is retained, and, for example, if the potential in the first line is turned to 0 volt, the third transistor $TR_3$ is brought into an on-state, and the MIS type diode DT and the channel forming region $CH_1$ of the first transistor $TR_1$ are put in a continuity. The impurity concentration of the impurity-containing layer $SC_{4A}$ is adjusted such that the third transistor $TR_3$ is brought into an off-state by the potential in the first line applied during the reading of information.

In the semiconductor memory cells shown in Figs. 140 and 142, the first region $SC_1$ and the third region $SC_3$ constitute a pn junction diode D, and the first region $SC_1$ is connected to the write-in information setting line WISL through the third region $SC_3$. In this case, it is preferred to employ a constitution in which the second line is used as a bit line, or a constitution in which the write-in information setting line WISL is used as a bit line as well and a second predetermined potential is applied to the second line.

The junction-field-effect transistor $JF_1$ is formed by

(X) optimizing the distance between the facing gate regions (the fifth region $SC_5$ and the part of the second region $SC_2$ which part is opposed to the fifth region $SC_5$), that is, the thickness of the channel region $CH_{J2}$, and

(Y) optimizing the impurity concentration of each of the facing gate regions (the fifth region $SC_5$ and the part of the second region $SC_2$ which part is opposed to the fifth region $SC_5$) and the impurity concentration of the channel region $CH_{J1}$.

The semiconductor memory cell (specifically, the first region $SC_1$) shown in Fig. 140 is formed in a well structure which is formed, for example, in an p-type semiconductor substrate and has the first conductivity type (for example, n-type). Further, when a first high-concentration-impurity-containing layer $SC_{10}$ having the first conductivity type (for example, $n^{++}$-type) is formed below the second region $SC_2$, the potential or charge to be stored in the channel forming region $CH_1$ of the first transistor $TR_1$ for readout can be increased. The semiconductor memory cell (specifically, the second region $SC_2$) shown in Fig. 142 is formed in a well structure which is formed, for example, in an n-type semiconductor substrate and has the second conductivity type (for example, p-type). Further, when a first high-concentration-impurity-containing layer $SC_{10}$ having the first conductivity type (for example, $n^{++}$-type) is formed below the second region $SC_2$,

the potential or charge to be stored in the channel forming region $CH_1$ of the first transistor $TR_1$ for readout can be increased.

In the semiconductor memory cell shown in Fig. 140 or Fig. 142, as is shown in the principle drawing of Fig. 138, there may be employed an example in which the formation of the pn junction diode D is omitted and the first region $SC_1$ corresponding to one source/drain region of the first transistor $TR_1$ is connected to the fourth line (not shown in Fig. 140 or 142). That is, for example, in the semiconductor memory cell shown in Fig. 140, a second high-concentration-impurity-containing layer $SC_{11}$ which has the first conductivity type (for example, $n^{++}$-type) and works as the fourth line can be formed below the first region $SC_1$. In these cases, it is preferred to employ a constitution in which the second line is used as a bit line and a second predetermined potential is applied to the fourth line, or a constitution in which the fourth line is used as a bit line and a second predetermined potential is applied to the second line.

In the semiconductor memory cells shown in the schematic partial cross-sectional views of Figs. 141 and Fig. 143 and the principle drawing of Fig. 139B, there may be employed a constitution in which there is further provided a diode-constituting region SCD which is formed in a surface region of the first region SC1 and is in contact with the first region SC1 to form a rectifier junction together with the first region SC1, the diode-constituting region SCD and the first region SC1 constitute a majority carrier diode DS, and the first region SC1 is connected to the write-in information setting line WISL through the diode-constituting region SCD. In this case, it is preferred to employ a constitution in which the second line is used as a bit line, or a constitution in which the write-in information setting line WISL is used as a bit line as well and a second predetermined potential is applied to the second line.

Example 14

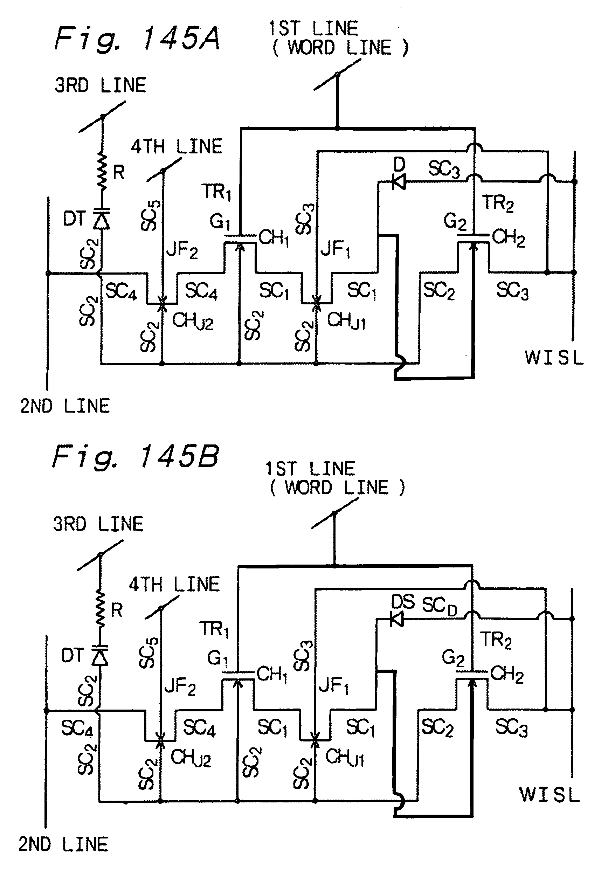

Example 14 is concerned with the semiconductor memory cell according to the ninth aspect of the present invention. The semiconductor memory cell of Example 14 differs from the semiconductor memory cell of Example 7 in that a second junction-field-effect transistor JF2 is provided. That is, as is shown in the principle drawing of Fig. 145A, the semiconductor memory cell of Example 14 comprises;

(1) a first transistor TR1 for readout, having a first conductivity type (for example, n-channel type), and having source/ drain regions, a semi-conductive channel forming region CH1 which is in contact with the source/drain regions and spaces out the source/drain regions, and a gate G capacitively coupled with the channel forming region CH1,

(2) a second transistor TR2 for switching, having a second conductivity type (for example, p-channel type), and having source/drain regions, a semi-conductive channel forming region $CH_2$ which is in contact with the source/ drain regions and spaces out the source/drain regions, and a gate G capacitively coupled with the channel forming region $CH_2$,

(3) a first junction-field-effect transistor $JF_1$ for current control, having source/drain regions, a channel region $CH_{J1}$ and gate regions,

(4) a second junction-field-effect transistor $JF_2$ for current control, having source/drain regions, a channel region $CH_{J2}$ and gate regions, and

(5) an MIS type diode DT for retaining information.

In the semiconductor memory cell of Example 14,

one source/drain region of the first transistor $TR_1$ corresponds to the channel forming region $CH_2$ of the second transistor $TR_2$ and corresponds to one source/drain region of the first junction-field-effect transistor $JF_1$,

the other source/drain region of the first transistor $TR_1$ corresponds to one source/drain region of the second junction-field-effect transistor $JF_2$,

one source/drain region of the second transistor $TR_2$ corresponds to the channel forming region $CH_1$ of the first transistor $TR_1$, corresponds to one gate region of the first junction-field-effect transistor $JF_1$ and corresponds to one gate region of the second junction-field-effect transistor $JF_2$, and

one end of the MIS type diode DT is formed of an extending portion of the channel forming region $CH_1$ of the first transistor $TR_1$, the other end of the MIS type diode DT is formed of an electrode EL composed of a conductive material, and the electrode EL is connected to a line (third line) having a predetermined potential.

In the semiconductor memory cell of Example 14,

the gate of the first transistor $TR_1$ and the gate of the second transistor $TR_2$ are connected to a first line (for example, word line) for memory cell selection, the other source/drain region of the first transistor $TR_1$ is connected to a second line through the second junction-field-effect transistor $JF_2$, the other gate region of the second junction-field-effect transistor $JF_2$ is connected to a fourth line, one source/drain region of the first transistor $TR_1$ is connected to a write-in information setting line WISL through the first junction-field-effect transistor $JF_1$ and a diode D, the other source/drain region of the second transistor $TR_2$ is connected to the write-in information setting line WISL, the other end of the MIS type diode DT is connected to a third line (corresponding to the above line) having a predetermined potential through a high-resistance element R. It is preferred to employ a constitution in which the second line is used as a bit line, or a constitution in which the write-in information setting line WISL is used as a bit line as well and a second predetermined potential is applied to the second line.

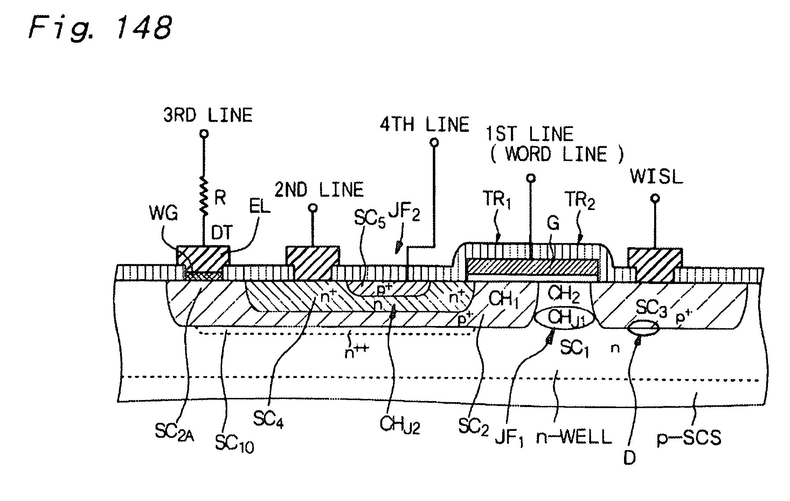

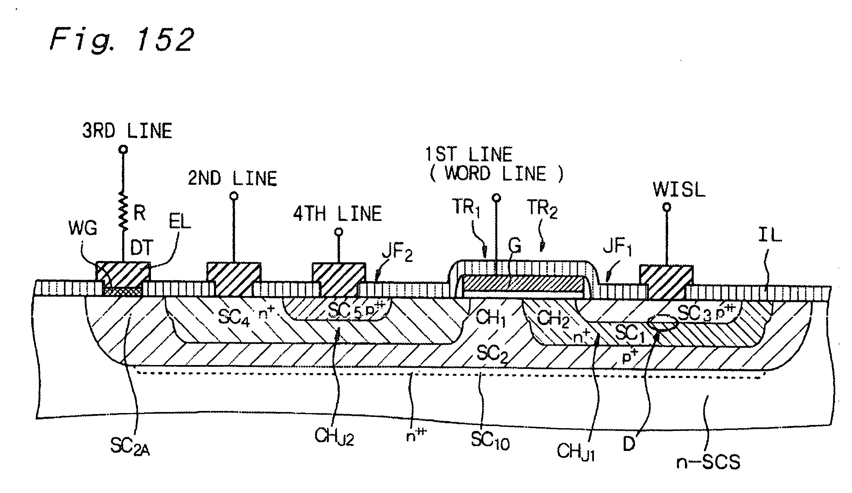

As shown in the schematic partial cross-sectional view of Fig. 148 or Fig. 152, the semiconductor memory cell of Example 14 comprises;

(1) a first transistor $TR_1$ for readout, having a first conductivity type (for example, n-channel type), and having source/drain regions, a semi-conductive channel forming region $CH_1$ which is in contact with the source/drain regions and spaces out the source/drain regions, and a gate G capacitively coupled with the channel forming region $CH_1$,

(2) a second transistor $TR_2$ for switching, having a second conductivity type (for example, p-channel type), and having source/drain regions, a semi-conductive channel forming region $CH_2$ which is in contact with the source/drain regions and spaces out the source/drain regions, and a gate G capacitively coupled with the channel forming region $CH_2$,

(3) a first junction-field-effect transistor $JF_1$ for current control, having source/drain regions, a channel region $CH_{J1}$ and gate regions,

(4) a second junction-field-effect transistor $JF_2$ for current control, having source/drain regions, a channel region $CH_{J2}$ and gate regions, and

(5) an MIS type diode DT for retaining information,

the semiconductor memory cell having;

(a) a semi-conductive first region $SC_1$ having a first conductivity type (for example, n-type),

(b) a semi-conductive second region $SC_2$ which is in contact with the first region $SC_1$ and has a second conductivity type (for example, $p^+$-type),

(c) a third region $SC_3$ which is formed in a surface region of the first region $SC_1$ and is in contact with the first region $SC_1$ so as to form a rectifier junction together with the first region $SC_1$, the third region $SC_3$ being a region which is semi-conductive and has the second conductivity type (for example, $p^+$-type) or which is conductive and is composed of a silicide, a metal or a metal compound,

(d) a semi-conductive fourth region $SC_4$ which is formed in a surface region of the second region $SC_2$ and has the first conductivity type (for example, $n^+$-type),

(e) a fifth region $SC_5$ which is formed in a surface region of the fourth region $SC_4$ and is in contact with the fourth region $SC_4$ so as to form a rectifier junction together with the fourth region $SC_4$, the fifth region $SC_5$ being a region which is semi-conductive and has the second conductivity type (for example, $p^+$-type) or which is conductive and is composed of a silicide, a metal or a metal compound, and

(f) the gate G which is formed, through an insulation layer, so as to bridge the first region $SC_1$ and the fourth region $SC_4$ and so as to bridge the second region $SC_2$ and the third region $SC_3$, and is shared by the first transistor $TR_1$ and the second transistor $TR_2$.

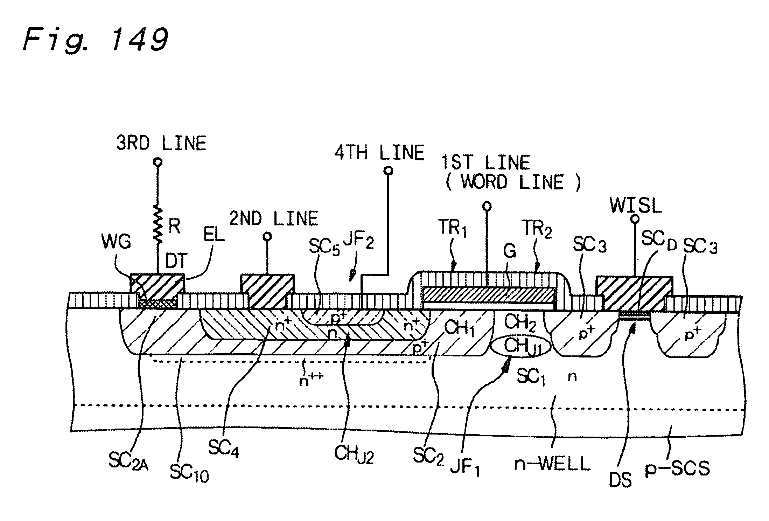

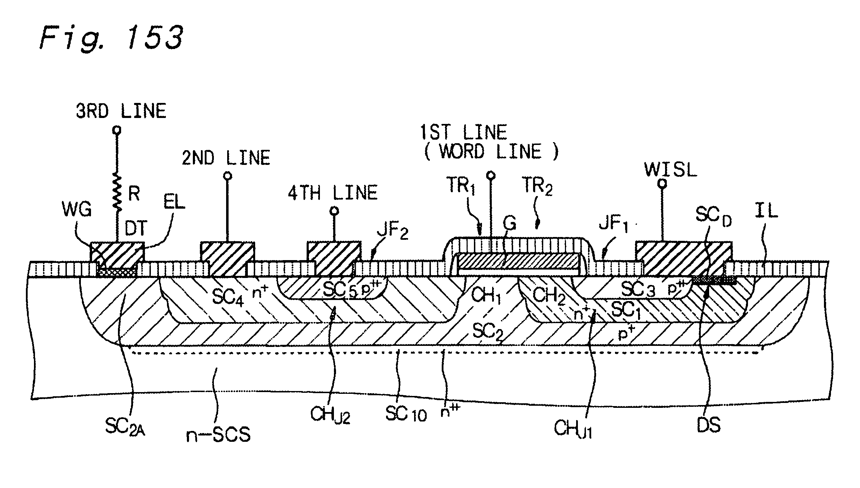

The first region $SC_1$ and the second region $SC_2$ are in contact with each other, and in the semiconductor memory cell shown in Fig. 148 and semiconductor memory cells to be explained later with reference to Figs. 149 to 151, specifically, the second region $SC_2$ is formed in a surface region of the first region $SC_1$. In the semiconductor memory cell shown in Fig. 152 and semiconductor memory cells to be explained later with reference to Figs. 153 to 155, the first region $SC_1$ is formed in a surface region of the second region $SC_2$.

Concerning the first transistor $TR_1$,

(A-1) one source/drain region is formed of a surface region of the first region $SC_1$,

(A-2) the other source/drain region is formed of a surface region of the fourth region $SC_4$, and

(A-3) the channel forming region $CH_1$ is formed of a surface region of the second region $SC_2$ which surface region is interposed between the surface region of the first region $SC_1$ and the surface region of the fourth region $SC_4$.

Concerning the second transistor $TR_2$,

(B-1) one source/drain region is formed of the surface region of the second region $SC_2$,

(B-2) the other source/drain region is formed of the third region $SC_3$, and

(B-3) the channel forming region $CH_2$ is formed of the surface region of the first region $SC_1$.

Concerning the first junction-field-effect transistor $JF_1$,

(C-1) the gate regions are formed of the third region $SC_3$ and part of the second region $SC_2$ which part is opposed to the third region $SC_3$,

(C-2) the channel region $CH_{J1}$ is formed of part of the first region $SC_1$ which part is interposed between the third region $SC_3$ and said part of the second region $SC_2$,

(C-3) one source/drain region is formed of the surface region of the first region $SC_1$ which surface region extends from one end of the channel region $CH_{J1}$ of the first junction-field-effect transistor $JF_1$ and constitutes one source/drain region of the first transistor $TR_1$, and

(C-4) the other source/drain region is formed of a portion of the first region $SC_1$ which portion extends from the other end of the channel region $CH_{J1}$ of the first junction-field-effect transistor $JF_1$.

Concerning the second junction-field-effect transistor $JF_2$,

(D-1) the gate regions are formed of the fifth region $SC_5$ and part of the second region $SC_2$ which part is opposed to the fifth region $SC_5$,

(D-2) the channel region $CH_{J2}$ is formed of part of the fourth region $SC_4$ which part is interposed between the fifth region $SC_5$ and said part of the second region $SC_2$,

(D-3) one source/drain region is formed of the surface region of the fourth region $SC_4$ which surface region extends from one end of the channel region $CH_2$ of the second junction-field-effect transistor $JF_2$ and constitutes the other source/drain region of the first transistor $TR_1$, and

(D-4) the other source/drain region is formed of a portion of the fourth region $SC_4$ which portion extends from the other end of the channel region $CH_{J2}$ of the second junction-field-effect transistor $JF_2$.

Further, concerning the MIS type diode DT,

(E-1) one end thereof is formed of part $SC_{2A}$ of the second region $SC_2$, and

(E-2) an electrode constituting the other end thereof is formed to be opposed to said part $SC_{2A}$, of the second region $SC_2$ which part $SC_{2A}$ constitutes one end of the MIS type diode DT, through a wide gap thin film WG.

The wide gap thin film WG can be composed of a material in which the tunnel transition of carriers is caused depending upon a potential difference between the potential in the second region $SC_2$ (the channel forming region $CH_1$ of the first transistor $TR_1$) and the potential in the other end (electrode EL) of the MIS type diode DT. Specifically, it can be composed, for example, of an $SiO_2$ or SiON film having a thickness of 5 nm or smaller, or an SiN film having a thickness of 9 nm or smaller.

The electrode EL-constituting the other end of the MIS type diode DT is connected to the line (third line) through a high-resistance element R having a resistance of approximately $10^9$ to $10^{12}$ $\Omega$. Specifically, the electrode EL constituting the other end of the MIS type diode DT and the high-resistance element R are integrally formed and are composed of a polysilicon thin layer containing an impurity having the first conductivity type.

In the above semiconductor memory cell, further,

(F) the gate G is connected to a first line (for example, word line) for memory cell selection,

(G) the third region $SC_3$ is connected to a write-in information setting line WISL,

(H) the portion of the fourth region $SC_4$ constituting the other source/drain region of the second junction-field-effect transistor $JF_2$ is connected to a second line,

(I) the electrode EL constituting the other end of the MIS type diode DT is connected to a third line having a predetermined potential, and

(J) the fifth region $SC_5$ is connected to a fourth line.

Further, the first region $SC_1$ and the third region $SC_3$ constitute a pn junction diode D, and the first region $SC_1$ is connected to the write-in information setting line WISL through the third region $SC_3$. In this case, it is preferred to employ a constitution in which the second line is used as a bit line, or a constitution in which the write-in information setting line WISL is used as a bit line as well and a second predetermined potential is applied to the second line.

The semiconductor memory cell (specifically, the first region $SC_1$) shown in Fig. 148 is formed in a well structure which is formed, for example, in an p-type semiconductor substrate and has the first conductivity type (for example, n-type). Further, when a first high-concentration-impurity-containing layer $SC_{10}$ having the first conductivity type (for example, $n^{++}$-type) is formed below the second region $SC_2$, the potential or charge to be stored in the channel forming region $CH_1$ of the first transistor $TR_1$ for readout can be increased. The semiconductor memory cell (specifically, the second region $SC_2$) shown in Fig. 152 is formed in a well structure which is formed, for example, in an n-type semiconductor substrate and has the second conductivity type (for example, p-type). Further, when a first high-concentration-impurity-containing layer $SC_{10}$ having the first conductivity type (for example, $n^{++}$-type) is formed below the second region $SC_2$,

the potential or charge to be stored in the channel forming region $CH_1$ of the first transistor $TR_1$ for readout can be increased.

The first junction-field-effect transistor $JF_1$ is formed by

(X) optimizing the distance between the facing gate regions (the third region $SC_3$ and the part of the second region $SC_2$ which part is opposed to the third region $SC_3$), that is, the thickness of the channel region $CH_{J1}$, and
(Y) optimizing the impurity concentration of each of the facing gate regions (the third region $SC_3$ and the part of the second region $SC_2$ which part is opposed to the third region $SC_3$) and the impurity concentration of the channel region $CH_{J1}$.

Further, the second junction-field-effect transistor $JF_2$ is formed by

(X) optimizing the distance between the facing gate regions (the fifth region $SC_5$ and part of the second region $SC_2$ which part is opposed to the fifth region $SC_5$), that is, the thickness of the channel region $CH_{J2}$, and
(Y) optimizing the impurity concentration of each of the facing gate regions (the fifth region $SC_5$ and the part of the second region $SC_2$ which part is opposed to the fifth region $SC_5$) and the impurity concentration of the channel region $CH_{J2}$.

In the semiconductor memory cells shown in Fig. 148 and Fig. 152, as is shown in the principle drawing of Fig. 144, there may be employed an embodiment in which the formation of the pn junction diode D is omitted and the first region $SC_1$ corresponding to one source/drain region of the first transistor $TR_1$ is connected to a fifth line (not shown in Fig. 148 and Fig. 152). In these cases, it is preferred to employ a constitution in which the second line is used as a bit line and a second predetermined potential is applied to the fifth line, or a constitution in which the fifth line is used as a bit line and a second predetermined potential is applied to the second line. In the semiconductor memory cell shown in Fig. 148, a second high-concentration-impurity-containing layer (not shown) which has the first conductivity type (for example, $n^{++}$-type) and works as the fifth line can be formed below the first region $SC_1$.

In the semiconductor memory cells shown in the principle drawing of Fig. 145B and the schematic partial cross-sectional views of Fig. 149 and Fig. 153, there is further provided a diode-constituting region $SC_D$ which is formed in a surface region of the first region $SC_1$ and is in contact with the first region $SC_1$ to form a rectifier junction together with the first region $SC_1$, the diode-constituting region $SC_D$ and the first region $SC_1$ constitute a majority carrier diode DS, and the first region $SC_1$ is connected to the write-in information setting line WISL through the diode-constituting region $SC_D$. In this case, it is preferred to employ a constitution in which the second line is used as a bit line, or a constitution in which the write-in information setting line WISL is used as a bit line as well and a second predetermined potential is applied to the second line.

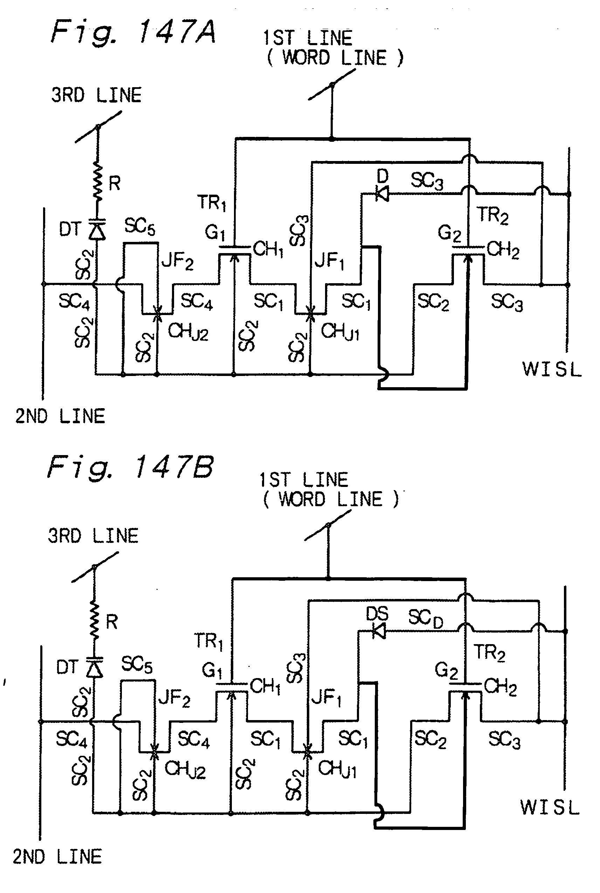

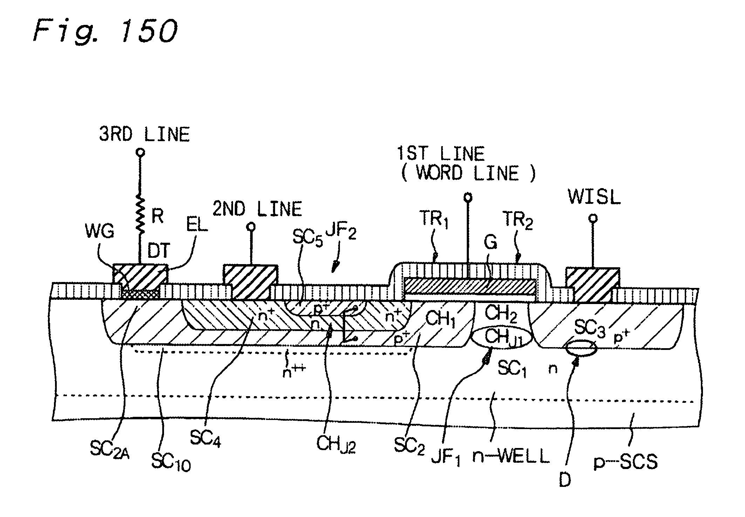

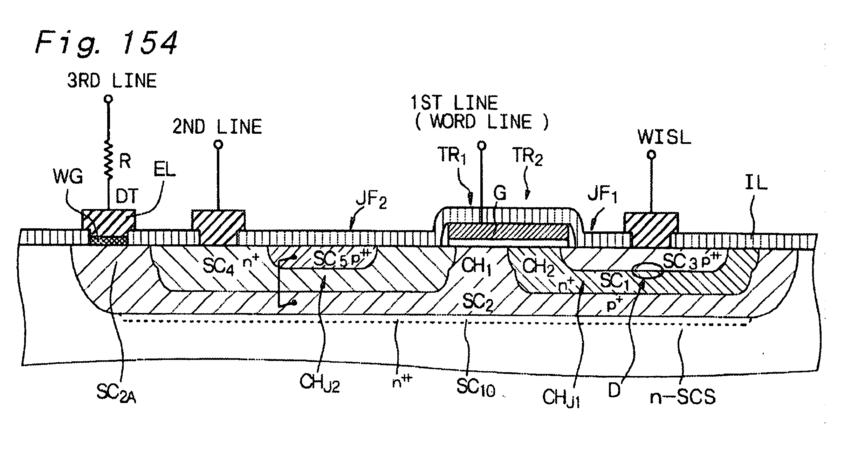

In semiconductor memory cells shown in the principle drawing of Fig. 147A and the schematic partial cross-sectional views of Fig. 150 and 154, the fifth region $SC_5$ corresponding to the other gate region of the second junction-field-effect transistor $JF_2$ is connected to the second region $SC_2$ corresponding to one gate region of the second junction-field-effect transistor $JF_2$ in place of being connected to the fourth line.

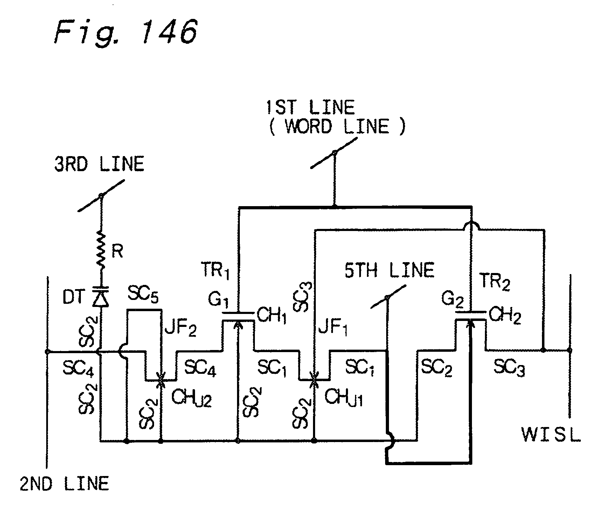

In the semiconductor memory cells shown in Fig. 150 and Fig. 154, as is shown in the principle drawing of Fig. 146, there may be employed an embodiment in which the formation of the pn junction diode D is omitted and the first region $SC_1$ corresponding to one source/drain region of the first transistor $TR_1$ is connected to a fifth line (not shown in Fig. 150 and Fig. 154). In these cases, it is preferred to employ a constitution in which the second line is used as a bit line and a second predetermined potential is applied to the fifth line, or a constitution in which the fifth line is used as a bit line and a second predetermined potential is applied to the second line. In the semiconductor memory cell shown in Fig. 150, the wiring structure of the semiconductor memory cell can be simplified by forming a second high-concentration-impurity-containing layer (not shown) which has the first conductivity type (for example, n++-type) and works as the fifth line, below the first region SC1.

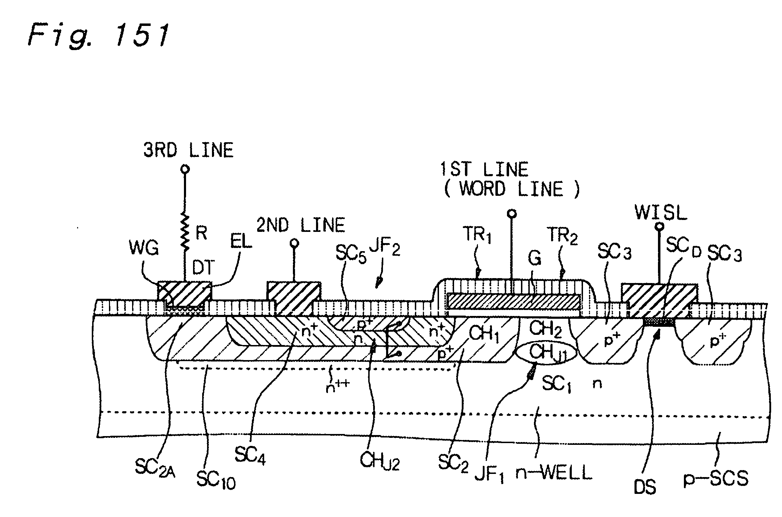

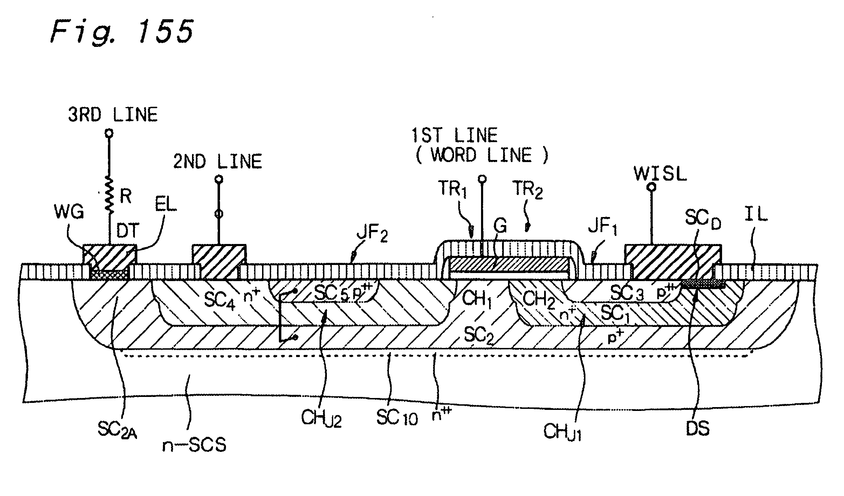

In the semiconductor memory cells shown in the principle drawing of Fig. 147B and the schematic partial cross-sectional views of Fig. 151 and Fig. 155, there is further provided a diode-constituting region SCD which is formed in a surface region of the first region SC1 and is in contact with the first region SC1 to form a rectifier junction together with the first region SC1, the diode-constituting region SCD and the first region SC1 constitute a majority carrier diode DS, and the first region SC1 is connected to the write-in information setting line WISL through the diode-constituting region SCD. In this case, it is preferred to employ a constitution in which the second line is used as a bit line, or a constitution in which the write-in information setting line WISL is used as a bit line as well and a second predetermined potential is applied to the second line.

Example 15

Example 15 is concerned with the semiconductor memory cell according to the ninth aspect of the present invention. The semiconductor memory cell of Example 15 differs from the semiconductor memory cell of Example 14 in that one end of the MIS type diode DT and the other gate region of the second junction-field-effect transistor JF2 are formed as a common region. Further, the fifth region SC5 constituting the other gate region of the second junction-field-effect transistor JF2 corresponds to an extending portion of the channel forming region CH1 of the first transistor TR1.

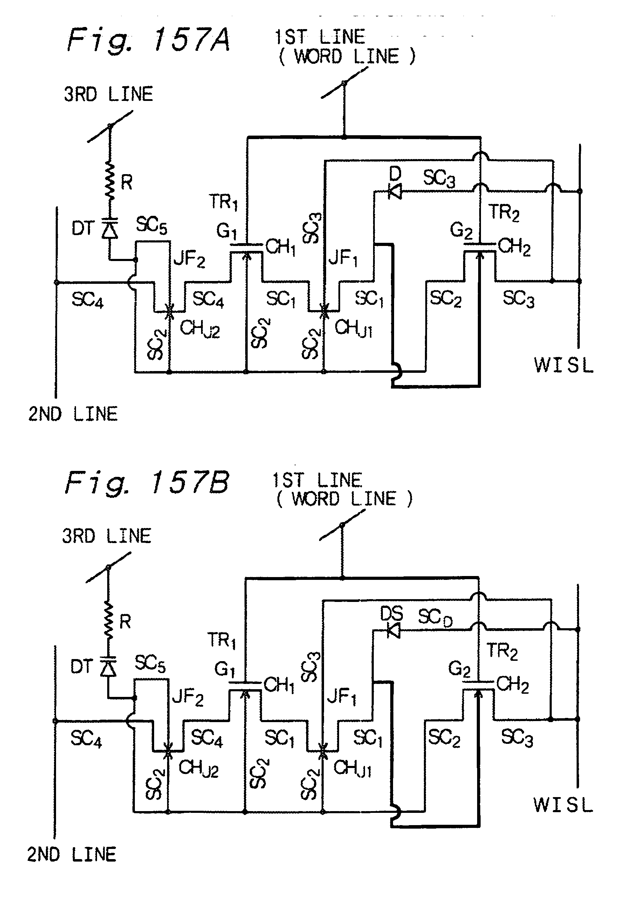

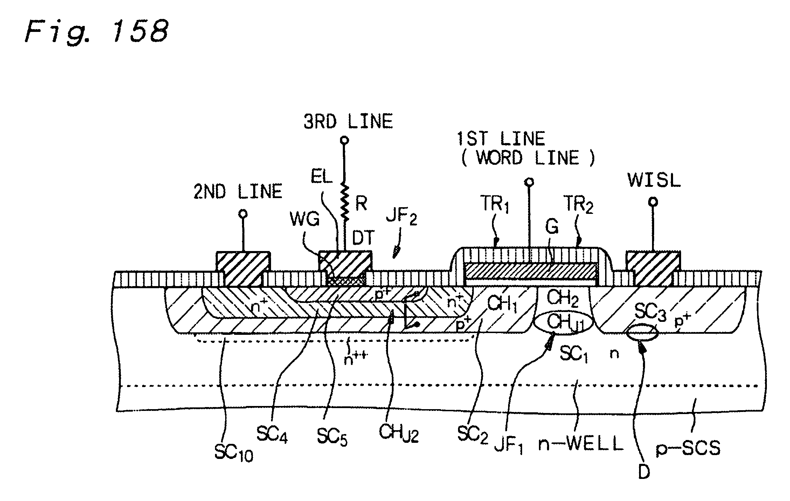

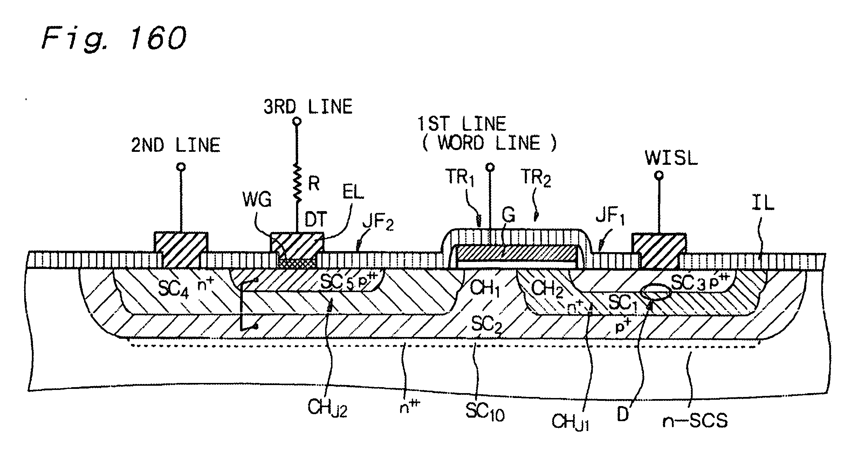

That is, the semiconductor memory cell of Example 15 shown in the principle drawing of Fig. 157A and the schematic partial cross-sectional views of Fig. 158 and Fig. 160 comprises;

(1) a first transistor $TR_1$ for readout, having a first conductivity type (for example, n-channel type), and having source/drain regions, a semi-conductive channel forming region $CH_1$ which is in contact with the source/drain regions and spaces out the source/drain regions, and a gate G capacitively coupled with the channel forming region $CH_1$,

(2) a second transistor $TR_2$ for switching, halving a second conductivity type (for example, p-channel type), and having source/drain regions, a semi-conductive channel forming region $CH_2$ which is in contact with the source/drain regions and spaces out the source/drain regions, and a gate G capacitively coupled with the channel forming region $CH_2$,

(3) a first junction-field-effect transistor $JF_1$ for current control, having source/drain regions, a channel region $CH_{J1}$ and gate regions,

(4) a second junction-field-effect transistor $JF_2$ for current control, having source/drain regions, a channel region $CH_{J2}$ and gate regions, and

(5) an MIS type diode DT for retaining information,

the semiconductor memory cell having;

(a) a semi-conductive first region $SC_1$ having a first conductivity type (for example, n-type),

(b) a semi-conductive second region $SC_2$ which is in contact with the first region $SC_1$ and has a second conductivity type (for example, $p^+$-type),

(c) a third region $SC_3$ which is formed in a surface region of the first region $SC_1$ and is in contact with the first region $SC_1$ so as to form a rectifier junction together with the first region $SC_1$, the third region $SC_3$ being a region which is semi-conductive and has the second conductivity type (for example, $p^+$-type) or which is conductive and is composed of a silicide, a metal or a metal compound,

(d) a semi-conductive fourth region $SC_4$ which is formed in a surface region of the second region $SC_2$ and has the first conductivity type (for example, $n^+$-type),

(e) a semi-conductive fifth region $SC_5$ which is formed in a surface region of the fourth region $SC_4$ and has the second conductivity type (for example, $p^+$-type), and

(f) the gate G which is formed, through an insulation layer, so as to bridge the first region $SC_1$ and the fourth region $SC_4$ and so as to bridge the second region $SC_2$ and the third region $SC_3$, and is shared by the first transistor $TR_1$ and the second transistor $TR_2$.

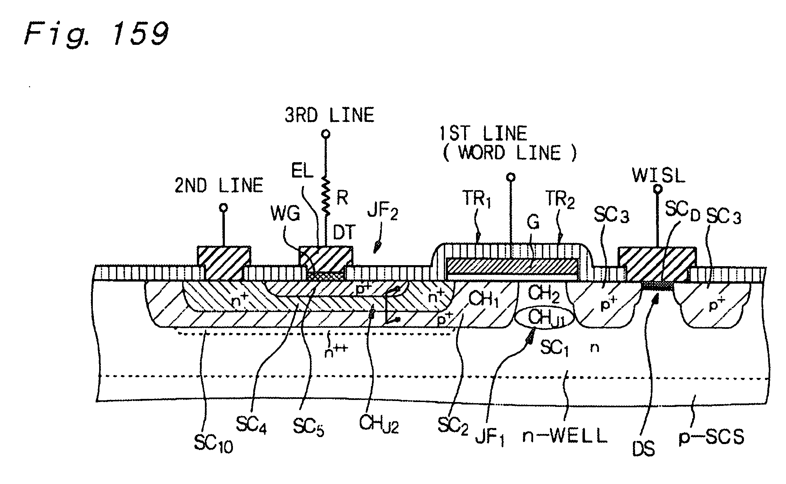

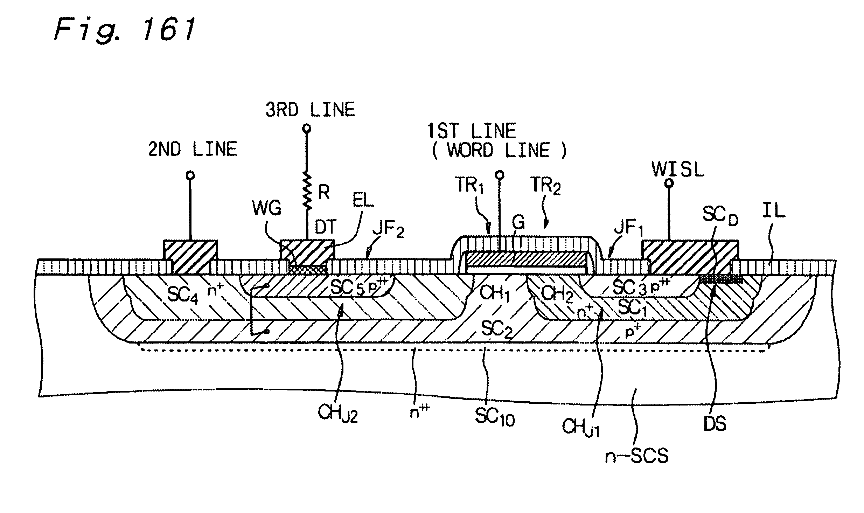

While the first region $SC_1$ and the second region $SC_2$ are in contact with each other, specifically, in the semiconductor memory cell shown in Fig. 158 or a semiconductor memory cell to be explained later with reference to Fig. 159, the second region $SC_2$ is formed in a surface region of the first region $SC_1$. In the semiconductor memory cell shown in Fig. 160 or a semiconductor memory cell to be explained later with reference to Fig. 161, the first region $SC_1$ is formed in a surface region of the second region $SC_2$.

Concerning the first transistor $TR_1$,

(A-1) one source/drain region is formed of a surface region of the first region $SC_1$,

(A-2) the other source/drain region is formed of a surface region of the fourth region $SC_4$, and

(A-3) the channel forming region $CH_1$ is formed of a surface region of the second region $SC_2$ which surface region is interposed between the surface region of the first region $SC_1$ and the surface region of the fourth region $SC_4$.

Concerning the second transistor $TR_2$,

(B-1) one source/drain region is formed of the surface region of the second region $SC_2$,

(B-2) the other source/drain region is formed of the third region $SC_3$, and

(B-3) the channel forming region $CH_2$ is formed of the surface region of the first region $SC_1$.

Concerning the first junction-field-effect transistor $JF_1$,

(C-1) the gate regions are formed of the third region $SC_3$ and part of the second region $SC_2$ which part is opposed to the third region $SC_3$,

(C-2) the channel region $CH_{J1}$ is formed of part of the first region $SC_1$ which part is interposed between the third region $SC_3$ and said part of the second region $SC_2$,

(C-3) one source/drain region is formed of the surface region of the first region $SC_1$ which surface region extends from one end of the channel region $CH_{J1}$ of the first junction-field-effect transistor $JF_1$ and constitutes one source/ drain region of the first transistor $TR_1$, and

(C-4) the other source/drain region is formed of a portion of the first region $SC_1$ which portion extends from the other end of the channel region $CH_{J1}$ of the first junction-field-effect transistor $JF_1$.

Concerning the second junction-field-effect transistor $JF_2$,

(D-1) the gate regions are formed of the fifth region $SC_5$ and part of the second region $SC_2$ which part is opposed to the fifth region $SC_5$,

(D-2) the channel region $CH_{J2}$ is formed of part of the fourth region $SC_4$ which part is interposed between the fifth region $SC_5$ and said part of the second region $SC_2$,

(D-3) one source/drain region is formed of the surface region of the fourth region $SC_4$ which surface region extends from one end of the channel region $CH_{J2}$ of the second junction-field-effect transistor $JF_2$ and constitutes the other source/drain region of the first transistor $TR_1$, and

(D-4) the other source/drain region is formed of a portion of the fourth region $SC_4$ which portion extends from the other end of the channel region $CH_{J2}$ of the second junction-field-effect transistor $JF_2$.

Further, concerning the MIS type diode DT,

(E-1) one end thereof is formed of the fifth region $SC_5$, and

(E-2) an electrode constituting the other end thereof is formed to be opposed to the fifth region $SC_5$ which constitutes one end of the MIS type diode DT, through a wide gap thin film WG.

The wide gap thin film WG can be composed of a material in which the tunnel transition of carriers is caused depending upon a potential difference between the potential in the fifth region $SC_5$ (corresponding to the extending portion of the channel forming region $CH_1$ of the first transistor $TR_1$) and the potential in the other end (electrode EL) of the MIS type diode DT. Specifically, it can be composed, for example, of an $SiO_2$ or SiON film having a thickness of 5 nm or smaller, or an SiN film having a thickness of 9 nm or smaller.

The electrode EL constituting the other end of the MIS type diode DT is connected to the line (third line) through a high-resistance element R having a resistance of approximately $10^9$ to $10^{12}\,\Omega$. Specifically, the electrode EL constituting the other end of the MIS type diode DT and the high-resistance element R are integrally formed and are composed of a polysilicon thin layer containing an impurity having the first conductivity type.

In the above semiconductor memory cell, further,

(F) the gate G is connected to a first line (for example, word line) for memory cell selection,

(G) the third region $SC_3$ is connected to a write-in information setting line WISL,

(H) the portion of the fourth region $SC_4$ constituting the other source/drain region of the second junction-field-effect transistor $JF_2$ is connected to a second line,

(I) the fifth region $SC_5$ is connected to the second region $SC_2$, and

(J) the electrode EL constituting the other end of the MIS type diode DT is connected to a third line having a predetermined potential.

Further, the first region $SC_1$ and the third region $SC_3$ constitute a pn junction diode D, and the first region $SC_1$ is connected to the write-in information setting line WISL through the third region $SC_3$. In this case, it is preferred to employ a constitution in which the second line is used as a bit line, or a constitution in which the write-in information setting line WISL is used as a bit line as well and a second predetermined potential is applied to the second line.

The semiconductor memory cell (specifically, the first region $SC_1$) shown in Fig. 158 is formed in a well structure which is formed, for example, in an p-type semiconductor substrate and has the first conductivity type (for example, n-type). Further, when a first high-concentration-impurity-containing layer $SC_{10}$ having the first conductivity type (for example, $n^{++}$-type) is formed below the second region $SC_2$, the potential or charge to be stored in the channel forming region $CH_1$ of the first transistor $TR_1$ for readout can be increased. The semiconductor memory cell (specifically, the second region $SC_2$) shown in Fig. 160 is formed in a well structure which is formed, for example, in an n-type semiconductor substrate and has the second conductivity type (for example, p-type). Further, when a first high-concentration-impurity-

containing layer $SC_{10}$ having the first conductivity type (for example, $n^{++}$-type) is formed below the second region $SC_2$, the potential or charge to be stored in the channel forming region $CH_1$ of the first transistor $TR_1$ for readout can be increased.

The first junction-field-effect transistor $JF_1$ is formed by

(X) optimizing the distance between the facing gate regions (the third region $SC_3$ and the part of the second region $SC_2$ which part is opposed to the third region $SC_3$), that is, the thickness of the channel region $CH_{J1}$, and
(Y) optimizing the impurity concentration of each of the facing gate regions (the third region $SC_3$ and the part of the second region $SC_2$ which part is opposed to the third region $SC_3$) and the impurity concentration of the channel region $CH_{J1}$.

Further, the second junction-field-effect transistor $JF_2$ is formed by

(X) optimizing the distance between the facing gate regions (the fifth region $SC_5$ and the part of the second region $SC_2$ which part is opposed to the fifth region $SC_5$), that is, the thickness of the channel region $CH_{J2}$, and
(Y) optimizing the impurity concentration of each of the facing gate regions (the fifth region $SC_5$ and the part of the second region $SC_2$ which part is opposed to the fifth region $SC_5$) and the impurity concentration of the channel region $CH_{J2}$.

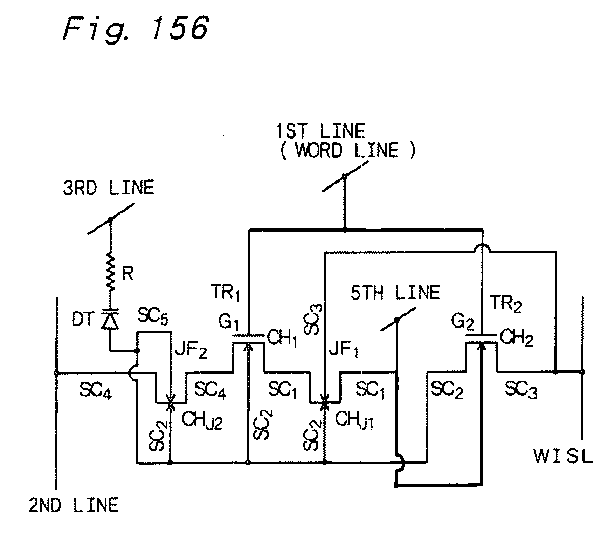

In the semiconductor memory cells shown in Fig. 158 and Fig. 160, as is shown in the principle drawing of Fig. 156, there may be employed an embodiment in which the formation of the pn junction diode D is omitted and the first region $SC_1$ corresponding to one source/drain region of the first transistor $TR_1$ is connected to a fifth line (not shown in Fig. 158 and Fig. 160). In these cases, it is preferred to employ a constitution in which the second line is used as a bit line and a second predetermined potential is applied to the fifth line, or a constitution in which the fifth line is used as a bit line and a second predetermined potential is applied to the second line. In the semiconductor memory cell shown in Fig. 158, a second high-concentration-impurity-containing layer (not shown) which has the first conductivity type (for example, n++-type) and works as the fifth line can be formed below the first region SC1.

In the semiconductor memory cells shown in the principle drawing of Fig. 157B and the schematic partial cross-sectional views of Fig. 159 and Fig. 161, there is further provided a diode-constituting region SCD which is formed in a surface region of the first region SC1 and is in contact with the first region SC1 to form a rectifier junction together with the first region SC1, the diode-constituting region SCD and the first region SC1 constitute a majority carrier diode DS, and the first region SC1 is connected to the write-in information setting line WISL through the diode-constituting region SCD. In this case, it is preferred to employ a constitution in which the second line is used as a bit line, or a constitution in which the write-in information setting line WISL is used as a bit line as well and a second predetermined potential is applied to the second line.

Example 16

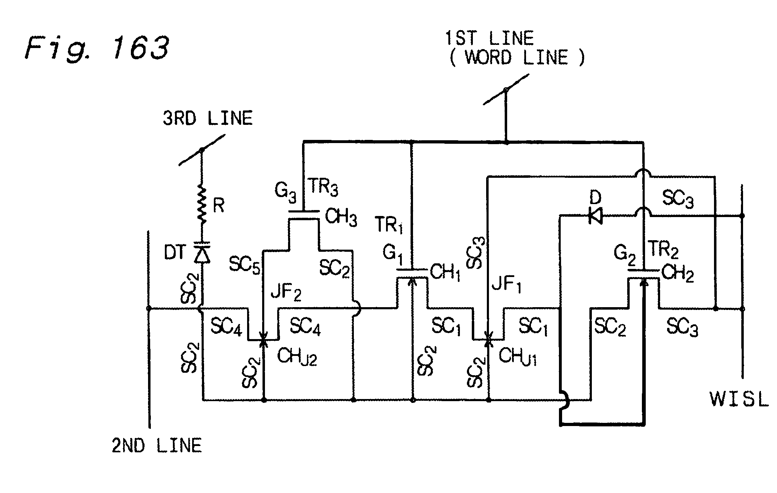

Example 16 is concerned with the semiconductor memory cell according to the tenth aspect of the present invention. The semiconductor memory cell of Example 16 differs from the semiconductor memory cell of Example 14 in that a third transistor TR3 for current control is provided. That is, as is shown in the principle drawing of Fig. 163, the semiconductor memory cell of Example 16 comprises;

(1) a first transistor TR1 for readout, having a first conductivity type (for example, n-channel type), and having source/drain regions, a semi-conductive channel forming region CH1 which is in contact with the source/drain regions and spaces out the source/drain regions, and a gate G capacitively coupled with the channel forming region CH1,
(2) a second transistor $TR_2$ for switching, having a second conductivity type (for example, p-channel type), and having source/drain regions, a semi-conductive channel forming region $CH_2$ which is in contact with the source/drain regions and spaces out the source/drain regions, and a gate G capacitively coupled with the channel forming region $CH_2$,
(3) a third transistor $TR_3$ for current control, having the second conductivity type (for example, p-channel type), and having source/drain regions, a semi-conductive channel forming region $CH_3$ which is in contact with the source/drain regions and spaces out the source/drain regions, and a gate G capacitively coupled with the channel forming region $CH_3$,
(4) a first junction-field-effect transistor $JF_1$ for current control, having source/drain regions, a channel region $CH_{J1}$ and gate regions,
(5) a second junction-field-effect transistor $JF_2$ for current control, having source/drain regions, a channel region $CH_{J2}$ and gate regions, and

(6) an MIS type diode DT for retaining information,

wherein:

one source/drain region of the first transistor $TR_1$ corresponds to the channel forming region $CH_2$ of the second transistor $TR_2$ and corresponds to one source/drain region of the first junction-field-effect transistor $JF_1$,
the other source/drain region of the first transistor $TR_1$ corresponds to one source/drain region of the second junction-field-effect transistor $JF_2$,
one source/drain region of the second transistor $TR_2$ corresponds to the channel forming region $CH_1$ of the first transistor $TR_1$, corresponds to one gate region of the first junction-field-effect transistor $JF_1$, corresponds to one gate region of the second junction-field-effect transistor $JF_2$ and corresponds to one source/drain region of the third transistor $TR_3$,
the other source/drain region of the third transistor $TR_3$ corresponds to the other gate region of the second junction-field-effect transistor $JF_2$, and
one end of the MIS type diode DT is formed of an extending portion of the channel forming region $CH_1$ of the first transistor $TR_1$, the other end of the MIS type diode DT is formed of an electrode EL composed of a conductive material, and the electrode EL is connected to a line (third line) having a predetermined potential.

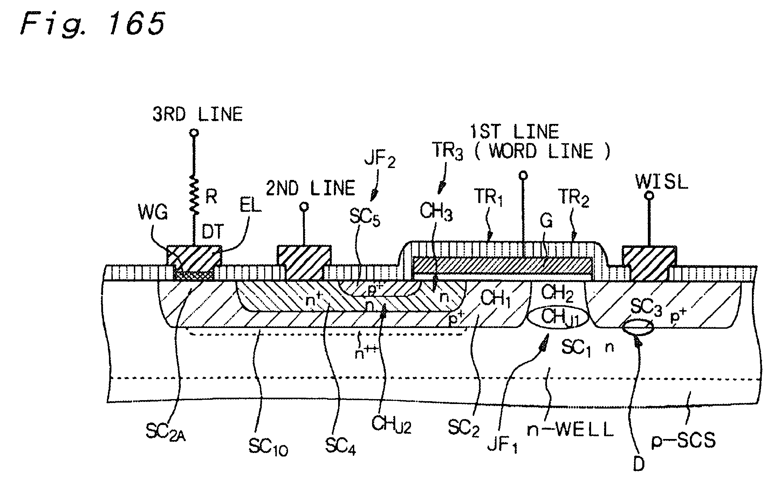

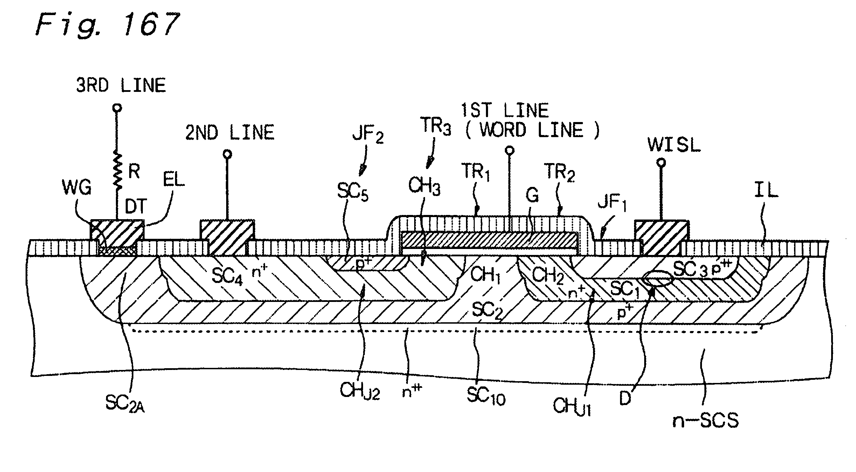

Further, the gate of the first transistor $TR_1$, the gate of the second transistor $TR_2$ and the gate of the third transistor $TR_3$ are connected to a first line (for example, word line) for memory cell selection, the other source/drain region of the first transistor $TR_1$ is connected to a second line through the second junction-field-effect transistor $JF_2$, one source/drain region of the first transistor $TR_1$ is connected to a write-in information setting line WISL through the first junction-field-effect transistor $JF_1$ and a diode D, the other source/drain region of the second transistor $TR_2$ is connected to the write-in information setting line WISL, the other gate region of the first junction-field-effect transistor $JF_1$ is connected to the write-in information setting line WISL, and the other end of the MIS type diode DT is connected to the above line (third line) having a predetermined potential through a high-resistance element R. It is preferred to employ a constitution in which the second line is used as a bit line, or a constitution in which the write-in information setting line WISL is used as a bit line as well and a second predetermined potential is applied to the second line.
As is shown in the schematic partial cross-sectional views of Figs. 165 and 167, the semiconductor memory cell of Example 16 comprises;

(1) a first transistor $TR_1$ for readout, having a first conductivity type (for example, n-channel type), and having source/drain regions, a semi-conductive channel forming region $CH_1$ which is in contact with the source/drain regions and spaces out the source/drain regions, and a gate G capacitively coupled with the channel forming region $CH_1$,
(2) a second transistor $TR_2$ for switching, having a second conductivity type (for example, p-channel type), and having source/drain regions, a semi-conductive channel forming region $CH_2$ which is in contact with the source/drain regions and spaces out the source/drain regions, and a gate G capacitively coupled with the channel forming region $CH_2$,
(3) a third transistor $TR_3$ for current control, having the second conductivity type (for example, p-channel type), and having source/drain regions, a semi-conductive channel forming region $CH_3$ which is in contact with the source/drain regions and spaces out the source/drain regions, and a gate G capacitively coupled with the channel forming region $CH_3$,
(4) a first junction-field-effect transistor $JF_1$ for current control, having source/drain regions, a channel region $CH_{J1}$ and gate regions,
(5) a second junction-field-effect transistor $JF_2$ for current control, having source/drain regions, a channel region $CH_{J1}$ and gate regions, and
(6) an MIS type diode DT for retaining information,
the semiconductor memory cell having;

(a) a semi-conductive first region $SC_1$ having a first conductivity type (for example, n-type),
(b) a semi-conductive second region $SC_2$ which is in contact with the first region $SC_1$ and has a second conductivity type (for example, $p^+$-type),
(c) a third region $SC_3$ which is formed in a surface region of the first region $SC_1$ and is in contact with the first region $SC_1$ so as to form a rectifier junction together with the first region $SC_1$, the third region $SC_3$ being a region which is semi-conductive and has the second conductivity type (for example, $p^+$-type) or which is conductive and is composed of a silicide, a metal or a metal compound,
(d) a semi-conductive fourth region $SC_4$ which is formed in a surface region of the second region $SC_2$ and has the first conductivity type (for example, $n^+$-type),

(e) a fifth region $SC_5$ which is formed in a surface region of the fourth region $SC_4$ and is in contact with the fourth region $SC_4$ so as to form a rectifier junction together with the fourth region $SC_4$, the fifth region $SC_5$ being a region which is semi-conductive and has the second conductivity type (for example, $p^+$-type) or which is conductive and is composed of a silicide, a metal or a metal compound, and

(f) the gate G which is formed, through an insulation layer, so as to bridge the first region $SC_1$ and the fourth region $SC_4$, so as to bridge the second region $SC_2$ and the third region $SC_3$ and so as to bridge the second region $SC_2$ and the fifth region $SC_5$, and is shared by the first transistor $TR_1$, the second transistor $TR_2$ and the third transistor $TR_3$.

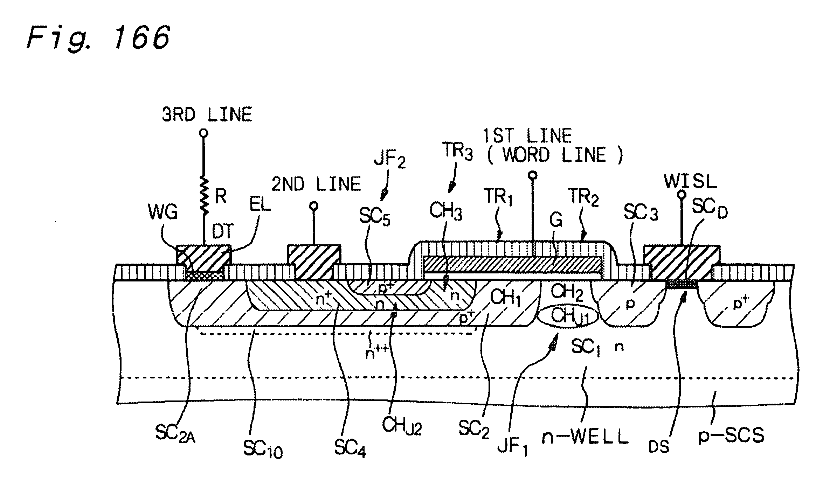

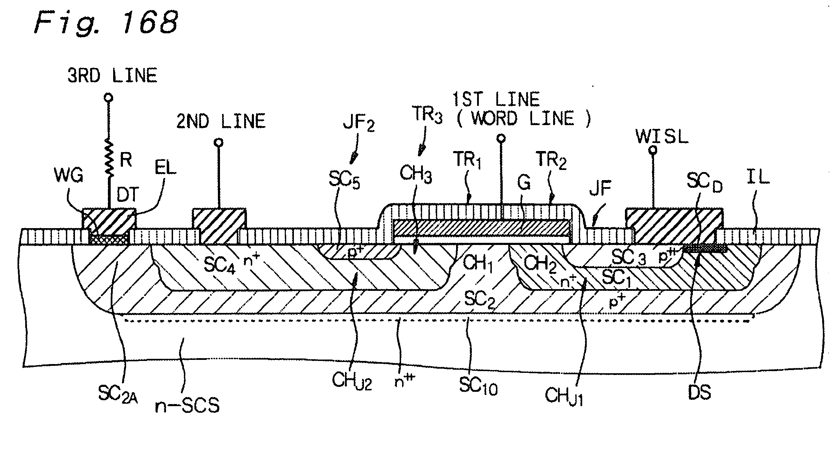

While the first region $SC_1$ and the second region $SC_2$ are in contact with each other, specifically, in the semiconductor memory cell shown in Fig. 165 or a semiconductor memory cell to be explained later with reference to Fig. 166, the second region $SC_2$ is formed in a surface region of the first region $SC_1$. In the semiconductor memory cell shown in Fig. 167 or a semiconductor memory cell to be explained later with reference to Fig. 168, the first region $SC_1$ is formed in a surface region of the second region $SC_2$.

Concerning the first transistor $TR_1$,

(A-1) one source/drain region is formed of a surface region of the first region $SC_1$,
(A-2) the other source/drain region is formed of a surface region of the fourth region $SC_4$, and
(A-3) the channel forming region $CH_1$ is formed of a surface region of the second region $SC_2$ which surface region is interposed between the surface region of the first region $SC_1$ and the surface region of the fourth region $SC_4$.

Concerning the second transistor $TR_2$,

(B-1) one source/drain region is formed of the surface region of the second region $SC_2$,
(B-2) the other source/drain region is formed of the third region $SC_3$, and
(B-3) the channel forming region $CH_2$ is formed of the surface region of the first region $SC_1$.

Concerning the third transistor $TR_3$,

(C-1) one source/drain region is formed of the surface region of the second region $SC_2$,
(C-2) the other source/drain region is formed of the fifth region $SC_5$, and
(C-3) the channel forming region $CH_3$ is formed of the surface region of the fourth region $SC_4$.

Concerning the first junction-field-effect transistor $JF_1$,

(D-1) the gate regions are formed of the third region $SC_3$ and part of the second region $SC_2$ which part is opposed to the third region $SC_3$,
(D-2) the channel region $CH_{J1}$ is formed of part of the first region $SC_1$ which part is interposed between the third region $SC_3$ and said part of the second region $SC_2$,
(D-3) one source/drain region is formed of the surface region of the first region $SC_1$ which surface region extends from one end of the channel region $CH_{J1}$ of the first junction-field-effect transistor $JF_1$ and constitutes one source/drain region of the first transistor $TR_1$, and
(D-4) the other source/drain region is formed of a portion of the first region $SC_1$ which portion extends from the other end of the channel region $CH_{J1}$ of the first junction-field-effect transistor $JF_1$.

Concerning the second junction-field-effect transistor $JF_2$,

(E-1) the gate regions are formed of the fifth region $SC_5$ and part of the second region $SC_2$ which part is opposed to the fifth region $SC_5$,
(E-2) the channel region $CH_{J2}$ is formed of part of the fourth region $SC_4$ which part is interposed between the fifth region $SC_5$ and said part of the second region $SC_2$,
(E-3) one source/drain region is formed of the surface region of the fourth region $SC_4$ which surface region extends from one end of the channel region $CH_{J2}$ of the second junction-field-effect transistor $JF_2$ and constitutes the other source/drain region of the first transistor $TR_1$ and the channel forming region $CH_3$ of the third transistor $TR_3$, and
(E-4) the other source/drain region is formed of a portion of the fourth region $SC_4$ which portion extends from the other end of the channel region $CH_{J2}$ of the second junction-field-effect transistor $JF_2$.

Further, concerning the MIS type diode DT,

(F-1) one end thereof is formed of part $SC_{2A}$ of the second region $SC_2$, and
(F-2) an electrode constituting the other end thereof is formed to be opposed to said part $SC_{2A}$ of the second region $SC_2$ which part constitutes one end of the MIS type diode DT, through a wide gap thin film WG.

The wide gap thin film WG can be composed of a material in which the tunnel transition of carriers is caused depending upon a potential difference between the potential in the second region $SC_2$ (the channel forming region $CH_1$ of the first transistor $TR_1$) and the potential in the other end (electrode EL) of the MIS type diode DT. Specifically, it can be composed, for example, of an $SiO_2$ or SiON film having a thickness of 5 nm or smaller, or an SiN film having a thickness of 9 nm or smaller.

The electrode EL constituting the other end of the MIS type diode DT is connected to the line (third line) through a high-resistance element R having a resistance of approximately $10^9$ to $10^{12}$ Ω. Specifically, the electrode EL constituting the other end of the MIS type diode DT and the high-resistance element R are integrally formed and are composed of a polysilicon thin layer containing an impurity having the first conductivity type.

In the above semiconductor memory cell, further,

(G) the gate G is connected to a first line (for example, word line) for memory cell selection,
(H) the third region $SC_3$ is connected to a write-in information setting line WISL,
(I) the portion of the fourth region $SC_4$ constituting the other source/drain region of the second junction-field-effect transistor $JF_2$ is connected to a second line, and
(J) the electrode EL constituting the other end of the MIS type diode DT is connected to a third line having a predetermined potential.

Further, the first region $SC_1$ and the third region $SC_3$ constitute a pn junction diode D, and the first region $SC_1$ is connected to the write-in information setting line WISL through the third region $SC_3$. In this case, it is preferred to employ a constitution in which the second line is used as a bit line, or a constitution in which the write-in information setting line WISL is used as a bit line as well and a second predetermined potential is applied to the second line.

The semiconductor memory cell (specifically, the first region $SC_1$) shown in Fig. 165 is formed in a well structure which is formed, for example, in an p-type semiconductor substrate and has the first conductivity type (for example, n-type). Further, when a first high-concentration-impurity-containing layer $SC_{10}$ having the first conductivity type (for example, $n^{++}$-type) is formed below the second region $SC_2$, the potential or charge to be stored in the channel forming region $CH_1$ of the first transistor $TR_1$ for readout can be increased. The semiconductor memory cell (specifically, the second region $SC_2$) shown in Fig. 167 is formed in a well structure which is formed, for example, in an n-type semiconductor substrate and has the second conductivity type (for example, p-type). Further, when a first high-concentration-impurity-containing layer $SC_{10}$ having the first conductivity type (for example, $n^{++}$-type) is formed below the second region $SC_2$, the potential or charge to be stored in the channel forming region $CH_1$ of the first transistor $TR_1$ for readout can be increased.

The first junction-field-effect transistor $JF_1$ is formed by

(X) optimizing the distance between the facing gate regions (the third region $SC_3$ and the part of the second region $SC_2$ which part is opposed to the third region $SC_3$), that is, the thickness of the channel region $CH_{J1}$, and
(Y) optimizing the impurity concentration of each of the facing gate regions (the third region $SC_3$ and the part of the second region $SC_2$ which part is opposed to the third region $SC_3$) and the impurity concentration of the channel region $CH_{J2}$.

Further, the second junction-field-effect transistor $JF_2$ is formed by

(X) optimizing the distance between the facing gate regions (the fifth region $SC_5$ and the part of the second region $SC_2$ which part is opposed to the fifth region $SC_5$), that is, the thickness of the channel region $CH_{J2}$, and
(Y) optimizing the impurity concentration of each of the facing gate regions (the fifth region $SC_5$ and the part of the second region $SC_2$ which part is opposed to the fifth region $SC_5$) and the impurity concentration of the channel region $cH_{J2}$.

In the semiconductor memory cells shown in Fig. 165 and Fig. 167, as is shown in the principle drawing of Fig. 162, there may be employed an embodiment in which the formation of the pn junction diode D is omitted and the first region $SC_1$ corresponding to one source/drain region of the first transistor $TR_1$ is connected to a fourth line (not shown in Fig. 165 and Fig. 167). In these cases, it is preferred to employ a constitution in which the second line is used as a bit line and a second predetermined potential is applied to the fourth line, or a constitution in which the fourth line is used as a bit line and a second predetermined potential is applied to the second line. In the semiconductor memory cell shown in Fig. 165, the wiring structure thereof can be simplified by forming a second high-concentration-impurity-containing layer (not shown) which has the first conductivity type (for example, $n^{++}$-type) and works as the fourth line, below the first region $SC_1$.

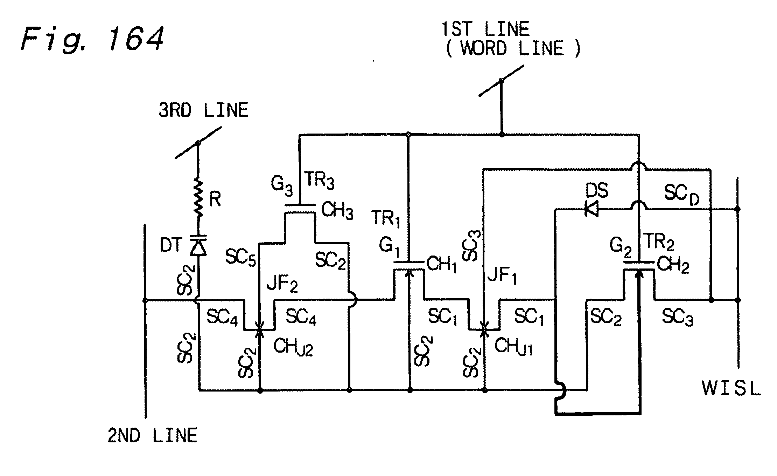

In semiconductor memory cells shown in the principle drawing of Fig. 164 and the schematic partial cross-sectional views of Fig. 166 and Fig. 168, there is further provided a diode-constituting region $SC_D$ which is formed in a surface region of the first region $SC_1$ and is in contact with the first region $SC_1$ to form a rectifier junction together with the first region $SC_1$, the diode-constituting region $SC_D$ and the first region $SC_1$ constitute a majority carrier diode DS, and the first region $SC_1$ is connected to the write-in information setting line WISL through the diode-constituting region $SC_D$. In this case, it is preferred to employ a constitution in which the second line is used as a bit line, or a constitution in which the write-in information setting line WISL is used as a bit line as well and a second predetermined potential is applied to the second line.

Example 17

Example 17 is concerned with the semiconductor memory cell according to the eleventh aspect which is not part of the present invention. The semiconductor memory cell of Example 17 differs from the semiconductor memory cell of Example 16 in that one end of the MIS type diode DT and the other gate region of the second junction-field-effect transistor JF2 are formed as a common region.

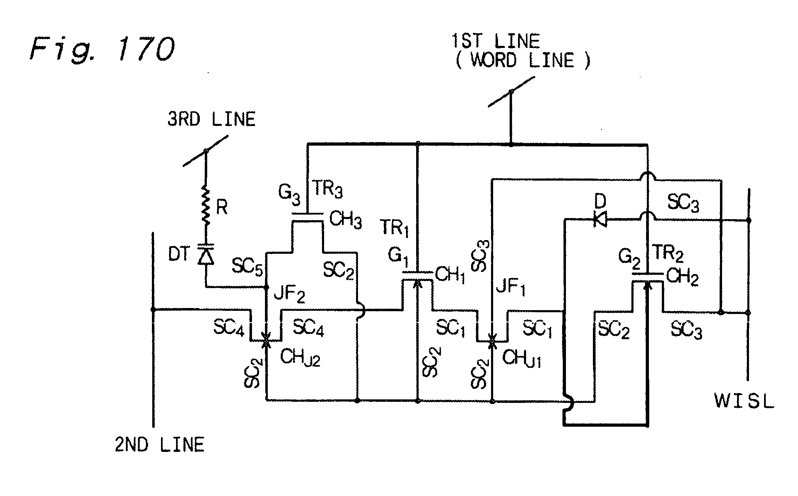

That is, as is shown in the principle drawing of Fig. 170, the semiconductor memory cell of Example 17 comprises;

(1) a first transistor TR1 for readout, having a first conductivity type (for example, n-channel type), and having source/drain regions, a semi-conductive channel forming region CH1 which is in contact with the source/drain regions and spaces out the source/drain regions, and a gate G capacitively coupled with the channel forming region CH1,
(2) a second transistor TR2 for switching, having a second conductivity type (for example, p-channel type), and having source/drain regions, a semi-conductive channel forming region CH2 which is in contact with the source/drain regions and spaces out the source/drain regions, and a gate G capacitively coupled with the channel forming region CH2,
(3) a third transistor TR3 for current control, having the second conductivity type (for example, p-channel type), and having source/drain regions, a semi-conductive channel forming region CH3 which is in contact with the source/drain regions and spaces out the source/drain regions, and a gate G capacitively coupled with the channel forming region CH3,
(4) a first junction-field-effect transistor JF1 for current control, having source/drain regions, a channel region $CH_{J2}$ and gate regions,
(5) a second junction-field-effect transistor $JF_2$ for current control, having source/drain regions, a channel region $CH_{J2}$ and gate regions, and
(6) an MIS type diode DT for retaining information,

wherein:

one source/drain region of the first transistor $TR_1$ corresponds to the channel forming region $CH_2$ of the second transistor $TR_2$ and corresponds to one source/drain region of the first junction-field-effect transistor $JF_1$,
the other source/drain region of the first transistor $TR_1$ corresponds to one source/drain region of the second junction-field-effect transistor $JF_2$,
one source/drain region of the second transistor $TR_2$ corresponds to channel forming region $CB_1$ of the first transistor $TR_1$, corresponds to one gate region of the first junction-field-effect transistor $JF_1$, corresponds to one gate region of the second junction-field-effect transistor $JF_2$ and corresponds to one source/drain region of the third transistor $TR_3$,
the other source/drain region of the third transistor $TR_3$ corresponds to the other gate region of the second junction-field-effect transistor $JF_2$, and
one end of the MIS type diode DT corresponds to the other source/drain region of the third transistor $TR_3$, the other end of the MIS type diode DT is formed of an electrode EL composed of a conductive material, and the electrode EL is connected to a line (third line) having a predetermined potential.

Further, the gate of the first transistor $TR_1$, the gate of the second transistor $TR_2$ and the gate of third transistor $TR_3$ are connected to a first line (for example, word line) for memory cell selection, the other source/drain region of the first transistor $TR_1$ is connected to a second line through the second junction-field-effect transistor $JF_2$, one source/drain region of the first transistor $TR_1$ is connected to a write-in information setting line WISL through the first junction-field-effect transistor $JF_1$ and a diode D, the other source/drain region of the second transistor $TR_2$ is connected to the write-in information setting line WISL, the other gate region of the first junction-field-effect transistor $JF_1$ is connected to the write-in information setting line WISL, and the other end of the MIS type diode DT is connected to the above line (third line) having a predetermined potential through a high-resistance element R. It is preferred to employ a constitution in which the second line is used as a bit line, or a constitution in which the write-in information setting line WISL is used as a bit line as well and a second predetermined potential is applied to the second line.

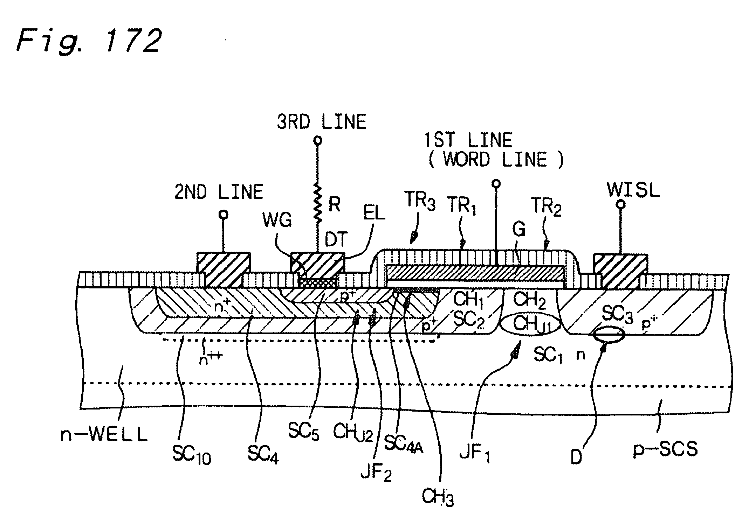

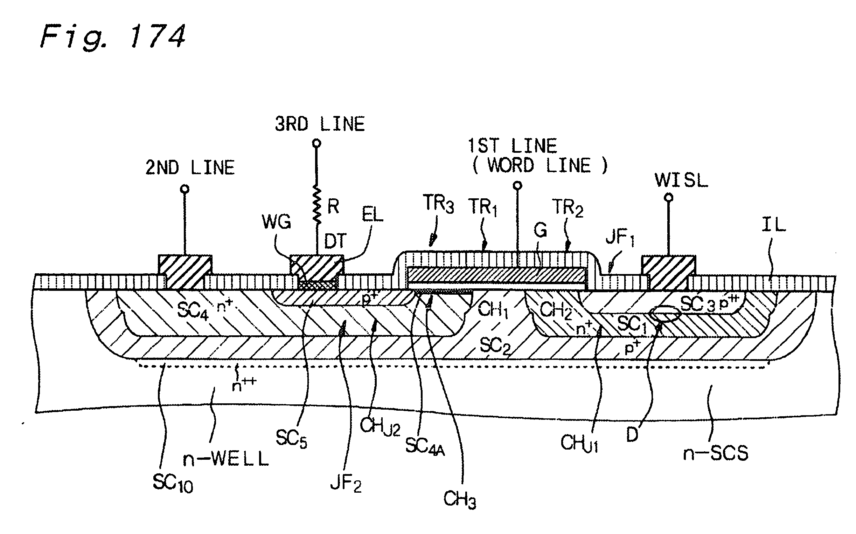

As is shown in the schematic partial cross-sectional views of Figs. 172 and 174, the semiconductor memory cell of Example 17 comprises;

(1) a first transistor $TR_1$ for readout, having a first conductivity type (for example, n-channel type), and having source/ drain regions, a semi-conductive channel forming region $CH_1$ which is in contact with the source/drain regions and spaces out the source/drain regions, and a gate G capacitively coupled with the channel forming region $CH_1$,

(2) a second transistor $TR_2$ for switching, having a second conductivity type (for example, p-channel type), and having source/drain regions, a semi-conductive channel forming region $CH_2$ which is in contact with the source/ drain regions and spaces out the source/drain regions, and a gate G capacitively coupled with the channel forming region $CH_2$,

(3) a third transistor $TR_3$ for current control, having the second conductivity type (for example, p-channel type), and having source/drain regions, a semi-conductive channel forming region $CH_3$ which is in contact with the source/ drain regions and spaces out the source/drain regions, and a gate G capacitively coupled with the channel forming region $CH_3$,

(4) a first junction-field-effect transistor $JF_1$ for current control, having source/drain regions, a channel region $CH_{J1}$ and gate regions,

(5) a second junction-field-effect transistor $JF_2$ for current control, having source/drain regions, a channel region $CH_{J2}$ and gate regions, and

(6) an MIS type diode DT for retaining information,

the semiconductor memory cell having;

(a) a semi-conductive first region $SC_1$ having a first conductivity type (for example, n-type),

(b) a semi-conductive second region $SC_2$ which is in contact with the first region $SC_1$ and has a second conductivity type (for example, $p^+$-type),

(c) a third region $SC_3$ which is formed in a surface region of the first region $SC_1$ and is in contact with the first region $SC_1$ so as to form a rectifier junction together with the first region $SC_1$, the third region $SC_3$ being a region which is semi-conductive and has the second conductivity type (for example, $p^+$-type) or which is conductive and is composed of a silicide, a metal or a metal compound,

(d) a semi-conductive fourth region $SC_4$ which is formed in a surface region of the second region $SC_2$ and has the first conductivity type (for example, $n^+$-type),

(e) a semi-conductive fifth region $SC_5$ which is formed in a surface region of the fourth region $SC_4$ and has the second conductivity type (for example, $p^+$-type), and

(f) the gate G which is formed, through an insulation layer, so as to bridge the first region $SC_1$ and the fourth region $SC_4$, so as to bridge the second region $SC_2$ and the third region $SC_3$ and so as to bridge the second region $SC_2$ and the fifth region $SC_5$, and is shared by the first transistor $TR_2$, the second transistor $TR_2$ and the third transistor $TR_3$.

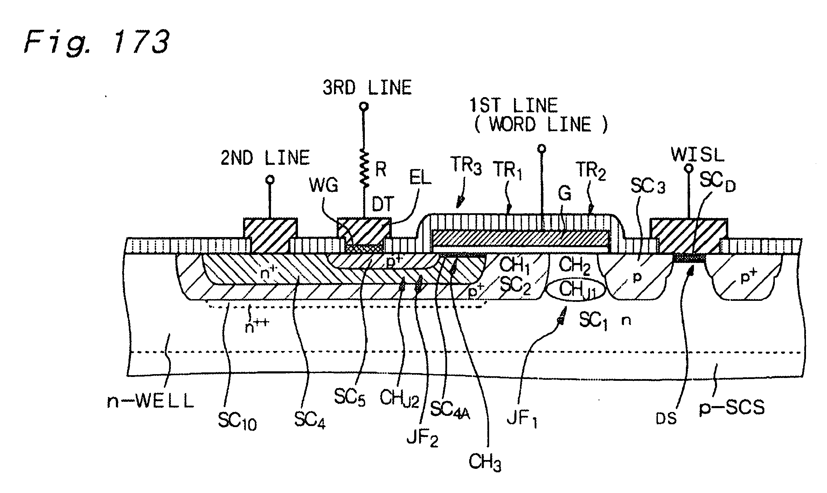

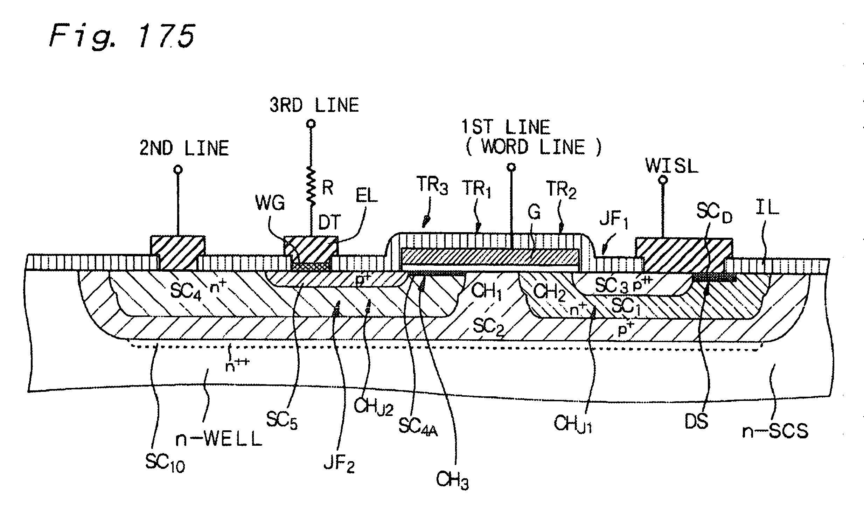

While the first region $SC_1$ and the second region $SC_2$ are in contact with each other, specifically, in the semiconductor memory cell shown in Fig. 172 or a semiconductor memory cell to be explained later with reference to Fig. 173, the second region $SC_2$ is formed in a surface region of the first region $SC_1$. In the semiconductor memory cell shown in Fig. 174 or a semiconductor memory cell to be explained later with reference to Fig. 175, the first region $SC_1$ is formed in a surface region of the second region $SC_2$.

Concerning the first transistor $TR_1$,

(A-1) one source/drain region is formed of a surface region of the first region $SC_1$,

(A-2) the other source/drain region is formed of a surface region of the fourth region $SC_4$, and

(A-3) the channel forming region $CH_1$ is formed of a surface region of the second region $SC_2$ which surface region is interposed between the surface region of the first region $SC_1$ and the surface region of the fourth region $SC_4$.

Concerning the second transistor $TR_2$,

(B-1) one source/drain region is formed of the surface region of the second region $SC_2$,

(B-2) the other source/drain region is formed of the third region $SC_3$, and

(B-3) the channel forming region $CH_2$ is formed of the surface region of the first region $SC_1$.

Concerning the third transistor $TR_3$,

(C-1) one source/drain region is formed of the surface region of the second region $SC_2$,
(C-2) the other source/drain region is formed of the fifth region $SC_5$, and
(C-3) the channel forming region $CH_3$ is formed of the surface region of the fourth region $SC_4$.

Concerning the first junction-field-effect transistor $JF_1$,

(D-1) the gate regions are formed of the third region $SC_3$ and part of the second region $SC_2$ which part is opposed to the third region $SC_3$,
(D-2) the channel region $CH_{J1}$ is formed of part of the first region $SC_1$ which part is interposed between the third region $SC_3$ and said part of the second region $SC_2$,
(D-3) one source/drain region is formed of the surface region of the first region $SC_1$ which surface region extends from one end of the channel region $CH_{J1}$ of the first junction-field-effect transistor $JF_1$ and constitutes one source/ drain region of the first transistor $TR_1$, and
(D-4) the other source/drain region is formed of a portion of the first region $SC_1$ which portion extends from the other end of the channel region $CH_{J1}$ of the first junction-field-effect transistor $JF_1$.

Concerning the second junction-field-effect transistor $JF_2$,

(E-1) the gate regions are formed of the fifth region $SC_5$ and part of the second region $SC_2$ which part is opposed to the fifth region $SC_5$,
(E-2) the channel region $CH_{J2}$ is formed of part of the fourth region $SC_4$ which part is interposed between the fifth region $SC_5$ and said part of the second region $SC_2$,
(E-3) one source/drain region is formed of the surface region of the fourth region $SC_4$ which surface region extends from one end of the channel region $CH_{J2}$ of the second junction-field-effect transistor $JF_2$ and constitutes the other source/drain region of the first transistor $TR_1$ and the channel forming region $CH_3$ of the third transistor $TR_3$, and
(E-4) the other source/drain region is formed of a portion of the fourth region $SC_4$ which portion extends from the other end of the channel region $CH_{J2}$ of the second junction-field-effect transistor $JF_2$.

Further, concerning the MIS type diode DT, (E-1) one end thereof is formed of the fifth region $SC_5$, and

(E-2) an electrode constituting the other end thereof is formed to be opposed to the fifth region $SC_5$ which constitutes one end of the MIS type diode DT, through a wide gap thin film WG.

The wide gap thin film WG can be composed of a material in which the tunnel transition of carriers is caused depending upon a potential difference between the potential in the fifth region $SC_5$ (the other source/drain region of the third transistor $TR_3$) and the potential in the other end (electrode EL) of the MIS type diode DT. Specifically, it can be composed, for example, of an $SiO_2$ or SiON film having a thickness of 5 nm or smaller, or an SiN film having a thickness of 9 nm or smaller.

The electrode EL constituting the other end of the MIS type diode DT is connected to the line (third line) through a high-resistance element R having a resistance of approximately $10^9$ to $10^{12}\,\Omega$. Specifically, the electrode EL constituting the other end of the MIS type diode DT and the high-resistance element R are integrally formed and are composed of a polysilicon thin layer containing an impurity having the first conductivity type.

In the above semiconductor memory cell, further,

(G) the gate G is connected to a first line (for example, word line) for memory cell selection,
(H) the third region $SC_3$ is connected to a write-in information setting line WISL,
(I) the portion of the fourth region $SC_4$ constituting the other source/drain region of the second junction-field-effect transistor $JF_2$ is connected to a second line,
(J) the fifth region $SC_5$ is connected to the second region $SC_2$, and
(K) the electrode EL constituting the other end of the MIS type diode DT is connected to a third line having a predetermined potential.

In the semiconductor memory cell of Example 17, an impurity-containing layer $SC_{4A}$ having the second conductivity type (for example, $p^{++}$-type) is formed in the surface region of the fourth region $SC_4$ which surface region constitutes the channel forming region $CH_3$ of the third transistor $TR_3$. Therefore, while information is retained, and, for example, if the potential in the first line is turned to 0 volt, the third transistor $TR_3$ is brought into an on-state, and the MIS type diode DT and the channel forming region $CH_1$ of the first transistor $TR_1$ are put in a continuity. The impurity concentration of the impurity-containing layer $SC_{4A}$ is adjusted such that the third transistor $TR_3$ is brought into an off-state by the potential in the first line applied during the reading of information.

Further, the first region $SC_1$ and the third region $SC_3$ constitute a pn junction diode D, and the first region $SC_1$ is connected to the write-in information setting line WISL through the third region $SC_3$. In this case, it is preferred to employ a constitution in which the second line is used as a bit line, or a constitution in which the write-in information setting line WISL is used as a bit line as well and a second predetermined potential is applied to the second line.

The semiconductor memory cell (specifically, the first region $SC_1$) shown in Fig. 172 is formed in a well structure which is formed, for example, in an p-type semiconductor substrate and has the first conductivity type (for example, n-type). Further, when a first high-concentration-impurity-containing layer $SC_{10}$ having the first conductivity type (for example, $n^{++}$-type) is formed below the second region $SC_2$, the potential or charge to be stored in the channel forming region $CH_1$ of the first transistor $TR_1$ for readout can be increased. The semiconductor memory cell (specifically, the second region $SC_2$) shown in Fig. 174 is formed in a well structure which is formed, for example, in an n-type semiconductor substrate and has the second conductivity type (for example, p-type). Further, when a first high-concentration-impurity-containing layer $SC_{10}$ having the first conductivity type (for example, $n^{++}$-type) is formed below the second region $SC_2$, the potential or charge to be stored in the channel forming region $CH_1$ of the first transistor $TR_1$ for readout can be increased.

The first junction-field-effect transistor $JF_1$ is formed by

(X) optimizing the distance between the facing gate regions (the third region $SC_3$ and the part of the second region $SC_2$ which part is opposed to the third region $SC_3$), that is, the thickness of the channel region $CH_{J1}$, and

(Y) optimizing the impurity concentration of each of the facing gate regions (the third region $SC_3$ and the part of the second region $SC_2$ which part is opposed to the third region $SC_3$) and the impurity concentration of the channel region $CH_{J1}$.

Further, the second junction-field-effect transistor $JF_2$ is formed by

(X) optimizing the distance between the facing gate regions (the fifth region $SC_5$ and the part of the second region $SC_2$ which part is opposed to the fifth region $SC_5$), that is, the thickness of the channel region $CH_{J2}$, and

(Y) optimizing the impurity concentration of each of the facing gate regions (the fifth region $SC_5$ and the part of the second region $SC_2$ which part is opposed to the fifth region $SC_5$) and the impurity concentration of the channel region $CH_{J2}$.

In the semiconductor memory cells shown in Fig. 172 and Fig. 174, as is shown in the principle drawing of Fig. 169, there may be employed an example in which the formation of the pn junction diode D is omitted and the first region $SC_1$ corresponding to one source/drain region of the first transistor $TR_1$ is connected to a fourth line (not shown in Fig. 172 and Fig. 174). In these cases, it is preferred to employ a constitution in which the second line is used as a bit line and a second predetermined potential is applied to the fourth line, or a constitution in which the fourth line is used as a bit line and a second predetermined potential is applied to the second line. In the semiconductor memory cell shown in Fig. 172, the wiring structure thereof can be simplified by forming a second high-concentration-impurity-containing layer (not shown) which has the first conductivity type (for example, $n^{++}$-type) and works as the fourth line, below the first region $SC_1$.

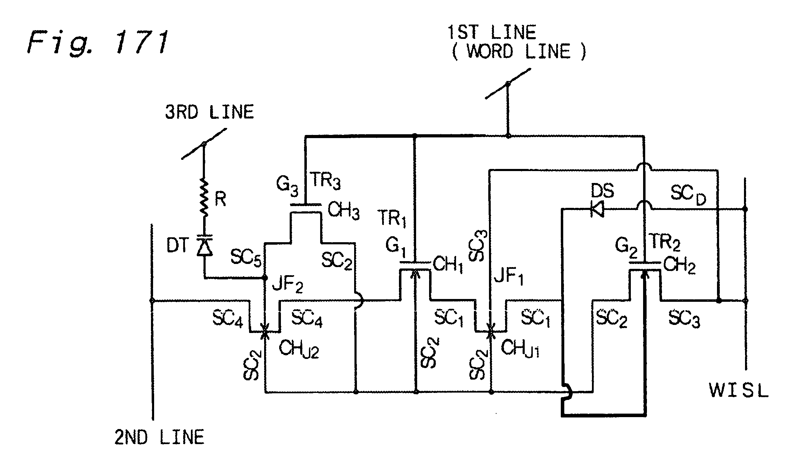

In semiconductor memory cells shown in the principle drawing of Fig. 171 and the schematic partial cross-sectional views of Fig. 173 and Fig. 175, there is further provided a diode-constituting region $SC_D$ which is formed in a surface region of the first region $SC_1$ and is in contact with the first region $SC_1$ to form a rectifier junction together with the first region $SC_1$, the diode-constituting region $SC_D$ and the first region $SC_1$ constitute a majority carrier diode DS, and the first region $SC_1$ is connected to the write-in information setting line WISL through the diode-constituting region $SC_D$. In this case, it is preferred to employ a constitution in which the second line is used as a bit line, or a constitution in which the write-in information setting line WISL is used as a bit line as well and a second predetermined potential is applied to the second line.

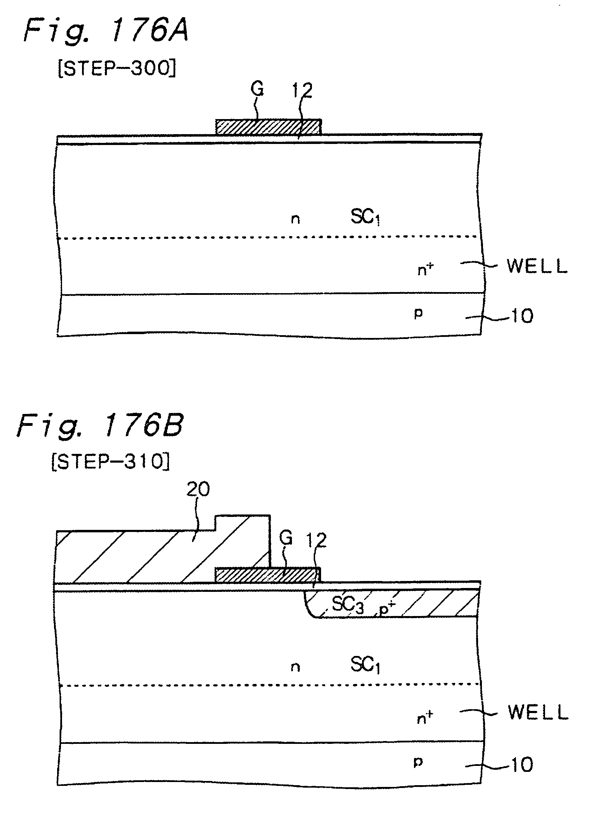

As an example of a not claimed process for manufacturing the semiconductor memory cell of the present invention, the process for manufacturing the semiconductor memory cell of Example 7 shown in Fig. 69 will be explained with reference to Figs. 176A, 176B, 177A, 177B, 178A and 178B hereinafter.

[Step-300]

First, a device separation region (not shown), the well of the first conductivity type (for example, n-type well), the semi-conductive first region $SC_1$ of the first conductivity type (for example, $n^{++}$-type), the first high-concentration-

impurity-containing layer $SC_{10}$ of the first conductivity type (for example, $n^{++}$-type) (not shown) and a gate insulation layer 12 corresponding to the insulation layer are formed in a p-type silicon semiconductor substrate 10 according to known methods. Then, gate G ($G_1$ + $G_2$) is formed, for example, from a polysilicon containing an impurity or a polyside or polymetal structure. In this manner, a structure shown in Fig. 176A can be obtained. The n-type first region $SC_1$ had an impurity concentration of $1.0 \times 10^{17}$/cm$^3$ and the gate G ($G_1$ + $G_2$) had a length of 0.28 $\mu$m.

[Step-310]

Then, an ion-implanting mask 20 is formed from a resist material, and an impurity having the second conductivity type (for example, p-type) is ion-implanted to form the semi-conductive third region $SC_3$ which is formed in a surface region of the first region $SC_1$ and has the second conductivity type (see Fig. 176B). The ion implantation can be carried out, for example, under the same conditions as those shown in Table 1.

[Step-320]

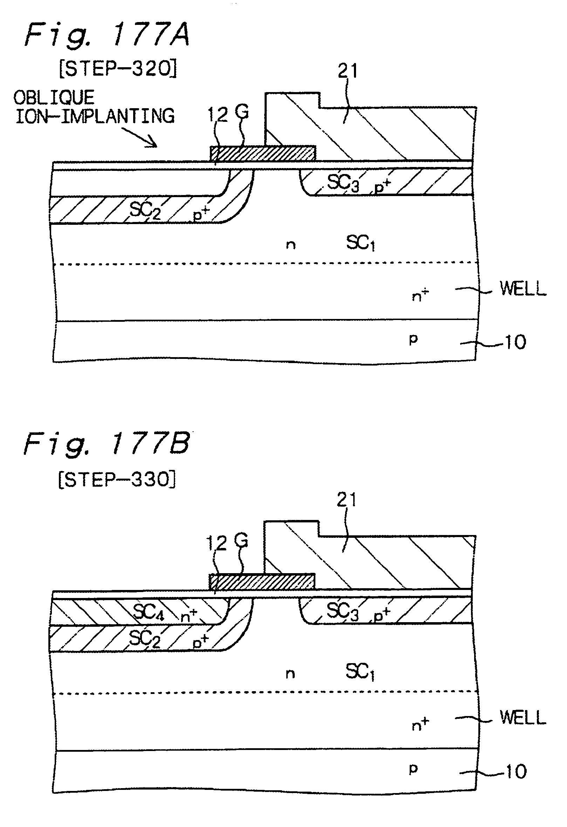

Then, the ion-implanting mask 20 is removed, an ion-implanting mask 21 is formed from a resist material, and an impurity having the second conductivity type (for example, p-type) is ion-implanted by an oblique ion implanting method, to form the semi-conductive second region $SC_2$ which is in contact with the first region $SC_1$ (specifically, formed in a surface region of the first region $SC_1$), is spaced from the third region $SC_3$ and has the second conductivity type (for example, $p^{++}$-type). Since the ion implantation is carried out by the oblique ion implanting method, the second region $SC_2$ is formed below the gates ($G_1$ + $G_2$) as well (see Fig. 177A). The ion implantation is carried out twice under the same conditions as those shown in Table 2, and the ion incidence angle during one ion-implantation is arranged to differ from that during the other ion-implantation. Particularly, when the ion incidence angle during the first ion-implantation is set at 60 degrees, the impurity concentration of the semi-conductive second region $SC_2$ below the gate G ($G_1$ + $G_2$) can be highly accurately controlled.

[Step-330]

Then, an impurity having the first conductivity type (for example, n-type) is ion-implanted to form the fourth region $SC_4$ which is formed in a surface region of the second region $SC_2$ and is in contact with the second region $SC_2$ to form a rectifier junction together with the second region $SC_2$ (see Fig. 177B). The ion-implantation can be carried out under the same conditions as those shown in Table 3.

[Step-340]

Then, the ion-implanting mask 21 is removed, an $SiO_2$ layer is formed on the entire surface by a CVD method, and the $SiO_2$ layer is etched back to form a side-wall 30 on the side wall of the gate G ($G_1$ + $G_2$).

[Step-350]

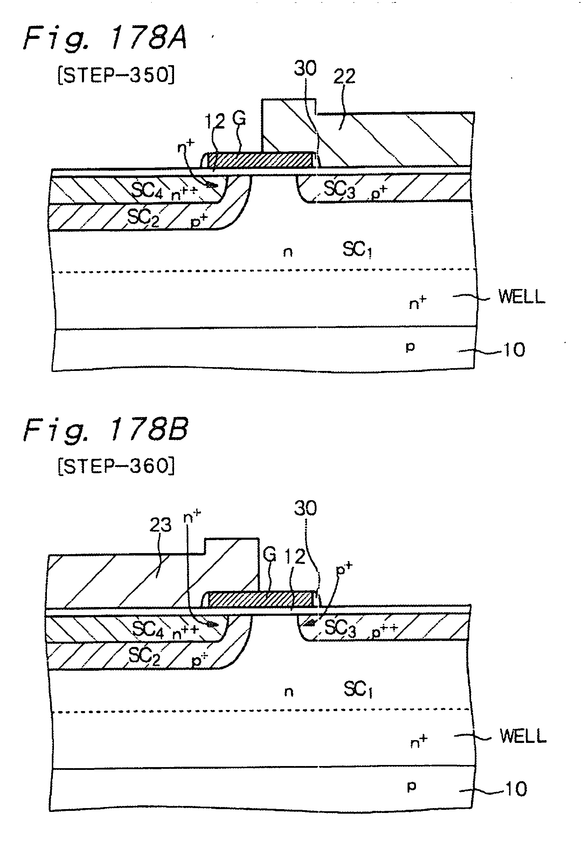

Then, an ion-implanting mask 22 is formed from a resist material, and an impurity having the first conductivity type (for example, n-type) is ion-implanted to increase the impurity concentration of the fourth region $SC_4$ up to approximately $10^{18}$ to $10^{20}$ cm$^{-3}$, whereby the resistance of the fourth region $SC_4$ is decreased (see Fig. 178A). The ion implantation can be carried out under the same conditions as those shown in Table 4.

[Step-360]

Then, the ion-implanting mask 22 is removed, an ion-implanting mask 23 is formed from a resist material, and an impurity having the second conductivity type (for example, p-type) is ion-implanted to increase the impurity concentration of the third region $SC_3$ up to approximately $10^{18}$ to $10^{20}$ cm$^{-3}$, whereby the resistance of the third region $SC_3$ is decreased (see Fig. 178B). The ion implantation can be carried out under the same conditions as those shown in Table 5.
Under the above ion-implanting conditions, the gate regions (second region $SC_2$ and third region $SC_3$) of the junction-field-effect transistor $JF_1$ and the channel region $CH_{J1}$ had impurity concentrations shown in the following Table 7. Further, the channel region $CH_{J1}$ of the junction-field-effect transistor $JF_1$ had a thickness of 0.1 $\mu$m.

Table 7

| Second region $SC_2$ | $1.5 \times 10^{18}$ Cm$^{-3}$ |
|---|---|

(continued)

| Third region SC$_3$ | 2.1 x 10$^{19}$ Cm$^{-3}$ |
|---|---|
| Channel region CH$_{J1}$ | 5.0 x 10$^{17}$ cm$^{-3}$ |

[Step-370]

Then, an insulating interlayer is formed on the entire surface, and the insulating interlayer is patterned using a patterned resist layer as a mask, to expose part of the second region SC$_2$. A silicon oxide layer (SiO$_2$ layer) as a wide gap thin film WG is formed on the exposed surface of the second region SC$_2$. Then, a polysilicon thin layer containing an impurity having the first conductivity type (for example, n-type) is formed on the entire surface, and the polysilicon thin layer is patterned to form the electrode EL constituting the other end of a MIS type diode DT connected to the wide gap thin film WG and also to form the high-resistance element R extending from the above electrode EL.

[Step-380]

Then, the write-in information setting line, the second line (bit line), the fourth line, etc., are formed according to known methods.
The steps of manufacturing the semiconductor memory cell shall not be limited to the above process. For example, [Step-310] may be omitted. [Step-320], [Step-330] and [Step-350] may be carried out in any order. The formation of the gate and the formation of the device separation region may be carried out after [Step-370]. The above-described ion-implantation conditions are given for explanation purposes and may be modified as required.
When the MIS-type-diode constituting region SCDT having the second conductivity type (for example, p+-type) is formed in the form of a buried plug, it can be formed in [Step-370] by a method in which an insulating interlayer is formed, then, the MIS-type-diode constituting region SCDT is formed by ion implantation using a patterned resist material as a mask, and then the MIS type diode DT is formed.

Example 18

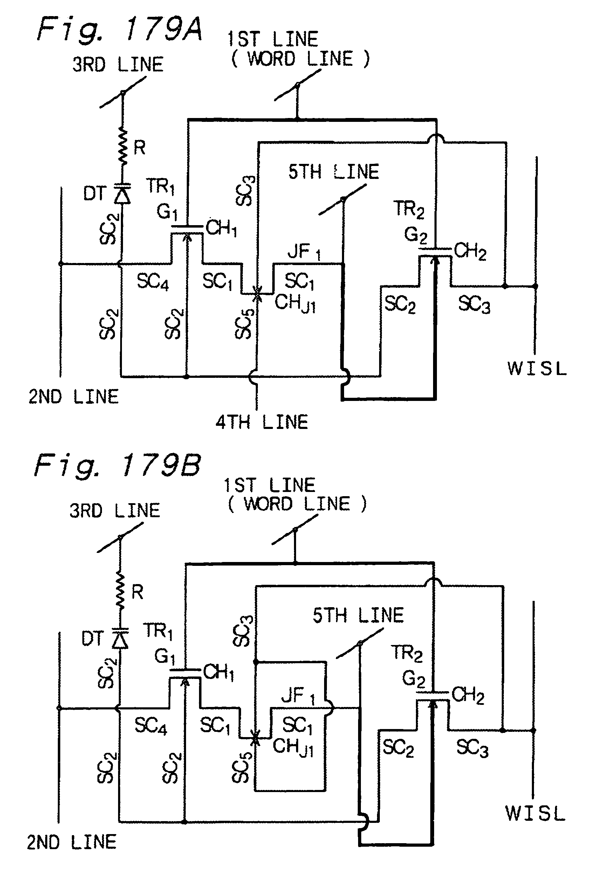

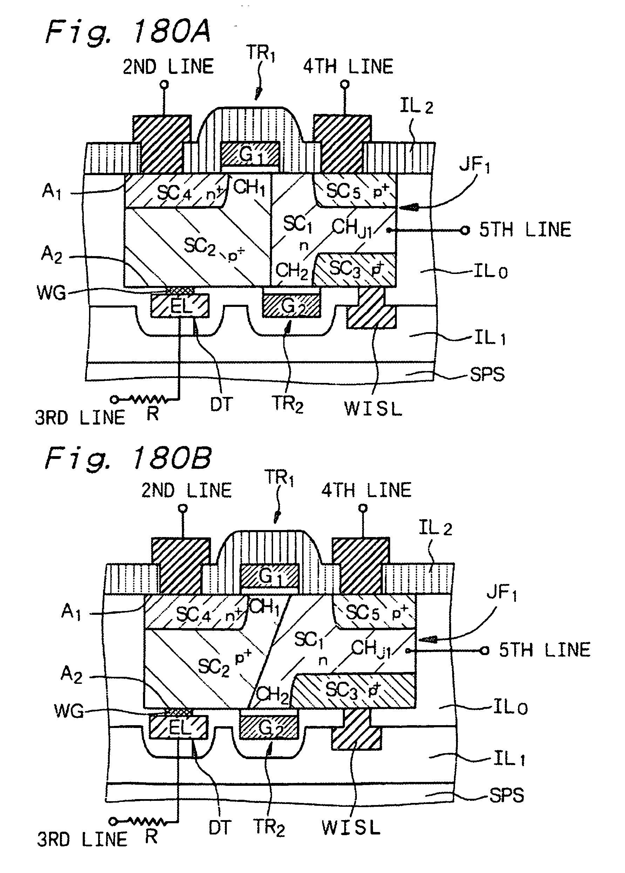

Example 18 is concerned with the semiconductor memory cell according to the fifth aspect of the present invention. As is shown in the principle drawing of Fig. 179A and the schematic partial cross-sectional view of Fig. 180A, the semiconductor memory cell of Example 18 has a semiconductor layer having two main surfaces opposed to each other, the main surfaces being a first main surface A1 and a second main surface A2, and the semiconductor memory cell comprises;

(1) a first transistor TR$_1$ for readout, having a first conductivity type (for example, n-channel type), and having source/drain regions, a semi-conductive channel forming region CH$_1$ which is in contact with the source/drain regions, and spaces out the source/drain regions, and a gate G$_1$ capacitively coupled with the channel forming region CH$_1$,
(2) a second transistor TR$_2$ for switching, having a second conductivity type (for example, p-channel type), and having source/drain regions, a semi-conductive channel forming region CH$_2$ which is in contact with the source/drain regions and spaces out the source/drain regions, and a gate G$_2$ capacitively coupled with the channel forming region CH$_2$,
(3) a junction-field-effect transistor JF$_1$ for current control, having source/drain regions, a channel region CH$_{J1}$ and gate regions, and
(4) an MIS type diode DT for retaining information.

In the semiconductor memory cell of Example 18 shown in Fig. 180A, the gate G$_1$ of the first transistor TR$_1$ and the gate G$_2$ of the second transistor TR$_2$ are respectively formed on the first main surface A$_1$ and the second main surface A$_2$ so as to be opposite to each other thorough the semiconductor layer, and positions of these gates are deviated to some extent with regard to the perpendicular direction. Further, the semiconductor memory cell has a so-called SOI structure in which it is surrounded by an insulation material layer IL$_0$ formed on a supporting substrate SPS. In the semiconductor memory cell of Example 18 shown in Fig. 180A, the supporting substrate SPS, an insulating interlayer IL$_1$, the gate G$_2$ of the second transistor TR$_2$ and the gate G$_1$ of the first transistor TR$_1$ are arranged in this order from below.
The semiconductor memory cell of Example 18 has;

(a) a semi-conductive first region SC$_1$ which is formed in the semiconductor layer to extend over from the first main surface A$_1$ to the second main surface A$_2$ and has a first conductivity type (for example, n-type),

57

(b) a semi-conductive second region $SC_2$ which is formed in the semiconductor layer to extend over from the first main surface $A_1$ to the second main surface $A_2$, is in contact with the first region $SC_1$ and has a second conductivity type (for example, p$^+$-type),

(c) a third region $SC_3$ which is formed in a surface region including the second main surface $A_2$ of the first region $SC_1$ to be spaced from the second region $SC_2$ and is in contact with the first region $SC_1$ so as to form a rectifier junction together with the first region $SC_1$, the third region $SC_3$ being a region which is semi-conductive and has the second conductivity type (for example, p$^+$-type) or which is conductive and is composed of a silicide, a metal or a metal compound,

(d) a fourth region $SC_4$ which is formed in a surface region including the first main surface $A_1$ of the second region $SC_2$ to be spaced from the first region $SC_1$ and is in contact with the second region $SC_2$ so as to form a rectifier junction together with the second region $SC_2$, the fourth region $SC_4$ being a region which is semi-conductive and has the second conductivity type (for example, n$^+$-type) or which is conductive and is composed of a silicide, a metal or a metal compound,

(e) a fifth region $SC_5$ which is formed in a surface region including the first main surface $A_1$ of the first region $SC_1$ to be spaced from the second region $SC_2$ and is in contact with the first region $SC_1$ so as to form a rectifier junction together with the first region $SC_1$, the fifth region $SC_5$ being a region which is semi-conductive and has the second conductivity type (for example, p$^+$-type) or which is conductive and is composed of a silicide, a metal or a metal compound,

(f) the gate $G_1$ of the first transistor $TR_1$ formed on a first insulation layer formed on the first main surface $A_1$ so as to bridge the first region $SC_1$ and the fourth region $SC_4$, and

(g) the gate $G_2$ of the second transistor $TR_2$ formed on a second insulation layer formed on the second main surface $A_2$ so as to bridge the second region $SC_2$ and the third region $SC_3$.

Concerning the first transistor $TR_1$,

(A-1) one source/drain region is formed of a surface region including the first main surface $A_1$ of the first region $SC_1$,

(A-2) the other source/drain region is formed of the fourth region $SC_4$, and

(A-3) the channel forming region $CH_1$ is formed of a surface region including the first main surface $A_1$ of the second region $SC_2$ which surface region is interposed between the surface region including the first main surface $A_1$ of the first region $SC_1$ and the fourth region $SC_4$.

Concerning the second transistor $TR_2$,

(B-1) one source/drain region is formed of a surface region including the second main surface $A_2$ of the second region $SC_2$,

(B-2) the other source/drain region is formed of the third region $SC_3$, and

(B-3) the channel forming region $CH_2$ is formed of a surface region including the second main surface $A_2$ of the first region $SC_1$ which surface region is interposed between the surface region including the second main surface $A_2$ of the second region $SC_2$ and the third region $SC_3$.

Concerning the junction-field-effect transistor $JF_1$,

(C-1) the gate regions of are formed of the fifth region $SC_5$ and the third region $SC_3$ which is opposed to the fifth region $SC_5$,

(C-2) the channel region $CH_{J1}$ is formed of part of the first region $SC_1$ which part is interposed between the fifth region $SC_5$ and the third region $SC_3$,

(C-3) one source/drain region is formed of a portion of the first region $SC_1$ which portion extends from one end of the channel region $CH_{J1}$ of the junction-field-effect transistor $JF_1$ and constitutes one source/drain region of the first transistor $TR_1$ and the channel forming region $CH_2$ of the second transistor $TR_2$, and

(C-4) the other source/drain region is formed of a portion of the first region $SC_1$ which portion extends from the other end of the channel region $CH_{J1}$ of the junction-field-effect transistor $JF_1$.

Concerning the MIS type diode DT,

(D-1) one end thereof is formed of part of the second region $SC_2$, and

(D-2) an electrode EL constituting the other end thereof is formed to be opposed to said part of the second region $SC_2$ constituting one end of the MIS type diode DT, through a wide gap thin film.

The junction-field-effect transistor $JF_1$ is formed by

(X) optimizing the distance between the facing gate regions (the fifth region $SC_5$ and the third region $SC_3$ which is opposed to the fifth region $SC_5$), that is, the thickness of the channel region $CH_{J1}$, and

(Y) optimizing the impurity concentration of each of the facing gate regions (the fifth region $SC_5$ and the third region $SC_3$ which is opposed to the fifth region $SC_5$) and the impurity concentration of the channel region $CH_{J1}$ (specifically, the first region $SC_1$).

The gate $G_1$ of the first transistor $TR_1$ and the gate $G_2$ of the second transistor $.TR_2$ are connected to a first line (word line) for memory cell selection, and the third region $SC_3$ is connected to the write-in information setting line WISL. Further, the fourth region $SC_4$ is connected to a second line, the electrode EL constituting the other end of the MIS type diode DT is connected to a third line having a predetermined potential, the fifth region $SC_5$ is connected to a fourth line, and the portion of the first region $SC_1$ which portion constitutes the other source/drain region of the junction-field-effect transistor $JF_1$ is connected to a fifth line. The electrode EL constituting the other end of the MIS type diode DT is connected to the third line through a high-resistance element R having a resistance of approximately $10^9$ to $10^{11}$ Ω. In this case, there may be employed an embodiment in which the second line to which the fourth region $SC_4$ is connected is used as a bit line and a second predetermined potential is applied to the fifth line to which the first region $SC_1$ is connected, or an embodiment in which a second predetermined potential is applied to the second line and the fifth line is used as a bit line.

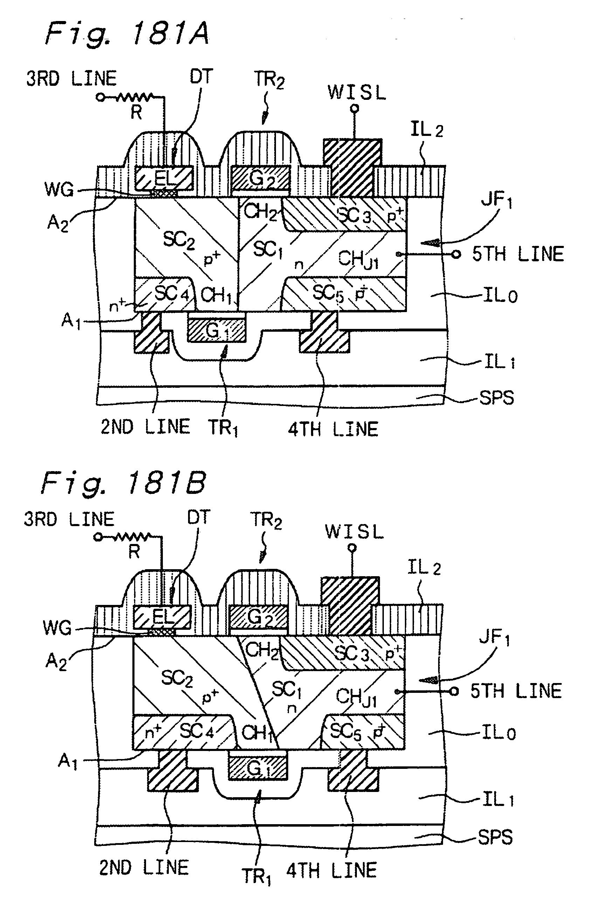

Figs. 180B, 181A and 181B show schematic partial cross-sectional views of variants of the semiconductor memory cell of Example 18. In the variant shown in Fig. 180B, positions of the gate $G_1$ of the first transistor $TR_1$ and the gate $G_2$ of the second transistor $TR_2$ are nearly aligned with regard to the perpendicular direction, differing from their positional relationship in Fig. 180A. Forming such a structure serves to decrease the area of the semiconductor memory cell. In the variants shown in Figs. 181A and 181B, the supporting substrate SPS, the insulating interlayer $IL_1$, the gate $G_1$ of the first transistor $TR_1$ and the gate $G_2$ of the second transistor $TR_2$ are arranged in this order from below. The positional relationship of these regions with regard to the perpendicular direction is reverse to the positional relationship of the regions of the semiconductor memory cells shown in Figs. 180A and 180B. In the variant shown in Fig. 181B, positions of the gate $G_1$ of the first transistor $TR_1$ and the gate $G_2$ of the second transistor $TR_2$ are nearly aligned with regard to the perpendicular direction, differing from their positional relationship in Fig. 181A.

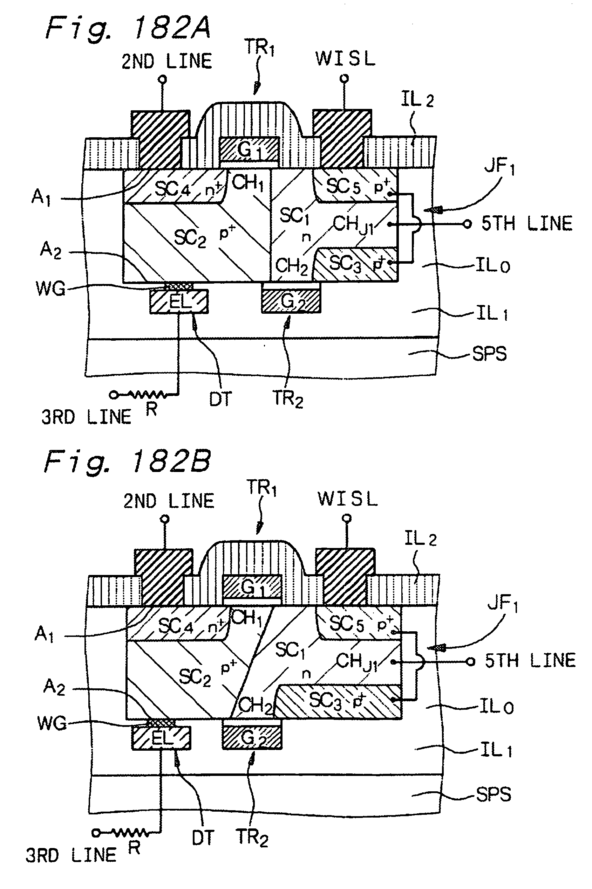

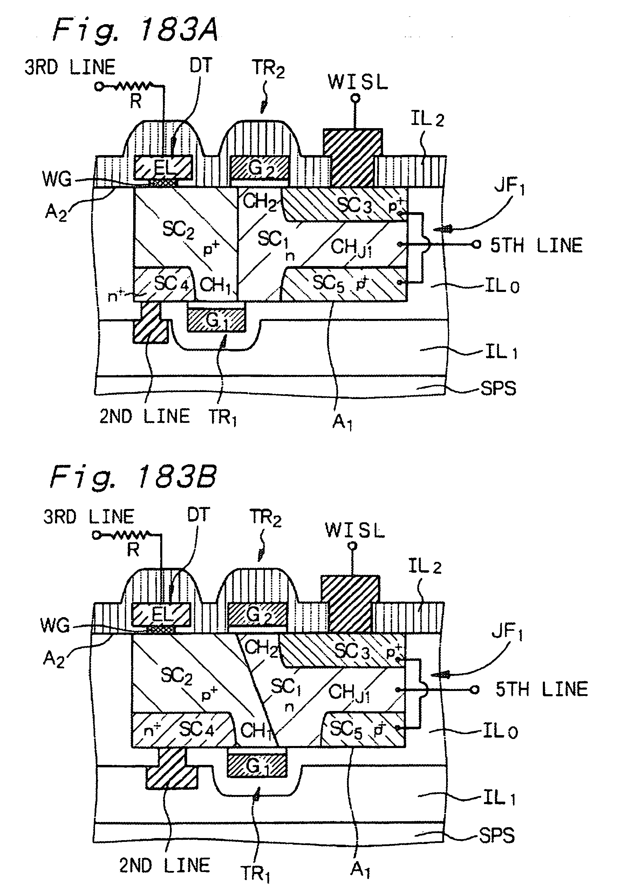

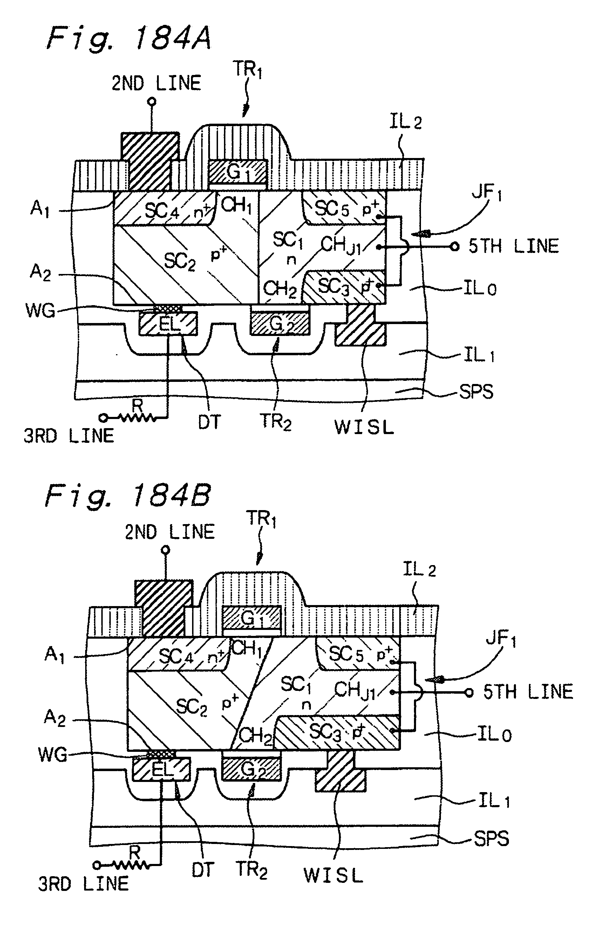

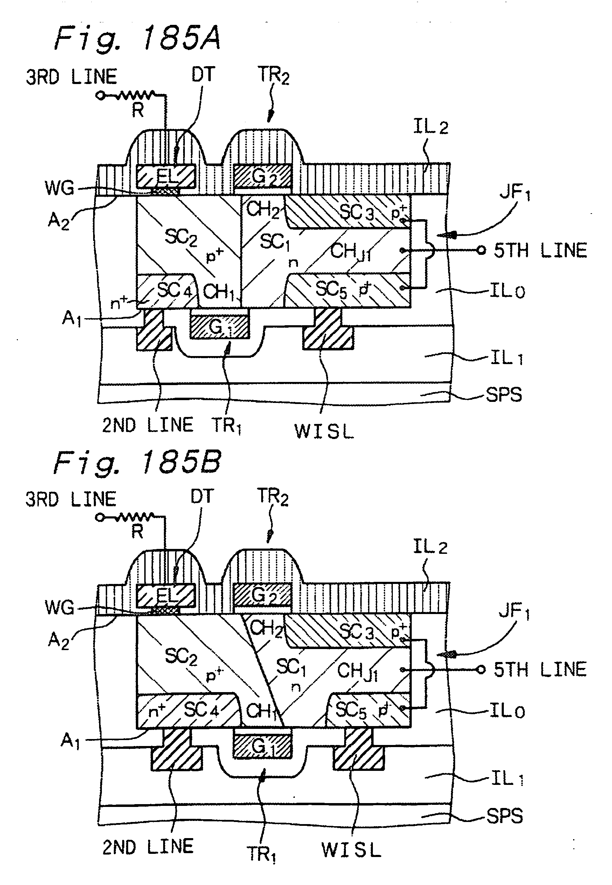

Further, Figs. 182A, 182B, 183A, 183B, 184A, 184B, 185A and 185B show schematic partial cross-sectional views of variants of the semiconductor memory cell of Example 18. The principle drawing of the semiconductor memory cells shown in these Figures is as shown in Fig. 179B. The semiconductor memory cells shown in Figs. 182A, 182B 184A and 184B are variants of the semiconductor memory cells shown in Figs. 180A and 180B, and the semiconductor memory cells shown in Figs. 183A, 183B, 185A and 185B are variants of the semiconductor memory cells shown in Figs. 181A and 181B.

In these semiconductor memory cells, the fifth region SC5 is connected to the write-in information setting line WISL in place of being connected to the fourth line. Being connected to the write-in information setting line WISL is equivalent to being connected to the third region SC3. Specifically, the fifth region SC5 and the third region SC3 can be connected to each other, for example, by forming a structure in which a portion of the third region SC3 is extended up to the first main surface A1 of the semiconductor layer and the fifth region SC5 and the extending portion of the third region SC3 are in contact with each other outside the first region SC1. The wiring structure of the semiconductor memory cell can be simplified by structuring the semiconductor memory cell as described above. In these cases, it is preferred to employ a constitution in which the second line is used as a bit line, or a constitution in which the write-in information setting line WISL is used as a bit line as well and a second predetermined potential is applied to the second line.

The junction-field-effect transistor JF1 can be formed by optimizing the distance between the fifth region SC5 and the third region SC3 which is opposed to the fifth region SC5, that is, the thickness of the channel region CHJ1, and by optimizing the impurity concentration of each of the fifth region SC5 and the third region SC3 which is opposed to the fifth region SC5 and the impurity concentration of the first region SC1 (corresponding to the channel region CHJ1). Further, the process for manufacturing semiconductor memory cells of Examples to be explained hereinafter can be also manufactured substantially by the same process as that explained in Example 3 except for differences, for example, in the formation of the fifth region SC5 and/or the sixth region SC6 and the formation of a common gate (G1 + G3), so that the detailed explanations thereof will be omitted.

when each of the semiconductor memory cells of Example 18 and Examples 19 to 22 to be explained later is produced, the order of the formation of gate G1 of the first transistor TR1 and formation of gate G2 of the second transistor TR2 can be determined depending upon structures of the semiconductor memory cells to be manufactured. Further, the gate G1 of the first transistor TR1, the gate G2 of the second transistor TR2, the facing gate regions of the junction-field-effect transistor JF1 and the channel region CHJ1 can be formed in an order required depending upon structures of semiconductor memory cells to be manufactured.

Example 19

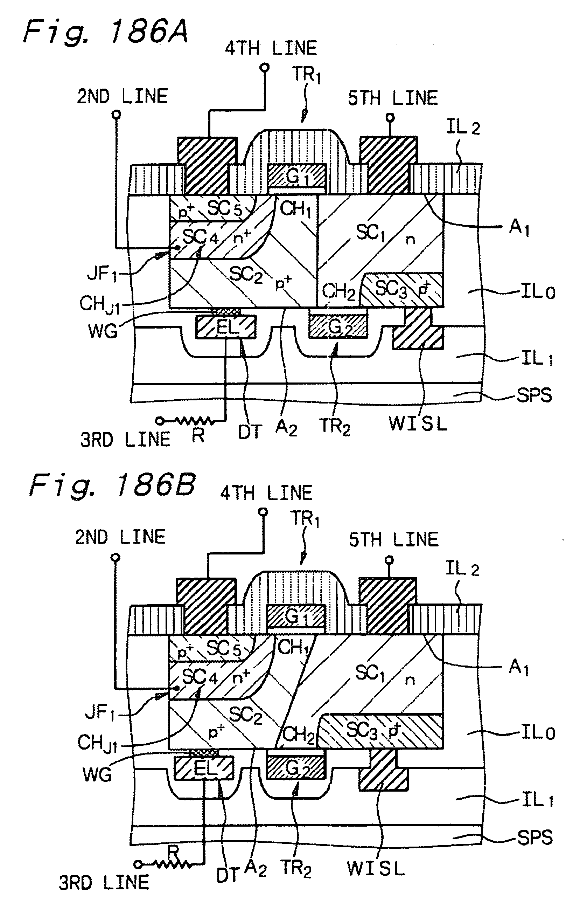

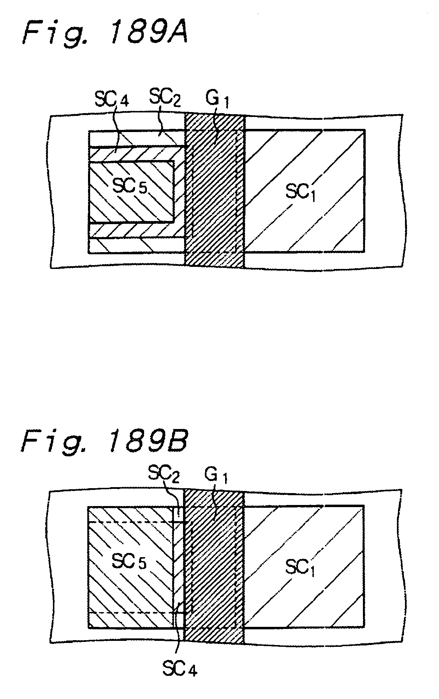

Example 19 is concerned with the semiconductor memory cell according to the sixth aspect of the present invention. As is shown in the principle drawing of Fig. 108, the schematic partial cross-sectional view of Fig. 186A and a schematic layout of gates and regions in Fig. 189A, the semiconductor memory cell of Example 19 has a semiconductor layer having two main surfaces opposed to each other, the main surfaces being a first main surface $A_1$ and a second main surface $A_2$, and the semiconductor memory cell comprises;

(1) a first transistor $TR_1$ for readout, having a first conductivity type (for example, n-channel type), and having source/drain regions, a semi-conductive channel forming region $CH_1$ which is in contact with the source/drain regions and spaces out the source/drain regions, and a gate $G_1$ capacitively coupled with the channel forming region $CH_1$,
(2) a second transistor $TR_2$ for switching, having a second conductivity type (for example, p-channel type), and having source/drain regions, a semi-conductive channel forming region $CH_2$ which is in contact with the source/drain regions and spaces out the source/drain regions, and a gate $G_2$ capacitively coupled with the channel forming region $CH_2$,
(3) a junction-field-effect transistor $JF_1$ for current control, having source/drain regions, a channel region $CH_{J1}$ and gate regions, and
(4) an MIS type diode DT for retaining information.

In the semiconductor memory cell of Example 19 shown in Fig. 186A, the gate $G_1$ of the first transistor $TR_1$ and the gate $G_2$ of the second transistor $TR_2$ are respectively formed on the first main surface $A_1$ and the second main surface $A_2$ so as to be opposite to each other thorough the semiconductor layer, and positions of these gates are deviated to some extent with regard to the perpendicular direction. Further, the semiconductor memory cell has a so-called SOI structure in which it is surrounded by an insulation material layer $IL_0$ formed on a supporting substrate SPS. In the semiconductor memory cell of Example 19 shown in Fig. 186A, the supporting substrate SPS, an insulating interlayer $IL_1$, the gate $G_2$ of the second transistor $TR_2$ and the gate $G_1$ of the first transistor $TR_1$ are arranged in this order from below. In Fig. 189A, showing of the gate $G_2$ and the third region $SC_3$ is omitted.
The semiconductor memory cell of Example 19 has;

(a) a semi-conductive first region $SC_1$ which is formed in the semiconductor layer to extend over from the first main surface $A_1$ to the second main surface $A_2$ and has a first conductivity type (for example, n-type),
(b) a semi-conductive second region $SC_2$ which is formed in the semiconductor layer to extend over from the first main surface $A_1$ to the second main surface $A_2$, is in contact with the first region $SC_1$ and has a second conductivity type (for example, $p^+$-type),
(c) a third region $SC_3$ which is formed in a surface region including the second main surface $A_2$ of the first region $SC_1$ to be spaced from the second region $SC_2$ and is in contact with the first region $SC_1$ so as to form a rectifier junction together with the first region $SC_1$, the third region $SC_3$ being a region which is semi-conductive and has the second conductivity type (for example, $p^+$-type) or which is conductive and is composed of a silicide, a metal or a metal compound,
(d) a fourth region $SC_4$ which is formed in a surface region including the first main surface $A_1$ of the second region $SC_2$ to be spaced from the first region $SC_1$ and is in contact with the second region $SC_2$ so as to form a rectifier junction together with the second region $SC_2$, the fourth region $SC_4$ being a region which is semi-conductive and has the second conductivity type (for example, $n^+$-type) or which is conductive and is composed of a silicide, a metal or a metal compound,
(e) a fifth region $SC_5$ which is formed in a surface region of the fourth region $SC_4$ and is in contact with the fourth region $SC_4$ so as to form a rectifier junction together with the fourth region $SC_4$, the fifth region $SC_5$ being a region which is semi-conductive and has the second conductivity type (for example, $p^+$-type) or which is conductive and is composed of a silicide, a metal or a metal compound,
(f) the gate $G_1$ of the first transistor $TR_1$ formed on a first insulation layer formed on the first main surface $A_1$ so as to bridge the first region $SC_1$ and the fourth region $SC_4$, and
(g) the gate $G_2$ of the second transistor $TR_2$ formed on a second insulation layer formed on the second main surface $A_2$ so as to bridge the second region $SC_2$ and the third region $SC_3$.

Concerning the first transistor $TR_1$,

(A-1) one source/drain region is formed of a surface region including the first main surface $A_1$ of the first region $SC_1$,
(A-2) the other source/drain region is formed of the fourth region $SC_4$, and
(A-3) the channel forming region $CH_1$ is formed of a surface region including the first main surface $A_1$ of the second

region $SC_2$ which surface region is interposed between the surface region including the first main surface $A_1$ of the first region $SC_1$ and the fourth region $SC_4$.

Concerning the second transistor $TR_2$,

(B-1) one source/drain region is formed of a surface region including the second main surface $A_2$ of the second region $SC_2$,

(B-2) the other source/drain region is formed of the third region $SC_3$, and

(B-3) the channel forming region $CH_2$ is formed of a surface region including the second main surface $A_2$ of the first region $SC_1$ which surface region is interposed between the surface region including the second main surface $A_2$ of the second region $SC_2$ and the third region $SC_3$ .

Concerning the junction-field-effect transistor $JF_1$,

(C-1) the gate regions are formed of the fifth region $SC_5$ and part of the second region $SC_2$ which part is opposed to the fifth region $SC_5$,

(C-2) the channel region $CH_{J1}$ is formed of part of the fourth region $SC_4$ which part is interposed between the fifth region $SC_5$ and said part of the second region $SC_2$,

(C-3) one source/drain region is formed of a portion of the fourth region $SC_4$ which portion extends from one end of the channel region $CH_{J1}$ of the junction-field-effect transistor $JF_1$ and constitutes the other source/drain region of the first transistor $TR_1$, and

(C-4) the other source/drain region is formed of a portion of the fourth region $SC_4$ which portion extends from the other end of the channel region $CH_{J1}$ of the junction-field-effect transistor $JF_1$.

The junction-field-effect transistor $JF_1$ is formed by

(X) optimizing the distance between the facing gate regions (the fifth region $SC_5$ and the part of the second region $SC_2$ which part is opposed to the fifth region $SC_5$), that is, the thickness of the channel region $CH_{J1}$, and

(Y) optimizing the impurity concentration of each of the facing gate regions (the fifth region $SC_5$ and the part of the second region $SC_2$ which part is opposed to the fifth region $SC_5$) and the impurity concentration of the channel region $CH_{J1}$ (fourth region $SC_4$).

Concerning the MIS type diode DT,

(D-1) one end thereof is formed of part of the second region $SC_2$, and

(D-2) an electrode EL constituting the other end thereof is formed to be opposed to said part of the second region $SC_2$ constituting one end of the MIS type diode DT, through a wide gap thin film.

The gate $G_1$ of the first transistor $TR_1$ and the gate $G_2$ of the second transistor $TR_2$ are connected to a first line (word line) for memory cell selection, and the portion of the fourth region $SC_4$ which portion constitutes the other source/drain region of the junction-field-effect transistor $JF_1$ is connected to a second line, the electrode EL constituting the other end of the MIS type diode DT is connected to a third line having a predetermined potential, and the third region $SC_3$ is connected to the write-in information setting line WISL. Further, the fifth region $SC_5$ is connected to a fourth line, and the first region $SC_1$ is connected to a fifth line. The electrode EL constituting the other end of the MIS type diode DT is connected to the third line through a high-resistance element R having a resistance of approximately $10^9$ to $10^{12}$ $\Omega$. In this case, there may be employed an embodiment in which the second line to which the fourth region $SC_4$ is connected is used as a bit line and a second predetermined potential is applied to the fifth line to which the first region $SC_1$ is connected, or an embodiment in which a second predetermined potential is applied to the second line to which the fourth region $SC_4$ is connected and the fifth line to which the first region $SC_1$ is connected is used as a bit line.

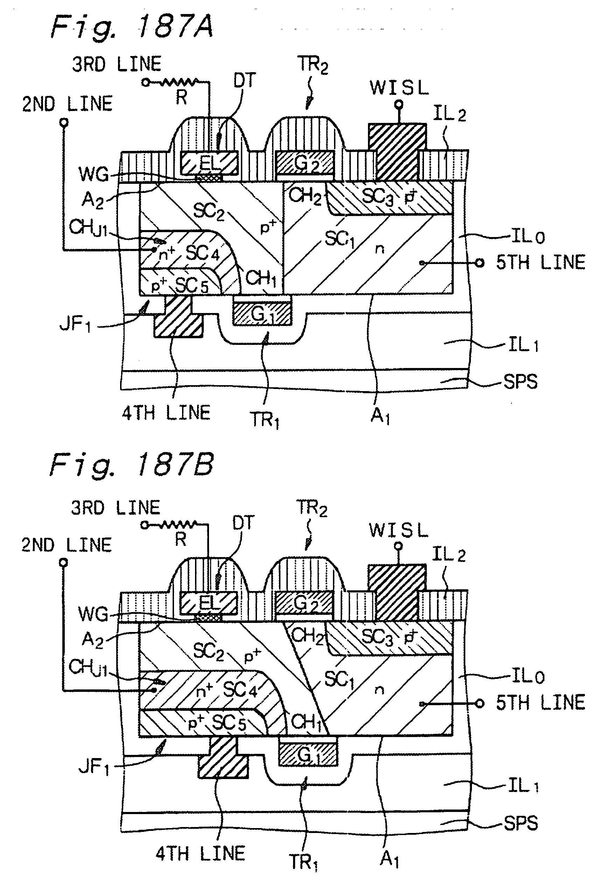

Fig. 186B, 187A and 187B show schematic partial cross-sectional views of variants of the semiconductor memory cell of Example 19. In the variant shown in Fig. 186B, positions of the gate $G_1$ of the first transistor $TR_1$ and the gate $G_2$ of the second transistor $TR_2$ are nearly aligned with regard to the perpendicular direction, differing from their positional relationship in Fig. 186A. Forming such a structure serves to decrease the area of the semiconductor memory cell. In the variants shown in Figs. 187A and 187B, the supporting substrate SPS, the insulating interlayer $IL_1$, the gate $G_1$ of the first transistor $TR_1$ and the gate $G_2$ of the second transistor $TR_2$ are arranged in this order from below. The positional relationship of these regions with regard to the perpendicular direction is reverse to the positional relationship of the regions of the semiconductor memory cells shown in Figs. 186A and 186B. In the variant shown in Fig. 187B, positions of the gate $G_1$ of the first transistor $TR_1$ and the gate $G_2$ of the second transistor $TR_2$ are nearly aligned with regard to the perpendicular direction, differing from their positional relationship in Fig. 187A.

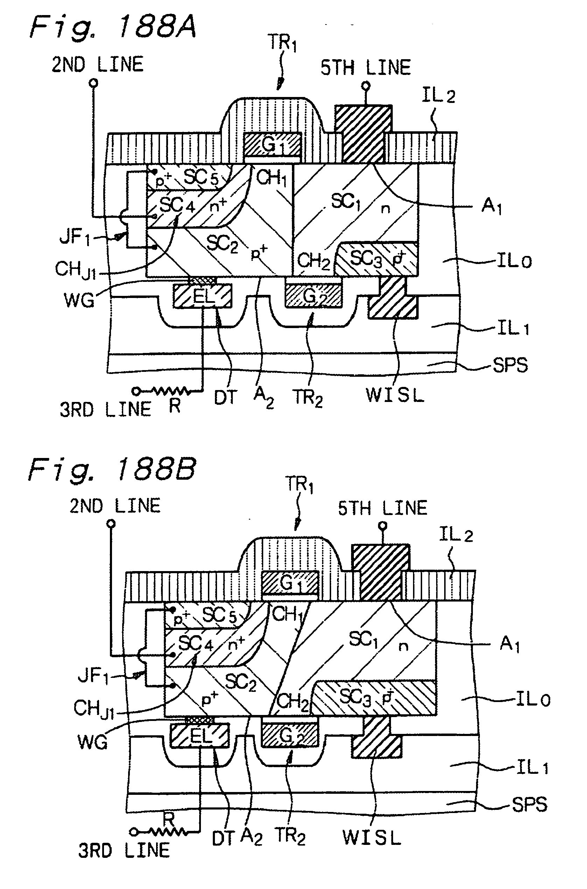

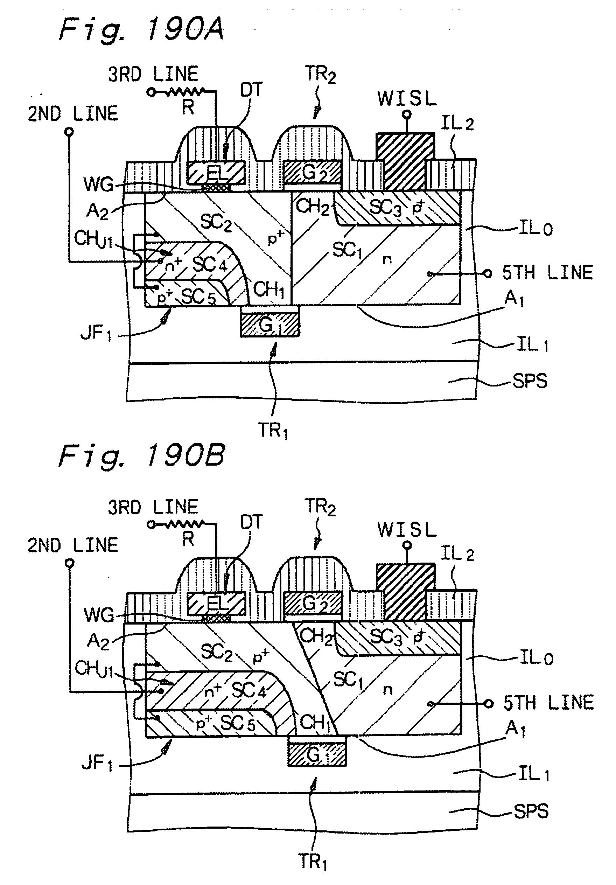

Further, Figs. 188A, 188B, 190A and 190B show schematic partial cross-sectional views of variants of the semiconductor memory cell of Example 19. Fig. 189B shows a schematic layout of gates and regions in the semiconductor memory cell shown in Fig. 188A. In Fig. 189B, showing of the gate $G_2$ and the third region $SC_3$ is omitted. The principle drawing of the semiconductor memory cells shown in these Figures is as shown in Fig. 112. That is, in these semiconductor memory cells, the fifth region $SC_5$ is connected to the second region $SC_2$ in place of being connected to the fourth line. Specifically, the fifth region $SC_5$ and the second region $SC_2$ can be connected to each other, for example, by forming a structure in which a portion of the second region $SC_2$ is extended up to the first main surface $A_1$ of the semiconductor layer and the fifth region $SC_5$ and the extending portion of the second region $SC_2$ are in contact with each other outside the fourth region $SC_4$. The wiring structure of the semiconductor memory cell can be simplified by structuring the semiconductor memory cell as described above. The semiconductor memory cells shown in Figs. 188A and 188B are variants of the semiconductor memory cells shown in Figs. 186A and 186B, and the semiconductor memory cells shown in Figs. 190A and 190B are variants of the semiconductor memory cells shown in Figs. 187A and 187B. In these cases, it is preferred to employ a constitution in which the second line is used as a bit line, or a constitution in which the write-in information setting line WISL is used as a bit line as well and a second predetermined potential is applied to the second line.

The operation (not claimed) of the semiconductor memory cell of Example 5 will be explained below. It should be noted that the principles of operation of the semiconductor memory cells of other Examples are substantially same. When the write-in information setting line also serves as the second line (for example, bit line), the term "the write-in information setting line" in the following paragraphs is literally convertible to "the second line (for example, bit line)".

In write-in operation, potentials at portions of the semiconductor memory cell are set as shown in the following Table 8.

<div align="center">Table 8</div>

| | |
|---|---|
| First line for memory cell selection : | $V_w$ |
| write-in information setting line when writing "0" (first information) : | $V_0$ (first potential) |
| when writing "1" (second information) | : $v_1$ (second potential) |

In read-out operation, potentials at portions of the semiconductor memory cell are set as shown in the following Table 9. When the write-in information setting line is provided separately from the second line, the predetermined potential including 0 volt is applied to the write-in information setting line.

<div align="center">Table 9</div>

| | |
|---|---|
| First line for memory cell selection (for example, word line) | : $V_R$ |
| Second line (for example, bit line) | : $V_2$ |

Further, the electrode EL constituting the other end of the MIS type diode DT is connected to the line (third line) having a predetermined potential, and the predetermined potential is set at $V_{DD}$. When the first conductivity type is n-type and the second conductivity type is p-type, $V_{DD}$ is a negative value.

A threshold voltage of the first transistor $TR_1$ seen from the gate $G_1$ is given as shown in the following Table 10. Further, the relationship among potentials in the first transistor $TR_1$ is set as shown in Table 10. A potential in the channel forming region $CH_1$ of the first transistor $TR_1$ when information "0" (the first information) is read out is different from that when information "1" (the second information) is read out. As a result, the threshold voltage of the first transistor $TR_1$ seen from the gate $G_1$ changes, depending upon whether the stored information is "0" or "1". When the ratio of an on-state current to an off-state current of the junction-field-effect transistor $JF_1$ for current control is large, the information can be read out without any error even if $|VR| \geq |V_{TH\_11}|$ .

<div align="center">Table 10</div>

| | |
|---|---|
| When "0" (first information) is read out | : $V_{TH\_10}$ |
| When "1" (second information) is read out | : $V_{TH\text{-}11}$ |
| $|V_{TH-11}| > |V_R| > |V_{TH\_10}|$ | |

[Operation to write information]

In operation to write "0" (the first information, and the potential in the write-in information setting line: $V_0$) or write "1" (the second information, and the potential in the write-in information setting line: $V_1$), the potential in the first line is set at $V_w$ (< 0). As a result, the potential in the gate $G_2$ of the second transistor $TR_2$ is set at $V_w$ (< 0) as well, and the second transistor $TR_2$ is brought into an on-state. Therefore, the potential in the channel forming region $CH_1$ of the first transistor $TR_1$ is $V_0$ (the first potential) when information "0" is written in, or $V_1$ (the second potential) when information "1" is written in. As a result, the potential in one end of the MIS type diode DT is $V_0$ (the first potential) when information "0" is written in, or $V_1$ (the second potential) when information "1" is written in.

Meanwhile, if a current flowing in the wide gap thin film WG is greater than a reverse bias junction leak current between the second region $SC_2$ and the first region $SC_1$, the first region $SC_1$ is in a steady state in which the first region $SC_1$ is pulled up toward the other end of the MIS type diode DT. When the wide gap thin film WG is composed of an $SiO_2$ or SiON layer having a thickness of approximately 3 nm, and if the absolute value of a difference between $V_{DD}$ and the potential in the first region $SC_1$ is 2 volts or greater (at least 2.5 volts for the necessity of carrier multiplication to be explained below), the above state is materialized.

When the potential in one end of the MIS type diode DT is at the level of $V_0$ (the case of information of "0") which is the first potential, and when the value of $|V_{DD}-V_0|$ is, for example, 2.5 volts or greater, electrons flow in the wide gap thin film WG from the electrode EL constituting the other end of the MIS type diode DT due to a tunnel effect (direct-tunnel phenomenon or Fowler-Nordheim tunnel phenomenon), i.e., a tunnel current flows, and the electrons are injected into the surface of the first region $SC_1$. When the injected electrons have an energy which is higher than an energy gap equivalent of the first region $SC_1$ when viewed from the conduction band of the first region $SC_1$, carrier multiplication takes place, and electron-hole pairs are generated. In Example 5, the first region $SC_1$ has a p-type conductivity, so that holes are stored or accumulated in a portion of the first region $SC_1$ (extending portion of the channel forming region $CH_1$ of the first transistor $TR_1$), and even after the second transistor $TR_2$ comes to be off, the first region $SC_1$ is retained at the level of $V_0$ which is the first potential or a potential close thereto. And, the injection of electrons from the electrode EL constituting the MIS type diode DT is continued, and as a result, the carrier multiplication continues. That is, the potential in the channel forming region $CH_1$ of the first transistor $TR_1$ is retained on nearly at the first potential ($\fallingdotseq V_0$). When the first region $SC_1$ is formed of a silicon containing a p-type impurity, and when the electrode EL of the MIS type diode DT is composed of a polysilicon thin layer containing an n-type impurity, the above phenomenon takes place when the value of $|V_{DD}-V_0|$ is 2.5 volts or greater. When the storing or accumulating of holes proceeds, the potential in the channel forming region $CH_1$ of the first transistor $TR_1$ sometimes comes to be higher than $V_0$ by approximately 0.1 to 0.2 volt when the conductivity type of the first transistor $TR_1$ is an n-type.

When the potential in one end of the MIS type diode DT is at the level of $V_1$ (the case of information of "1") which is the second potential, and when the value of $|V_{DD}-V_0|$ is equivalent to, or smaller than, the band gap of a material constituting the first region $SC_1$, the carrier multiplication does not take place. Actually, even if the value of $|V_{DD}-V_0|$ equals approximately the band gap of a material constituting the first region $SC_1$ + 0.5 volt, no carrier multiplication takes place. As a result, the junction leak current between the second region $SC_2$ and the first region $SC_1$ is compensated by the transition of majority carriers (holes) in the extending portion of the channel forming region $CH_1$ of the first transistor $TR_1$ to the electrode EL through the wide gap thin film WG according to the tunnel transition, and the potential in the first region $SC_1$ is retained at the level of $V_1$ which is the second potential. That is, the channel forming region $CH_1$ of the first transistor $TR_1$ is retained on at the level of the second potential ($V_1$).

In operation to write information, the potential in the gate $G_1$ of the first transistor $TR_1$ is also set at $V_w$ (< 0). As a result, the first transistor $TR_1$ is in an off-state. In this state, the potential in the channel forming region $CH_1$ of the first transistor $TR_1$ is $V_0$ when information "0" is written in, or, $V_1$ when information "1" is written in. This state is maintained until operation of reading out information.

In an information maintaining state after the information has been written in and before the information is read out, potentials in portions in the first transistor $TR_1$ and the second transistor $TR_2$ should be set at such values that these transistors do not conduct. For this purpose, typically, the potential in the first line is set at 0 volt and the potential in the write-in information setting line is set at $V_1$.

[Operation to read out information]

In operation to read out the information "0" or "1", the potential in the first line is set at $V_R$ (> 0). Therefore, the potential in the gate $G_2$ of the second transistor $TR_2$ is also set at $V_R$ (> 0). As a result, the second transistor $TR_2$ is brought into an off-state.

The potential in the gate $G_1$ of the first transistor $TR_1$ is set at $V_R$ (> 0) as well. The threshold voltage of the first transistor $TR_1$ seen from the gate is $V_{TH\_10}$ or $V_{TH\_1}$ for stored information of "0" or "1", respectively. The threshold voltage of the first transistor $TR_1$ depends upon the state of the potential in the channel forming region $CH_1$. The relationship among the potentials and the threshold voltages is as follows.

$$|V_{TH\_11}| \; > \; |V_R| \; > \; |V_{TH\_10}|$$

Therefore, when the stored information is "0", the first transistor $TR_1$ is brought into an on-state. When the stored information is "1", on the other hand, the first transistor $TR_2$ is brought into an off-state. However, when the ratio of an on-state current to an off-state current of the junction-field-effect transistor $JF_1$ is large, the information can be read out without any error even if $|V_R| \geq |V_{TH\_11}|$.

Further, the first transistor $TR_1$ for readout is controlled by the junction-field-effect transistor $JF_1$ on the basis of the bias conditions of the gate regions of the junction-field-effect transistor $JF_1$ which are constituted of the fifth region $SC_5$ and the first region SC. That is, when the stored information is "0", the junction-field-effect transistor $JF_1$ is brought into an on-state. When the stored information is "1", on the other hand, the junction-field-effect transistor $JF_1$ is brought into an off-state.

In the above manner, the first transistor $TR_1$ can be brought into an on-state or an off-state with a high degree of reliability depending upon the stored information. Since the fourth region $SC_4$ is connected to the second line (for example, bit line), a current flows or does not flow in the first transistor $TR_1$ depending upon whether the stored information is "0" or "1". As a result, the stored information can be read out by the first transistor $TR_1$.

The operating states of the first transistor $TR_1$ for readout and the second transistor $TR_2$ for switching described above are summarized in Table 11. It should be noted that the values of potentials shown in Table 11 are no more than typical values, which can be any values as long as the conditions described above are satisfied.

Table 11

| | | | unit : | volt |
|---|---|---|---|---|
| Write-in operation | Write-in of "0" | | write-in of "1" | |
| Potential in first line | $V_w$ | -1.5 | $V_w$ | -1.5 |
| Potential in write-in information setting line | $V_0$ | 0 | $V_1$ | -1.5 |
| Potential in gate | $V_w$ | -1.5 | $V_w$ | -1.5 |
| State of $TR_2$ | ON | | ON | |
| Potential in channel forming region $CH_1$ | $V_0$ | $\fallingdotseq 0$ | $V_1$ | -1.5 |
| State of $TR_1$ | OFF | | OFF | |
| Potential in the other end of MIS type diode DT | -2.5 | | | |
| | | | | |
| Read-out operation | Read-out of "0" | | Read-out of "1" | |
| Potential in first line | $V_R$ | 0.8 | $V_R$ | 0.8 |
| Potential in gate | $V_R$ | 0.8 | $V_R$ | 0.8 |
| State of $TR_2$ | OFF | | OFF | |
| Potential in channel forming region $CH_1$ | $V_0$ | 0 | $V_1$ | -1.5 |
| Threshold voltage of $TR_1$ seen from gate | $V_{TH1\_0}$ | 0.25 | $V_{TH1\_1}$ | 1.3 |
| State of $TR_1$ | ON | | OFF | |
| Potential in second line | $V_2$ | 0 | $V_2$ | 0 |

The semiconductor memory cell of the present invention has been explained with reference to preferred embodiments hereinabove, while the present invention shall not be limited to those embodiments. The structures of the semiconductor memory cells, and voltages, potentials, etc., in the semiconductor memory cells explained as embodiments are examples, and may be changed as required. For example, in the semiconductor memory cells explained as embodiments, the first transistor for readout and the junction-field-effect transistor(s) $JF_1$, $JF_2$ may be p-type transistors, and the second transistor for switching and the third transistor for current control may be n-type transistors. In this case, further, it is sufficient to reverse the relationship of holes and electrons and the polarity of $V_{DD}$ (predetermined potential in the line (third line) to which the electrode constituting the other end of the MIS type diode is connected) with regard to the MIS type diode DT. The layout of elements in each transistor is an example, and may be changed as required.

The SOI structure shown in Figs. 52 and 73 and so on and the TFT structure can be applied to the semiconductor memory cell of the present invention. An impurity may be introduced into each region not only by an ion-implanting method but also by a solid-phase diffusion method. Further, the present invention can be applied not only to a semiconductor memory cell composed of a silicon semiconductor but also to a semiconductor memory cell composed of a compound semiconductor, for example, of a GaAs system. Moreover, the semiconductor memory cell of the present invention can be applied to a semiconductor memory cell having an MES FET structure.

In the present invention, the MIS type diode for retaining information is provided, and the potential in the channel forming region of the first transistor can be retained on during writing the information into the semiconductor memory cell, so that the refreshing operation required in a conventional DRAM is no longer required.

Further, an extremely large capacitor required in a conventional DRAM is no longer required. Further, the semiconductor memory cell having the MIS type diode for retaining information, provided by the present invention, an be integrated into only two transistor regions. The semiconductor memory cell of the present invention can be manufactured by a CMOS logic circuit manufacturing process with increasing a few steps alone.

Further, the junction-field-effect transistor for current control is controlled to turn on/off during the reading of information, so that the margin of a current to flow between the second region and the third region can be remarkably broadened. As a result, the number of semiconductor memory cells which are connected to a bit line is less limited, and the time period for retaining information in the semiconductor memory cell (retention time) can be increased. Further, when the third transistor is provided, the gate is structured so as to extend up to an end of the surface region of the fourth region, and, for example, the sixth region can be formed in a self-alignment manner, so that the area of the semiconductor memory cell can be further decreased.

**Claims**

**1.** A semiconductor memory cell comprising;

(1) a first transistor ($TR_1$) for readout, having a first conductivity type, and having source/drain regions, a semi-conductive channel forming region ($CH_1$) which is in contact with the source/drain regions and spaces out the source/drain regions, and a gate (Gi) capacitively coupled with the channel forming region ($CH_1$),

(2) a second transistor ($TR_2$) for switching, having a second conductivity type, and having source/drain regions, a semi-conductive channel forming region ($CH_2$) which is in contact with the source/drain regions and spaces out the source/drain regions, and a gate ($G_2$) capacitively coupled with the channel forming region ($CH_2$),

(3) a first junction-field-effect transistor ($JF_1$) for current control, having source/drain regions, a channel region ($CH_{J1}$) and gate regions,

wherein:

one source/drain region of the second transistor ($TR_2$) corresponds to the channel forming region ($CH_1$) of the first transistor ($TR_1$) and corresponds to one gate region of the first junction-field-effect transistor ($JF_1$), **characterized in that** the semiconductor memory cell also comprises (4) an MIS type diode (DT) for retaining information, wherein

one source/drain region of the first transistor ($TR_1$) corresponds to the channel forming region ($CH_2$) of the second transistor ($TR_2$), and corresponds to one source/drain region of the first junction-field-effect transistor ($JF_1$), and

one end of the MIS type diode (DT) is formed of an extending portion of the channel forming region ($CH_1$) of the first transistor ($TR_1$), the other end of the MIS type diode (DT) is formed of an electrode composed of a conductive material, and the electrode is connected to a line having a predetermined potential.

**2.** The semiconductor memory cell according to claim 1, wherein the gate ($G_1$) of the first transistor ($TR_1$) and the gate ($G_2$) of the second transistor ($TR_2$) are connected to a first line for memory cell selection,

the other source/drain region of the first transistor ($TR_1$) is connected to a second line,

the other end of the MIS type diode (DT) is connected to a third line corresponding to said line having a predetermined potential through a high-resistance element (R),

the other gate region of the first junction-field-effect transistor ($IF_1$) is connected to a fourth line,

the one source/drain region of the first transistor ($TR_1$) is connected to a fifth line through the first junction-field-effect transistor ($JF_1$), and

the other source/drain region of the second transistor ($TR_2$) is connected to a write-in information setting line (WISL).

3. The semiconductor memory cell according to claim 1 further comprising;
a second junction-field-effect transistor ($JF_2$) for current control, having source/drain regions, a channel region and gate regions, and
wherein:

the other source/drain region of the first transistor ($TR_1$) corresponds to one source/drain region of the second junction-field-effect transistor ($JF_2$), and
said source/drain region of the second transistor ($TR_2$) further corresponds to one gate region of the second junction-field-effect transistor ($JF_2$).

4. The semi-conductor memory cell according to claim 3,
wherein the gate ($G_1$) of the first transistor ($TR_1$) and the gate ($G_2$) of the second transistor ($TR_2$) are connected to a first line for memory cell selection,
the other source/drain region of the first transistor ($TR_1$) is connected to a second line through the second junction-field-effect transistor ($JF_2$),
the other end of the MIS type diode (DT) is connected to a third line corresponding to said line having a predetermined potential through a high-resistance element (R),
the other gate region of the second junction-field-effect transistor ($JF_2$) is R connected to a fourth line,
the one source/drain region of the first transistor ($TR_1$) is connected to a fifth line through the first junction-field-effect transistor ($JF_1$),
the other gate region of the first junction-field-effect transistor ($JF_1$) is connected to a write-in information setting line (WISL), and
the other source/drain region of the second transistor ($TR_2$) is connected to the write-in information setting line (WISL).

5. The semi-conductor memory cell according to claims 1 and 3, wherein the first transistor ($TR_1$) and the second transistor ($TR_2$) have a common gate.

6. The semiconductor memory cell according to claim 1, further comprising;
a third transistor ($TR_3$) for current control, having the second conductivity type, and having source/drain regions, a semi-conductive channel forming region ($CH_3$) which is in contact with the source/drain regions and spaces out the source/drain regions, and a gate (G) capacitively coupled with the channel forming region ($CH_3$), and
a second junction-field-effect transistor ($JF_2$) for current control, having source/drain regions, a channel region and gate regions,
wherein:

the other source/drain region of the first transistor ($TR_1$) corresponds to one source/drain region of the second junction-field-effect transistor ($JF_2$),
said source/drain region of the second transistor further corresponds to one gate region of the second junction-field-effect transistor ($JF_2$) and corresponds to one source/drain region of the third transistor ($TR_3$), and
the other source/drain region of the third transistor ($TR_3$) corresponds to the other gate region of the second junction-field-effect transistor ($JF_2$).

7. A semiconductor memory cell comprising;

(1) a first transistor ($TR_1$) for readout, having a first conductivity type, and having source/drain regions, a semi-conductive channel forming region ($CH_1$) which is in contact with the source/drain regions and spaces out the source/drain regions, and a gate ($G_1$) capacitively coupled with the channel forming region ($CH_1$),
(2) a second transistor ($TR_2$) for switching, having a second conductivity type, and having source/drain regions, a semi-conductive channel forming region ($CH_2$) which is in contact with the source/drain regions and spaces out the source/drain regions, and a gate ($G_2$) capacitively coupled with the channel forming region ($CH_2$),
(3) a first junction-field-effect transistor ($JF_1$) for current control, having source/drain regions, a channel region ($CH_{J1}$) and gate regions,

wherein:

one source/drain region of the second transistor ($TR_2$) corresponds to the channel forming region ($CH_1$) of the first transistor ($TR_1$) and corresponds to one gate region of the first junction-field-effect transistor ($JF_1$),
the other source/drain region of the first transistor ($TR_1$) corresponds to one source/drain region of the first

66

junction-field-effect transistor (JF$_1$),
**characterised in that**
the semiconductor memory cell also comprises (4) an MIS type diode (DT) for retaining information,
wherein
one source/drain region of the first transistor (TR$_1$) corresponds to the channel forming region (CH$_2$) of the second transistor (TR$_2$), and
one end of the MIS type diode (DT) is formed of an extending portion of the channel forming region (CH$_1$) of the first transistor (TR$_1$), the other end of the MIS type diode (DT) is formed of an electrode composed of a conductive material, and the electrode is connected to a line having a predetermined potential.

8. The semiconductor memory cell according to claim 7, wherein the gate (G$_1$) of the first transistor (TR$_1$) and the gate (G$_2$) of the second transistor (TR$_2$) are connected to a first line for memory cell selection,
the other source/drain region of the first transistor (TR$_1$) is connected to a second line through the first junction-field-effect transistor (JF$_1$),
the other end of the MIS type diode (DT) is connected to a third line corresponding to said line having a predetermined potential through a high-resistance element (R),
the other gate region of the first junction-field-effect transistor (JF$_1$) is connected to a fourth line,
the one source/drain region of the first transistor (TR$_1$) is connected to a fifth line, and
the other source/drain region of the second transistor (TR$_2$) is connected to a write-in information setting line (WISL).

9. The semiconductor memory cell according to claim 7 further comprising;
a third transistor (TR$_3$) for current control, having the second conductivity type, and having source/drain regions, a semi-conductive channel forming region (CH$_3$) which is in contact with the source/drain regions and spaces out the source/drain regions, and a gate (G) capacitively coupled with the channel forming region (CH$_3$),
wherein:

said source/drain region of the second transistor (TR$_2$) further corresponds to one source/drain region of the third transistor (TR$_3$) and,
the other source/drain region of the third transistor (TR$_3$) corresponds to the other gate region of the first junction-field-effect transistor (JF$_1$).

10. The semi-conductor memory cell according to claim 9, wherein the gate (G$_1$) of the first transistor (TR$_1$), the gate (G$_2$) of the second transistor (TR$_2$) and the gate (G) of the third transistor (TR$_3$) are connected to a first line for memory cell selection,
the other source/drain region of the first transistor (TR$_1$) is connected to a second line through the first junction-field-effect transistor (JF$_1$),
the other end of the MIS type diode (DT) is connected to a third line corresponding to said line having a predetermined potential through a high-resistance element (R),
the one source/drain region of the first transistor (TR$_1$) is connected to a fourth line,and
the other source/drain region of the second transistor (TR$_2$) is connected to a write-in information setting line (WISL).

11. The semi-conductor memory cell according to any one of claims 1, 3, 6 and 9, wherein a material is interposed between one end and the other end of the MIS diode (DT), in which material the tunnel transition of carriers is caused depending upon a potential difference between the potential in the channel forming region of the first transistor (TR$_1$) and the potential in the other end of the MIS type diode (DT).

12. The semi-conductor memory cell according to any one of claims 6 and 9, wherein the first transistor (TR$_1$), the second transistor (TR$_2$) and the third transistor (TR$_3$) have a common gate.

13. The semi-conductor memory cell according to claim 6, wherein the gate of the first transistor (TR$_1$), the gate of the second transistor (TR$_2$) and the gate of the third transistor (TR$_3$) are connected to a first line for memory cell selection,
the other source/drain region of the first transistor (TR$_1$) is connected to a second line through the second junction-field-effect transistor (JF$_2$),
the other end of the MIS type diode (DT) is connected to a third line corresponding to said line having a predetermined potential through a high-resistance element (R),
the one source/drain region of the first transistor (TR$_1$) is connected to a fourth line through the first junction-field-effect transistor (JF$_1$),
the other source/drain region of the second transistor (TR$_2$) is connected to a write-in information setting line (WISL), and

the other gate region of the first junction-field-effect transistor (JF$_1$) is connected to the write-in information setting line (WISL).

**Patentansprüche**

1. Halbleiterspeicherzelle, aufweisend:

1) einen ersten Transistor (TR$_1$) zum Auslesen, der einen ersten Leitfähigkeitstyp aufweist und Source/Drain-Gebiete, ein einen halbleitenden Kanal bildendes Gebiet (CH$_1$), das mit den Source/Drain-Gebieten in Kontakt ist und die Source/Drain-Gebiete auf Abstand hält, und ein Gate (G$_1$), das mit dem Kanal bildenden Gebiet (CH$_1$) kapazitiv gekoppelt ist, aufweist,
2) einen zweiten Transistor (TR$_2$) zum Schalten, der einen zweiten Leitfähigkeitstyp aufweist und Source/Drain-Gebiete, ein einen halbleitenden Kanal bildendes Gebiet (CH$_2$), das mit den Source-Drain-Gebieten in Kontakt ist und die Source/Drain-Gebiete auf Abstand hält, und ein Gate (G2), das mit dem Kanal bildenden Gebiet (CH$_2$) kapazitiv gekoppelt ist, aufweist,
3) einen ersten Sperrschicht-Feldeffekttransistor (JF$_1$) zum Stromsteuern, der Source/Drain-Gebiete, ein Kanalgebiet (CH$_{J1}$) und Gate-Gebiete aufweist,
wobei
ein Source/Drain-Gebiet des zweiten Transistors (TR$_2$) mit dem Kanal bildenden Gebiet (CH$_1$) des ersten Transistors (TR$_1$) korrespondiert und mit einem Gate-Gebiet des ersten Sperrschicht-Feldeffekttransistors (JF$_1$) korrespondiert, **dadurch gekennzeichnet, dass** die Halbleiterspeicherzelle auch
4) eine MIS-Typ-Diode (DT) zum Halten von Information aufweist,
wobei
ein Source/Drain-Gebiet des ersten Transistors (TR$_1$) mit dem Kanal bildenden Gebiet (CH$_2$) des zweiten Transistors (TR$_2$) korrespondiert und mit einem Source/Drain-Gebiet des ersten Sperrschicht-Feldeffekttransistors (JF$_1$) korrespondiert und
ein Ende der MIS-Typ-Diode (DT) aus einem sich erweiternden Abschnitt des Kanal bildenden Gebiets (CH$_1$) des ersten Transistors (TR$_1$) gebildet ist, das andere Ende der MIS-Typ-Diode (DT) aus einer aus leitendem Material bestehenden Elektrode gebildet ist und die Elektrode mit einer ein vorbestimmtes Potential aufweisenden Leitung verbunden ist,

2. Halbleiterspeicherzelle nach Anspruch 1, wobei das Gate (G$_1$) des ersten Transistors (TR$_1$) und das Gate (G$_2$) des zweiten Transistors (TR$_2$) mit einer ersten Leitung zur Speicherzellenauswahl verbunden sind,
das andere Source/Drain-Gebiet des ersten Transistors (TR$_1$) mit einer zweiten Leitung verbunden ist,
das andere Ende der MIS-Typ-Diode (DT) durch ein Hochwiderstandselement (R) mit einer mit der das vorbestimmte Potential aufweisenden Leitung korrespondierenden dritten Leitung verbunden ist,
das andere Gate-Gebiet des ersten Sperrschicht-Feldeffekttransistors (JF$_1$) mit einer vierten Leitung verbunden ist,
das eine Source/Drain-Gebiet des ersten Transistors (TR$_1$) durch den ersten Sperrschicht-Feldeffekttransistor (JF$_1$) mit einer fünften Leitung verbunden ist, und
das andere Source/Drain-Gebiet des zweiten Transistors (TR$_2$) mit einer Einschreibinformations-Einstellungsleitung (WISL) verbunden ist.

3. Halbleiterspeicherzelle nach Anspruch 1, weiter aufweisend:

einen zweiten Sperrschicht-Feldeffekttransistor (JF$_2$) zum Stromsteuern, der Source/Drain-Gebiete, ein Kanalgebiet und Gate-Gebiete aufweist, und
wobei:

das andere Source/Drain-Gebiet des ersten Transistors (TR$_1$) mit einem Source/Drain-Gebiet des zweiten Sperrschicht-Feldeffekttransistors (JF$_2$) korrespondiert, und
das genannte Source/Drain-Gebiet des zweiten Transistors (TR$_2$) weiter mit einem Gate-Gebiet des zweiten Sperrschicht-Feldeffekttransistors (JF$_2$) korrespondiert.

4. Halbleiterspeicherzelle nach Anspruch 3,
wobei das Gate (G$_1$) des ersten Transistors (TR$_1$) und das Gate (G$_2$) des zweiten Transistors (TR$_2$) mit einer ersten Leitung zur Speicherzellenauswahl verbunden sind,

das andere Source/Drain-Gebiet des ersten Transistors (TR$_1$) durch den zweiten Sperrschicht-Feldeffekttransistor (JF$_2$) mit einer zweiten Leitung verbunden ist,

das andere Ende der MIS-Typ-Diode (DT) durch ein Hochwiderstandselement (R) mit einer mit der das vorbestimmte Potential aufweisenden Leitung korrespondierenden dritten Leitung verbunden ist,

das andere Gate-Gebiet des zweiten Sperrschicht-Feldeffekttransistors (JF$_2$) mit einer vierten Leitung verbunden ist, das eine Source/Drain-Gebiet des ersten Transistors (TR$_1$) durch den ersten Sperrschicht-Feldeffekttransistor (JF$_1$) mit einer fünften Leitung verbunden ist,

das andere Gate-Gebiet des ersten Sperrschicht-Feldeffekttransistors (JF$_1$) mit einer Einschreibinformations-Einstellungsleitung (WISL) verbunden ist und das andere Source/Drain-Gebiet des zweiten Transistors (TR$_2$) mit der Einschreibinformations-Einstellungsleitung (WISL) verbunden ist.

5.  Halbleiterspeicherzelle nach den Ansprüche 1 und 3, wobei der erste Transistor (TR$_1$) und der zweite Transistor (TR$_2$) ein gemeinsames Gate aufweisen.

6.  Halbleiterspeicherzelle nach Anspruch 1, weiter aufweisend:

    einen dritten Transistor (TR$_3$) zum Stromsteuern, der den zweiten Leitfähigkeitstyp aufweist und Source/Drain-Gebiete, ein einen halbleitenden Kanal bildendes Gebiet (CH$_3$), das in Kontakt mit den Source/Drain-Gebieten ist und die Source/Drain-Gebiete auf Abstand hält, und ein mit dem Kanal bildenden Gebiet (CH$_3$) kapazitiv gekoppeltes Gate (G) aufweist, und

    einen zweiten Sperrschicht-Feldeffekttransistor (JF$_2$) zum Stromsteuern, der Source/Drain-Gebiete, ein Kanalgebiet und Gate-Gebiete aufweist,

    wobei:

        das andere Source/Drain-Gebiet des ersten Transistors (TR$_1$) mit einem Source/Drain-Gebiet des zweiten Sperrschicht-Feldeffekttransistors (JF$_2$) korrespondiert,

        das Source/Drain-Gebiet des zweiten Transistors weiter mit einem Gate-Gebiet des zweiten Sperrschicht-Feldeffekttransistors (JF$_2$) korrespondiert und mit einem Source/Drain-Gebiet des dritten Transistors (TR$_3$) korrespondiert, und

        das andere Source/Drain-Gebiet des dritten Transistors (TR$_3$) mit dem anderen Gate-Gebiet des zweiten Sperrschicht-Feldeffekttransistors (JF$_2$) korrespondiert.

7.  Halbleiterspeicherzelle, aufweisend:

    1) einen ersten Transistor (TR$_1$) zum Auslesen, der einen ersten Leitfähigkeitstyp aufweist und Source/Drain-Gebiete, ein einen halbleitenden Kanal bildendes Gebiet (CH$_1$), das in Kontakt mit den Source/Drain-Gebieten ist und die Source/Drain-Gebiete auf Abstand hält, und ein mit dem Kanal bildenden Gebiet (CH$_1$) kapazitiv gekoppeltes Gate (G$_1$) aufweist,

    2) einen zweiten Transistor (TR$_2$) zum Schalten, der einen zweiten Leitfähigkeitstyp aufweist und Source/Drain-Gebiete, ein einen halbleitenden Kanal bildendes Gebiet (CH$_2$), das in Kontakt mit den Source/Drain-Gebieten ist und die Source/Drain-Gebiete ausschließt bzw. auf Abstand hält, und ein mit dem Kanal bildenden Gebiet (CH$_2$) kapazitiv gekoppeltes Gate (G$_2$) aufweist,

    3) einen ersten Sperrschicht-Feldeffekttransistor (JF$_1$) zum Stromsteuern, der Source/Drain-Gebiete, ein Kanalgebiet (CH$_{J1}$ und Gate-Gebiete aufweist,

    wobei

    ein Source/Drain-Gebiet des zweiten Transistors (TR$_2$) mit dem Kanal bildenden Gebiet (CH$_1$) des ersten Transistors (TR$_1$ korrespondiert und mit einem Gate-Gebiet des ersten Sperrschicht-Feldeffekttransistors (JF$_1$ korrespondiert,

    das andere Source/Drain-Gebiet des ersten Transistors (TR$_1$) mit einem Source/Drain-Gebiet des ersten Sperrschicht-Feldeffekttransistors (JF$_1$) korrespondiert,

    **dadurch gekennzeichnet, dass** die Halbleiterspeicherzelle auch

    4) eine MIS-Typ-Diode (DT) zum Halten von Information aufweist,

    wobei

    ein Source/Drain-Gebiet des ersten Transistors (TR$_1$) mit dem Kanal bildenden Gebiet (CH$_2$) des zweiten Transistors (TR$_2$) korrespondiert und

    ein Ende der MIS-Typ-Diode (DT) aus einem sich erweiternden Abschnitt des Kanal bildenden Gebiets (CH$_1$) des ersten Transistors (TR$_1$ gebildet ist, das andere Ende der MIS-Typ-Diode (DT) aus einer aus leitendem Material bestehenden Elektrode gebildet ist und die Elektrode mit einer ein vorbestimmtes Potential aufweisenden Leitung verbunden ist.

8.  Halbleiterspeicherzelle nach Anspruch 7, wobei das Gate ($G_1$) des ersten Transistors ($TR_1$ und das Gate ($G_2$) des zweiten Transistors ($G_2$) mit einer ersten Leitung zur Speicherzellenauswahl verbunden sind,
    das andere Source/Drain-Gebiet des ersten Transistors ($TR_1$) durch den ersten Sperrschicht-Feldeffekttransistor ($JF_1$) mit einer zweiten Leitung verbunden ist,
    das andere Ende der MIS-Typ-Diode (DT) durch ein Hochwiderstandselement (R) mit einer mit der das vorbestimmte Potential aufweisenden Leitung korrespondierenden dritten Leitung verbunden ist,
    das andere Gate-Gebiet des ersten Sperrschicht-Feldeffekttransistors ($JF_1$) mit einer vierten Leitung verbunden ist,
    das eine Source/Drain-Gebiet des ersten Transistors ($TR_1$) mit einer fünften Leitung verbunden ist und
    das andere Source/Drain-Gebiet des zweiten Transistors ($TR_2$) mit einer Einschreibinformations-Einstellungsleitung (WISL) verbunden ist.

9.  Halbleiterspeicherzelle nach Anspruch 7, weiter aufweisend:

    einen dritten Transistor ($TR_3$) zum Stromsteuern, der den zweiten Leitfähigkeitstyp aufweist und Source/Drain-Gebiete, ein einen halbleitenden Kanal bildendes Gebiet ($CH_3$), das in Kontakt mit den Source/Drain-Gebieten ist und die Source/Drain-Gebiete ausschließt bzw. auf Abstand hält, und ein mit dem den Kanal bildenden Gebiet ($CH_3$) kapazitiv gekoppeltes Gate (G) aufweist,
    wobei:

    das genannte Source/Drain-Gebiet des zweiten Transistors ($TR_2$) weiter mit einem Source/Drain-Gebiet des dritten Transistors ($TR_3$) korrespondiert und
    das andere Source/Drain-Gebiet des dritten Transistors ($TR_3$) mit dem anderen Gate-Gebiet des ersten Sperrschicht-Feldeffekttransistors ($JF_1$) korrespondiert.

10. Halbleiterspeicherzelle nach Anspruch 9, wobei das Gate ($G_1$) des ersten Transistors ($TR_1$), das Gate ($G_2$) des zweiten Transistors ($TR_2$) und das Gate (G) des dritten Transistors ($TR_3$) mit einer ersten Leitung zur Speicherzellenauswahl verbunden sind,
    das andere Source/Drain-Gebiet des ersten Transistors ($TR_1$) durch den ersten Sperrschicht-Feldeffekttransistor ($JF_1$) mit einer zweiten Leitung verbunden ist,
    das andere Ende der MIS-Typ-Diode (DT) durch ein Hochwiderstandselement (R) mit einer mit der das vorbestimmte Potential aufweisenden Leitung korrespondierenden dritten Leitung verbunden ist,
    das eine Source/Drain-Gebiet des ersten Transistors ($TR_1$) mit einer vierten Leitung verbunden ist und
    das andere Source/Drain-Gebiet des zweiten Transistors ($TR_2$) mit einer Einschreibinformations-Einstellungsleitung (WISL) verbunden ist.

11. Halbleiterspeicherzelle nach einem der Ansprüche 1, 3, 6 und 9, wobei zwischen einem Ende und dem anderen Ende der MIS-Typ-Diode (DT) ein Material angeordnet ist, in welchem Material der Tunnelübergang von Trägern abhängig von einer Potentialdifferenz zwischen dem Potential des Kanal bildenden Gebiets des ersten Transistors ($TR_1$) und dem Potential im anderen Ende der MIS-Typ-Diode (DT) bewirkt wird.

12. Halbleiterspeicherzelle nach einem der Ansprüche 6 und 9, wobei der erste Transistor (TR1), der zweite Transistor (TR2) und der dritte Transistor (TR3) ein gemeinsames Gate aufweisen.

13. Halbleiterspeicherzelle nach Anspruch 6, wobei das Gate des ersten Transistors ($TR_1$), das Gate des zweiten Transistors ($TR_2$) und das Gate des dritten Transistors ($TR_3$) mit einer ersten Leitung zur Speicherzellenauswahl verbunden sind,
    das andere Source/Drain-Gebiet des ersten Transistors ($TR_1$) durch den zweiten Sperrschicht-Feldeffekttransistor ($JF_2$) mit einer zweiten Leitung verbunden ist,
    das andere Ende der MIS-Typ-Diode (DT) durch ein Hochwiderstandselement (R) mit einer mit der das vorbestimmte Potential aufweisenden Leitung korrespondierenden dritten Leitung verbunden ist,
    das eine Source/Drain-Gebiet des ersten Transistors ($TR_1$) durch den ersten Sperrschicht-Feldeffekttransistor ($JF_1$) mit einer vierten Leitung verbunden ist,
    das andere Source/Drain-Gebiet des zweiten Transistors ($TR_2$) mit einer Einschreibinformations-Einstellungsleitung (WISL) verbunden ist und
    das andere Gate-Gebiet des ersten Sperrschicht-Feldeffekttransistors ($JF_1$) mit der Einschreibinformation-Einstellungsleitung (WISL) verbunden ist.

**Revendications**

1. Cellule de mémoire à semi-conducteur comprenant :

   (1) un premier transistor (TR$_1$) pour la sortie en lecture, ayant un premier type de conductivité, et ayant des régions source/drain, une région de formation de canal semi-conductrice (CH$_1$) qui est en contact avec les régions source/drain et crée un espace entre les régions source/drain, et une grille (G$_1$) couplée capacitivement avec la région de formation de canal (CH$_1$),
   (2) un deuxième transistor (TR$_2$) pour la commutation, ayant un second type de conductivité, et ayant des régions source/drain, une région de formation de canal semi-conductrice (CH$_2$) qui est en contact avec les régions source/drain et crée un espace entre les régions source/drain, et une grille (G$_2$) couplée capacitivement avec la région de formation de canal (CH$_2$),
   (3) un premier transistor à effet de champ à jonction (JF$_1$) pour la commande de courant, ayant des régions source/drain, une région de canal (CH$_{J1}$) et des régions de grille,
   où :

       une région source/drain du deuxième transistor (TR$_2$) correspond à la région de formation de canal (CH$_1$) du premier transistor (TR$_1$) et correspond à une région de grille du premier transistor à effet de champ à jonction (JF$_1$), **caractérisée en ce que** la cellule de mémoire à semi-conducteur comprend également

   (4) une diode de type MIS (DT) pour conserver des informations,
   où
   une région source/drain du premier transistor (TR$_1$) correspond à la région de formation de canal (CH$_2$) du deuxième transistor (TR$_2$), et correspond à une région source/drain du premier transistor à effet de champ à jonction (JF$_1$), et
   une extrémité de la diode de type MIS (DT) est formée d'une partie en extension de la région de formation de canal (CH$_1$) du premier transistor (TR$_1$), l'autre extrémité de la diode de type MIS (DT) est formée d'une électrode composée d'un matériau conducteur, et l'électrode est connectée à une ligne ayant un potentiel prédéterminé.

2. Cellule de mémoire à semi-conducteur selon la revendication 1, dans laquelle la grille (G$_1$) du premier transistor (TR$_1$) et la grille (G$_2$) du deuxième transistor (TR$_2$) sont connectées à une première ligne pour la sélection de cellule de mémoire,
   l'autre région source/drain du premier transistor (TR$_1$) est connectée à une deuxième ligne,
   l'autre extrémité de la diode de type MIS (DT) est connectée à une troisième ligne correspondant à ladite ligne ayant un potentiel prédéterminé par l'intermédiaire d'un élément à haute résistance (R),
   l'autre région de grille du premier transistor à effet de champ à jonction (JF$_1$) est connectée à une quatrième ligne,
   ladite une région source/drain du premier transistor (TR$_1$) est connectée à une cinquième ligne par l'intermédiaire du premier transistor à effet de champ à jonction (JF$_1$), et
   l'autre région source/drain du deuxième transistor (TR$_2$) est connectée à une ligne d'établissement d'informations d'entrée en écriture (WISL).

3. Cellule de mémoire à semi-conducteur selon la revendication 1, comprenant en outre :

   un second transistor à effet de champ à jonction (JF$_2$) pour la commande de courant, ayant des régions source/drain, une région de canal et des régions de grille, et
   où :

       l'autre région source/drain du premier transistor (TR$_1$) correspond à une région source/drain du second transistor à effet de champ à jonction (JF$_2$), et
       ladite région source/drain du deuxième transistor (TR$_2$) correspond en outre à une région de grille du second transistor à effet de champ à jonction (JF$_2$).

4. Cellule de mémoire à semi-conducteur selon la revendication 3,
   dans laquelle la grille (G$_1$) du premier transistor (TR$_1$) et la grille (G$_2$) du deuxième transistor (TR$_2$) sont connectées à une première ligne pour la sélection de cellule de mémoire,
   l'autre région source/drain du premier transistor (TR$_1$) est connectée à une deuxième ligne par l'intermédiaire du second transistor à effet de champ à jonction (JF$_2$),
   l'autre extrémité de la diode de type MIS (DT) est connectée à une troisième ligne correspondant à ladite ligne ayant un potentiel prédéterminé par l'intermédiaire d'un élément à haute résistance (R),

l'autre région de grille du second transistor à effet de champ à jonction ($JF_2$) est connectée à une quatrième ligne,

ladite une région source/drain du premier transistor ($TR_1$) est connectée à une cinquième ligne par l'intermédiaire du premier transistor à effet de champ à jonction ($JF_1$),

l'autre région de grille du premier transistor à effet de champ à jonction ($JF_1$) est connectée à une ligne d'établissement d'informations d'entrée en écriture (WISL), et

l'autre région source/drain du deuxième transistor ($TR_2$) est connectée à la ligne d'établissement d'informations d'entrée en écriture (WISL).

5. Cellule de mémoire à semi-conducteur selon les revendications 1 et 3, dans laquelle le premier transistor ($TR_1$) et le deuxième transistor ($TR_2$) ont une grille commune.

6. Cellule de mémoire à semi-conducteur selon la revendication 1, comprenant en outre :

un troisième transistor ($TR_3$) pour la commande de courant, ayant le second type de conductivité, et ayant des régions source/drain, une région de formation de canal semi-conductrice ($CH_3$) qui est en contact avec les régions source/drain et crée un espace entre les régions source/drain, et une grille (G) couplée capacitivement avec la région de formation de canal ($CH_3$), et

un second transistor à effet de champ à jonction ($JF_2$) pour la commande de courant, ayant des régions source/drain, une région de canal et des régions de grille,

où :

l'autre région source/drain du premier transistor ($TR_1$) correspond à une région source/drain du second transistor à effet de champ à jonction ($JF_2$),

ladite région source/drain du deuxième transistor correspond en outre à une région de grille du second transistor à effet de champ à jonction ($JF_2$) et correspond à une région source/drain du troisième transistor ($TR_3$), et

l'autre région source/drain du troisième transistor ($TR_3$) correspond à l'autre région de grille du second transistor à effet de champ à jonction ($JF_2$).

7. Cellule de mémoire à semi-conducteur comprenant :

(1) un premier transistor ($TR_1$) pour la sortie en lecture, ayant un premier type de conductivité, et ayant des régions source/drain, une région de formation de canal semi-conductrice ($CH_1$) qui est en contact avec les régions source/drain et crée un espace entre les régions source/drain, et une grille ($G_1$) couplée capacitivement avec la région de formation de canal ($CH_1$),

(2) un deuxième transistor ($TR_2$) pour la commutation, ayant un second type de conductivité, et ayant des régions source/drain, une région de formation de canal semi-conductrice ($CH_2$) qui est en contact avec les régions source/drain et crée un espace entre les régions source/drain, et une grille ($G_2$) couplée capacitivement avec la région de formation de canal ($CH_2$),

(3) un premier transistor à effet de champ à jonction ($JF_1$) pour la commande de courant, ayant des régions source/drain, une région de canal ($CH_{J1}$) et des régions de grille,

où :

une région source/drain du deuxième transistor ($TR_2$) correspond à la région de formation de canal ($CH_1$) du premier transistor ($TR_1$) et correspond à une région de grille du premier transistor à effet de champ à jonction ($JF_1$),

l'autre région source/drain du premier transistor ($TR_1$) correspond à une région source/drain du premier transistor à effet de champ à jonction ($JF_1$),

**caractérisée en ce que**

la cellule de mémoire à semi-conducteur comprend également

(4) une diode de type MIS (DT) pour conserver des informations,

où

une région source/drain du premier transistor ($TR_1$) correspond à la région de formation de canal ($CH_2$) du deuxième transistor ($TR_2$), et

une extrémité de la diode de type MIS (DT) est formée d'une partie en extension de la région de formation de canal ($CH_1$) du premier transistor ($TR_1$), l'autre extrémité de la diode de type MIS (DT) est formée d'une électrode composée d'un matériau conducteur, et l'électrode est connectée à une ligne ayant un potentiel prédéterminé.

8. Cellule de mémoire à semi-conducteur selon la revendication 7, dans laquelle la grille ($G_1$) du premier transistor ($TR_1$) et la grille ($G_2$) du deuxième transistor ($TR_2$) sont connectées à une première ligne pour la sélection de cellule de mémoire,
l'autre région source/drain du premier transistor ($TR_1$) est connectée à une deuxième ligne par l'intermédiaire du premier transistor à effet de champ à jonction ($JF_1$),
l'autre extrémité de la diode de type MIS (DT) est connectée à une troisième ligne correspondant à ladite ligne ayant un potentiel prédéterminé par l'intermédiaire d'un élément à haute résistance (R),
l'autre région de grille du premier transistor à effet de champ à jonction ($JF_1$) est connectée à une quatrième ligne,
ladite une région source/drain du premier transistor ($TR_1$) est connectée à une cinquième ligne, et
l'autre région source/drain du deuxième transistor ($TR_2$) est connectée à une ligne d'établissement d'informations d'entrée en écriture (WISL).

9. Cellule de mémoire à semi-conducteur selon la revendication 7, comprenant en outre :

un troisième transistor ($TR_3$) pour la commande de courant, ayant le second type de conductivité, et ayant des régions source/drain, une région de formation de canal semi-conductrice ($CH_3$) qui est en contact avec les régions source/drain et crée un espace les régions source/drain, et une grille (G) couplée capacitivement avec la région de formation de canal ($CH_3$),
où :

ladite région source/drain du deuxième transistor ($TR_2$) correspond en outre à une région source/drain du troisième transistor ($TR_3$) et,
l'autre région source/drain du troisième transistor ($TR_3$) correspond à l'autre région de grille du premier transistor à effet de champ à jonction ($JF_1$).

10. Cellule de mémoire à semi-conducteur selon la revendication 9, dans laquelle la grille ($G_1$) du premier transistor ($TR_1$), la grille ($G_2$) du deuxième transistor ($TR_2$) et la grille (G) du troisième transistor ($TR_3$) sont connectées à une première ligne pour la sélection de cellule de mémoire,
l'autre région source/drain du premier transistor ($TR_1$) est connectée à une deuxième ligne par l'intermédiaire du premier transistor à effet de champ à jonction ($JF_1$),
l'autre extrémité de la diode de type MIS (DT) est connectée à une troisième ligne correspondant à ladite ligne ayant un potentiel prédéterminé par l'intermédiaire d'un élément à haute résistance (R),
ladite une région source/drain du premier transistor ($TR_1$) est connectée à une quatrième ligne, et
l'autre région source/drain du deuxième transistor ($TR_2$) est connectée à une ligne d'établissement d'informations d'entrée en écriture (WISL).

11. Cellule de mémoire à semi-conducteur selon l'une quelconque des revendications 1, 3, 6 et 9, dans laquelle un matériau est intercalé entre une extrémité et l'autre extrémité de la diode MIS (DT), dans lequel matériau la transition de tunnel de porteurs est provoquée en fonction d'une différence de potentiel entre le potentiel dans la région de formation de canal du premier transistor ($TR_1$) et le potentiel dans l'autre extrémité de la diode de type MIS (DT).

12. Cellule de mémoire à semi-conducteur selon l'une quelconque des revendications 6 et 9, dans laquelle le premier transistor ($TR_1$), le deuxième transistor ($TR_2$) et le troisième transistor ($TR_3$) ont une grille commune.

13. Cellule de mémoire à semi-conducteur selon la revendication 6, dans laquelle la grille du premier transistor ($TR_1$), la grille du deuxième transistor ($TR_2$) et la grille du troisième transistor ($TR_3$) sont connectées à une première ligne pour la sélection de cellule de mémoire,
l'autre région source/drain du premier transistor ($TR_1$) est connectée à une deuxième ligne par l'intermédiaire du second transistor à effet de champ à jonction ($JF_2$),
l'autre extrémité de la diode de type MIS (DT) est connectée à une troisième ligne correspondant à ladite ligne ayant un potentiel prédéterminé par l'intermédiaire d'un élément à haute résistance (R),
ladite une région source/drain du premier transistor ($TR_1$) est connectée à une quatrième ligne par l'intermédiaire du premier transistor à effet de champ à jonction ($JF_1$),
l'autre région source/drain du deuxième transistor ($TR_2$) est connectée à une ligne d'établissement d'informations d'entrée en écriture (WISL), et
l'autre région de grille du premier transistor à effet de champ à jonction ($JF_1$) est connectée à la ligne d'établissement d'informations d'entrée en écriture (WISL).

# Fig. 44

*Fig. 45A*

*Fig. 45B*

## Fig. 46

3RD LINE

1ST LINE
( WORD LINE )

5TH LINE

$SC_1$  R  DT  $SC_1$  $G_1$  $TR_1$  $CH_1$  $SC_5$  $JF_1$  $TR_2$  $G_2$  $CH_2$

$SC_4$  $SC_2$  $SC_2$  $SC_1$  $SC_3$

$SC_1$  $SC_1$  $SC_1$  $CH_{J1}$

WISL

2ND LINE

*Fig. 47A*

*Fig. 47B*

## Fig. 48

*Fig. 49*

3RD LINE

1ST LINE
( WORD LINE )

R

DT

5TH LINE

G₁ TR₁
CH₁

SC₅

JF₁

TR₂
G₂
CH₂

SC₄ SC₂ SC₂

SC₁ SC₁ SC₁ CH_{J1}

SC₁ SC₃

2ND LINE

WISL

*Fig. 50A*

*Fig. 50B*

Fig. 51

# Fig. 52

Fig. 53

# Fig. 54

EP 1 032 044 B1

Fig. 55

EP 1 032 044 B1

Fig. 56

EP 1 032 044 B1

*Fig. 57*

Fig. 58

## Fig. 59

Fig. 60

*Fig. 61*

## Fig. 62A

## Fig. 62B

Fig. 63

Fig. 64

*Fig. 65*

## Fig. 66A

## Fig. 66B

# Fig. 67

## Fig. 68A

## Fig. 68B

EP 1 032 044 B1

*Fig. 69A*

3RD LINE    2ND LINE    1ST LINE ( WORD LINE )    WISL

R    TR₁    G    TR₂    CH₂    IL

DT    EL

WG

IR

n⁺⁺    SC₄    CH₁    CH₁

p⁺    SC₁    n

SC₁₁

p

SC₂ₐ    n⁺⁺    n⁺⁺    SC₁₀    SC₂    JF₁    SCS

5TH LINE

*Fig. 69B*

EL    SC₂    SC₄    G = G₁ + G₂    SC₃    SC₁

IR

## Fig. 70

EP 1 032 044 B1

EP 1 032 044 B1

Fig. 71

Fig. 72A

Fig. 72B

*Fig. 73A*

*Fig. 73B*

# Fig. 74

## Fig. 75A

## Fig. 75B

Fig. 76

EP 1 032 044 B1

*Fig. 77A*

2ND LINE  3RD LINE  1ST LINE ( WORD LINE )  WISL

R

WG  DT  EL  TR₁  G  TR₂  CH₂  IL

SC₄  n⁺⁺  CH₁  SC₃  p⁺⁺

I R  p⁺  CH_J₁  SC₁  n

SC₁₁

5TH LINE

p

n⁺⁺  n⁺⁺  SC_DT  SC₁₀  SC₂  JF₁  SCS

*Fig. 77C*  *Fig. 77B*

SC₁  I R  EL  SC₂  SC₄  G = G₁ + G₂  SC₁

SC₄  SC₃

SC₁₀

SC₁₁

SC₂  SC_DT

108

Fig. 78

EP 1 032 044 B1

## Fig. 79

EP 1 032 044 B1

Fig. 80

Fig. 81

Fig. 82

## Fig. 83A

## Fig. 83B

## Fig. 84A

## Fig. 84B

*Fig. 85A*

*Fig. 85B*

Fig. 86

Fig. 87

Fig. 88

EP 1 032 044 B1

Fig. 89

Fig. 90

Fig. 91

EP 1 032 044 B1

# Fig. 92

## Fig. 93A

## Fig. 93B

## Fig. 94

1ST LINE
( WORD LINE )

3RD LINE

R

DT

$SC_1$

$SC_5$

$TR_1$
$G_1$

5TH LINE

$TR_2$
$G_2$

$CH_1$

$CH_2$

$JF_1$

$SC_4$

$SC_4$

$SC_2$

$SC_1$

$SC_3$

$SC_1$

$SC_1$

$CH_{J1}$

$SC_1$

WISL

2ND LINE

*Fig. 95A*

*Fig. 95B*

# Fig. 96

3RD LINE

1ST LINE
( WORD LINE )

R

DT

SC₅

TR₁
G₁    CH₁    5TH LINE

SC̄₁    JF₁

SC₄                SC₄        SC₂        TR₂
                                         G₂    CH₂

SC₄    CH_J1    SC₁

SC̄₁    SC̄₁    SC̄₁        SC₁    SC₃

2ND LINE                                    WISL

# Fig. 97A

# Fig. 97B

Fig. 98

EP 1 032 044 B1

*Fig. 99*

Fig. 100

*Fig. 101*

EP 1 032 044 B1

*Fig. 102*

EP 1 032 044 B1

Fig. 103

EP 1 032 044 B1

*Fig. 104*

*Fig. 105A*

*Fig. 105B*

EP 1 032 044 B1

## Fig. 106

Fig. 107

EP 1 032 044 B1

# Fig. 108

## Fig. 109A

## Fig. 109B

Fig. 110

## Fig. 111A

## Fig. 111B

*Fig. 112*

## Fig. 113A

## Fig. 113B

Fig. 114

Fig. 115

Fig. 116

Fig. 117

Fig. 118

Fig. 119

EP 1 032 044 B1

*Fig. 120*

*Fig. 121*

# Fig. 122

WISL

3RD LINE

2ND LINE

1ST LINE
( WORD LINE )

WG    R    EL         $TR_1$    G    $TR_2$

DT                    $JF_1$                                        IL

$SC_4$  $n^+$    $SC_5 p^{++}$    $CH_1$    $CH_2$    $SC_3 p^{++}$

$SC_2$    $n^+$  $SC_1$

$p^+$

$SC_{2A}$    $CH_{U1}$    $n^{++}$    $SC_{10}$    D    n–SCS

EP 1 032 044 B1

# Fig. 123

EP 1 032 044 B1

Fig. 124

EP 1 032 044 B1

Fig. 125

EP 1 032 044 B1

## Fig. 126

## Fig. 127A

3RD LINE

1ST LINE
( WORD LINE )

R

DT

SC5

JF1

SC4        SC4        SC1

CH_J1

SC2

2ND LINE

TR1
G1    CH1

D    SC3

TR2
G2    CH2

SC2        SC3

SC2

WISL

## Fig. 127B

3RD LINE

1ST LINE
( WORD LINE )

R

DT

SC5

JF1

SC4        SC4        SC1

CH_J1

SC2

2ND LINE

TR1
G1    CH1

DS  SC_D

TR2
G2    CH2

SC2        SC3

SC2

WISL

*Fig. 128*

EP 1 032 044 B1

## Fig. 129

## Fig. 130

Fig. 131

# Fig. 132

*Fig. 133A*

*Fig. 133B*

# Fig. 134

EP 1 032 044 B1

# Fig. 135

Fig. 136

EP 1 032 044 B1

EP 1 032 044 B1

*Fig. 137*

## Fig. 138

Fig. 139A

Fig. 139B

Fig. 140

EP 1 032 044 B1

## Fig. 141

Fig. 142

EP 1 032 044 B1

Fig. 143

*Fig. 144*

*Fig. 145A*

*Fig. 145B*

*Fig. 146*

*Fig. 147A*

*Fig. 147B*

Fig. 148

Fig. 149

Fig. 150

# Fig. 151

Fig. 152

EP 1 032 044 B1

Fig. 153

Fig. 154

Fig. 155

Fig. 156

Fig. 157A

Fig. 157B

Fig. 158

EP 1 032 044 B1

Fig. 159

EP 1 032 044 B1

Fig. 160

Fig. 161

EP 1 032 044 B1

Fig. 162

EP 1 032 044 B1

Fig. 163

Fig. 164

EP 1 032 044 B1

Fig. 165

Fig. 166

Fig. 167

Fig. 168

Fig. 169

Fig. 170

Fig. 171

1ST LINE
(WORD LINE)

3RD LINE

WISL

2ND LINE

EP 1 032 044 B1

Fig. 172

Fig. 173

*Fig. 174*

EP 1 032 044 B1

Fig. 175

## Fig. 176A
[STEP—300]

## Fig. 176B
[STEP—310]

# Fig. 177A

[STEP—320]

# Fig. 177B

[STEP—330]

*Fig. 178A*

[STEP–350]

*Fig. 178B*

[STEP–360]

## Fig. 179A

## Fig. 179B

*Fig. 180A*

*Fig. 180B*

## Fig. 181A

## Fig. 181B

## Fig. 182A

## Fig. 182B

## Fig. 183A

## Fig. 183B

## Fig. 184A

2ND LINE     TR$_1$     IL$_2$

A$_1$    SC4 $n^+$   CH$_1$   SC5 $p^+$   JF$_1$

G1

SC$_2$ $p^+$    SC$_1$ $n$   CH$_{J1}$   5TH LINE

A$_2$    CH$_2$   SC$_3$ $p^+$   IL$_0$

WG    EL    G$_2$

IL$_1$

SPS

R    DT   TR$_2$   WISL

3RD LINE

## Fig. 184B

2ND LINE     TR$_1$     IL$_2$

A$_1$    SC4 $n^+$   CH$_1$   SC5 $p^+$   JF$_1$

G1

SC$_2$ $p^+$    SC$_1$ $n$   CH$_{J1}$   5TH LINE

A$_2$    CH$_2$   SC$_3$ $p^+$   IL$_0$

WG    EL    G$_2$

IL$_1$

SPS

R    DT   TR$_2$   WISL

3RD LINE

## Fig. 185A

## Fig. 185B

## Fig. 186A

## Fig. 186B

## Fig. 187A

## Fig. 187B

Fig. 188A

Fig. 188B

Fig. 189A

Fig. 189B

Fig. 190A

Fig. 190B

*Fig. 210A*

W

TRANSISTOR

B

CAPACITOR

*Fig. 210B*

TRANSISTOR        W        CAPACITOR

B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 5246264 A
- JP 7099251 A
- US 5428238 A

- JP 9251646 A
- JP 10154757 A
- EP 0869511 A2

### Non-patent literature cited in the description

- **Y. HAYASHI.** Switching phenomena in thin-insulator metal-insulator-semiconductor diodes. *Appl. Phys. Lett.,* 15 August 1980, vol. 37 (4